# EUROPEAN PATENT APPLICATION

(11) **EP 4 749 365 A1**
(43) Date of publication of application: **27.05.2026**
(21) Application number: 25217532.8
(22) Date of filing: 21.11.2025
(51) Int. Cl.: G03F 7/004, G03F 7/038

(54) **CHEMICALLY AMPLIFIED NEGATIVE RESIST COMPOSITION AND RESIST PATTERN FORMING PROCESS**

(30) Priority: 22.11.2024 JP 2024203637
(71) Applicant: Shin-Etsu Chemical Co., Ltd., Tokyo 100-0005 (JP)
(72) Inventor: FUKUSHIMA, Masahiro, Joetsu-shi (JP)
(74) Representative: Ter Meer Steinmeister & Partner

(57) **Abstract**

An onium salt in which an aromatic ring having a sulfo group bonded thereto and another aromatic ring structure containing a bulky substituent group are linked via a sulfonamide bond generates an aromatic sulfonic acid with adequate acidity and controlled diffusion. When a chemically amplified negative resist composition comprising the onium salt as an acid generator and a polymer is processed by lithography, a pattern with improved resolution, reduced LER and satisfactory fidelity is obtainable.

## Description

### TECHNICAL FIELD

This invention relates to a chemically amplified negative resist composition and a resist pattern forming process using the same.

### BACKGROUND ART

To meet the demand for higher integration density and operating speed of LSIs, the effort to reduce the pattern rule is in rapid progress. Acid-catalyzed chemically amplified resist compositions are most often used in forming resist patterns with a feature size of 0.2 µm or less. High-energy radiation such as UV, deep-UV or EB is used as the light source for exposure of these resist compositions. In particular, while EB lithography is utilized as the ultra-fine microfabrication technique, it is also indispensable in processing photomask blanks to form photomasks for use in semiconductor device fabrication.

Polymers comprising a major proportion of aromatic structure having an acidic side chain, for example, polyhydroxystyrene are useful in resist materials for the KrF excimer laser lithography. These polymers are not used in resist materials for the ArF excimer laser lithography because they exhibit strong absorption at a wavelength of around 200 nm. These polymers, however, are expected to form useful resist materials for the EB and EUV lithography for forming patterns of smaller size than the processing limit of ArF excimer laser because they offer high etching resistance.

One of the important applications of chemically amplified resist material resides in processing of photomask blanks. Some photomask blanks have a surface material that can have an impact on the pattern profile of the overlying chemically amplified resist film, for example, a layer of a chromium compound, typically chromium oxide deposited on a photomask substrate. For high resolution and profile retention after etching, it is one important performance factor to maintain the profile of a resist film pattern rectangular independent of the type of substrate. In recent years, the multibeam mask writing (MBMW) process is used in the processing of mask blanks to achieve further miniaturization. The resist used in the MBMW process is a low-sensitivity resist (or high-dose region) which is advantageous in roughness while a spotlight is brought to the optimization of the resist composition in the high-dose region.

Resist compositions for photolithography include positive ones in which exposed areas are dissolved away and negative ones in which exposed areas are left as a pattern. A viable composition is selected among them depending on the desired resist pattern. In general, the chemically amplified negative resist composition comprises a polymer which is normally soluble in an aqueous alkaline developer, an acid generator which is decomposed to generate an acid upon exposure to light, and a crosslinker which causes the polymer to crosslink in the presence of the acid serving as a catalyst, thus rendering the polymer insoluble in the developer (sometimes, the crosslinker is incorporated in the polymer). Most often a quencher is added for controlling the diffusion of the acid generated upon light exposure.

Typical of the alkali-soluble units to constitute polymers which dissolve in aqueous alkaline developer are units derived from phenols. A number of negative resist compositions of such type were developed, especially as adapted for exposure to KrF excimer laser light. These compositions have not been used in the ArF excimer laser lithography because the phenolic units are not transmissive to exposure light having a wavelength of 150 to 220 nm. Recently, these compositions are recognized attractive again as the negative resist composition for the short wavelength (e.g., EB or EUV) lithography capable of forming smaller size patterns. Exemplary compositions are described in Patent Documents 1 to 3.

Of many acid generators known in the art, Patent Document 4 describes a sulfonium salt capable of generating a sulfonic acid having an iodized aromatic group. This sulfonium salt aims to enhance the sensitization effect in the EUV lithography and is mainly handled as a quencher for fluorinated alkane sulfonic acids. The sulfonium salt has not been fully studied as the acid generator, especially for use in resist compositions comprising polyhydroxystyrene as a base polymer as used in the EB writing process in the processing of mask blanks.

Attempts were made to ameliorate resist sensitivity and pattern profile in a controlled way by properly selecting and combining components used in resist compositions and adjusting processing conditions. One outstanding problem is the diffusion of acid because acid diffusion has a significant impact on the resolution of a chemically amplified resist composition.

The quencher is, in fact, essential for controlling acid diffusion and improving resist performance, especially resolution. Studies have been made on the quencher while amines and weak acid onium salts have been generally used. The weak acid onium salts are exemplified in several patent documents. For example, Patent Document 5 describes that the addition of triphenylsulfonium acetate ensures to form a satisfactory resist pattern without T-top profile, a difference in line width between isolated and grouped patterns, and standing waves. Patent Document 6 describes the addition of ammonium salts of sulfonic acids or carboxylic acids for achieving improvements in sensitivity, resolution and exposure margin. Also, Patent Document 7 describes that a resist composition for KrF or EB lithography comprising a PAG capable of generating a fluorinated carboxylic acid is improved in resolution and process latitudes such as exposure margin and depth of focus. Patent Document 8 describes that a resist composition for F₂ lithography using F₂ laser comprising a PAG capable of generating a fluorinated carboxylic acid is improved in LER and overcomes the footing problem. These compositions are used in the KrF, EB and F₂ lithography processes.

Patent Document 9 describes a positive photosensitive composition for ArF lithography comprising a carboxylic acid onium salt. This system is based on the mechanism that a salt exchange occurs between a weak acid onium salt and a strong acid (sulfonic acid) generated by a PAG upon exposure, to form a weak acid and a strong acid onium salt. That is, the strong acid (sulfonic acid) having high acidity is replaced by a weak acid (carboxylic acid), thereby suppressing acid-catalyzed decomposition reaction of acid labile group and reducing or controlling the distance of acid diffusion. The onium salt apparently functions as a quencher.

In addition to further improvements in roughness, resist compositions are recently demanded which are capable of forming not only line-and-space (LS), isolated line (IL) and isolated space (IS) patterns of satisfactory profile, but also dot patterns of satisfactory profile. Patent Document 10 describes a photoacid generator capable of generating a bulky acid with controlled diffusion, from which patterns having satisfactory resolution and roughness are obtainable, but the formation of dot patterns is accompanied with corner rounding. Patent Document 11 describes a photoacid generator capable of generating a non-fluorinated aromatic sulfonic acid having a plurality of bulky norbornyl groups. Patent Document 12 describes a photoacid generator of a triarylbenzenesulfonic acid anion structure. Patent Document 13 describes a photoacid generator capable of generating a non-fluorinated aromatic sulfonic acid having a fluorinated aromatic ring introduced therein. Although these patent documents intend to control acid diffusion by introducing plural alkyl substituents, aromatic rings or iodine atoms so that the generated acids may have a higher molecular weight, the control of acid diffusion is still insufficient for the purpose of forming small-size patterns. There remains room for further improvement.

### Citation List

| | |
|---|---|
| Patent Document 1: | JP-A 2006-201532 (US 20060166133, EP 1684118) |
| Patent Document 2: | JP-A 2006-215180 |
| Patent Document 3: | JP-A 2008-249762 (USP 9075306, EP 1975711) |
| Patent Document 4: | JP 6645464 |
| Patent Document 5: | JP 3955384 (USP 6479210) |
| Patent Document 6: | JP-A H11-327143 |
| Patent Document 7: | JP 4231622 (USP 6485883) |
| Patent Document 8: | JP 4116340 (USP 7214467) |
| Patent Document 9: | JP 4226803 (USP 6492091) |
| Patent Document 10: | JP 6248882 |
| Patent Document 11: | JP 7067271 |
| Patent Document 12: | JP 7032549 |
| Patent Document 13: | JP-A 2023-177038 |

### SUMMARY OF THE INVENTION

An object of the invention is to provide a chemically amplified negative resist composition which exhibits an improved resolution upon pattern formation and forms a pattern with reduced LER and high fidelity, and a resist pattern forming process using the same.

The inventors have found that when an onium salt in which an aromatic ring having a sulfo group bonded thereto and another aromatic ring structure containing a bulky substituent group are linked via a sulfonamide bond to restrain the degree of freedom of rotation is introduced into a resist composition as a photoacid generator, the onium salt generates an aromatic sulfonic acid having an adequate acidity, the structure is effective for restraining the acid from excessive diffusion, and a pattern with satisfactory resolution and reduced LER is obtained. By virtue of proper dissolution inhibition, a pattern of rectangular profile is obtained.

In one aspect, the invention provides a chemically amplified negative resist composition comprising (A) a photoacid generator in the form of an onium salt having the formula (A) and (B) a base polymer containing a polymer comprising repeat units having the formula (B1).

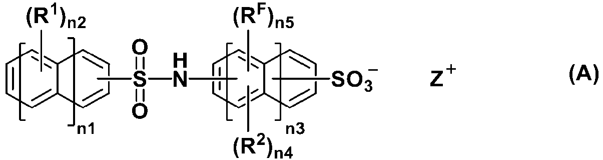

Herein n1 is 0 or 1, n2 is 1, 2, 3, 4 or 5 when n1=0, n2 is 1, 2, 3, 4, 5, 6 or 7 when n1=1, n3 is 0 or 1, n4 is 0, 1, 2, 3 or 4, n5 is 0, 1, 2, 3 or 4, n3 to n5 are in the range: 0 ≤ n4+n5 ≤ 4 when n3=0, and 0 ≤ n4+n5 ≤ 6 when n3=1,
R¹ is each independently iodine or a C₃-C₂₀ branched or cyclic hydrocarbyl group which may contain a heteroatom, at least one R¹ is bonded to a carbon atom adjoining the carbon atom to which S is bonded; when n2 is 2 or more, a plurality of R¹ may be identical or different and a plurality of R¹ may bond together to form a ring with the carbon atoms to which they are attached,
R² is halogen exclusive of fluorine, or a C₁-C₂₀ hydrocarbyl group which may contain a heteroatom exclusive of fluorine; when n4 is 2, 3 or 4, a plurality of R² may be identical or different and a plurality of R² may bond together to form a ring with the carbon atoms to which they are attached,
R^{F} is fluorine, a C₁-C₆ fluorinated alkyl group, C₁-C₆ fluorinated alkoxy group or C₁-C₆ fluorinated alkylthio group; when n5 is 2, 3 or 4, a plurality of R^{F} may be identical or different,
Z⁺ is an onium cation.

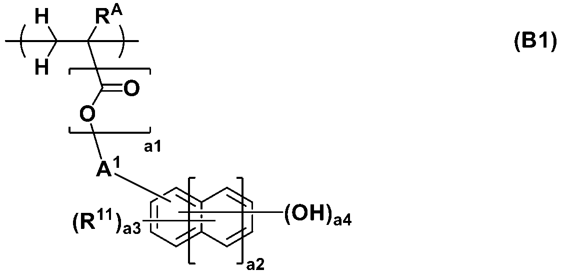

Herein a1 is 0 or 1, a2 is 0, 1 or 2, a3 is an integer meeting 0 ≤ a3 ≤ 5+2(a2)-a4, a4 is 1, 2 or 3,
R^{A} is hydrogen, fluorine, methyl or trifluoromethyl,
R¹¹ is halogen, nitro group, carboxy group, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group; when a3 is 2 or more, a plurality of R¹¹ may be identical or different, and
A¹ is a single bond or C₁-C₁₀ saturated hydrocarbylene group in which some -CH₂-may be replaced by -O-.

In one preferred embodiment, the onium salt has the formula (A1): 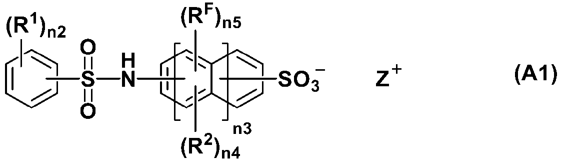 wherein n2, n3, n4, n5, R¹, R², R^{F}, and Z⁺ are as defined above.

More preferably, the onium salt has the formula (A2): 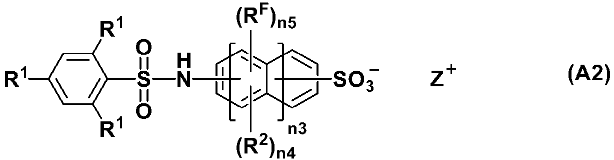 wherein n3, n4, n5, R¹, R², R^{F}, and Z⁺ are as defined above.

In one preferred embodiment, Z⁺ is a sulfonium cation having the formula (Z-1) or iodonium cation having the formula (Z-2): 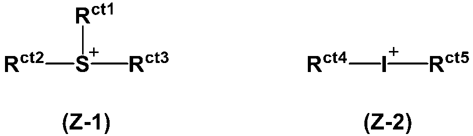 wherein R^{ct1} to R^{ct5} are each independently halogen or a C₁-C₃₀ hydrocarbyl group which may contain a heteroatom, R^{ct1} and R^{ct2} may bond together to form a ring with the sulfur atom to which they are attached.

In another preferred embodiment, Z⁺ is a sulfonium cation having the formula (Z-3).

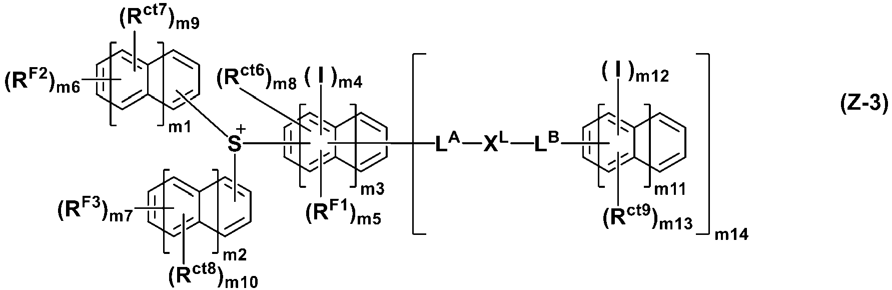

Herein m1 is 0 or 1, m2 is 0 or 1, m3 is 0 or 1, m4 is 0, 1,2,3 or 4, m5 is 0, 1,2,3 or 4, m6 is 0, 1, 2, 3, 4, 5 or 6, m7 is 0, 1, 2, 3, 4, 5 or 6, m8 is 0, 1 or 2, m9 is 0, 1 or 2, m10 is 0, 1 or 2, m11 is 0 or 1, m12 is 0, 1, 2, 3 or 4, m13 is 0, 1 or 2, m14 is 0, 1 or 2, meeting 0 ≤ m6+m9 ≤ 4 when m1=0, 0 ≤ m6+m9 ≤ 6 when m1=1, 0 ≤ m7+m10 ≤ 4 when m2=0, 0 ≤ m7+m10 ≤ 6 when m2=1, 1 ≤ m4+m5+m8+m14 ≤ 4 when m3=0, 1 ≤ m4+m5+m8+m14 ≤ 6 when m3=1, 0 ≤ m12+m13 ≤ 4 when m11=0, 0 ≤ m12+m13 ≤ 6 when m11=1, and m4+m12 ≥ 1,
R^{F1} to R^{F3} are each independently fluorine, a C₁-C₆ fluorinated saturated hydrocarbyl group, C₁-C₆ fluorinated saturated hydrocarbyloxy group, or C₁-C₆ fluorinated saturated hydrocarbylthio group, with the proviso that a plurality of R^{F1} may be identical or different when m5 is 2, 3 or 4, a plurality of R^{F2} may be identical or different when m6 is 2, 3, 4, 5 or 6, and a plurality of R^{F3} may be identical or different when m7 is 2, 3, 4, 5 or 6,
R^{ct6} to R^{ct9} are each independently halogen exclusive of iodine and fluorine, nitro, cyano, a C₁-C₂₀ hydrocarbyl group which may contain a heteroatom, C₁-C₂₀ hydrocarbyloxy group which may contain a heteroatom, or C₁-C₂₀ hydrocarbylthio group which may contain a heteroatom, with the proviso that two R^{ct6} may be identical or different and two R^{ct6} may bond together to form a ring with the carbon atoms to which they are attached when m8=2, two R^{ct7} may be identical or different and two R^{ct7} may bond together to form a ring with the carbon atoms to which they are attached when m9=2, two R^{ct8} may be identical or different and two R^{ct8} may bond together to form a ring with the carbon atoms to which they are attached when m10=2, two R^{ct9} may be identical or different and two R^{ct9} may bond together to form a ring with the carbon atoms to which they are attached when m13=2,
the aromatic rings directly bonded to S⁺ in the sulfonium cation may bond together to form a ring with S⁺,
L^{A} and L^{B} are each independently a single bond, ether bond, ester bond, amide bond, sulfonate ester bond, sulfonamide bond, carbonate bond or carbamate bond, and
X^{L} is a single bond or a C₁-C₄₀ hydrocarbylene group which may contain a heteroatom.

In one preferred embodiment, the polymer further comprises repeat units of at least one type selected from repeat units having the formula (B2) and repeat units having the formula (B3).

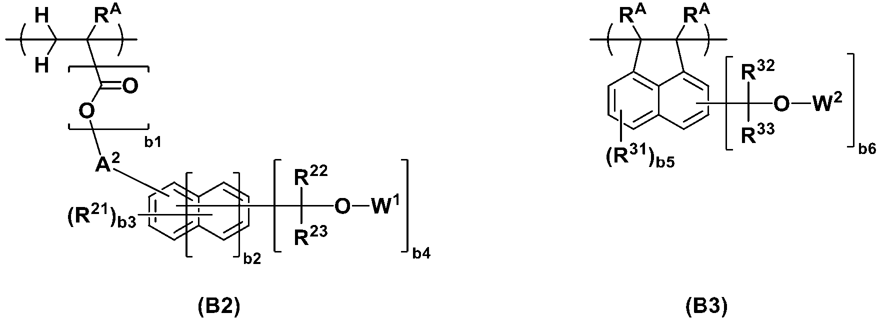

Herein b1 is 0 or 1, b2 is 0, 1 or 2, b3 is an integer meeting 0 ≤ b3 ≤ 5+2(b2)-b4, b4 is 1, 2 or 3, b5 is 0, 1 or 2, b6 is 1 or 2,
R^{A} is each independently hydrogen, fluorine, methyl or trifluoromethyl,
R²¹ is halogen or a C₁-C₂₀ hydrocarbyl group which may contain a heteroatom, a plurality of R²¹ may be identical or different when b3 is 2 or more,
R²² and R²³ are each independently hydrogen, a C₁-C₁₅ saturated hydrocarbyl group which may be substituted with a hydroxy or C₁-C₆ saturated hydrocarbyloxy moiety, or an optionally substituted C₆-C₁₅ aryl group, excluding that R²² and R²³ are hydrogen at the same time, R²² and R²³ may bond together to form a ring with the carbon atom to which they are attached, some -CH₂- in the ring may be replaced by -O- or -S-; a plurality of R²² may be identical or different when b4 is 2 or 3, a plurality of R²³ may be identical or different when b4 is 2 or 3,
R³¹ is halogen or a C₁-C₂₀ hydrocarbyl group which may contain a heteroatom, a plurality of R³¹ may be identical or different when b5=2,
R³² and R³³ are each independently hydrogen, a C₁-C₁₅ saturated hydrocarbyl group which may be substituted with a hydroxy or C₁-C₆ saturated hydrocarbyloxy moiety, or an optionally substituted C₆-C₁₅ aryl group, excluding that R³² and R³³ are hydrogen at the same time, R³² and R³³ may bond together to form a ring with the carbon atom to which they are attached, some -CH₂- in the ring may be replaced by -O- or -S-; a plurality of R³² may be identical or different when b6=2, and a plurality of R³³ may be identical or different when b6=2,
A² is a single bond or C₁-C₁₀ saturated hydrocarbylene group in which some -CH₂-may be replaced by -O-,
W¹ and W² are each independently hydrogen, a C₁-C₁₀ aliphatic hydrocarbyl group, C₂-C₁₀ aliphatic hydrocarbylcarbonyl group, or optionally substituted C₆-C₁₅ aryl group; a plurality of W¹ may be identical or different when b4 is 2 or 3, and a plurality of W² may be identical or different when b6=2.

In one preferred embodiment, the polymer further comprises repeat units of at least one type selected from repeat units having the formula (B4), repeat units having the formula (B5), and repeat units having the formula (B6).

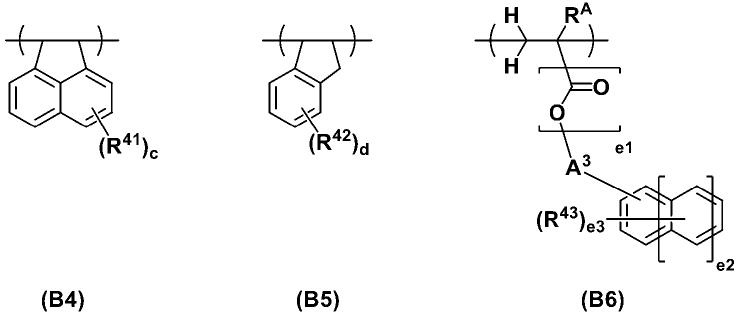

Herein c and d are each independently 0, 1, 2, 3 or 4, e1 is 0 or 1, e2 is 0, 1 or 2, e3 is 0, 1, 2, 3, 4 or 5,
R^{A} is hydrogen, fluorine, methyl or trifluoromethyl,
R⁴¹ and R⁴² are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group; a plurality of R⁴¹ may be identical or different when c is 2, 3 or 4, and a plurality of R⁴² may be identical or different when d is 2, 3 or 4,
R⁴³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro, cyano, C₁-C₂₀ saturated hydrocarbylsulfinyl group, or C₁-C₂₀ saturated hydrocarbylsulfonyl group, a plurality of R⁴³ may be identical or different when e3 is 2, 3, 4 or 5, and
A³ is a single bond or C₁-C₁₀ saturated hydrocarbylene group in which some -CH₂-may be replaced by -O-.

In one preferred embodiment, the polymer further comprises repeat units of at least one type selected from repeat units having the formula (B7), repeat units having the formula (B8), repeat units having the formula (B9), repeat units having the formula (B10), and repeat units having the formula (B11).

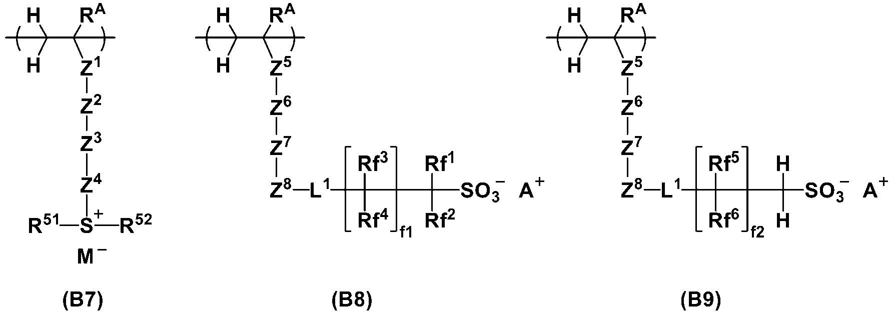

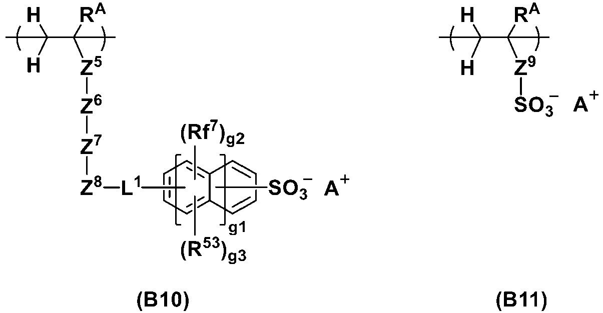

Herein f1 and f2 are each independently 0, 1, 2 or 3, g1 is 0 or 1, g2 is 0, 1, 2, 3 or 4, g3 is 0, 1, 2, 3 or 4, meeting 0 ≤ g2+g3 ≤ 4 when g1=0, and 0 ≤ g2+g3 ≤ 6 when g1=1,
R^{A} is each independently hydrogen, fluorine, methyl or trifluoromethyl,
Z¹ is a single bond or an optionally substituted phenylene group,
Z² is a single bond, **-C(=O)-O-Z²¹-, **-C(=O)-NH-Z²¹-, or **-O-Z²¹-, Z²¹ is a C₁-C₆ aliphatic hydrocarbylene group, phenylene group or a divalent group obtained by combining the foregoing, which may contain halogen, carbonyl moiety, ester bond, ether bond or hydroxy moiety,
Z³ is a single bond, ether bond, ester bond, amide bond, sulfonate ester bond, sulfonamide bond, carbonate bond or carbamate bond,
Z⁴ is a single bond, or a C₁-C₆ aliphatic hydrocarbylene group, phenylene group or a divalent group obtained by combining the foregoing, which may contain halogen, carbonyl moiety, ester bond, ether bond or hydroxy moiety,
Z⁵ is each independently a single bond, an optionally substituted phenylene, naphthylene, or *-C(=O)-O-Z⁵¹-, Z⁵¹ is a C₁-C₁₀ aliphatic hydrocarbylene group which may contain halogen, hydroxy moiety, ether bond, ester bond or lactone ring, or phenylene or naphthylene group,
Z⁶ is a single bond, ether bond, ester bond, amide bond, sulfonate ester bond, sulfonamide bond, carbonate bond or carbamate bond,
Z⁷ is each independently a single bond, ***-Z⁷¹-C(=O)-O-, ***-C(=O)-NH-Z⁷¹-, or ***-O-Z⁷¹-, Z⁷¹ is a C₁-C₂₀ hydrocarbylene group which may contain a heteroatom,
Z⁸ is each independently a single bond, ****-Z⁸¹-C(=O)-O-, ****-C(=O)-NH-Z⁸¹-, or ****-O-Z⁸¹-, Z⁸¹ is a C₁-C₂₀ hydrocarbylene group which may contain a heteroatom,
Z⁹ is a single bond, methylene, ethylene, phenylene, fluorinated phenylene, trifluoromethyl-substituted phenylene, *-C(=O)-O-Z⁹¹-, *-C(=O)-N(H)-Z⁹¹-, or *-O-Z⁹¹-, Z⁹¹ is a C₁-C₆ aliphatic hydrocarbylene group, phenylene group, fluorinated phenylene group or trifluoromethyl-substituted phenylene group, which may contain a carbonyl moiety, ester bond, ether bond or hydroxy moiety,
* is a point of attachment to the carbon atom in the backbone, ** is a point of attachment to Z¹, *** is a point of attachment to Z⁶, **** is a point of attachment to Z⁷,
L¹ is a single bond, ether bond, ester bond, carbonyl group, sulfonate ester bond, sulfonamide bond, carbonate bond or carbamate bond,
Rf¹ and Rf² are each independently fluorine or a C₁-C₆ fluorinated saturated hydrocarbyl group,
Rf³ and Rf⁴ are each independently hydrogen, fluorine, or a C₁-C₆ fluorinated saturated hydrocarbyl group,
Rf⁵ and Rf⁶ are each independently hydrogen, fluorine, or a C₁-C₆ fluorinated saturated hydrocarbyl group, excluding that all Rf⁵ and Rf⁶ are hydrogen at the same time,
Rf⁷ is fluorine, a C₁-C₆ fluorinated alkyl group, C₁-C₆ fluorinated alkoxy group, or C₁-C₆ fluorinated alkylthio group, a plurality of Rf⁷ may be identical or different when g2 is 2, 3 or 4,
R⁵¹ and R⁵² are each independently a C₁-C₂₀ hydrocarbyl group which may contain a heteroatom, R⁵¹ and R⁵² may bond together to form a ring with the sulfur atom to which they are attached,
R⁵³ is halogen exclusive of fluorine, or a C₁-C₂₀ hydrocarbyl group which may contain a heteroatom; when g3 is 2, 3 or 4, a plurality of R⁵³ may be identical or different and a plurality of R⁵³ may bond together to form a ring with the carbon atoms to which they are attached,
M⁻ is a non-nucleophilic counter ion,
A⁺ is an onium cation.

In one preferred embodiment, the polymer comprises repeat units having the formula (B 1-1), repeat units having the formula (B2-1), (B2-2) or (B3-1), and repeat units having the formula (B8-1).

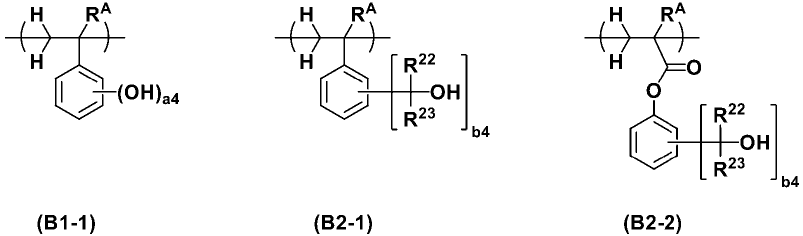

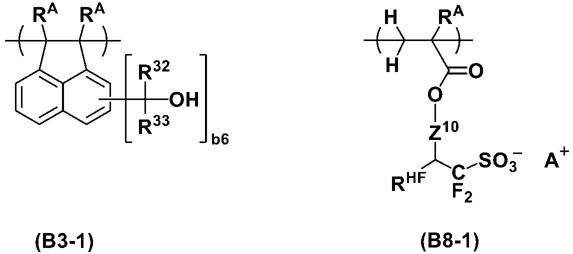

Herein a4, b4, b6, R^{A}, R²², R²³ , R³², R³³, and A⁺ are as defined above,
R^{HF} is hydrogen or trifluoromethyl, and
Z¹⁰ is a single bond or *****-Z¹⁰¹-C(=O)-O-, Z¹⁰¹ is a C₁-C₂₀ hydrocarbylene group which may contain a heteroatom, ***** designates a point of attachment to the oxygen atom in the formula.

In a preferred embodiment, the base polymer (B) contains a polymer comprising repeat units having formula (B1) and repeat units having formula (B2) or (B3), but not repeat units having formulae (B7) to (B11).

In a preferred embodiment, repeat units having an aromatic ring structure account for at least 60 mol% of the overall repeat units of the polymer in the base polymer.

The negative resist composition may further comprise (C) a crosslinker. In another embodiment, the negative resist composition is free of a crosslinker.

The negative resist composition may further comprise (D) a fluorinated polymer comprising repeat units of at least one type selected from repeat units having the formula (D1), repeat units having the formula (D2), repeat units having the formula (D3) and repeat units having the formula (D4) and optionally repeat units of at least one type selected from repeat units having the formula (D5) and repeat units having the formula (D6).

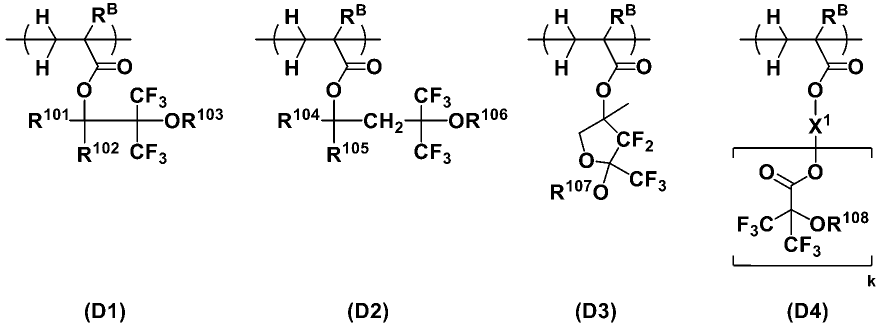

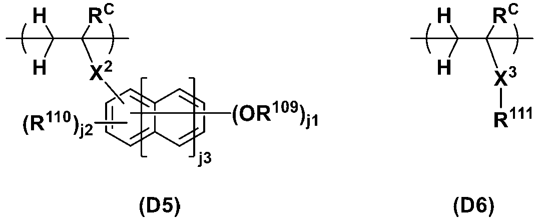

Herein j1 is 1, 2 or 3, j2 is an integer meeting 0 ≤ j2 ≤ 5+2(j3)-j1, j3 is 0 or 1, k is 1, 2 or 3,
R^{B} is each independently hydrogen, fluorine, methyl or trifluoromethyl,
R^{C} is each independently hydrogen or methyl,
R¹⁰¹, R¹⁰², R¹⁰⁴ and R¹⁰⁵ are each independently hydrogen or a C₁-C₁₀ saturated hydrocarbyl group,
R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, and when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
R¹⁰⁹ is hydrogen or a C₁-C₅ straight or branched hydrocarbyl group in which a heteroatom-containing moiety may intervene in a carbon-carbon bond,
R¹¹⁰ is a C₁-C₅ straight or branched hydrocarbyl group in which a heteroatom-containing moiety may intervene in a carbon-carbon bond,
R¹¹¹ is a C₁-C₂₀ saturated hydrocarbyl group in which at least one hydrogen is substituted by fluorine, and in which some constituent -CH₂- may be replaced by an ester bond or ether bond,
X¹ is a C₁-C₂₀ (k+1)-valent hydrocarbon group or C₁-C₂₀ (k+1)-valent fluorinated hydrocarbon group,
X² is a single bond, *-C(=O)-O- or *-C(=O)-NH-, * designates a point of attachment to the carbon atom in the backbone,
X³ is a single bond, -O-, *-C(=O)=O-X³¹-X³²- or *-C(=O)-NH-X³¹-X³²-, X³¹ is a single bond or C₁-C₁₀ saturated hydrocarbylene group, X³² is a single bond, ester bond, ether bond, or sulfonamide bond, and * designates a point of attachment to the carbon atom in the backbone.

The negative resist composition may further comprise (E) a quencher.

In a preferred embodiment, the acid generator (A) and the quencher (E) are present in a weight ratio of less than 6/1.

The negative resist composition may further comprise (F) an organic solvent and/or (G) a photoacid generator other than the photoacid generator (A).

In another aspect, the invention provides a resist pattern forming process comprising the steps of applying the chemically amplified negative resist composition defined herein onto a substrate to form a resist film thereon, exposing the resist film patternwise to high-energy radiation, and developing the exposed resist film in an alkaline developer.

Typically, the high-energy radiation is EUV of wavelength 3 to 15 nm or EB.

In one embodiment, the substrate has the outermost surface of a material containing at least one element selected from chromium, silicon, tantalum, molybdenum, cobalt, nickel, tungsten, and tin.

In one embodiment, the substrate is a mask blank of transmission or reflection type.

Also contemplated herein is a mask blank of transmission or reflection type which is coated with the chemically amplified negative resist composition defined herein.

### ADVANTAGEOUS EFFECTS OF THE INVENTION

When processed by the microfabrication technology, especially EB and EUV lithography processes, a chemically amplified negative resist composition comprising the inventive onium salt as a photoacid generator can form a resist pattern having a very high resolution and reduced LER. A pattern of rectangular profile is obtainable by virtue of adequate dissolution inhibition.

### DESCRIPTION OF THE PREFERRED EMBODIMENT

As used herein, the singular forms "a," "an" and "the" include plural referents unless the context clearly dictates otherwise. "Optional" or "optionally" means that the subsequently described event or circumstances may or may not occur, and that description includes instances where the event or circumstance occurs and instances where it does not. The notation (Cn-Cm) means a group containing from n to m carbon atoms per group. In chemical formulae, Me stands for methyl, Ac stands for acetyl, and the broken line (---) and asterisk (*) designate a point of attachment or valence bond. As used herein, the term "halogenated" refers to a halogen-substituted or halogen-containing compound or group. For example, "fluorinated" refers to a fluorine-substituted or fluorine-containing compound or group. The terms "group" and "moiety" are interchangeable.

The abbreviations and acronyms have the following meaning.
- EB:: electron beam
- EUV:: extreme ultraviolet
- Mw:: weight average molecular weight
- Mn:: number average molecular weight
- Mw/Mn:: molecular weight distribution or dispersity
- GPC:: gel permeation chromatography
- PEB:: post-exposure bake
- PAG:: photoacid generator
- LER:: line edge roughness

It is understood that for some structures represented by chemical formulae, there can exist enantiomers and diastereomers because of the presence of asymmetric carbon atoms. In such a case, a single formula collectively represents all such isomers. The isomers may be used alone or in admixture.

### Negative resist composition

One embodiment of the invention is a chemically amplified negative resist composition comprising (A) a photoacid generator in the form of an onium salt capable of generating a specific benzenesulfonic acid derivative and (B) a base polymer containing a specific polymer.

### (A) Photoacid generator

The photoacid generator as component (A) is an onium salt having the formula (A).

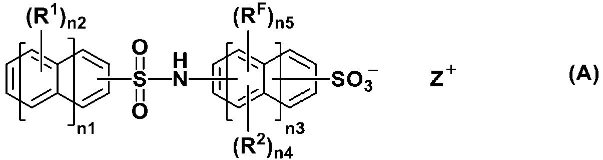

In formula (A), n1 is 0 or 1. The relevant structure is a benzene ring when n1=0, and a naphthalene ring when n1=1. The benzene ring corresponding to n1=0 is preferred from the aspect of solvent solubility. The subscript n2 is 1, 2, 3, 4 or 5 when n1=0, and n2 is 1, 2, 3, 4, 5, 6 or 7 when n1=1. It is preferred from the aspect of reactant availability that n2 be 1, 2, 3 or 4, more preferably 2 or 3. The subscript n3 is 0 or 1. The relevant structure is a benzene ring when n3=0, and a naphthalene ring when n3=1. The benzene ring corresponding to n3=0 is preferred from the aspect of solvent solubility. The subscript n4 is 0, 1, 2, 3 or 4, and n5 is 0, 1, 2, 3 or 4. It is noted that n3 to n5 are in the range: 0 ≤ n4+n5 ≤ 4 when n3=0, and 0 ≤ n4+n5 ≤ 6 when n3=1.

In formula (A), R¹ is each independently iodine or a C₃-C₂₀ branched or cyclic hydrocarbyl group which may contain a heteroatom. At least one R¹ is bonded to a carbon atom adjoining the carbon atom to which S is bonded. Non-limiting examples of the hydrocarbyl group include branched alkyl groups such as isopropyl, sec-butyl, tert-butyl, tert-pentyl and 2-ethylhexyl; C₃-C₂₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, oxanorbornyl, tricyclo[5.2.1.0^{2,6}]decyl, and adamantyl; C₆-C₂₀ aryl groups such as phenyl, naphthyl and anthracenyl; and combinations thereof. In the hydrocarbyl group, some or all hydrogen may be substituted by a moiety containing a heteroatom such as oxygen, sulfur, nitrogen or halogen, and some -CH₂- may be replaced by a moiety containing a heteroatom such as oxygen, sulfur or nitrogen, so that the group may contain a hydroxy, cyano, halogen, carbonyl, ether bond, ester bond, sulfonate ester bond, carbonate bond, lactone ring, sultone ring, carboxylic anhydride (-C(=O)-O-C(=O)-) or haloalkyl moiety. Suitable halogen atoms include fluorine, chlorine, bromine and iodine, with fluorine and iodine being preferred. Preferably, R¹ is selected from C₃-C₂₀ branched alkyl groups such as isopropyl, sec-butyl, tert-butyl, tert-pentyl and 2-ethylhexyl; C₃-C₂₀ aliphatic cyclic hydrocarbyl groups such as cyclopentyl, cyclohexyl, norbornyl, oxanorbornyl, and adamantyl; and optionally substituted C₆-C₂₀ aryl groups such as phenyl and naphthyl. Preferred examples of the optional substituent on the aryl group include fluorine, chlorine, bromine, iodine, C₁-C₁₀ hydrocarbyl moieties which may contain a heteroatom, C₁-C₁₀ hydrocarbyloxy moieties which may contain a heteroatom, and C₂-C₁₀ hydrocarbyloxycarbonyl moieties which may contain a heteroatom. When n2 is 2 or more, a plurality of R¹ may be identical or different.

When n2 is 2 or more, a plurality of R¹ may bond together to form a ring with the carbon atoms to which they are attached. The ring is preferably 5 to 8-membered.

Examples of the structure of an aromatic ring having R¹ bonded thereto are shown below, but not limited thereto. Herein, the broken line (---) designates a point of attachment to S.

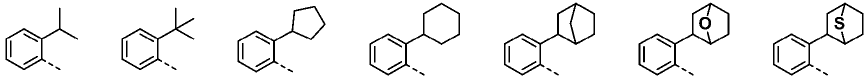

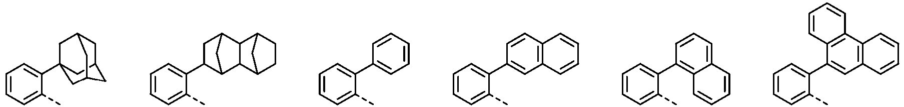

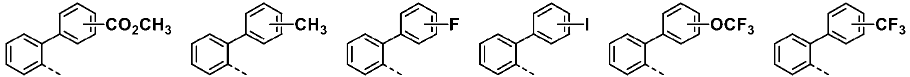

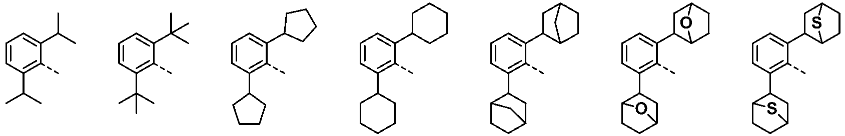

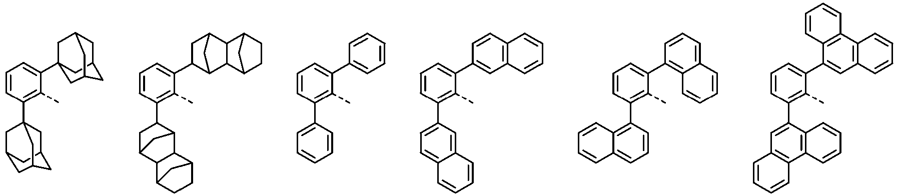

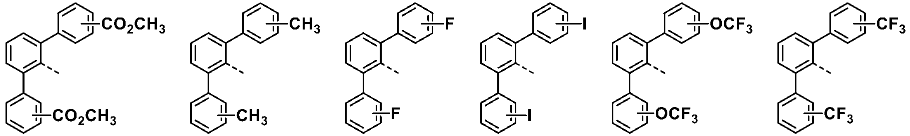

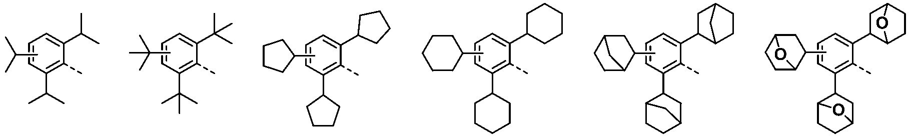

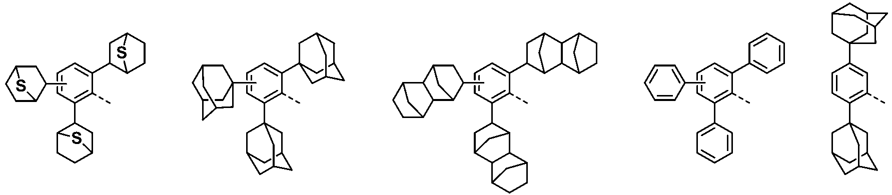

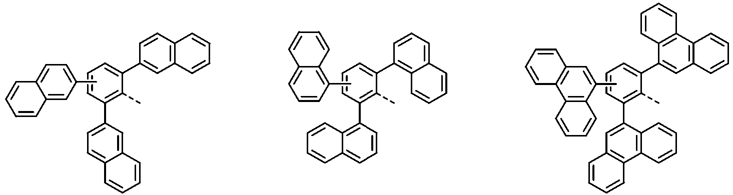

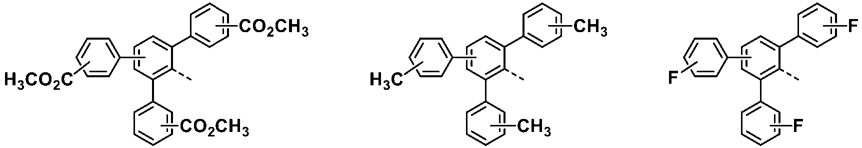

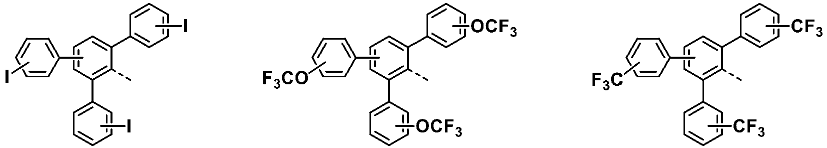

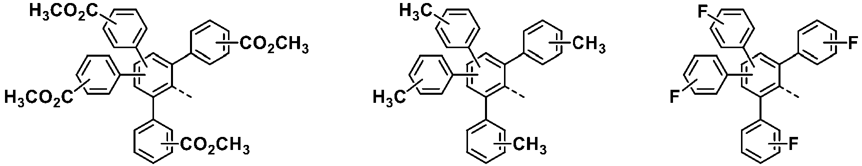

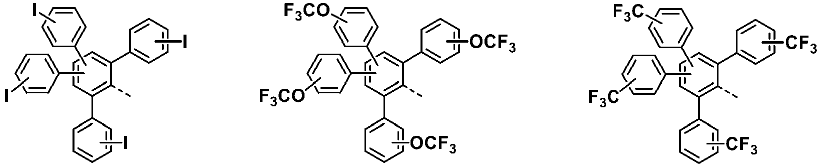

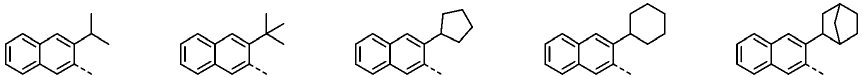

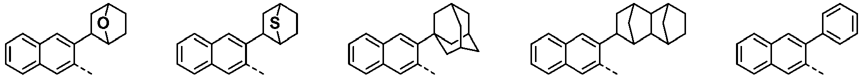

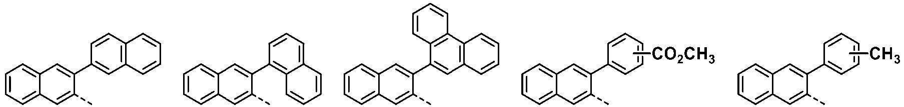

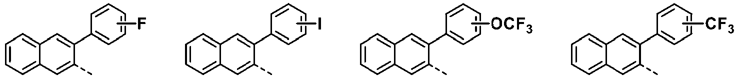

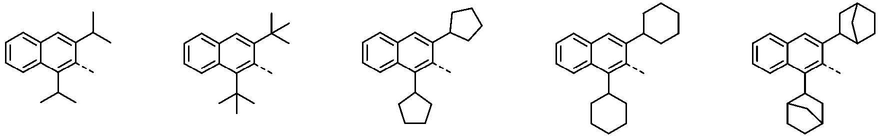

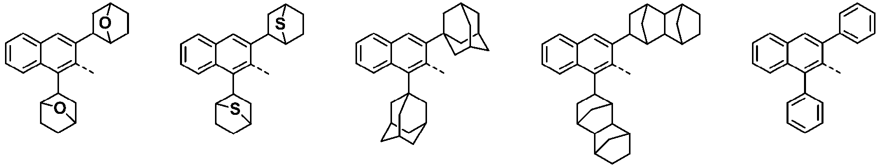

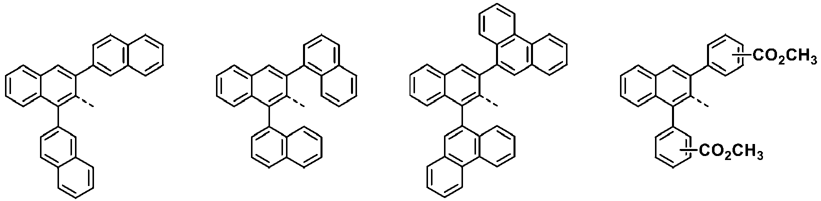

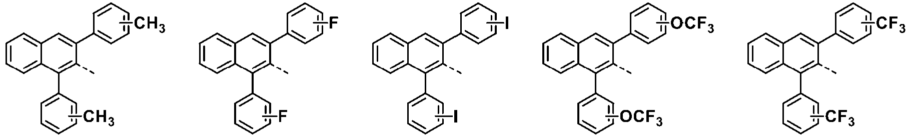

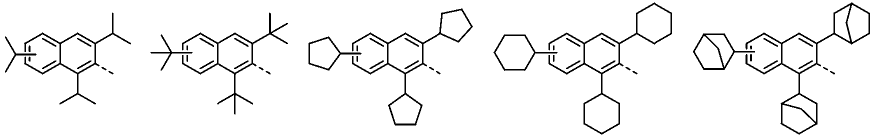

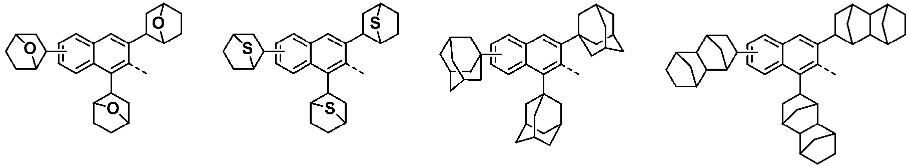

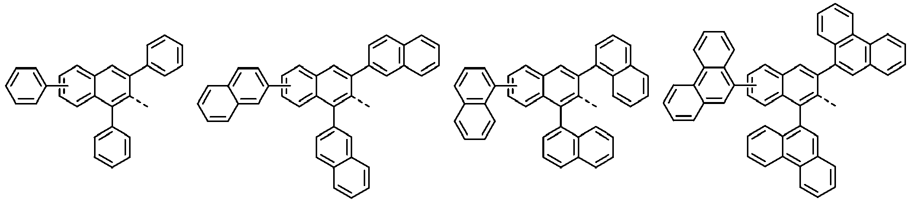

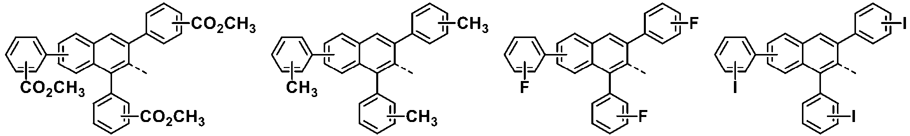

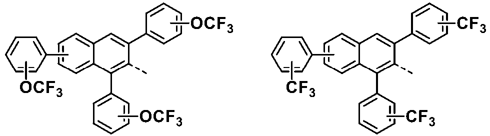

In formula (A), at least one R¹ is bonded to a carbon atom adjoining the carbon atom to which S is bonded. This means that R¹ and the other aromatic ring having the sulfo group bonded thereto are positioned spatially close to bring about steric hindrance. Then the rotation of the sulfonamide bond is restrained and acid diffusion is substantially suppressed.

In formula (A), R² is halogen exclusive of fluorine, or a C₁-C₂₀ hydrocarbyl group which may contain a heteroatom exclusive of fluorine. Suitable halogen atoms exclusive of fluorine include chlorine, bromine and iodine. The hydrocarbyl group may be saturated or unsaturated and straight, branched or cyclic. Examples thereof include C₁-C₂₀ alkyl groups such as methyl, ethyl, n-propyl, isopropyl, n-butyl, isobutyl, sec-butyl, tert-butyl, n-pentyl, tert-pentyl, n-hexyl, n-octyl, 2-ethylhexyl, n-nonyl, and n-decyl; C₃-C₂₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decyl, adamantyl and adamantylmethyl; and C₆-C₂₀ aryl groups such as phenyl, naphthyl and anthracenyl. In the hydrocarbyl group, some or all hydrogen may be substituted by a moiety containing a heteroatom such as oxygen, sulfur, nitrogen or halogen, and some -CH₂- may be replaced by a moiety containing a heteroatom such as oxygen, sulfur or nitrogen, so that the group may contain a hydroxy, cyano, chlorine, bromine, iodine, carbonyl, ether bond, ester bond, sulfonate ester bond, carbonate bond, lactone ring, sultone ring, carboxylic anhydride (-C(=O)-O-C(=O)-) or haloalkyl moiety. When n4 is 2, 3 or 4, a plurality of R² may be identical or different. When n4 is 2, 3 or 4, a plurality of R² may bond together to form a ring with the carbon atoms to which they are attached. The ring is preferably 5- to 8-membered.

In formula (A), R^{F} is fluorine, a C₁-C₆ fluorinated alkyl group, C₁-C₆ fluorinated alkoxy group, or C₁-C₆ fluorinated alkylthio group. R^{F} is preferably fluorine, trifluoromethyl, difluoromethyl, trifluoromethoxy, difluoromethoxy, trifluoromethylthio or difluoromethylthio, more preferably fluorine, trifluoromethyl or trifluoromethoxy. Since fluorine or fluorine-containing substituents exert an electron-withdrawing effect, the strength of generated acid is so increased that the deprotection reaction of acid labile groups such as tertiary ester or tertiary ether groups may smoothly take place. When n5 is 2, 3 or 4, a plurality of R^{F} may be identical or different.

Of the onium salts having formula (A), those having the formula (A1) are preferred.

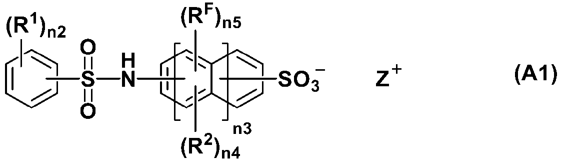

Herein n2, n3, n4, n5, R¹, R², R^{F}, and Z⁺ are as defined above.

Of the onium salts having formula (A1), those having the formula (A2) are preferred.

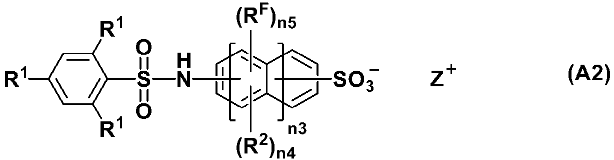

Herein n3, n4, n5, R¹, R², R^{F}, and Z⁺ are as defined above.

Preferred examples of the anion in the onium salt having formula (A) are shown below, but not limited thereto.

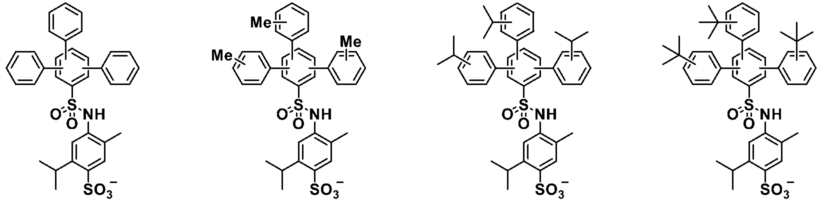

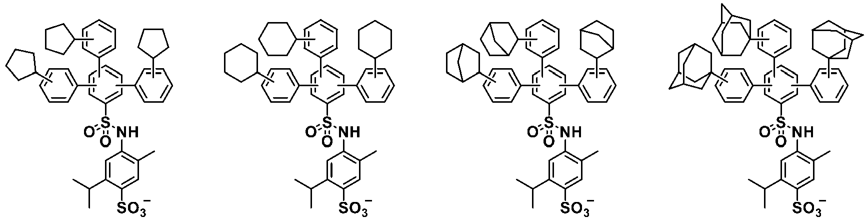

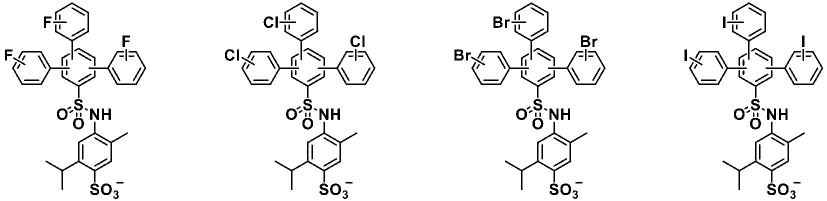

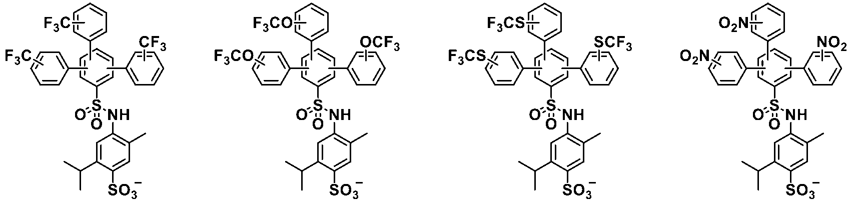

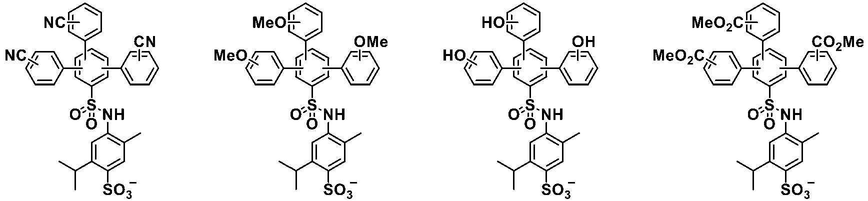

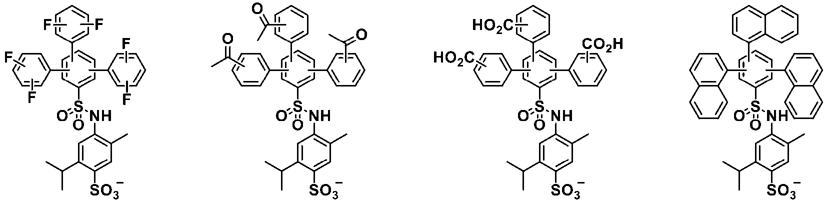

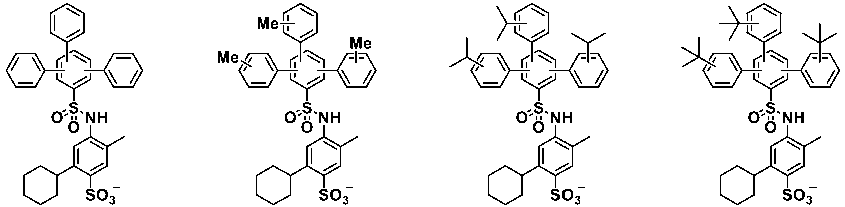

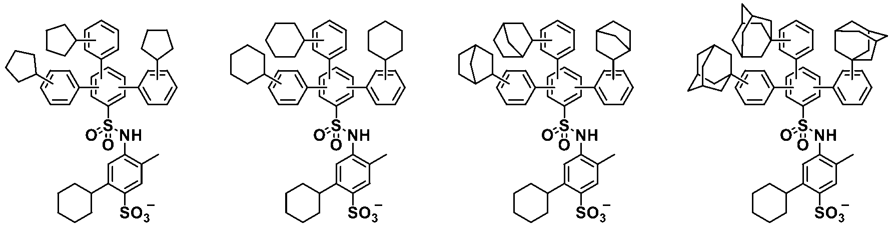

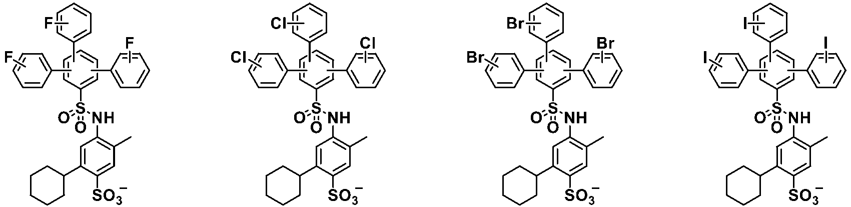

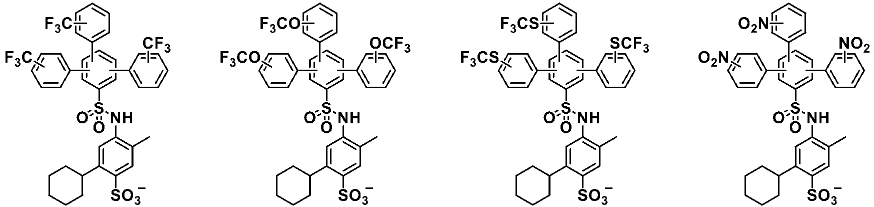

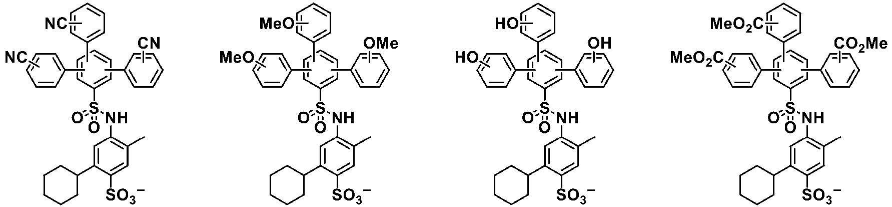

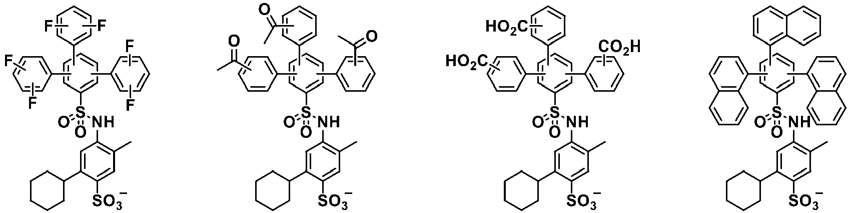

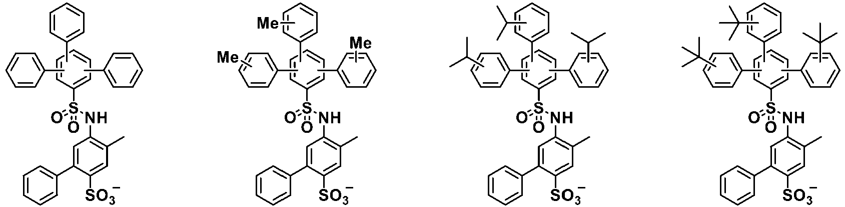

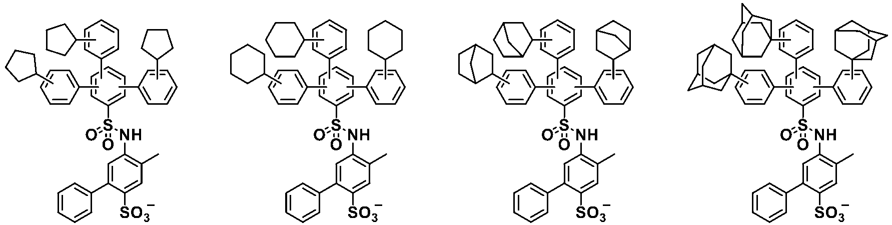

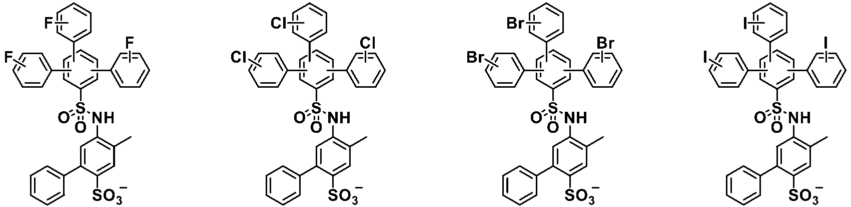

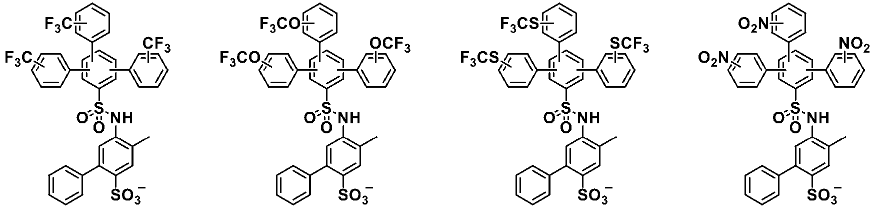

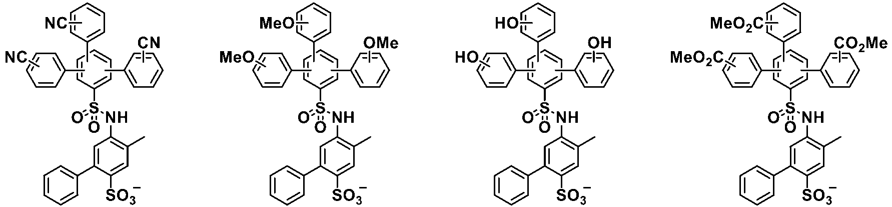

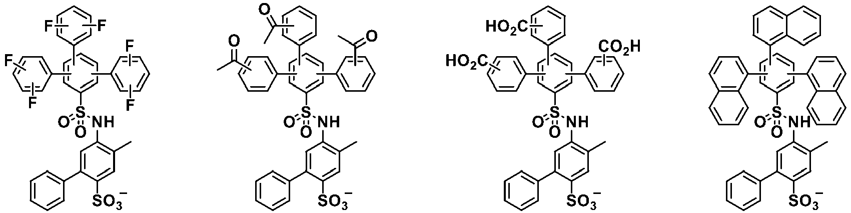

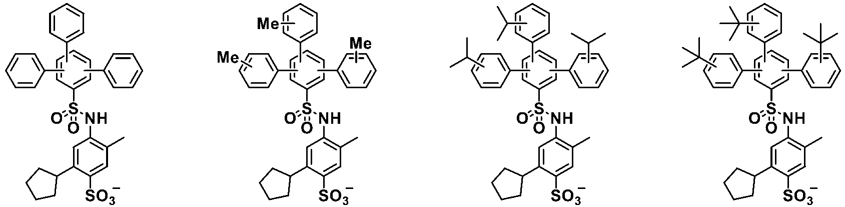

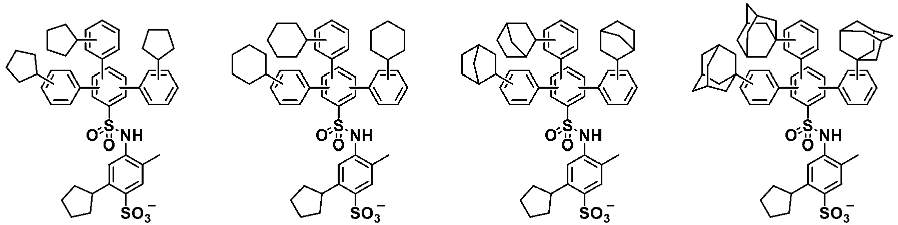

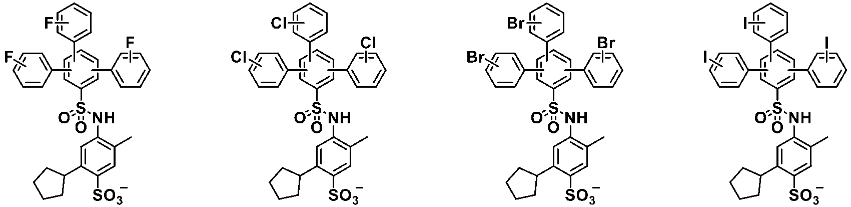

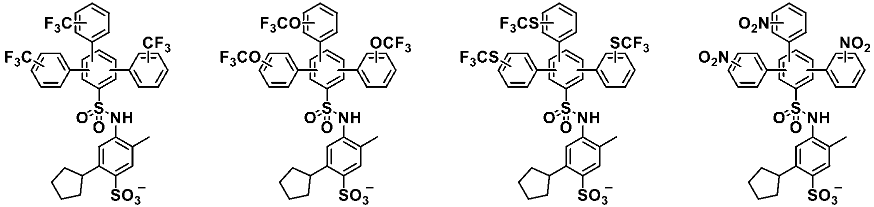

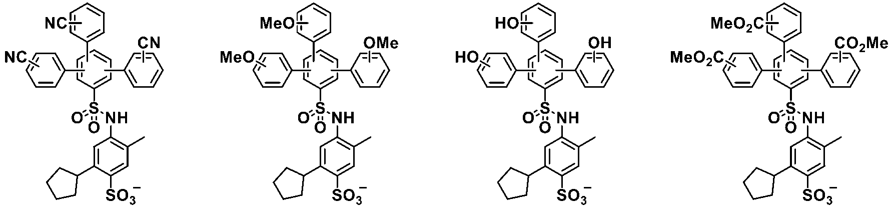

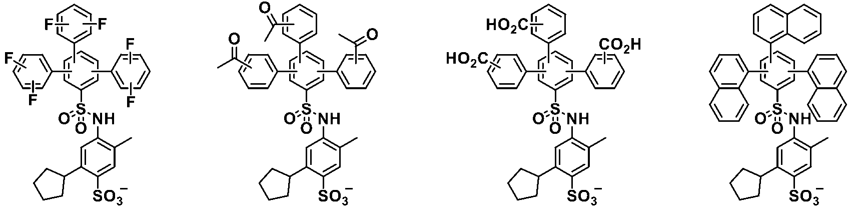

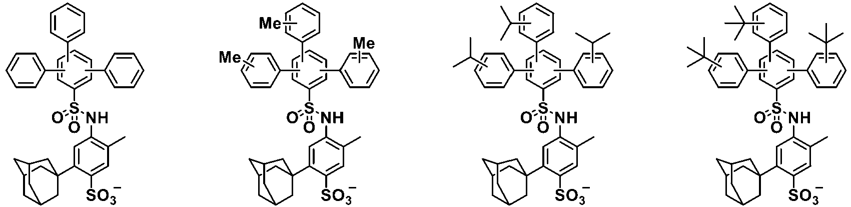

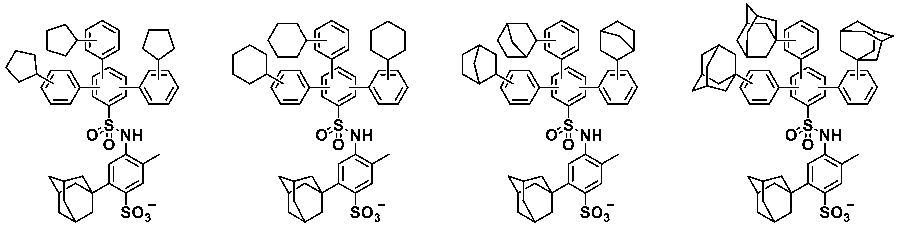

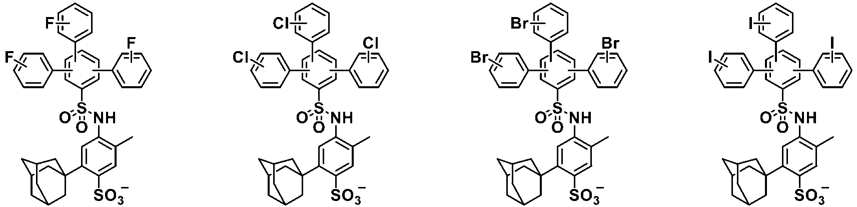

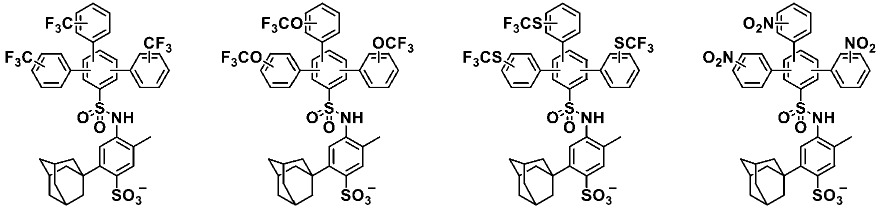

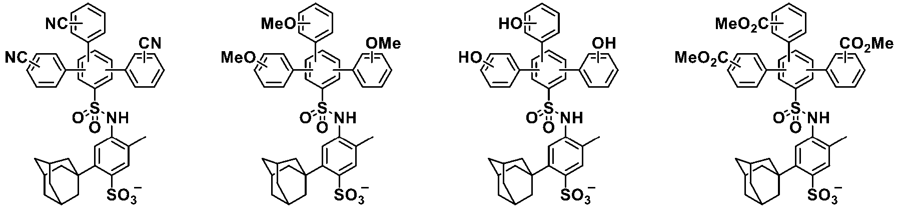

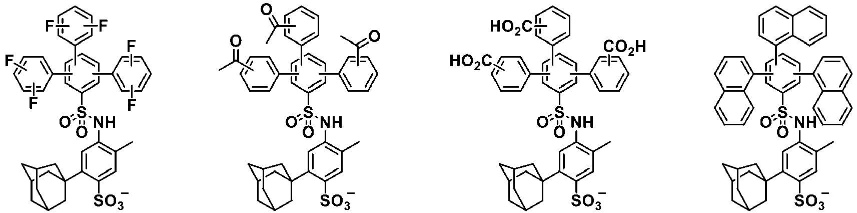

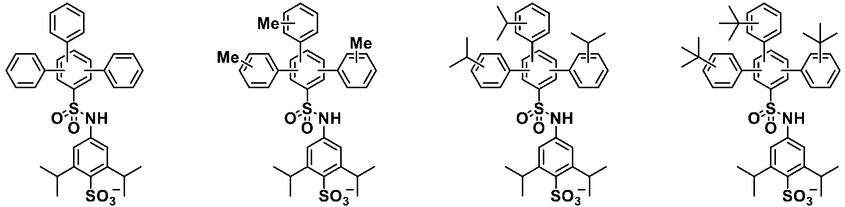

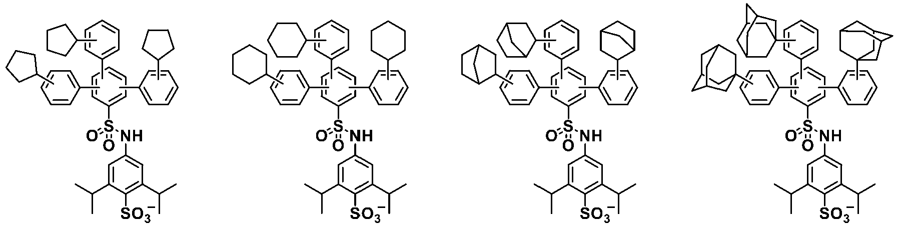

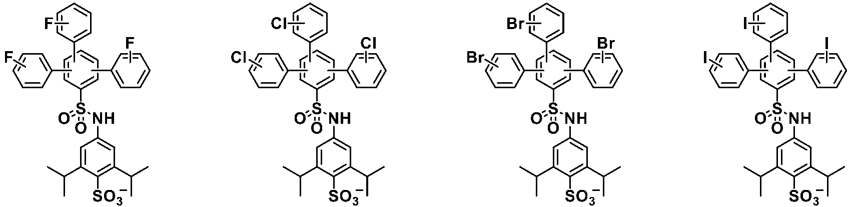

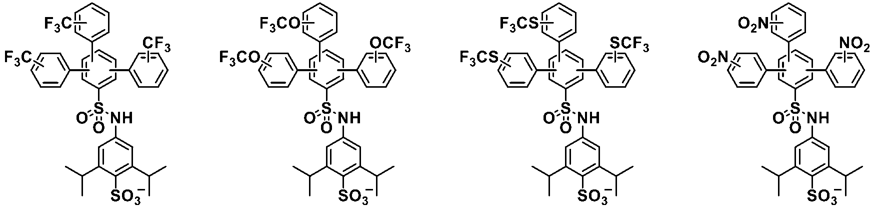

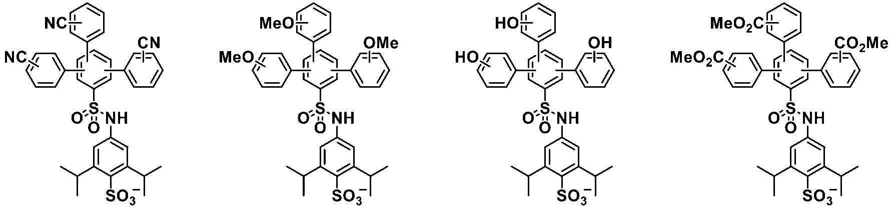

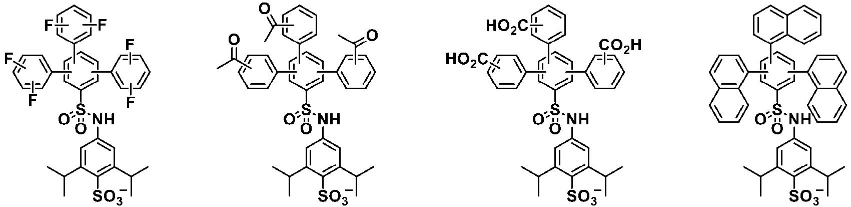

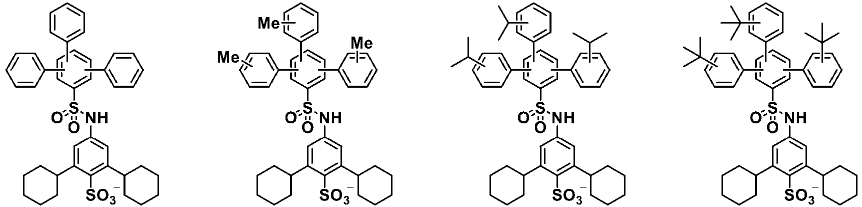

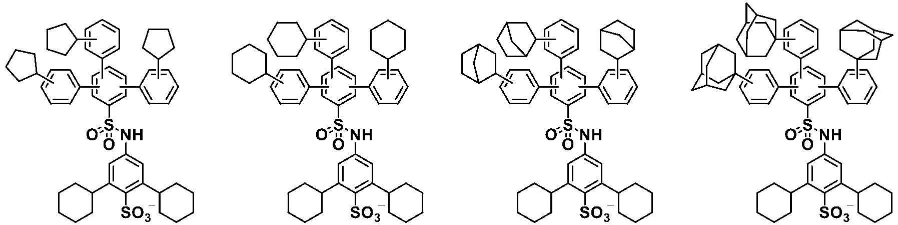

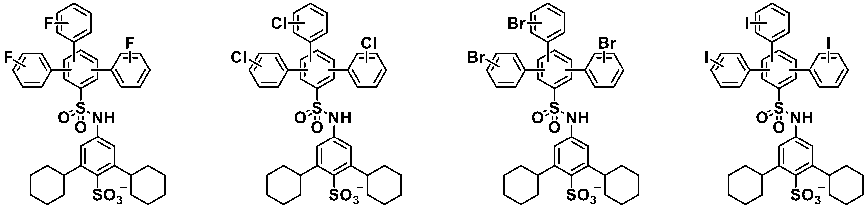

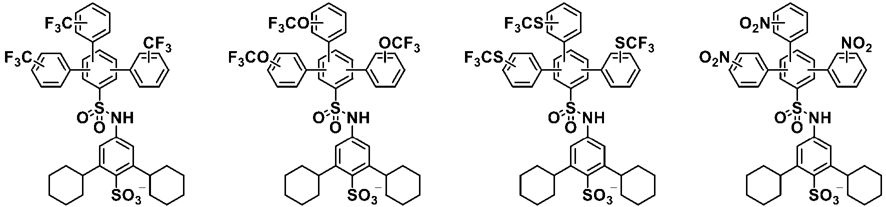

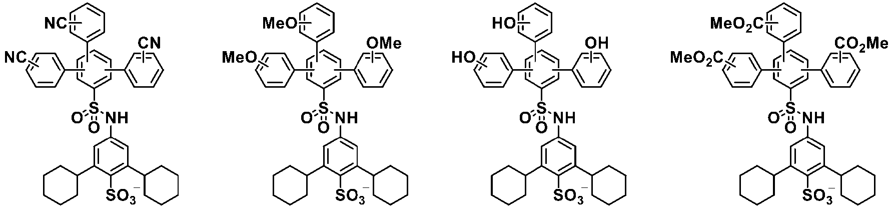

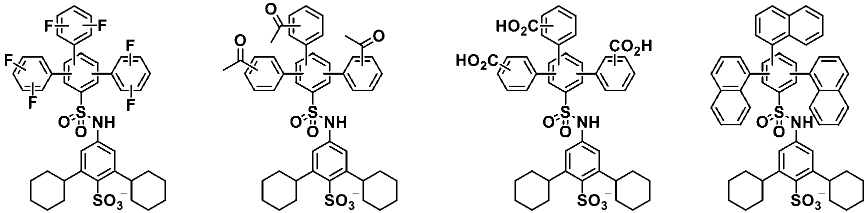

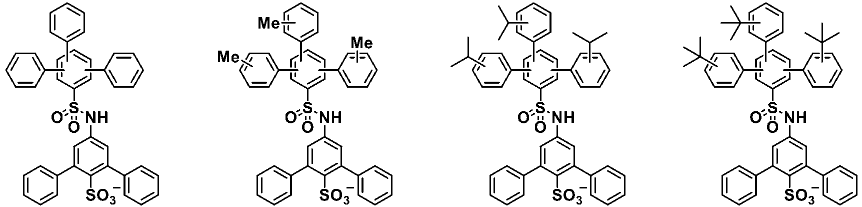

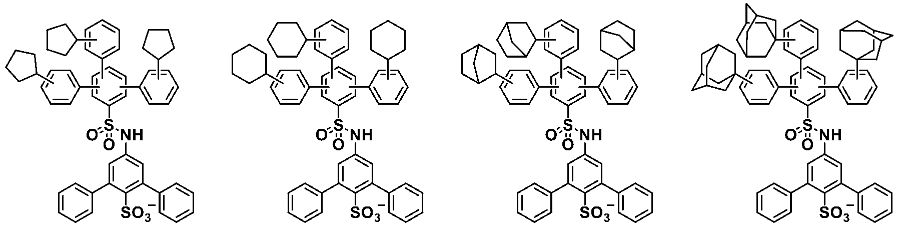

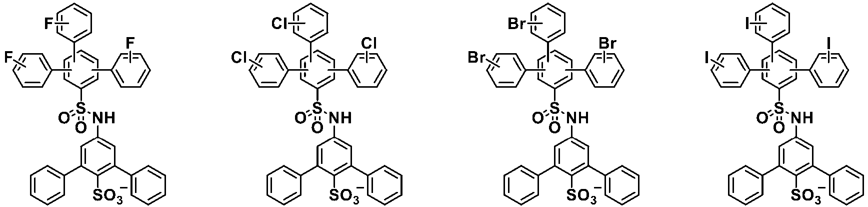

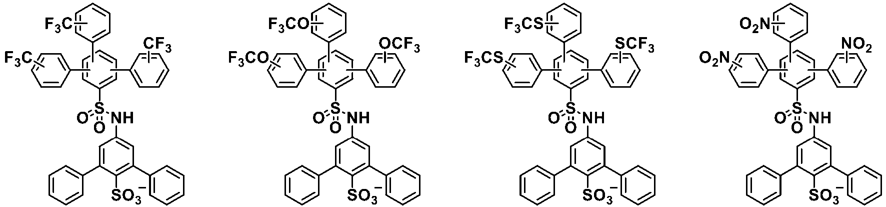

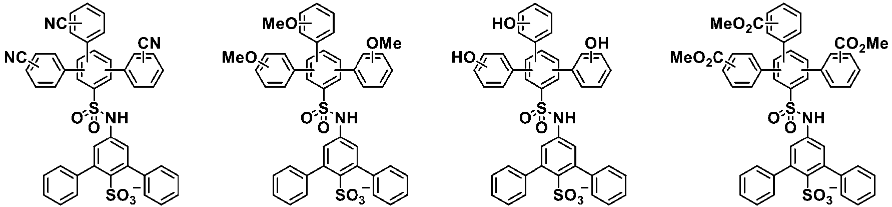

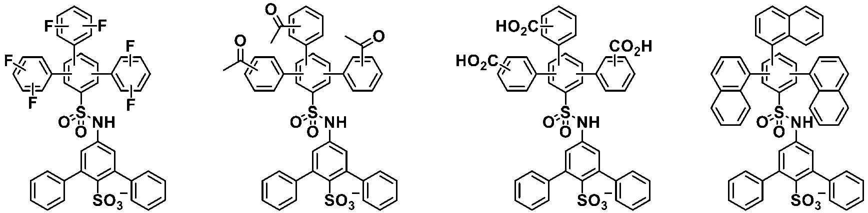

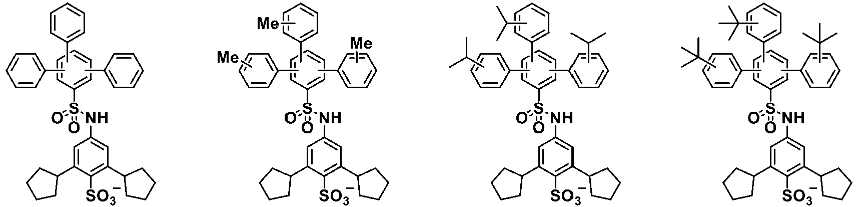

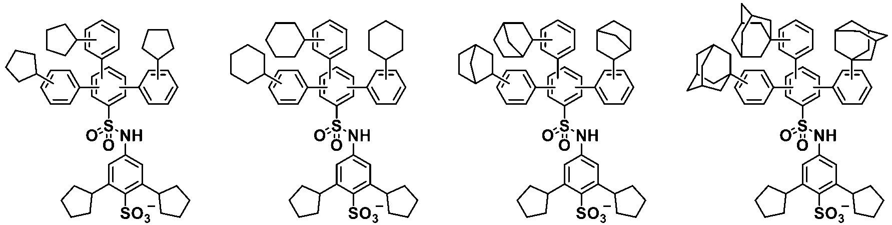

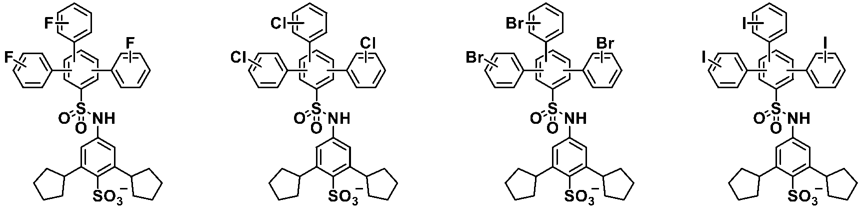

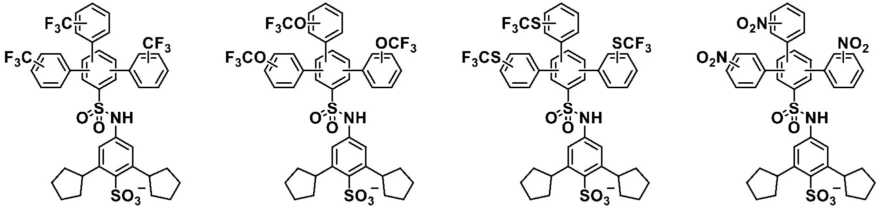

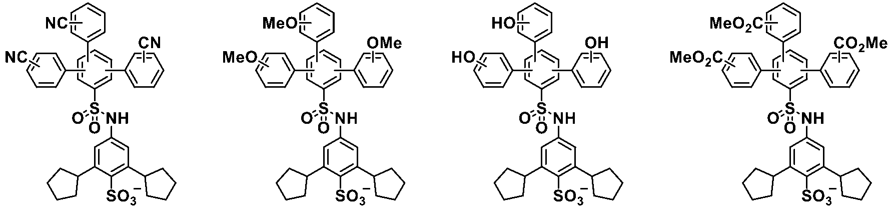

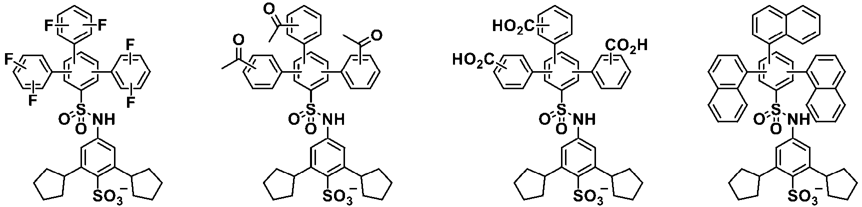

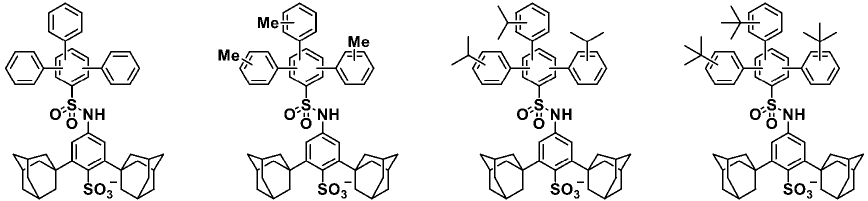

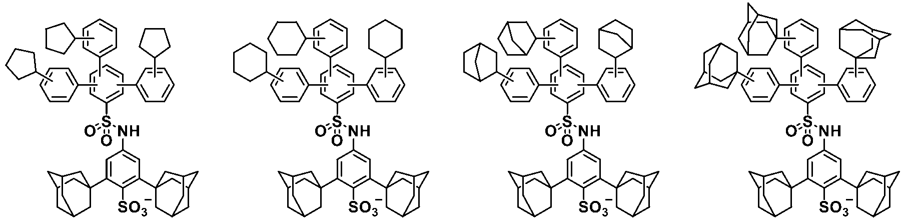

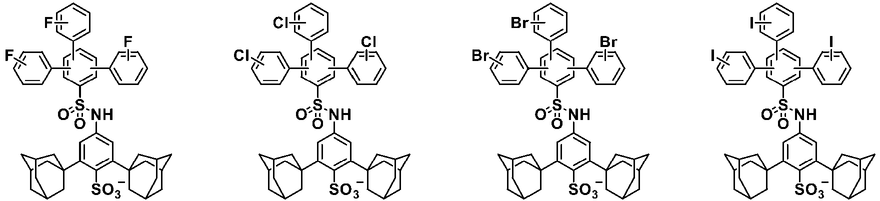

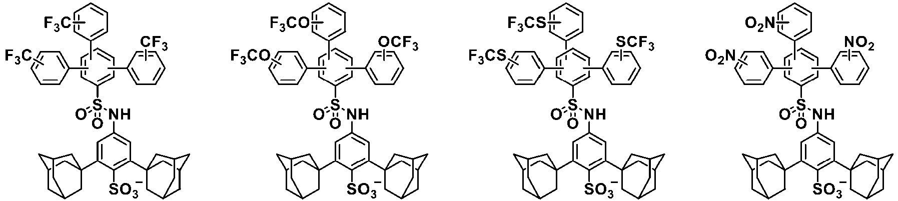

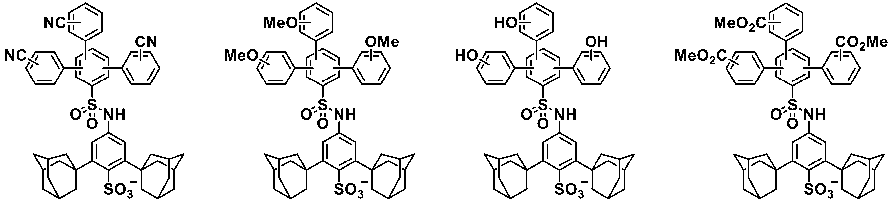

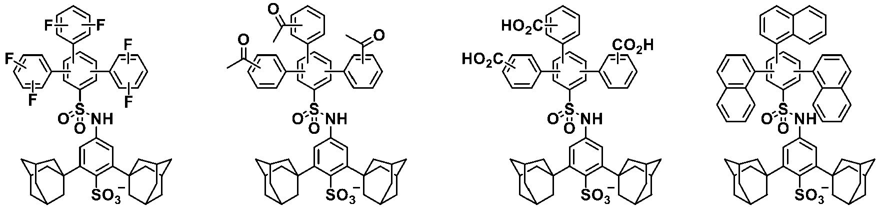

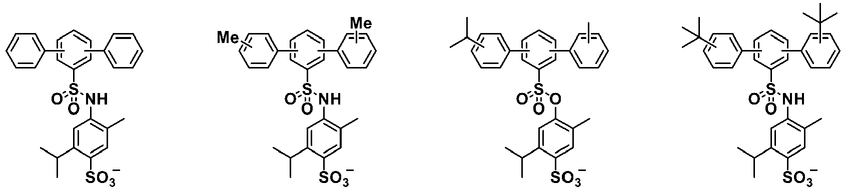

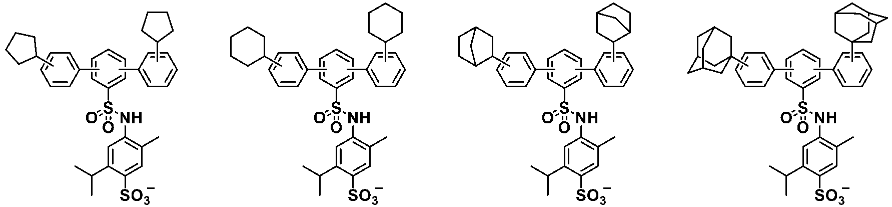

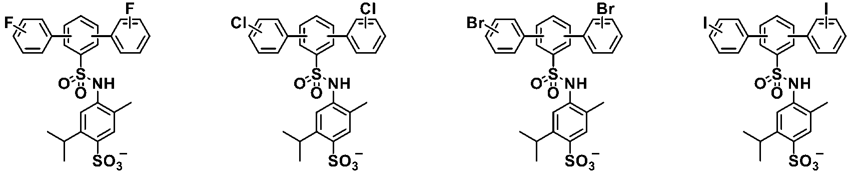

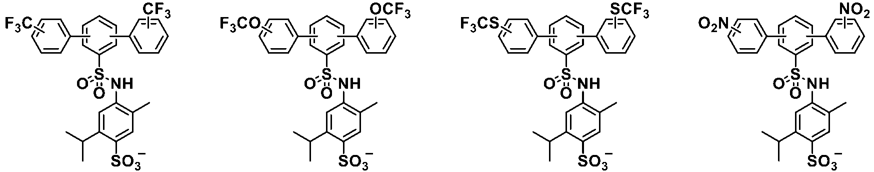

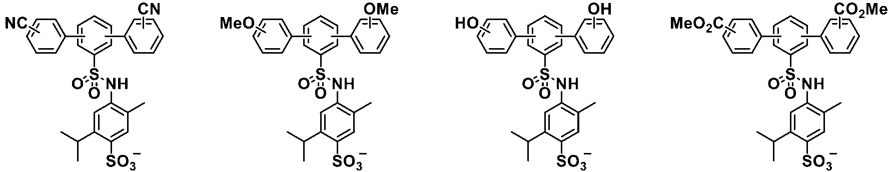

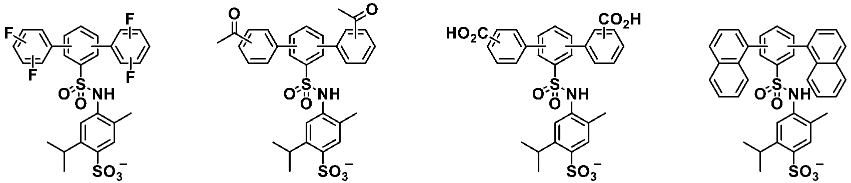

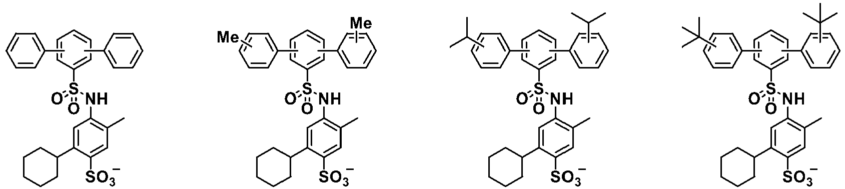

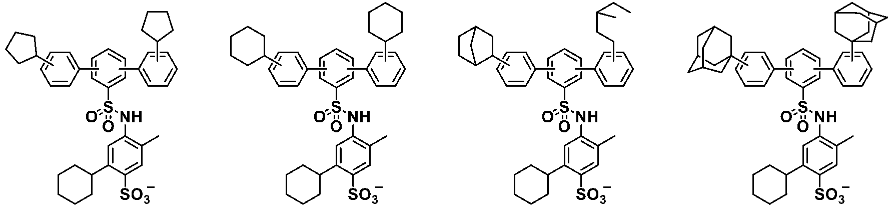

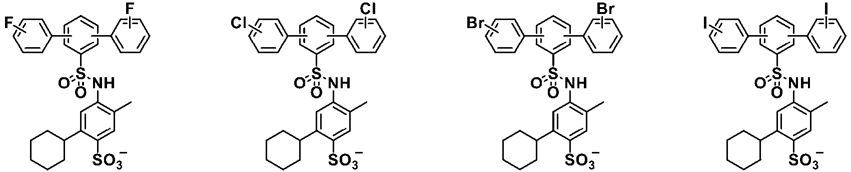

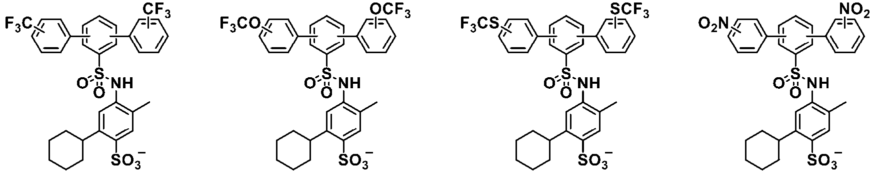

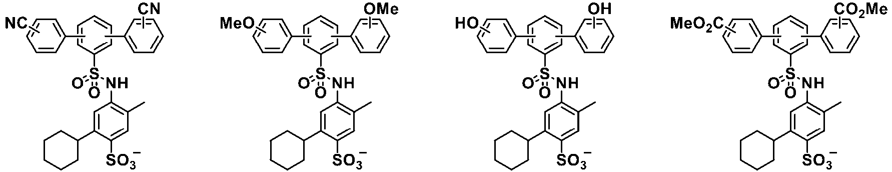

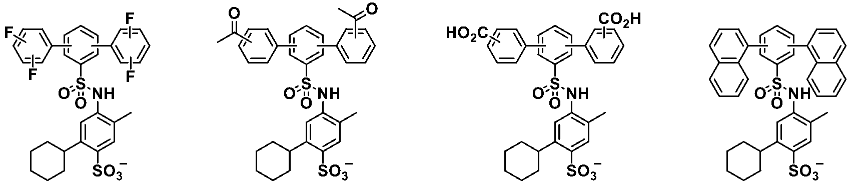

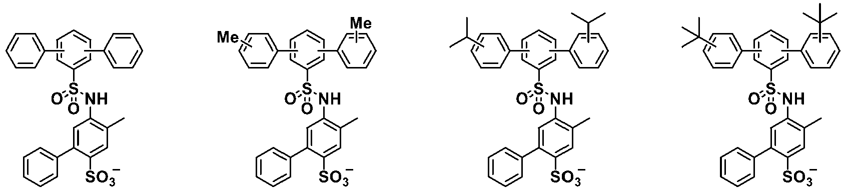

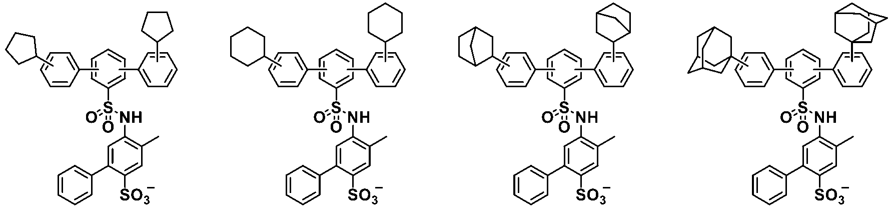

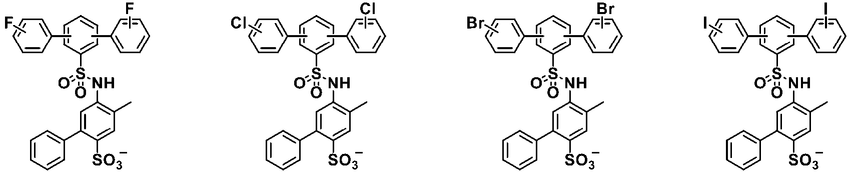

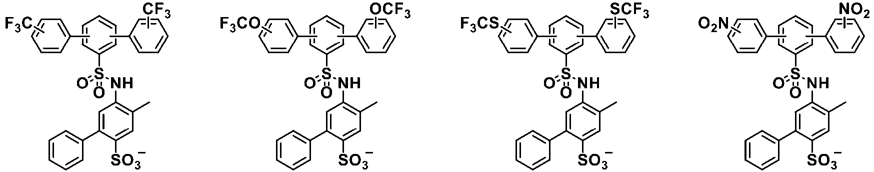

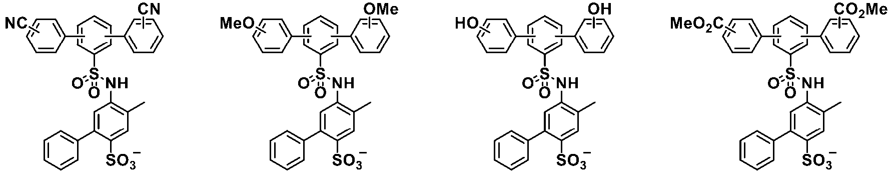

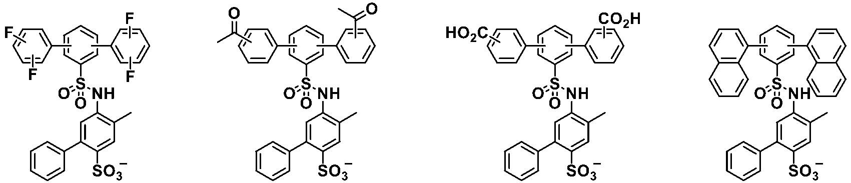

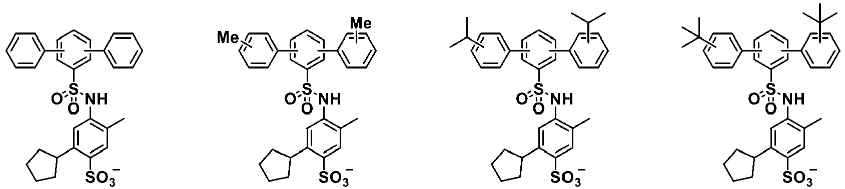

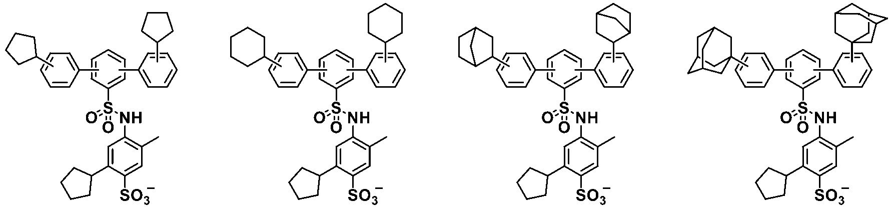

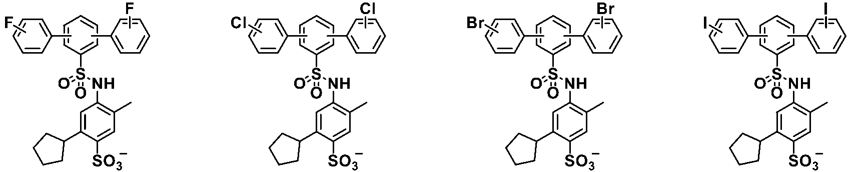

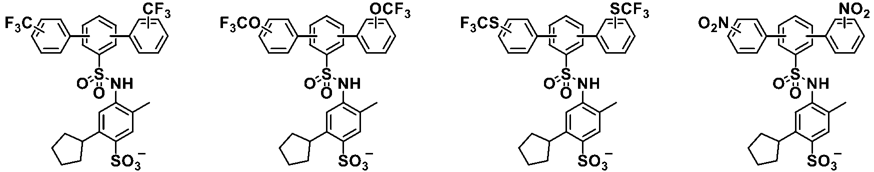

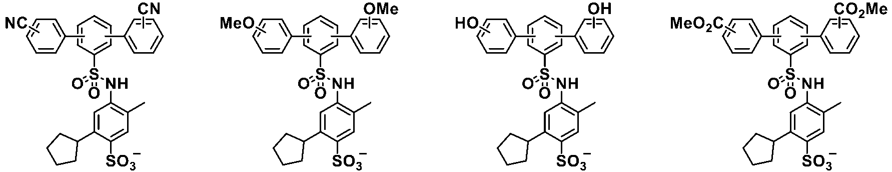

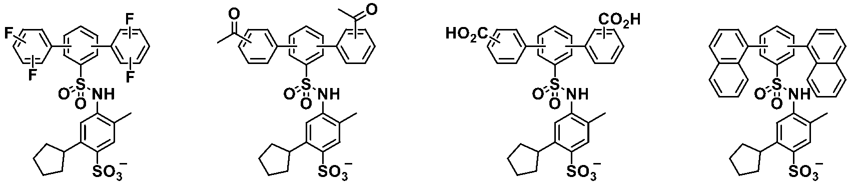

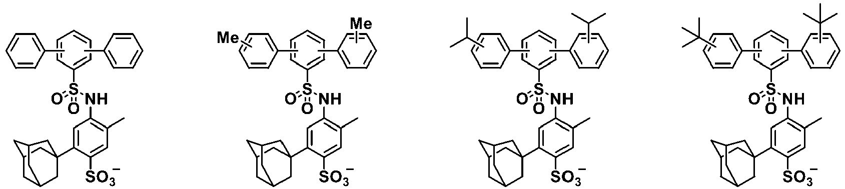

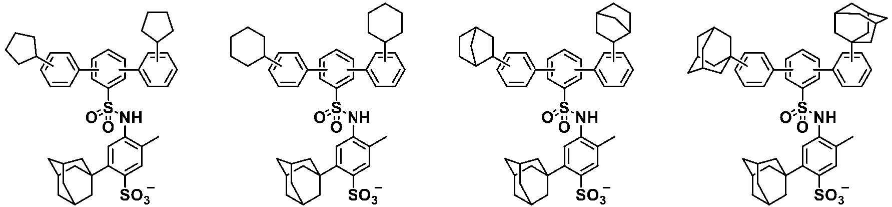

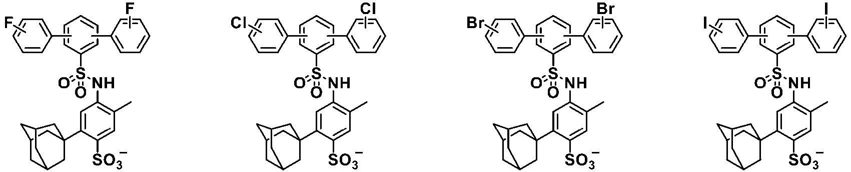

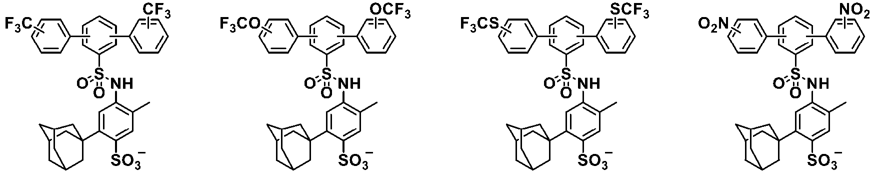

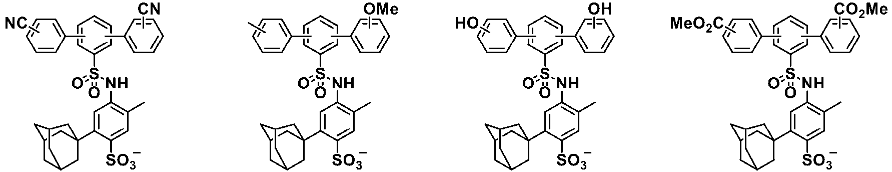

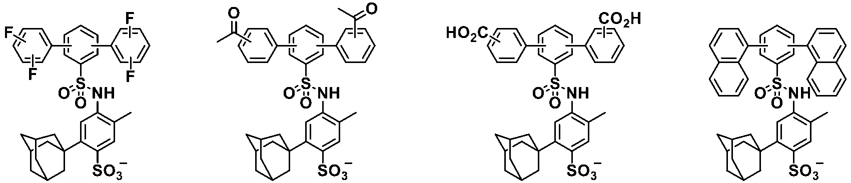

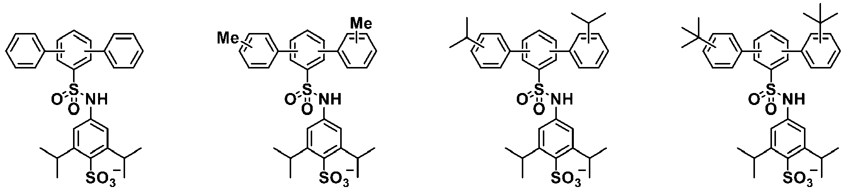

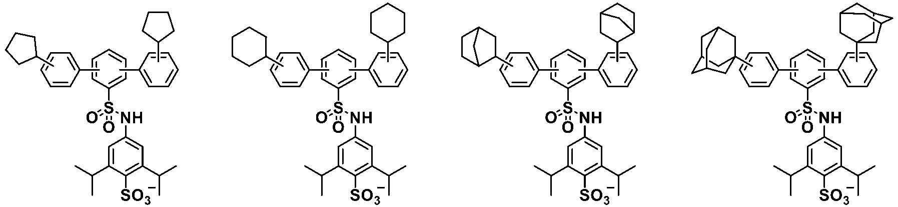

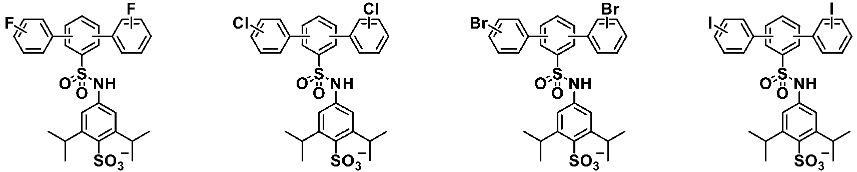

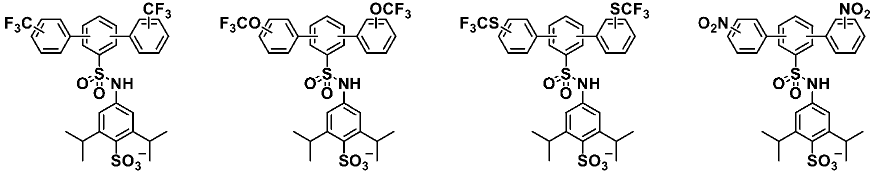

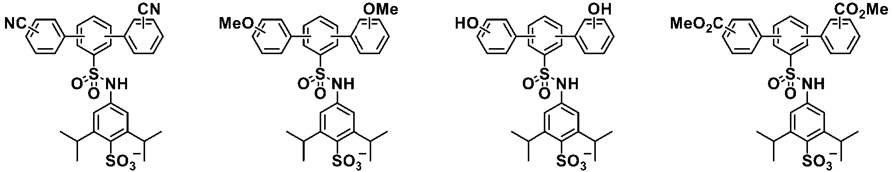

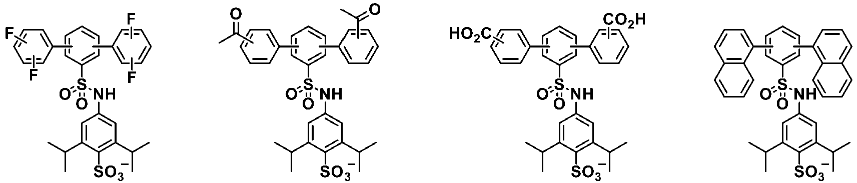

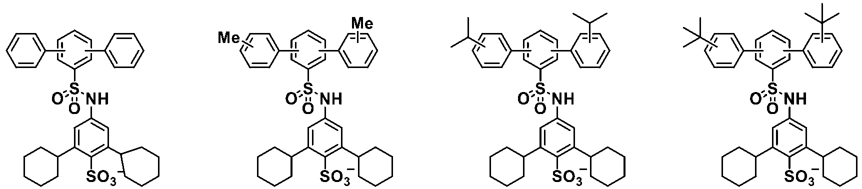

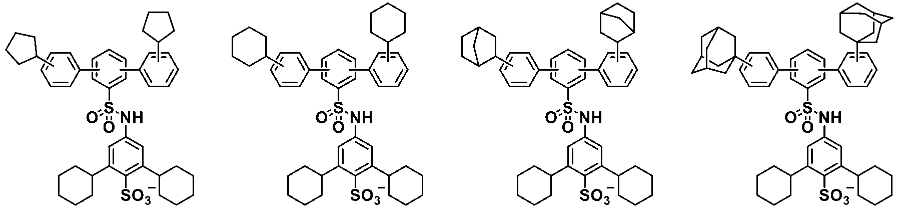

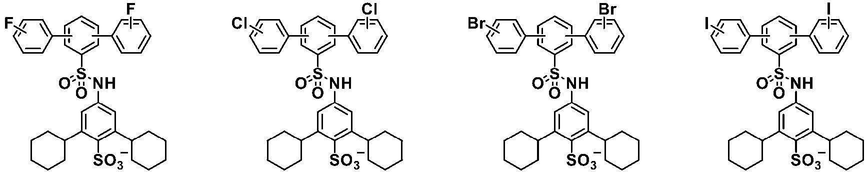

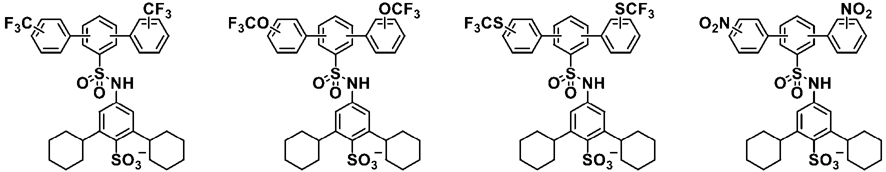

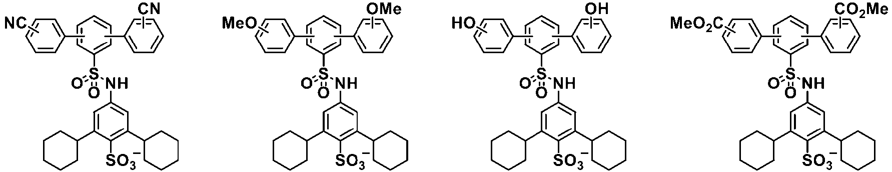

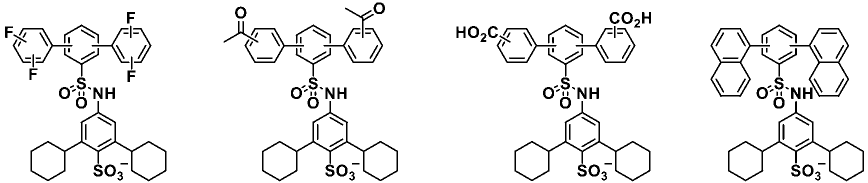

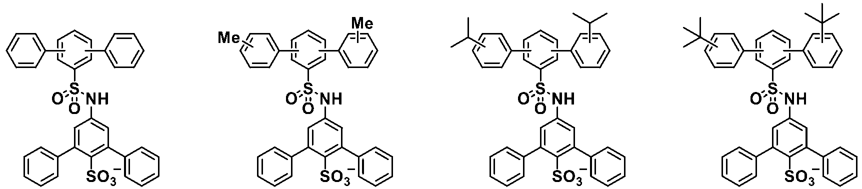

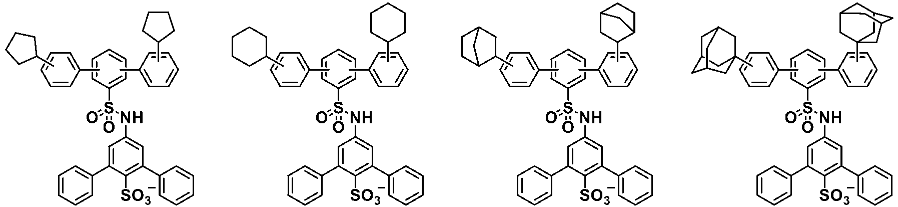

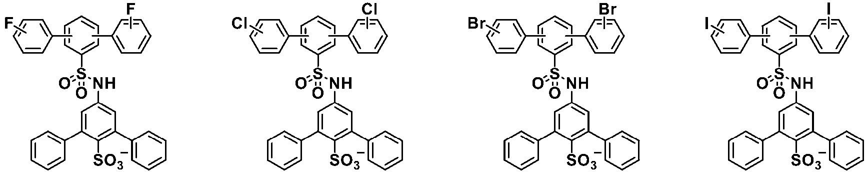

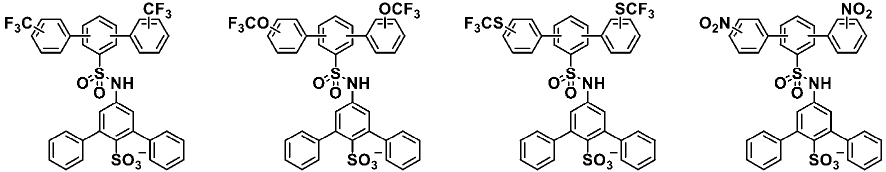

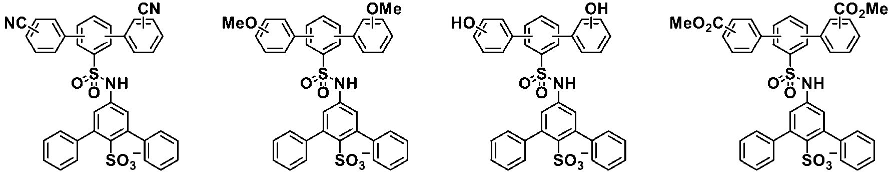

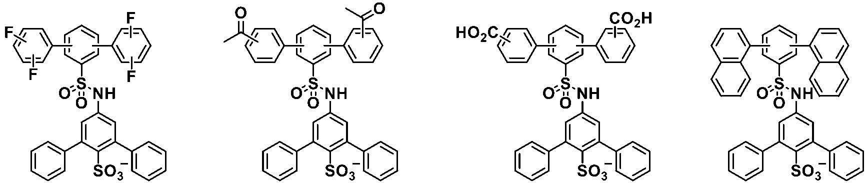

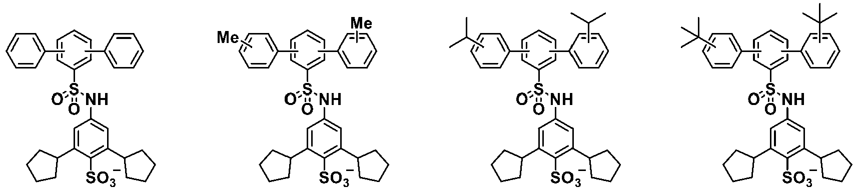

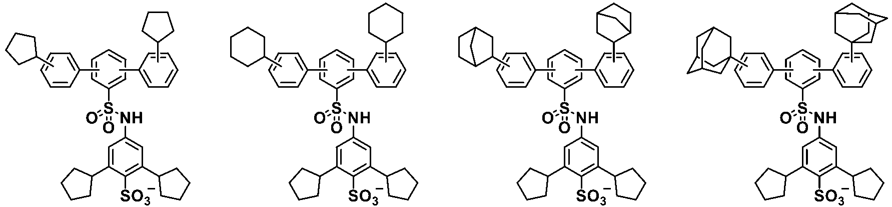

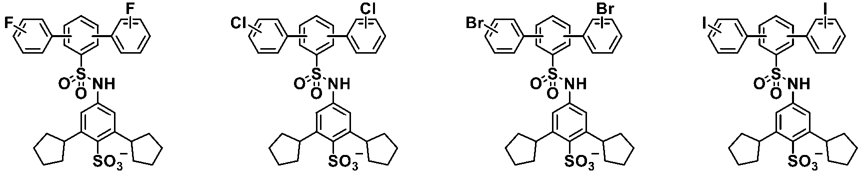

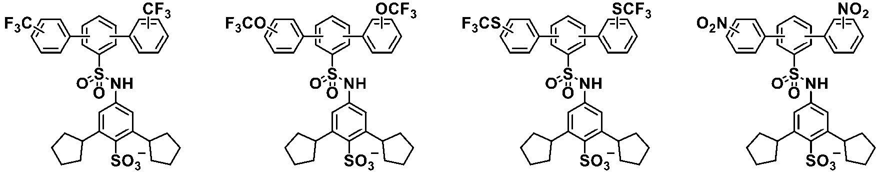

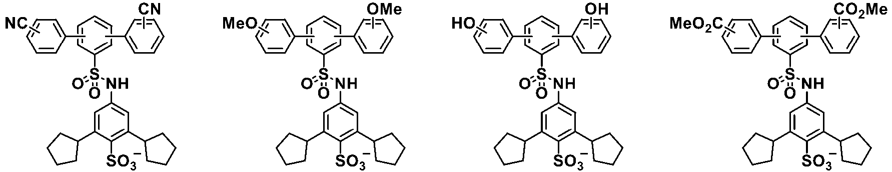

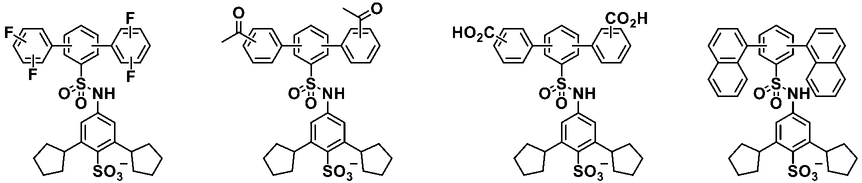

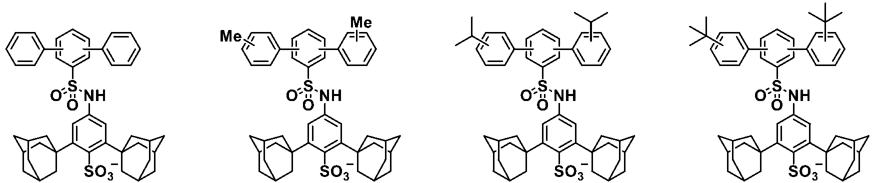

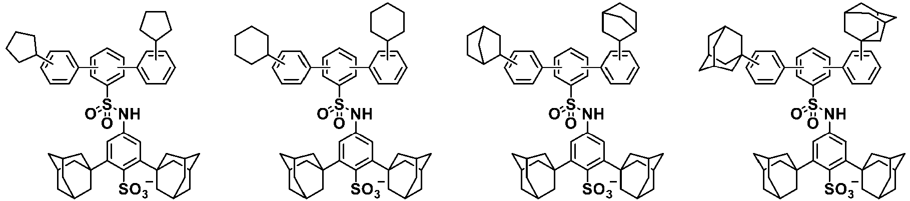

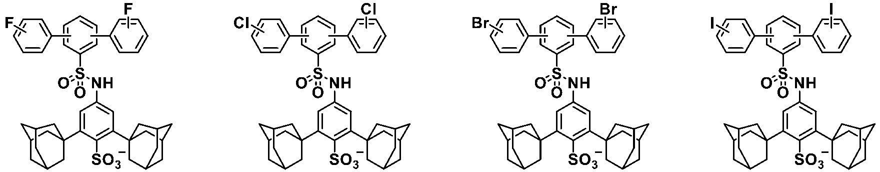

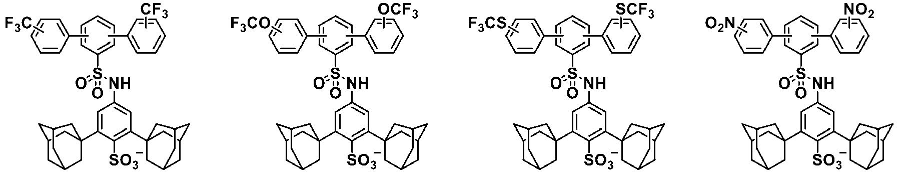

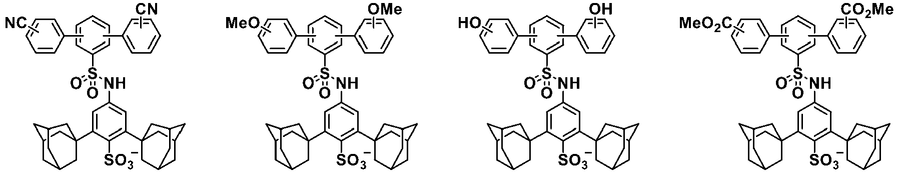

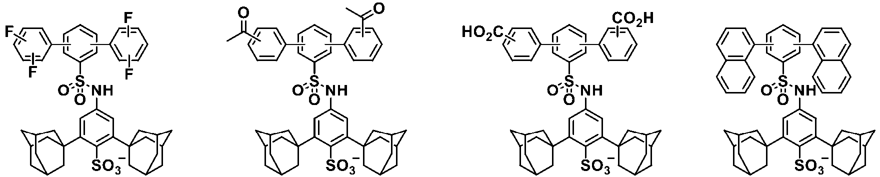

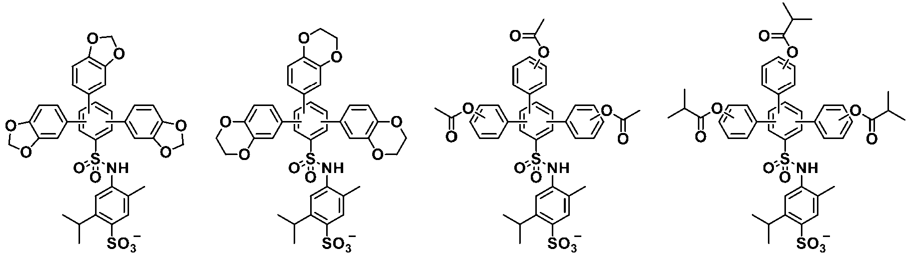

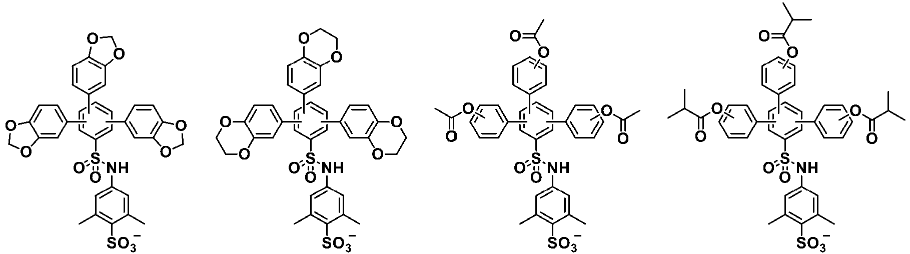

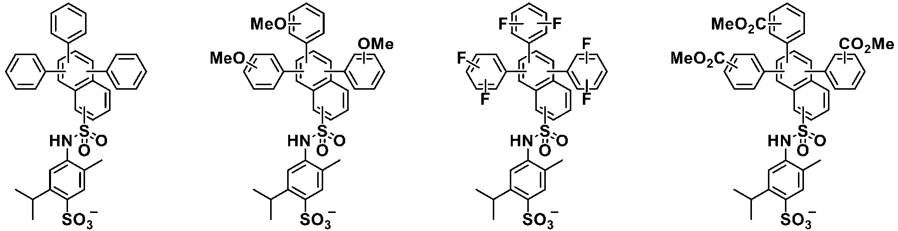

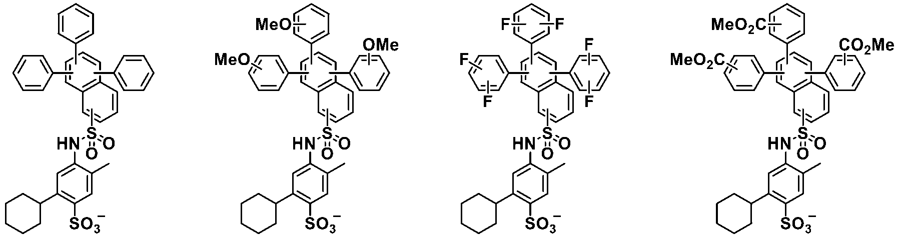

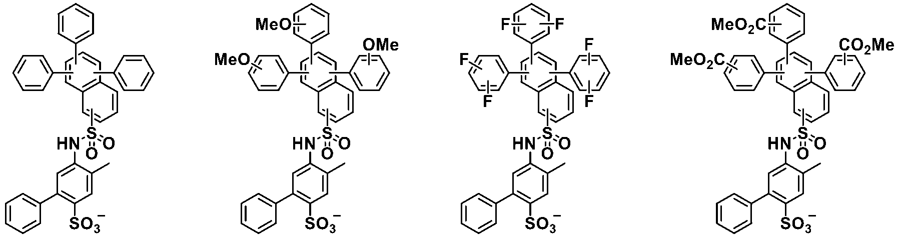

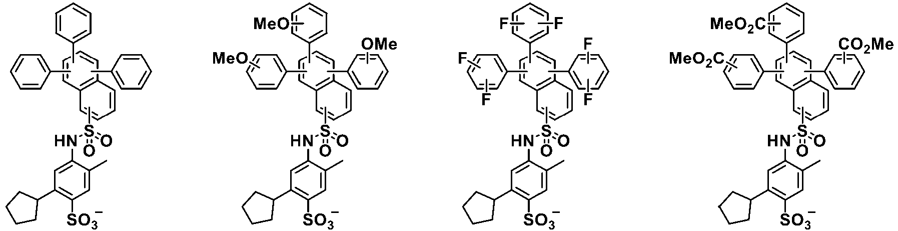

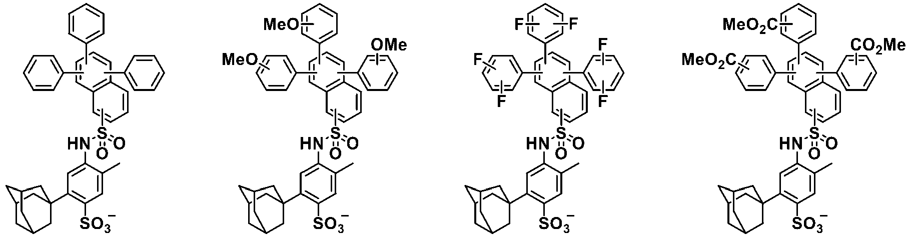

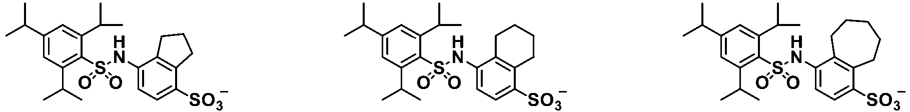

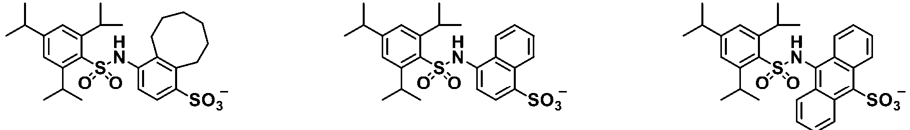

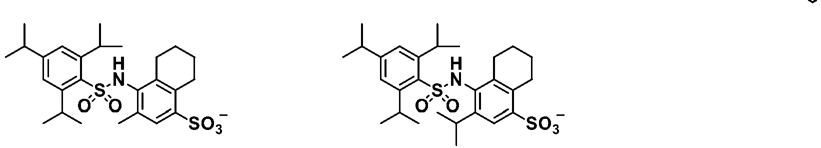

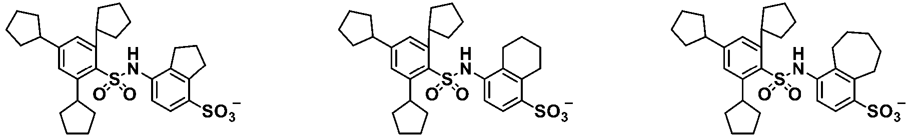

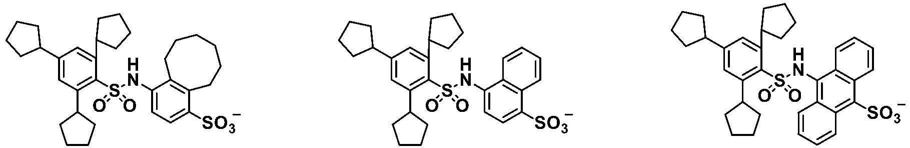

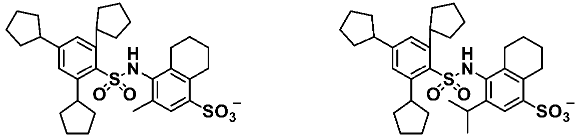

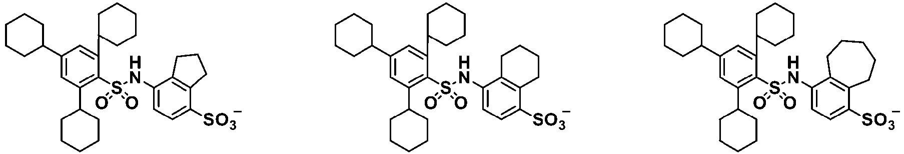

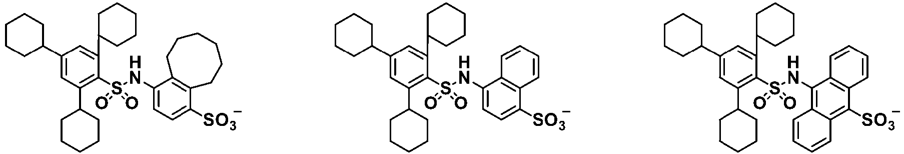

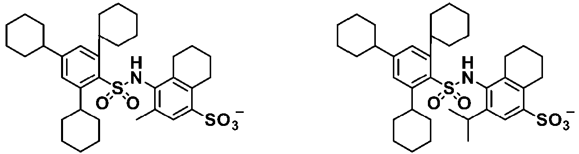

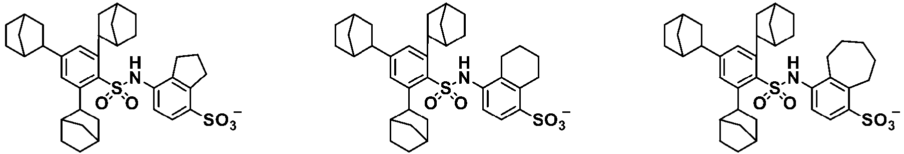

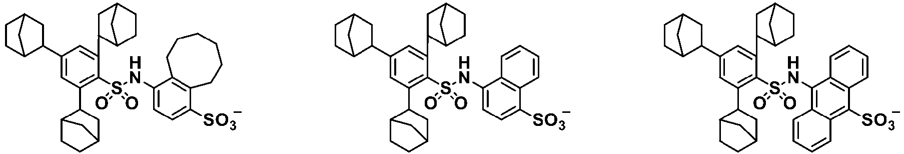

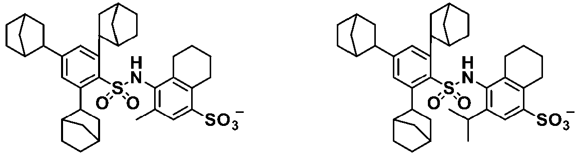

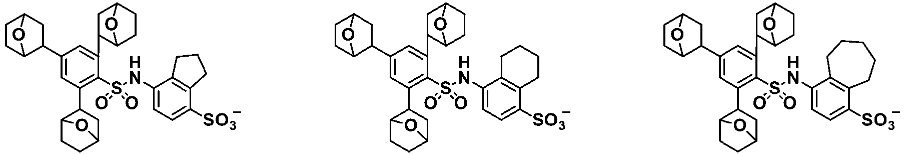

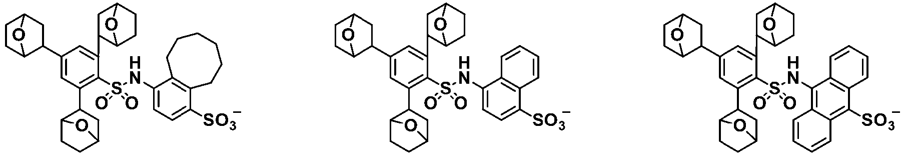

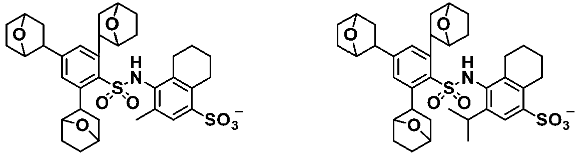

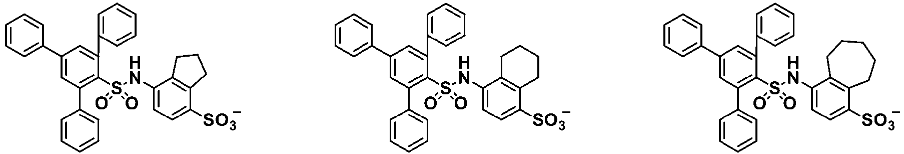

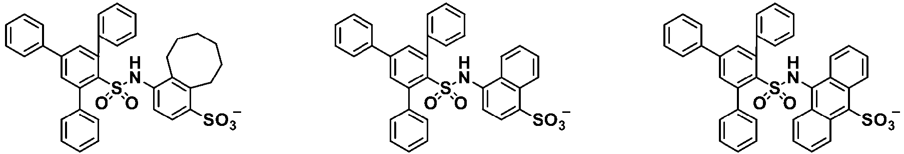

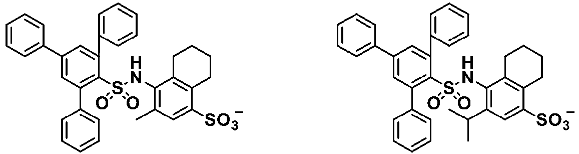

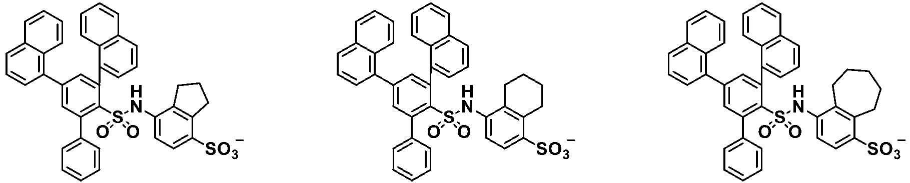

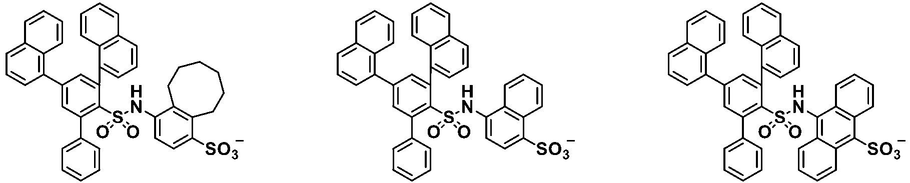

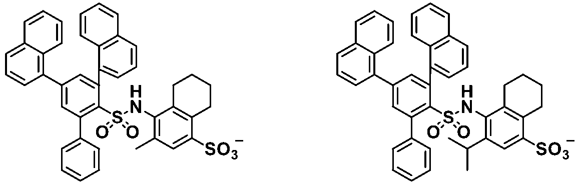

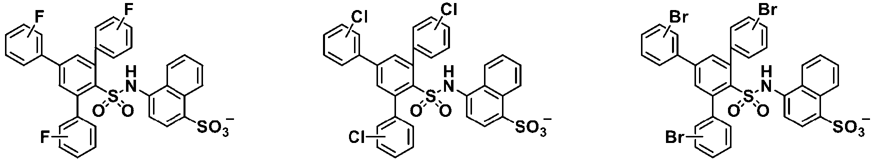

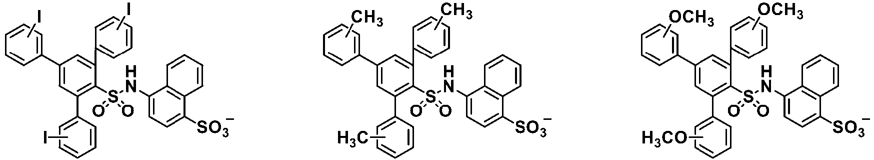

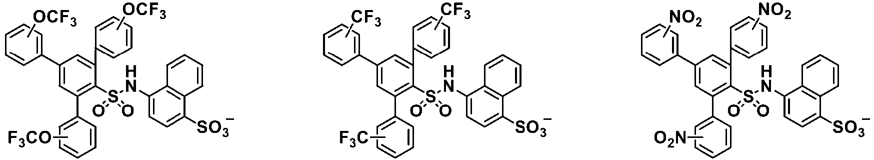

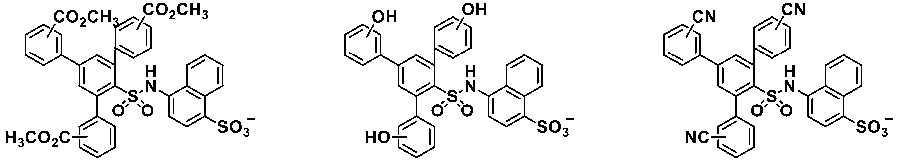

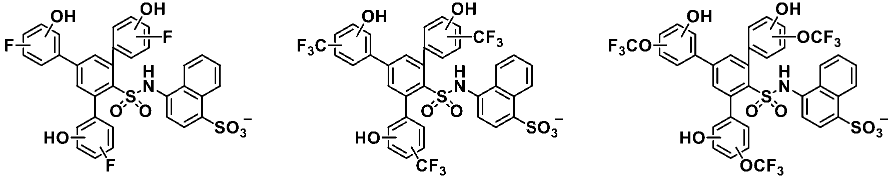

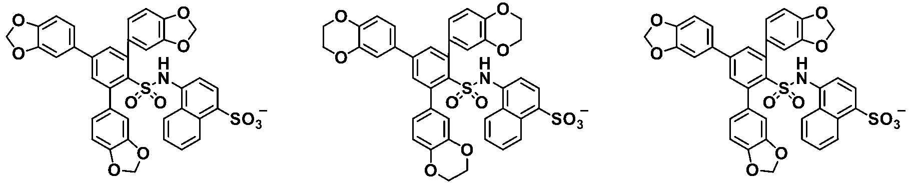

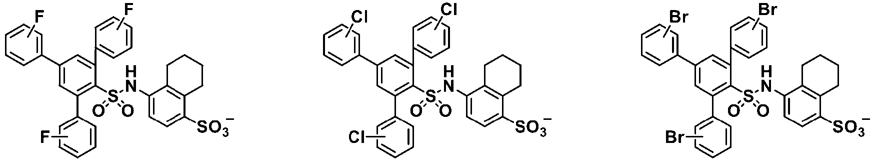

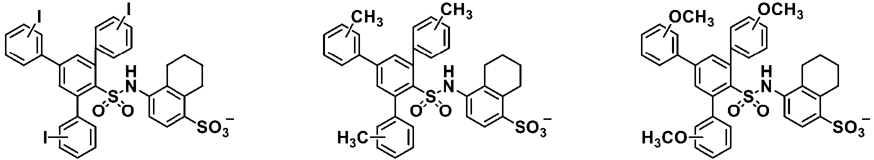

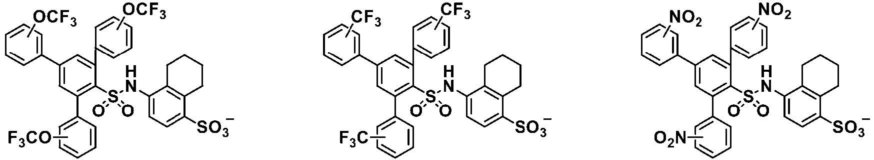

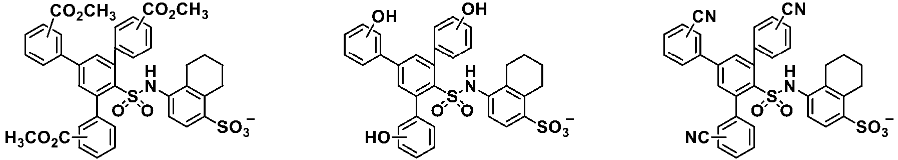

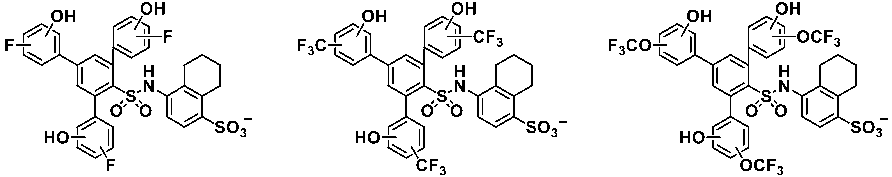

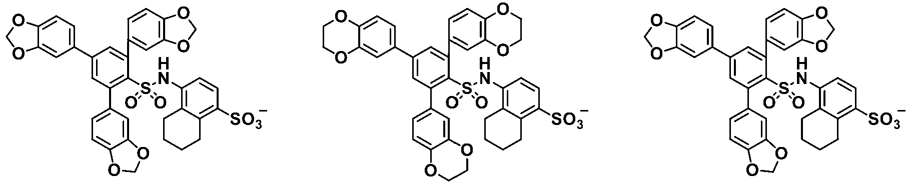

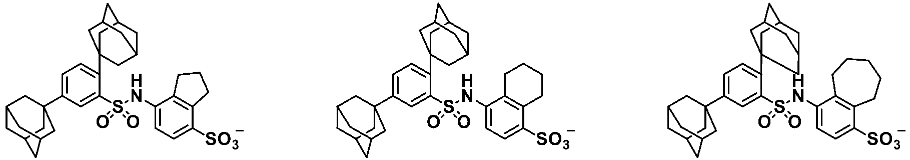

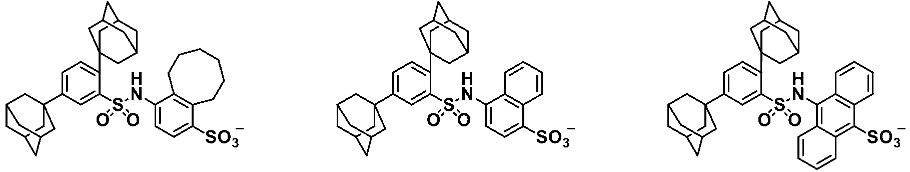

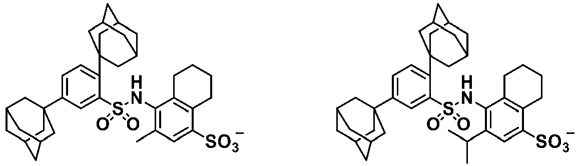

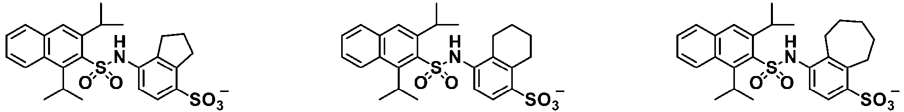

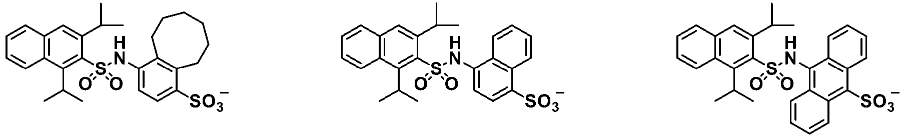

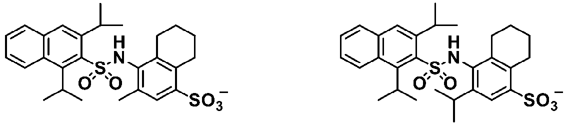

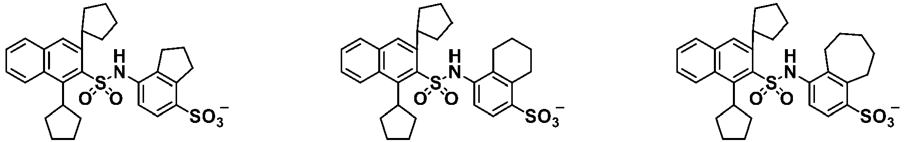

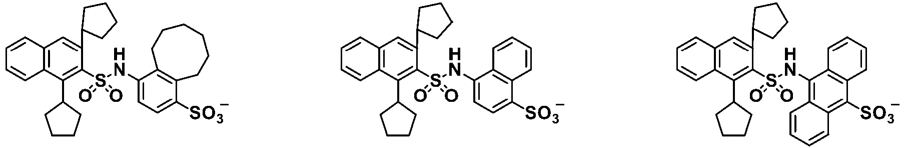

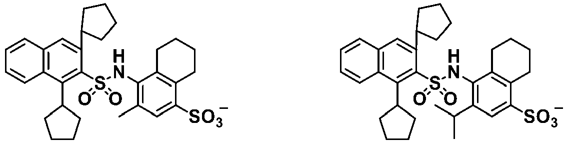

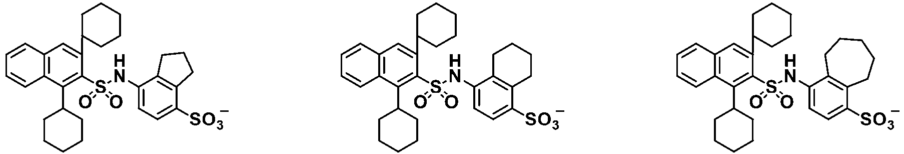

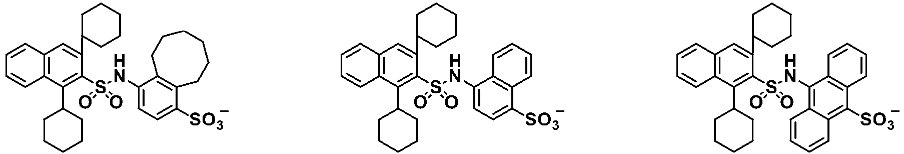

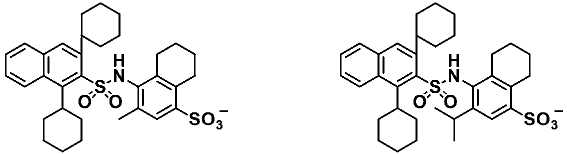

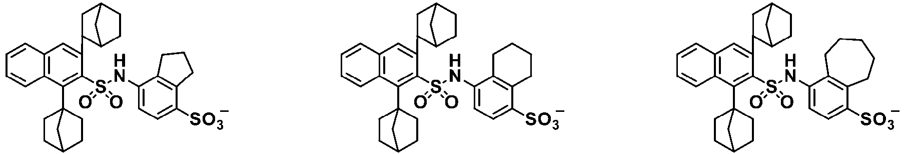

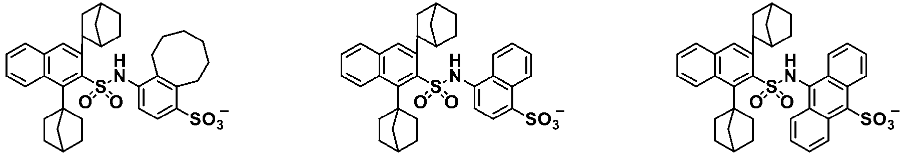

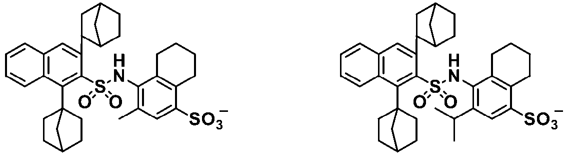

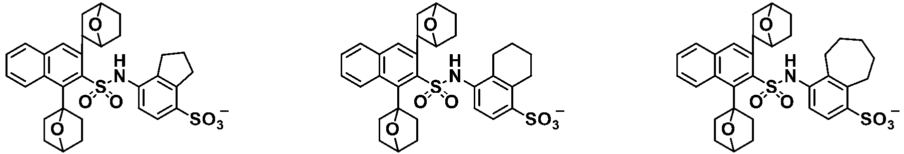

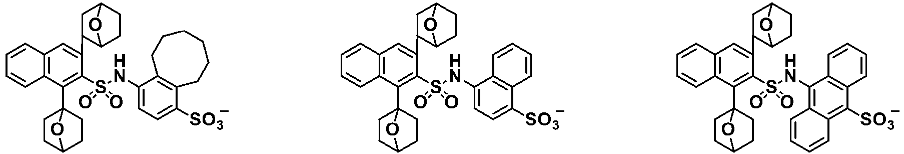

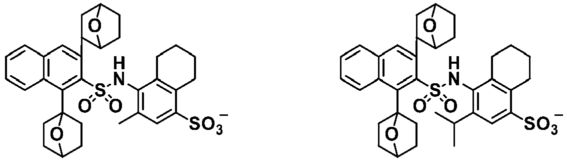

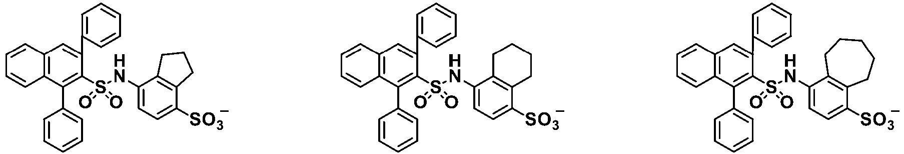

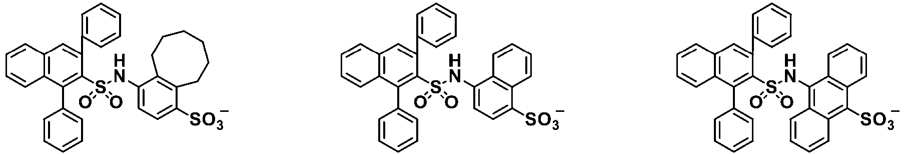

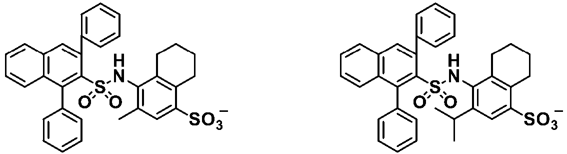

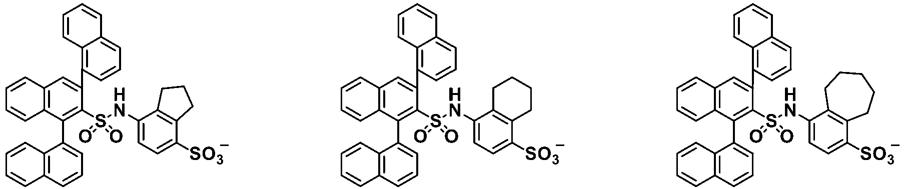

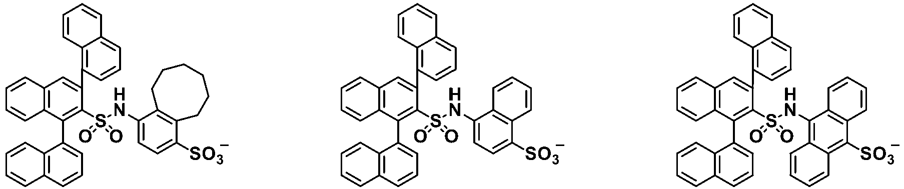

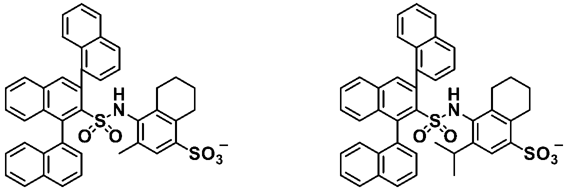

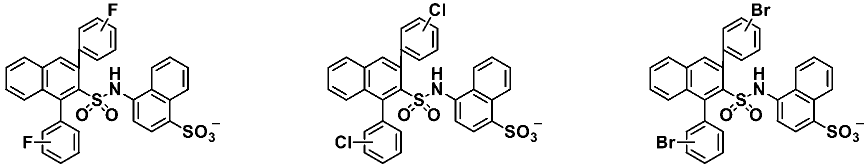

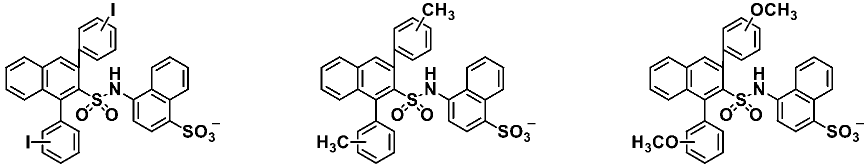

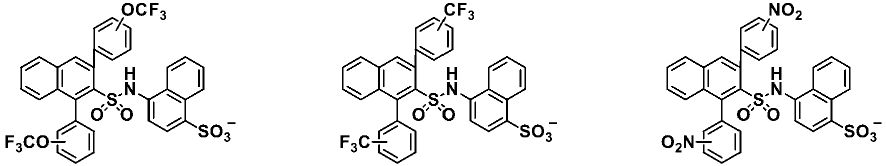

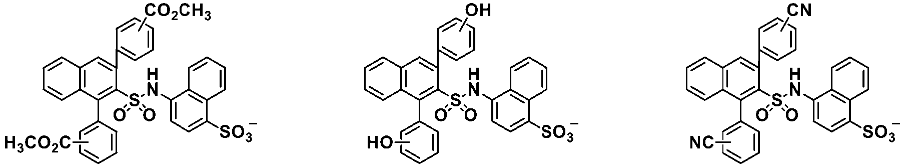

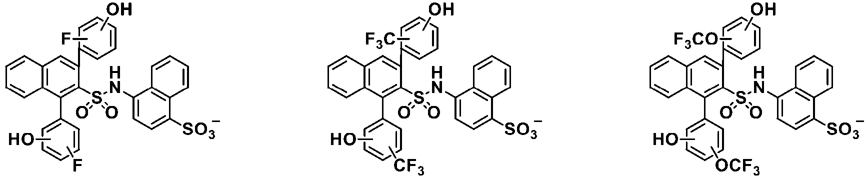

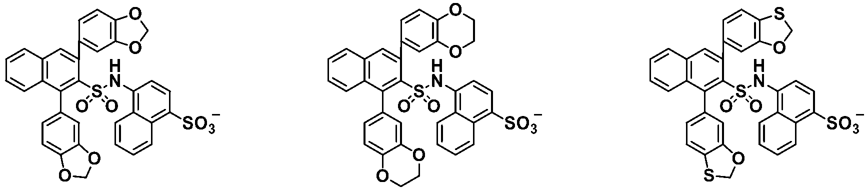

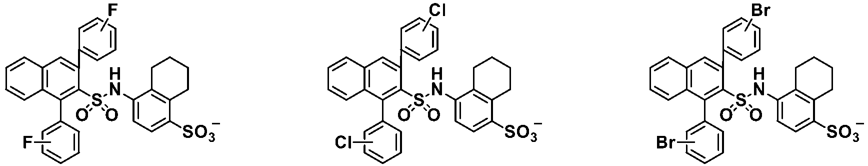

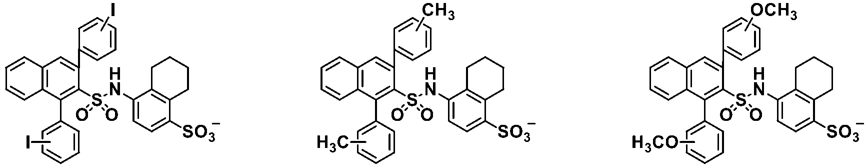

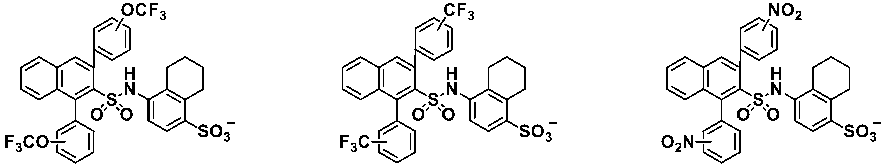

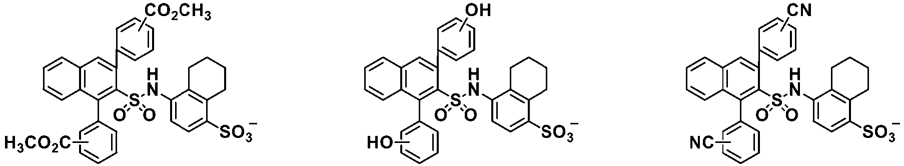

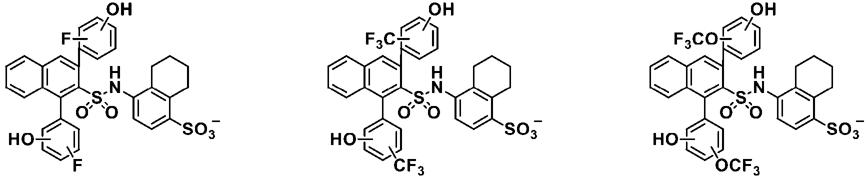

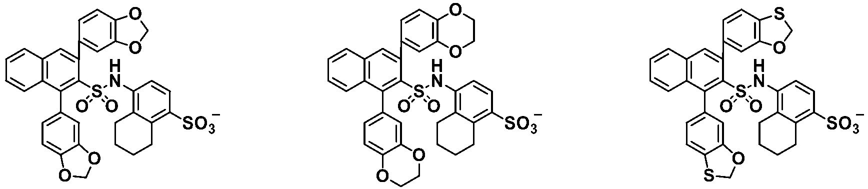

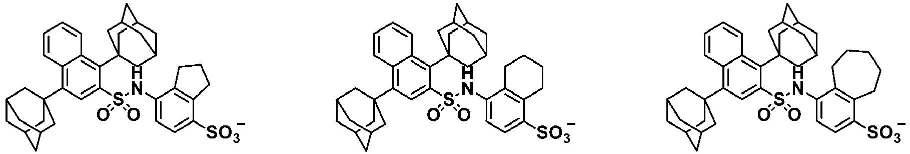

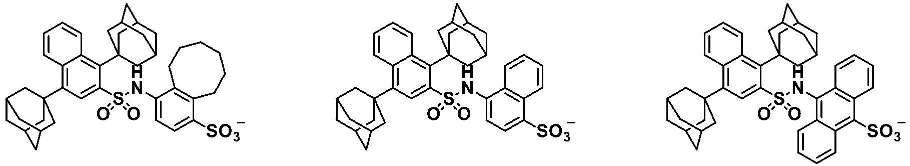

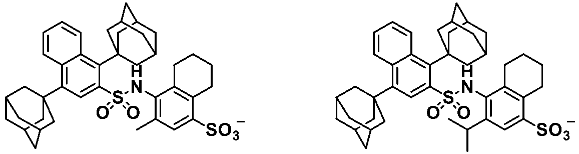

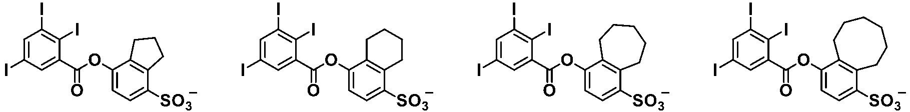

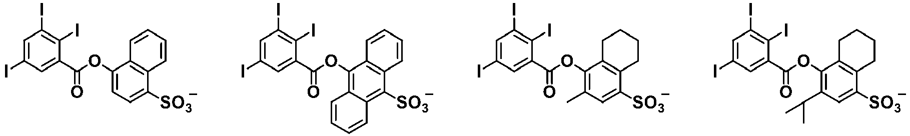

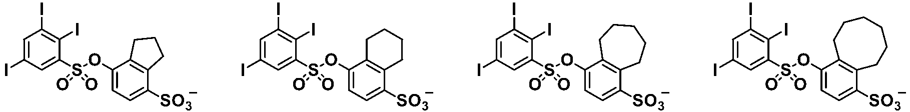

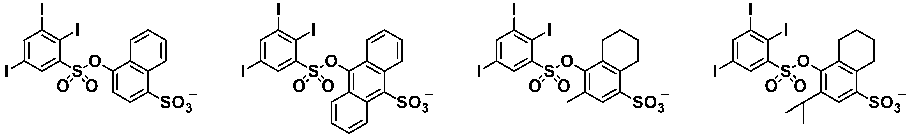

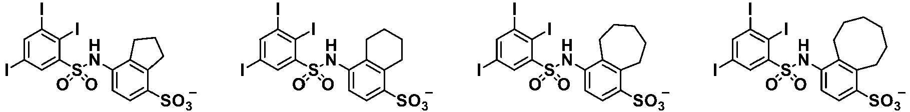

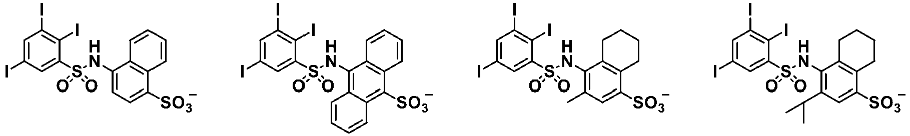

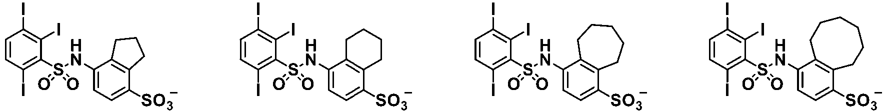

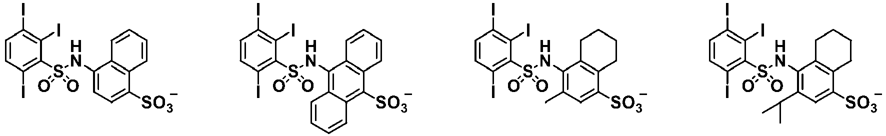

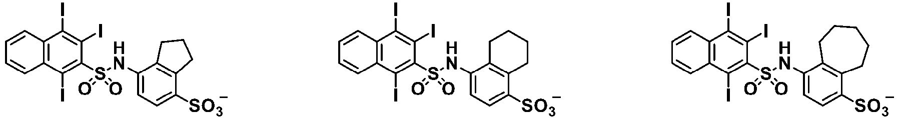

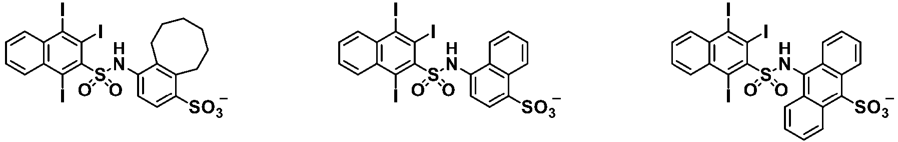

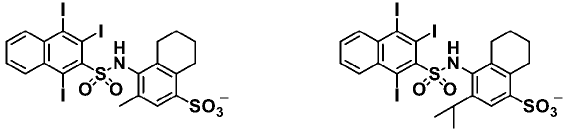

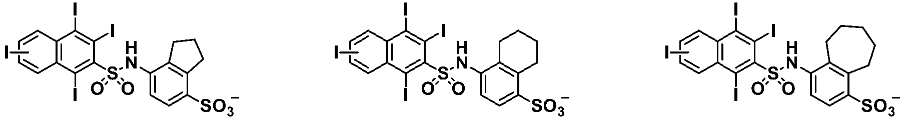

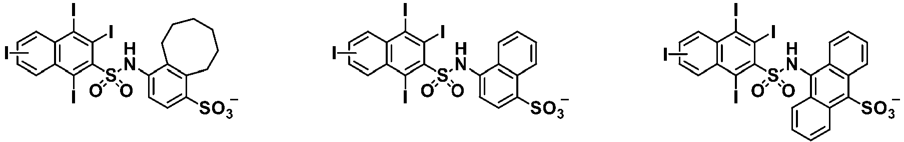

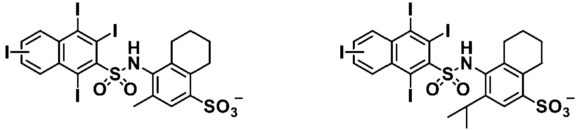

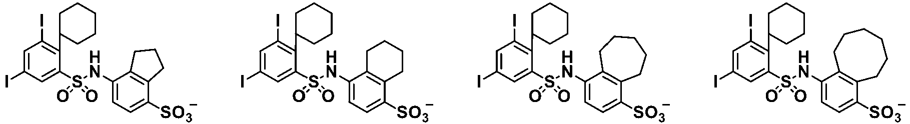

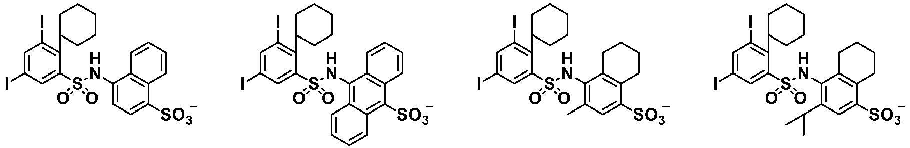

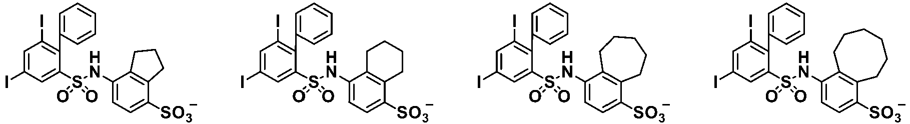

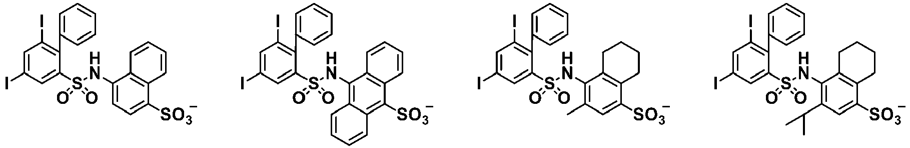

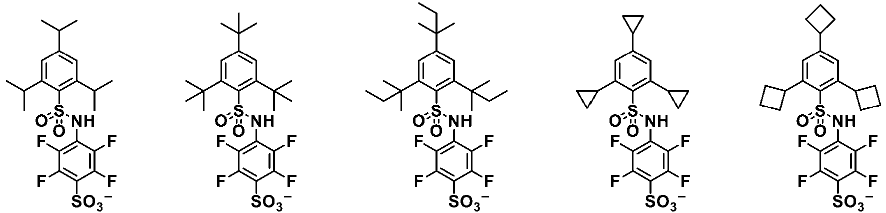

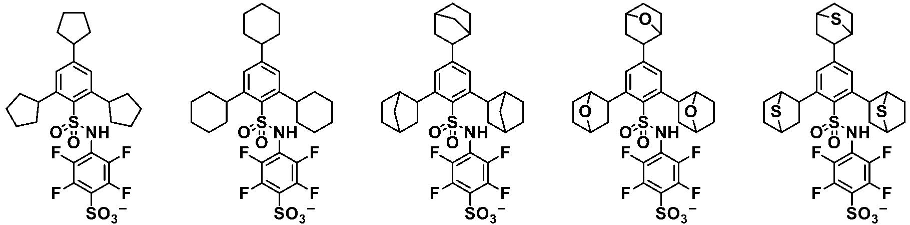

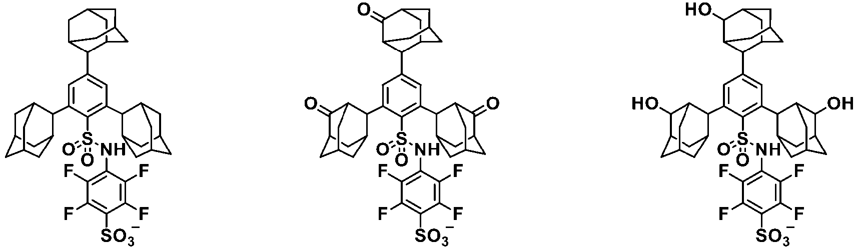

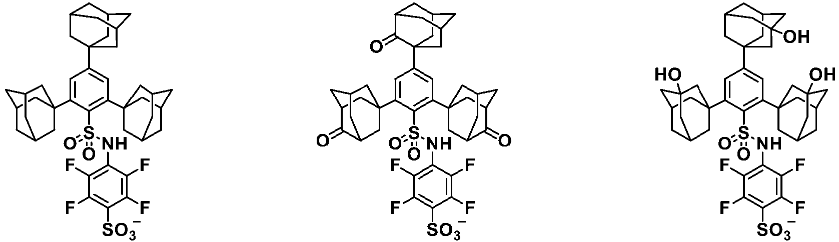

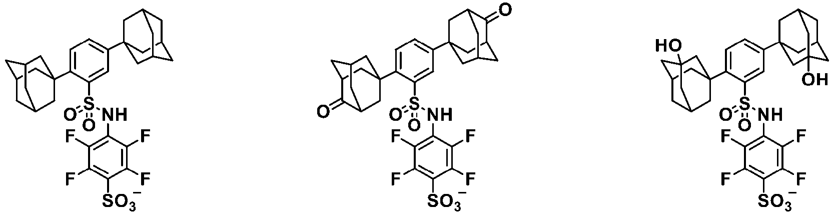

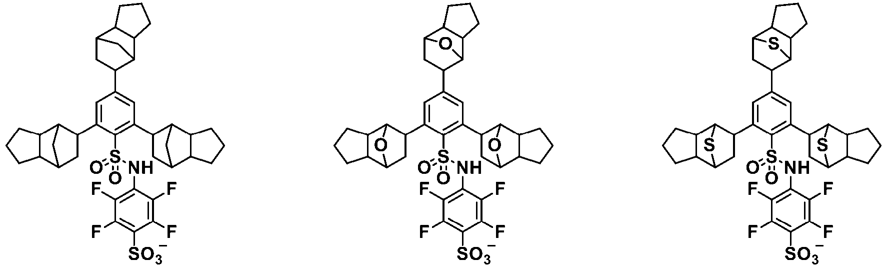

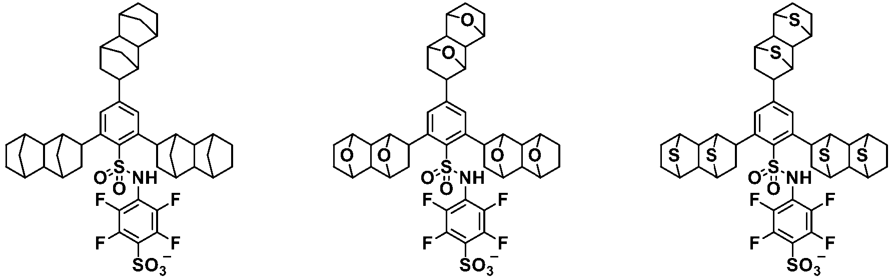

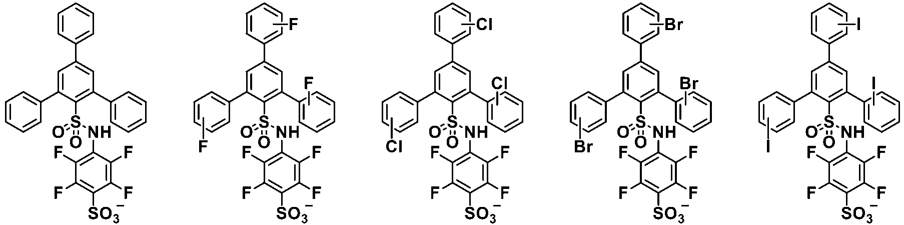

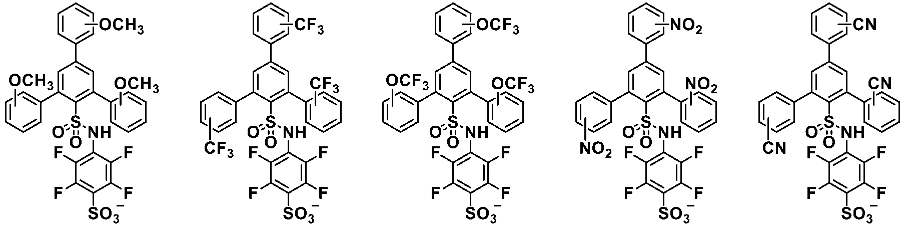

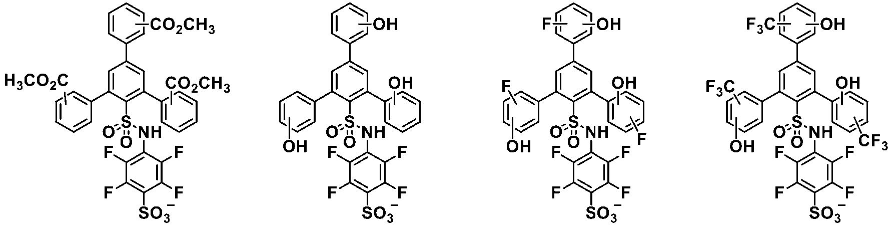

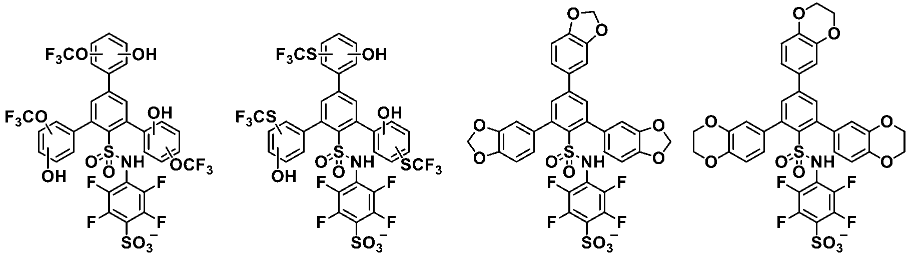

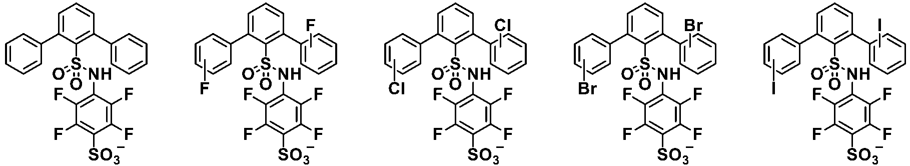

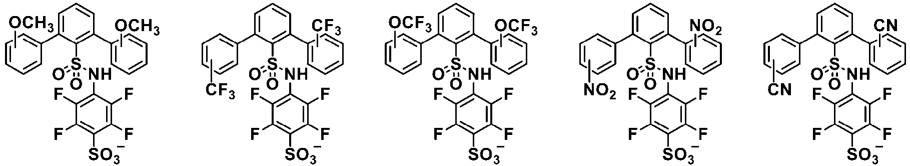

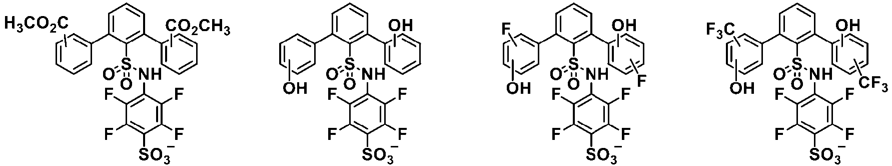

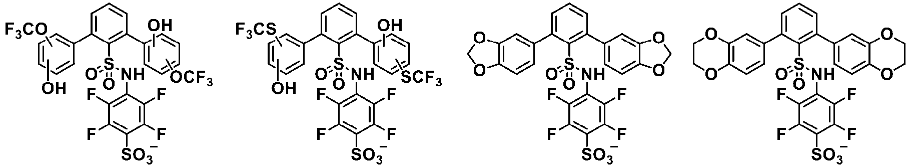

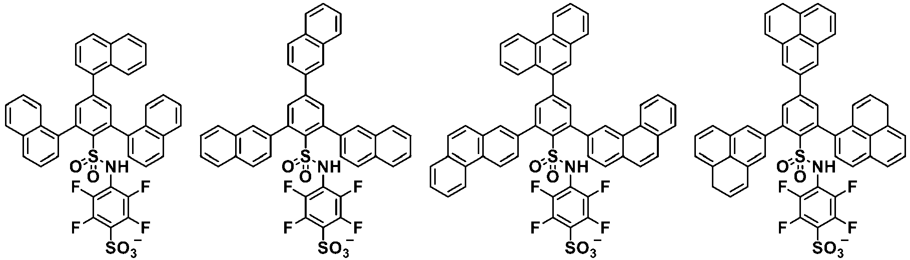

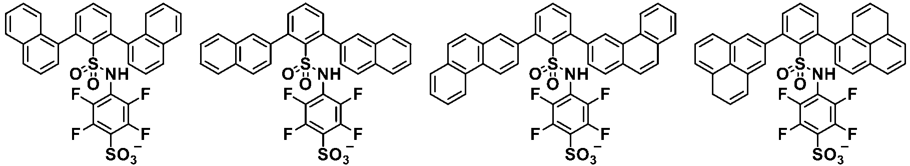

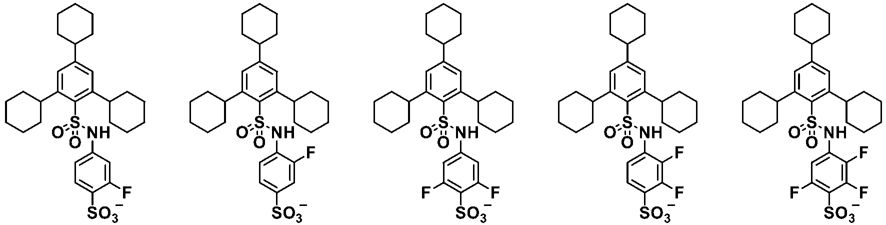

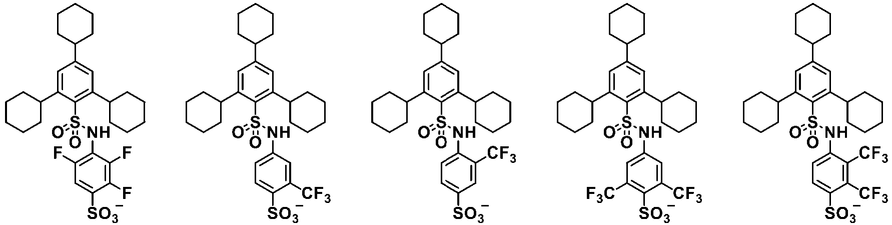

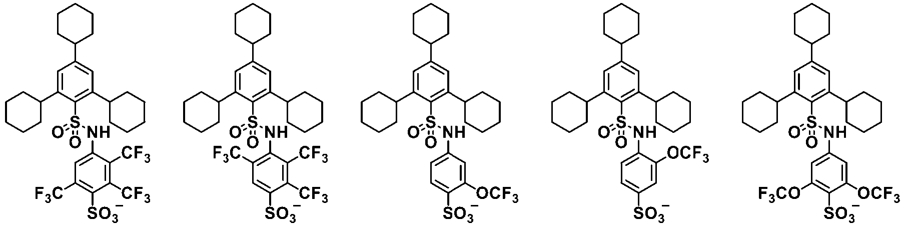

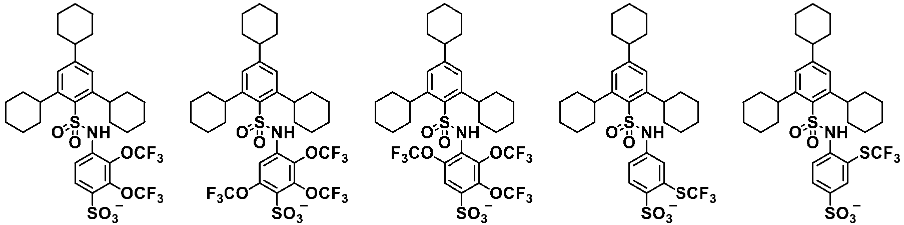

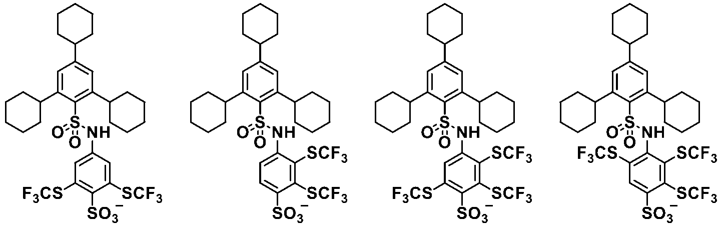

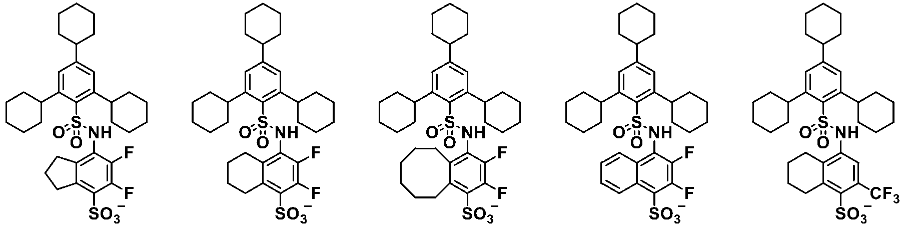

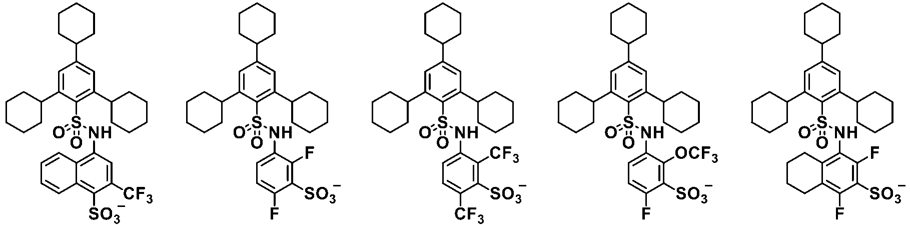

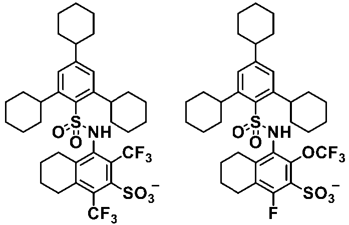

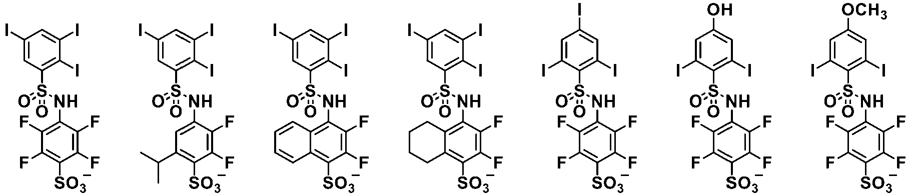

In formula (A), Z⁺ is an onium cation, preferably sulfonium cation having the formula (Z-1) or iodonium cation having the formula (Z-2).

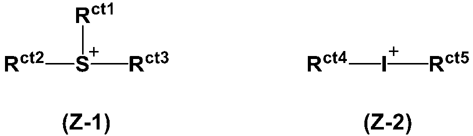

In formulae (Z-1) and (Z-2), R^{ct1} to R^{ct5} are each independently halogen or a C₁-C₃₀ hydrocarbyl group which may contain a heteroatom. Suitable halogen atoms include fluorine, chlorine, bromine and iodine. The hydrocarbyl group may be saturated or unsaturated and straight, branched or cyclic. Examples thereof include C₁-C₃₀ alkyl groups such as methyl, ethyl, n-propyl, isopropyl, n-butyl, isobutyl, sec-butyl, tert-butyl; C₃-C₃₀ cyclic saturated hydrocarbyl groups such as cyclopropyl, cyclopentyl, cyclohexyl, cyclopropylmethyl, 4-methylcyclohexyl, cyclohexylmethyl, norbornyl, adamantyl; C₂-C₃₀ alkenyl groups such as vinyl, 1-propenyl, 2-propenyl, butenyl, hexenyl; C₃-C₃₀ cyclic unsaturated hydrocarbyl groups such as cyclohexenyl; C₆-C₃₀ aryl groups such as phenyl, naphthyl, thienyl; C₇-C₃₀ aralkyl groups such as benzyl, 1-phenylethyl, 2-phenylethyl, and combinations thereof. Inter alia, the aryl groups are preferred. In the hydrocarbyl groups, some or all hydrogen may be substituted by a moiety containing a heteroatom such as oxygen, sulfur, nitrogen or halogen, and some -CH₂- may be replaced by a moiety containing a heteroatom such as oxygen, sulfur or nitrogen, so that the group may contain a hydroxy, fluorine, chlorine, bromine, iodine, cyano, nitro, carbonyl, ether bond, ester bond, sulfonate ester bond, carbonate bond, lactone ring, sultone ring, carboxylic anhydride (-C(=O)-O-C(=O)-) or haloalkyl moiety.

Also, R^{ct1} and R^{ct2} may bond together to form a ring with the sulfur atom to which they are attached. Exemplary structures of the ring are shown below.

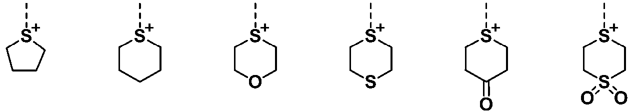

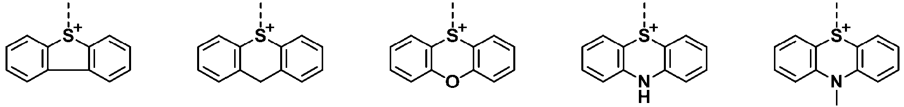

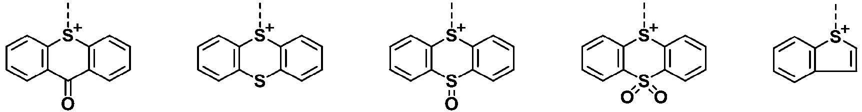

The broken line designates a point of attachment to R^{ct3}.

Examples of the sulfonium cation having formula (Z-1) include the cations described in JP-A 2024-003744, paragraphs [0102]-[0125] and JP-A 2023-169812, paragraphs [0070]-[0085], but are not limited thereto.

Examples of the iodonium cation having formula (Z-2) include the cations described in JP-A 2024-000259, paragraph [0181], but are not limited thereto.

A sulfonium cation having the formula (Z-3) is also preferable as the onium cation Z⁺.

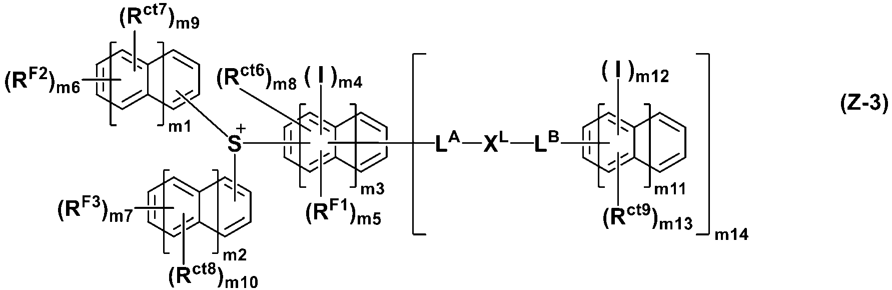

In formula (Z-3), m1 is 0 or 1. The relevant structure is a benzene ring when m1=0, and a naphthalene ring when m1=1. The benzene ring corresponding to m1=0 is preferred from the aspect of solvent solubility. The subscript m2 is 0 or 1. The relevant structure is a benzene ring when m2=0, and a naphthalene ring when m2=1. The benzene ring corresponding to m2=0 is preferred from the aspect of solvent solubility. The subscript m3 is 0 or 1. The relevant structure is a benzene ring when m3=0, and a naphthalene ring when m3=1. The benzene ring corresponding to m3=0 is preferred from the aspect of solvent solubility.

In formula (Z-3), m4 is 0, 1, 2, 3 or 4. As the number of iodine atoms in the cation structure increases, the compound becomes more absorptive to EUV, but so poor in solvent solubility that it may precipitate in a resist composition. For this reason, m4 is preferably 0, 1, 2 or 3, more preferably 0, 1 or 2.

In formula (Z-3), m5 is 0, 1, 2, 3 or 4. From the aspect of reactant availability, m5 is preferably 0, 1, 2 or 3, more preferably 0, 1 or 2. The subscript m6 is 0, 1, 2, 3, 4, 5 or 6. From the aspect of reactant availability, m6 is preferably 0, 1, 2 or 3, more preferably 0, 1 or 2. The subscript m7 is 0, 1, 2, 3, 4, 5 or 6. From the aspect of reactant availability, m7 is preferably 0, 1, 2 or 3, more preferably 0, 1 or 2.

In formula (Z-3), m8 is 0, 1 or 2. From the aspect of reactant availability, m8 is preferably 0 or 1. The subscript m9 is 0, 1 or 2. From the aspect of reactant availability, m9 is preferably 0 or 1. The subscript m10 is 0, 1 or 2. From the aspect of reactant availability, m10 is preferably 0 or 1.

In formula (Z-3), m11 is 0 or 1. The relevant structure is a benzene ring when m11=0, and a naphthalene ring when m11=1. The benzene ring corresponding to m11=0 is preferred from the aspect of solvent solubility.

In formula (Z-3), m12 is 0, 1, 2, 3 or 4. As the number of iodine atoms in the cation structure increases, the compound becomes more absorptive to EUV, but so poor in solvent solubility that it may precipitate in a resist composition. For this reason, m12 is preferably 0, 1, 2 or 3, more preferably 0, 1 or 2.

In formula (Z-3), m13 is 0, 1 or 2. From the aspect of reactant availability, m13 is preferably 0 or 1. The subscript m14 is 0, 1 or 2. From the aspect of synthesis, m14 is preferably 0 or 1.

The subscripts m1 to m14 are in the range: 0 ≤ m6+m9 ≤ 4 when m1=0, 0 ≤ m6+m9 ≤ 6 when m1=1; 0 ≤ m7+m10 ≤ 4 when m2=0, 0 ≤ m7+m10 ≤ 6 when m2=1; 1 ≤ m4+m5+m8+m14 ≤ 4 when m3=0, 1 ≤ m4+m5+m8+m14 ≤ 6 when m3=1; 0 ≤ m12+m13 ≤ 4 when m11=0, 0 ≤ m12+m13 ≤ 6 when m11=1; and m4+m12 ≥ 1.

In formula (Z-3), R^{F1} to R^{F3} are each independently fluorine, a C₁-C₆ fluorinated saturated hydrocarbyl group, C₁-C₆ fluorinated saturated hydrocarbyloxy group, or C₁-C₆ fluorinated saturated hydrocarbylthio group. Of these, trifluoromethyl, trifluoromethoxy, and trifluorothiomethoxy are preferred. A plurality of R^{F1} may be identical or different when m5 is 2, 3 or 4, a plurality of R^{F2} may be identical or different when m6 is 2, 3, 4, 5 or 6, and a plurality of R^{F3} may be identical or different when m7 is 2, 3, 4, 5 or 6.

In formula (Z-3), R^{ct6} to R^{ct9} are each independently halogen exclusive of iodine and fluorine, nitro, cyano, a C₁-C₂₀ hydrocarbyl group which may contain a heteroatom, C₁-C₂₀ hydrocarbyloxy group which may contain a heteroatom, or C₁-C₂₀ hydrocarbylthio group which may contain a heteroatom. The hydrocarbyl group and hydrocarbyl moiety in the hydrocarbyloxy and hydrocarbylthio groups may be saturated or unsaturated and straight, branched or cyclic. Examples thereof are as exemplified above for the hydrocarbyl group R² in formula (A). In the hydrocarbyl group and hydrocarbyl moiety in the hydrocarbyloxy and hydrocarbylthio groups, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy moiety, cyano moiety, fluorine, chlorine, bromine, iodine, carbonyl moiety, ether bond, ester bond, sulfonate ester bond, carbonate bond, lactone ring, sultone ring, carboxylic anhydride (-C(=O)-O-C(=O)-) or haloalkyl moiety.

When m8=2, two R^{ct6} may be identical or different and two R^{ct6} may bond together to form a ring with the carbon atoms to which they are attached. When m9=2, two R^{ct7} may be identical or different and two R^{ct7} may bond together to form a ring with the carbon atoms to which they are attached. When m10=2, two R^{ct8} may be identical or different and two R^{ct8} may bond together to form a ring with the carbon atoms to which they are attached. When m13=2, two R^{ct9} may be identical or different and two R^{ct9} may bond together to form a ring with the carbon atoms to which they are attached. Examples of the ring thus formed include cyclopropane, cyclobutane, cyclopentane, cyclohexane, norbornane, and adamantane rings. In the ring, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the ring may contain a hydroxy moiety, fluorine, chlorine, bromine, iodine, cyano moiety, carbonyl moiety, ether bond, ester bond, sulfonate ester bond, carbonate bond, lactone ring, sultone ring, carboxylic anhydride (-C(=O)-O-C(=O)-) or haloalkyl moiety.

The aromatic rings directly bonded to S⁺ in the sulfonium cation having formula (Z-3) may bond together to form a ring with S⁺. Exemplary structures of the ring are shown below.

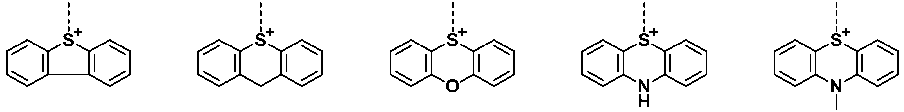

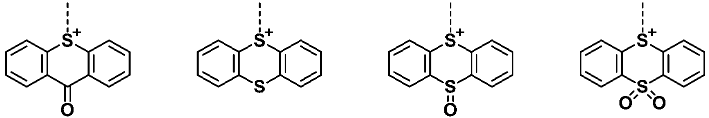

In formula (Z-3), L^{A} and L^{B} are each independently a single bond, ether bond, ester bond, sulfonate ester bond, amide bond, sulfonamide bond, carbonate bond or carbamate bond. L^{A} is preferably a single bond, ether bond, ester bond or sulfonate ester bond, more preferably an ester bond or sulfonate ester bond. L^{B} is preferably a single bond, ether bond or ester bond, more preferably a single bond.

In formula (Z-3), X^{L} is a single bond or a C₁-C₄₀ hydrocarbylene group which may contain a heteroatom. The hydrocarbylene group may be straight, branched or cyclic and examples thereof include alkanediyl and cyclic saturated hydrocarbylene groups. Exemplary heteroatoms include oxygen, nitrogen and sulfur.

Examples of the C₁-C₄₀ hydrocarbylene group which may contain a heteroatom, represented by X^{L}, are shown below, but not limited thereto. Herein, * designates a point of attachment to L^{A} or L^{B}.

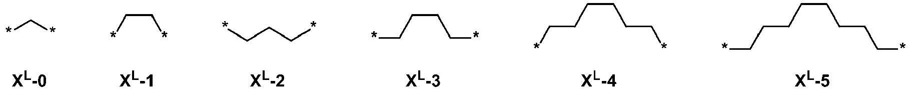

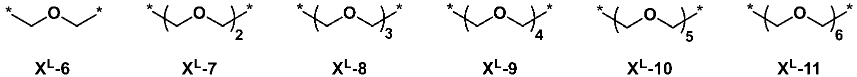

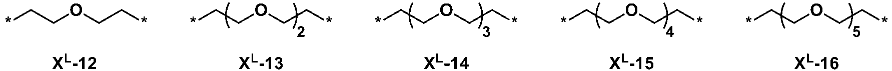

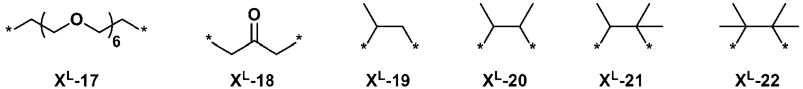

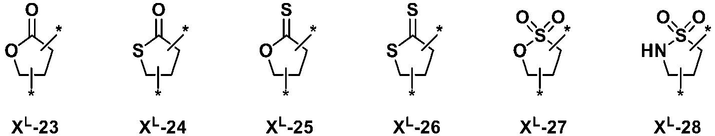

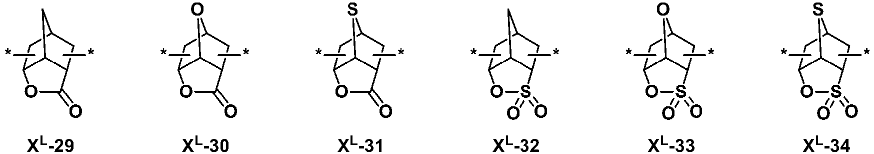

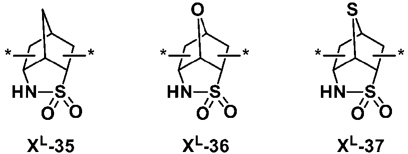

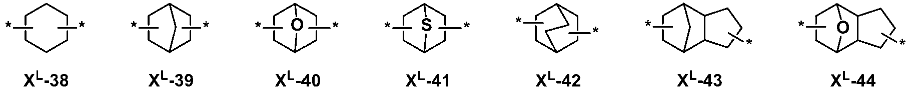

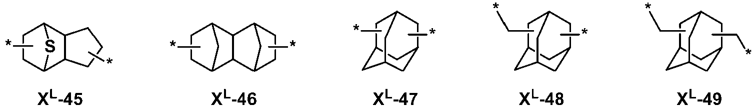

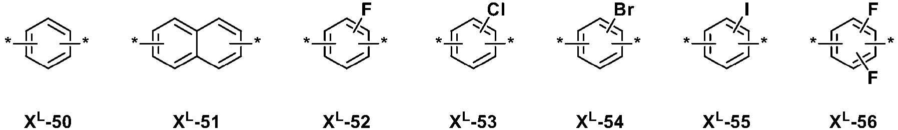

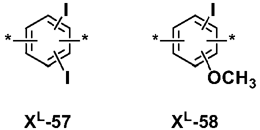

Of these, X^{L}-0 to X^{L}-22 and X^{L}-47 to X^{L}-58 are preferred.

Of the sulfonium cations having formula (Z-3), those having the formula (Z-3-1) are preferred.

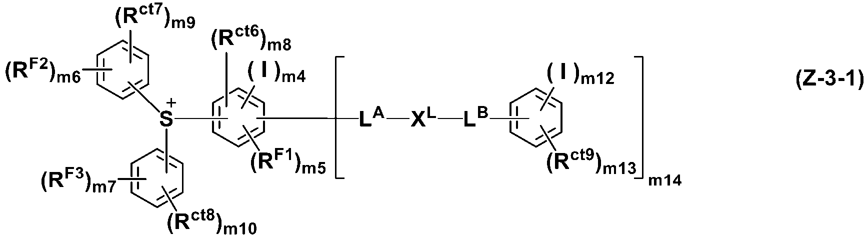

Herein m4 to m10, m12 to m14, R^{F1} to R^{F3}, R^{ct6} to R^{ct9}, L^{A}, L^{B}, and X^{L} are as defined above.

Of the sulfonium cations having formula (Z-3-1), those having the formula (Z-3-2) are preferred.

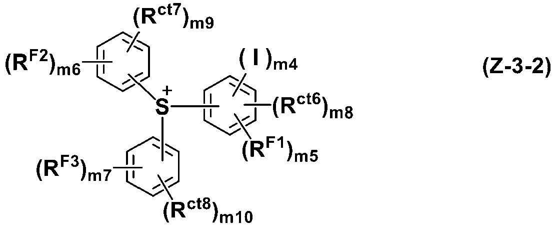

Herein m4 to m10, R^{F1} to R^{F3}, and R^{ct6} to R^{ct8} are as defined above.

Examples of the sulfonium cation having formula (Z-3) are shown below, but not limited thereto.

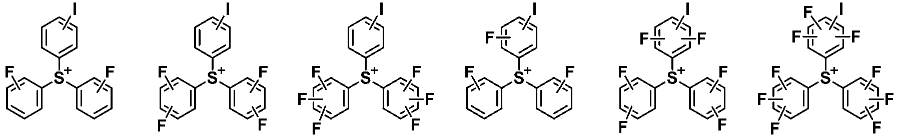

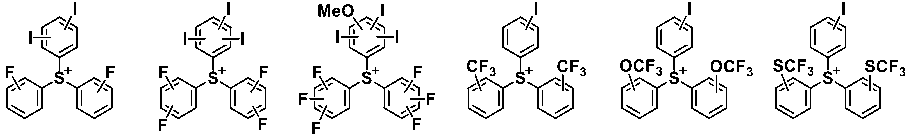

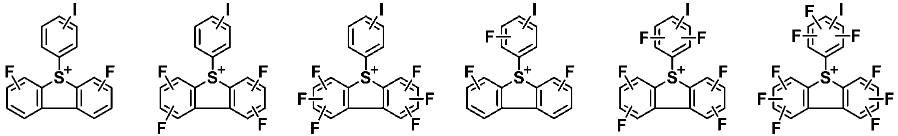

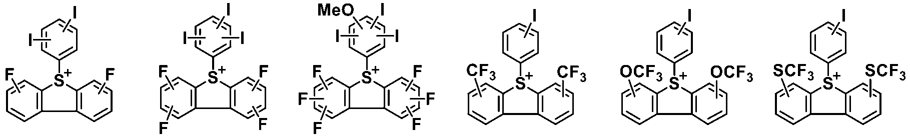

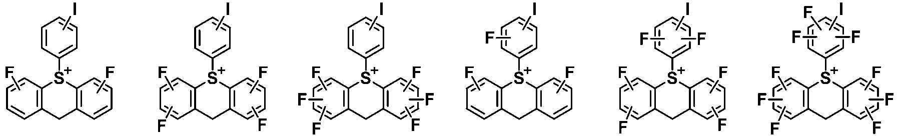

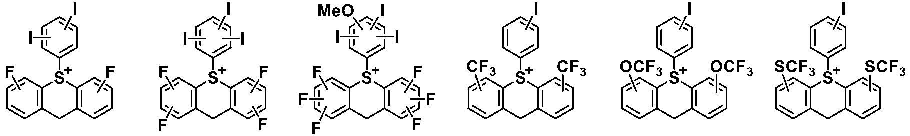

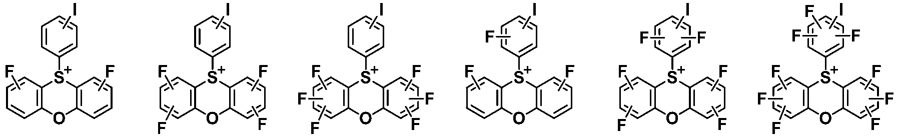

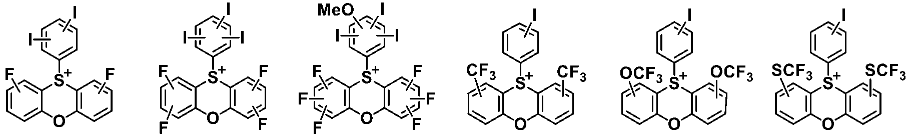

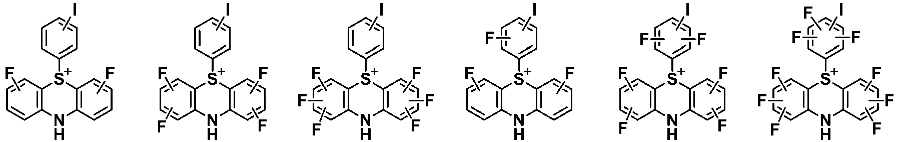

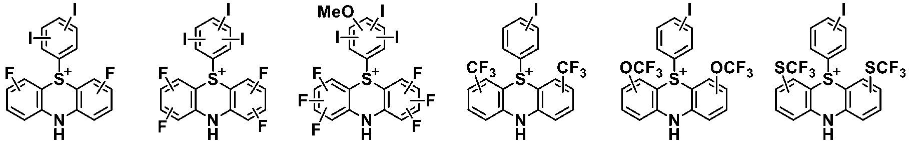

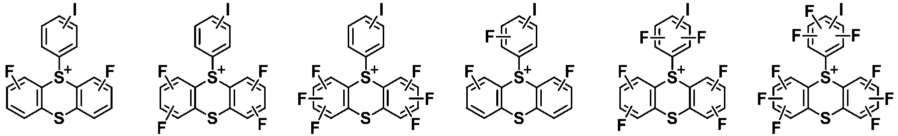

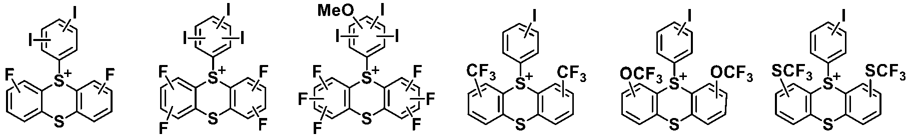

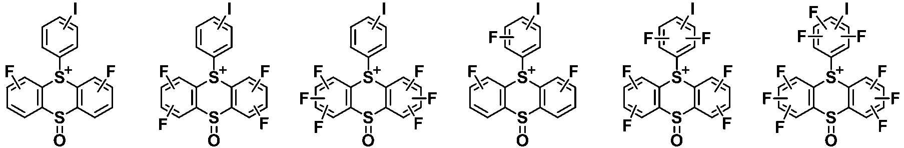

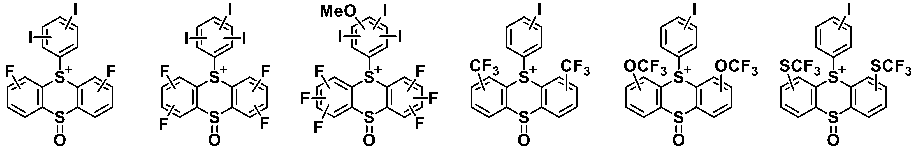

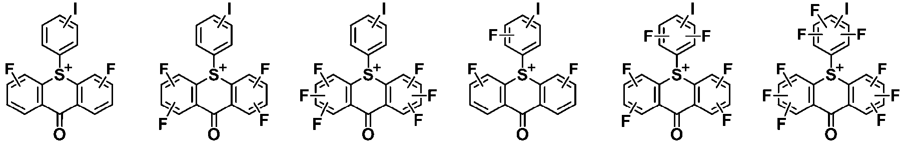

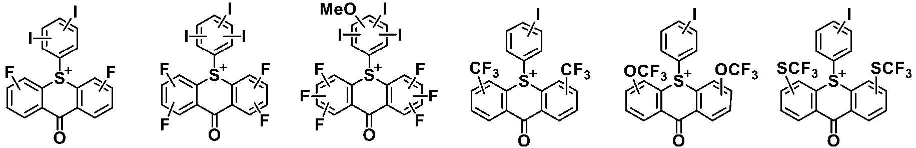

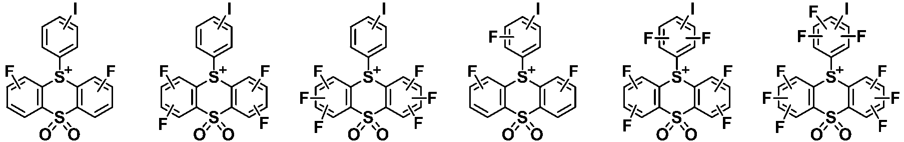

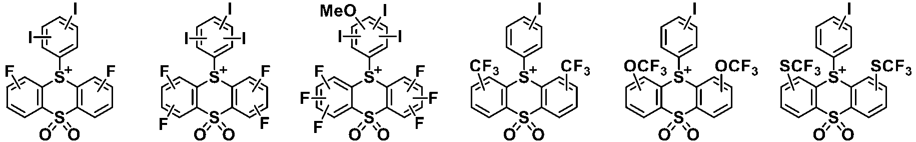

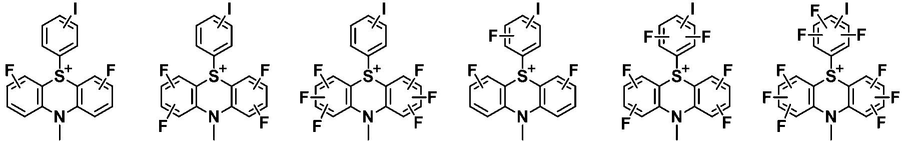

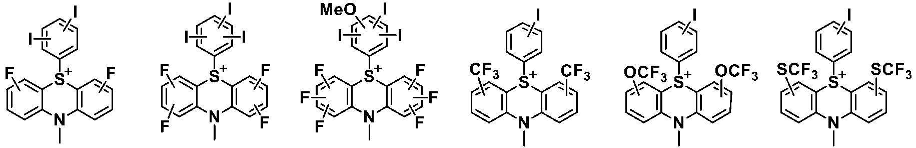

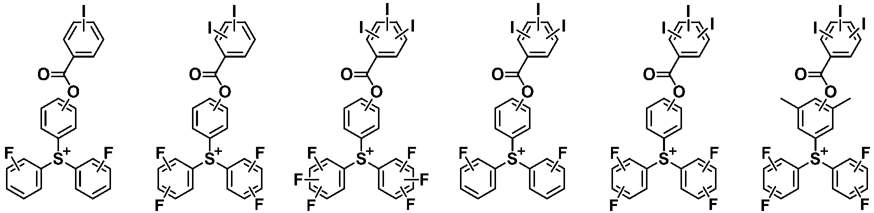

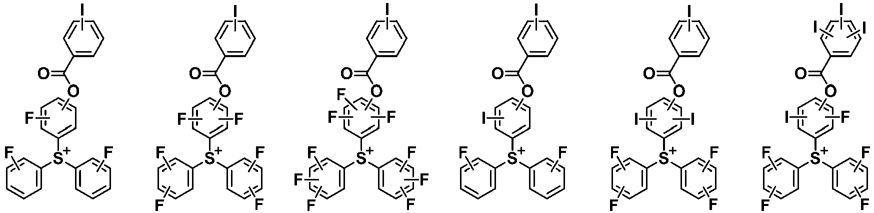

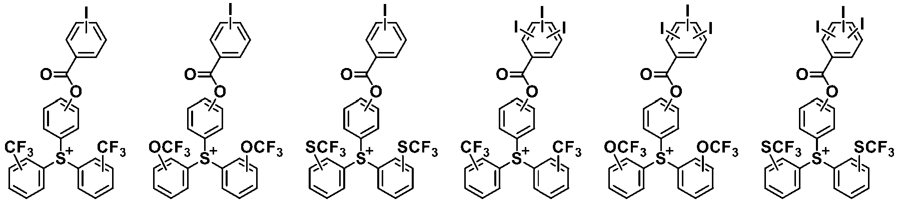

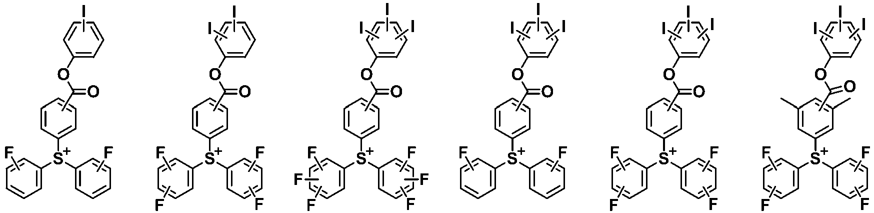

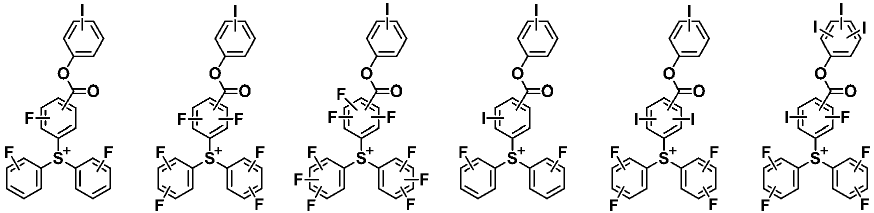

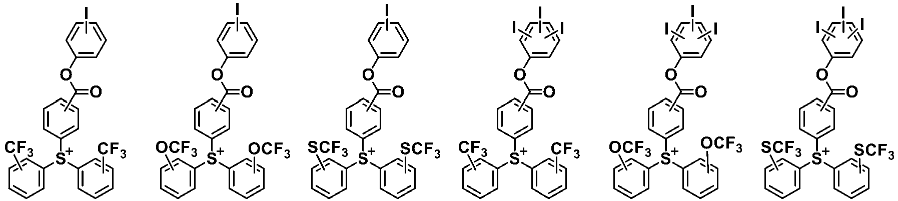

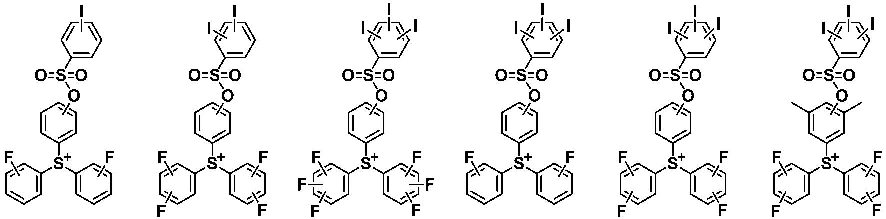

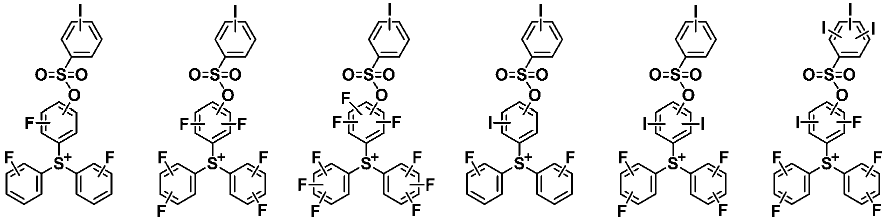

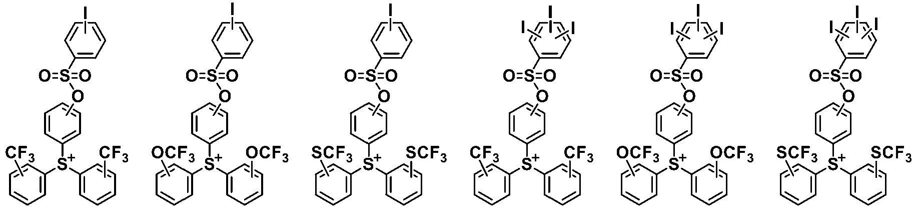

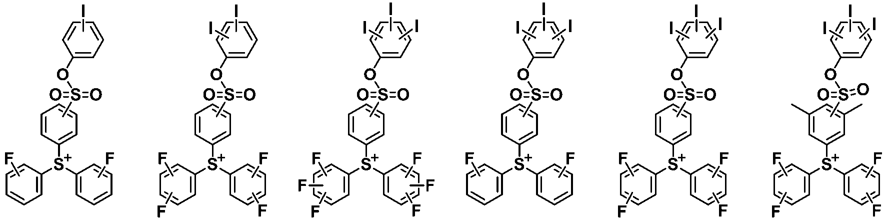

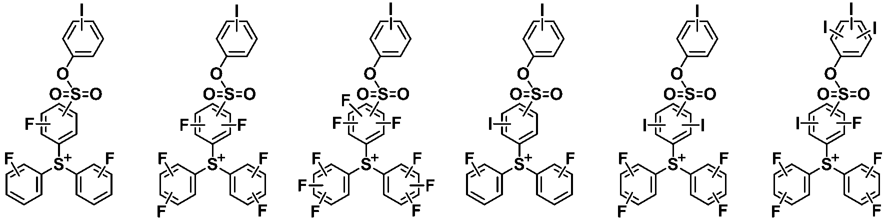

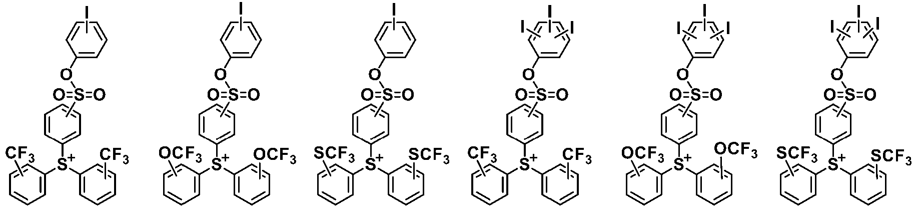

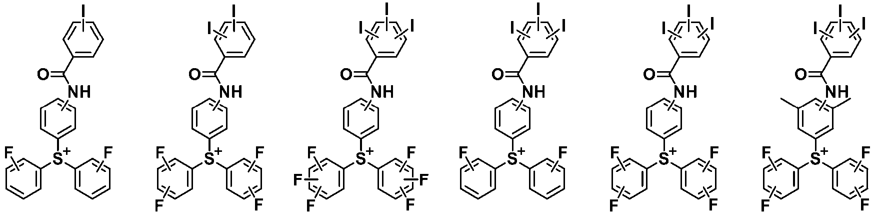

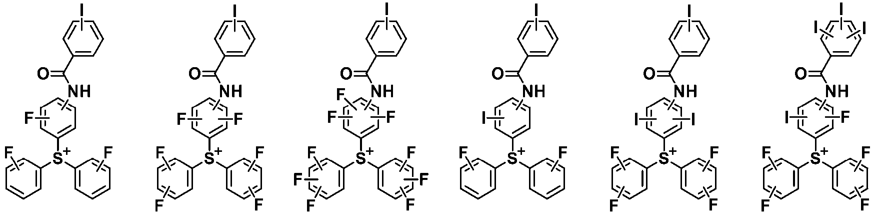

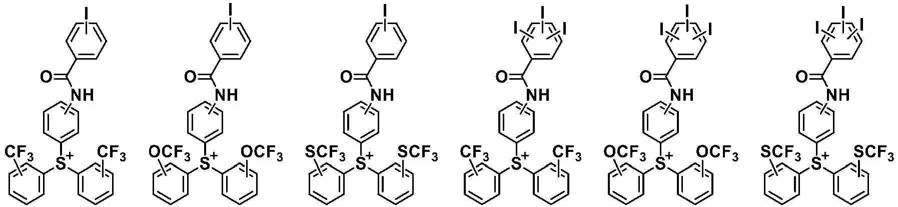

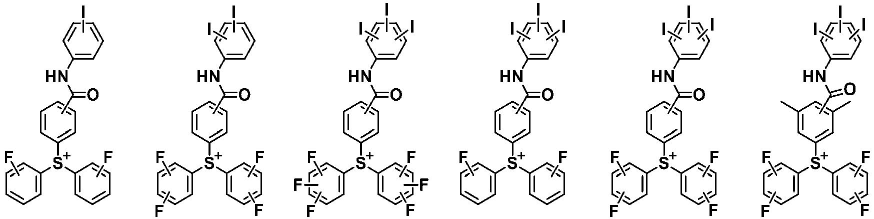

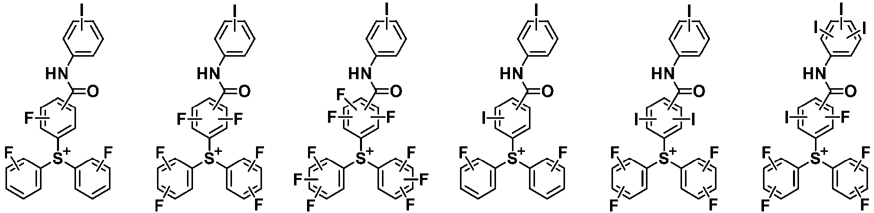

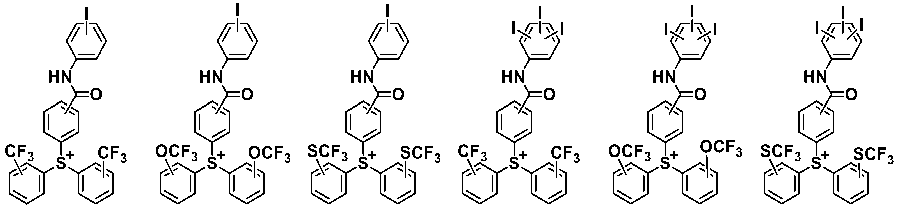

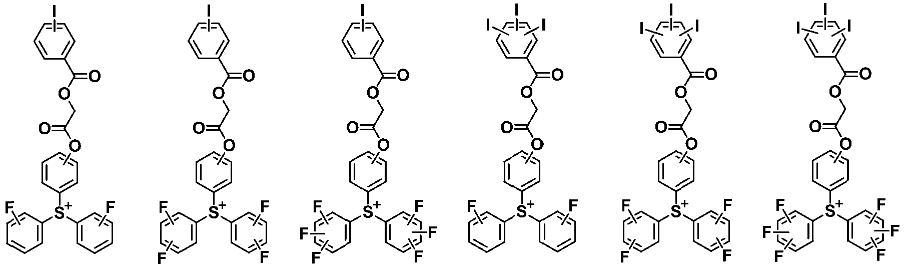

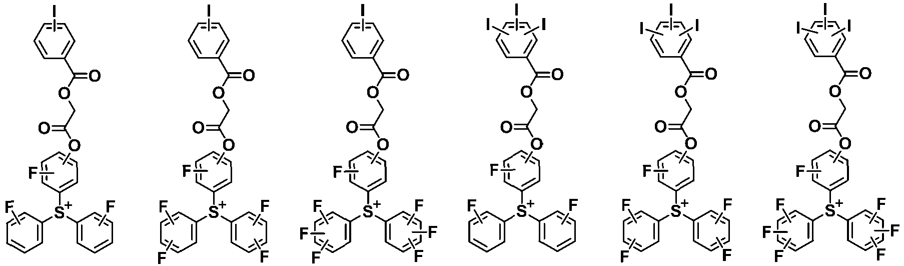

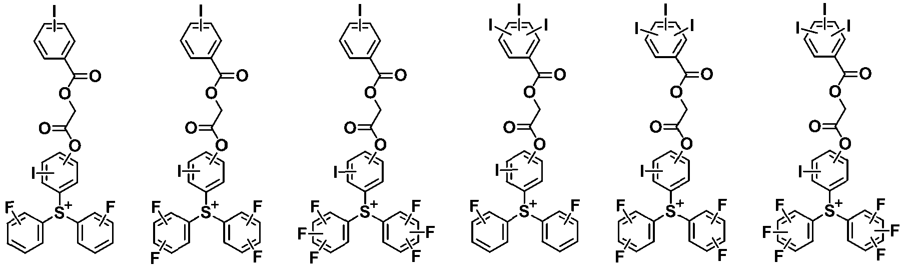

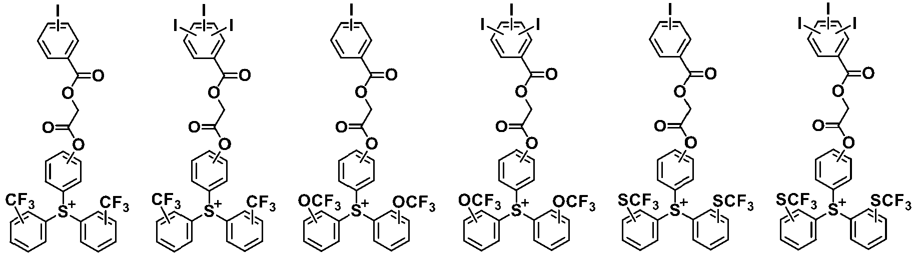

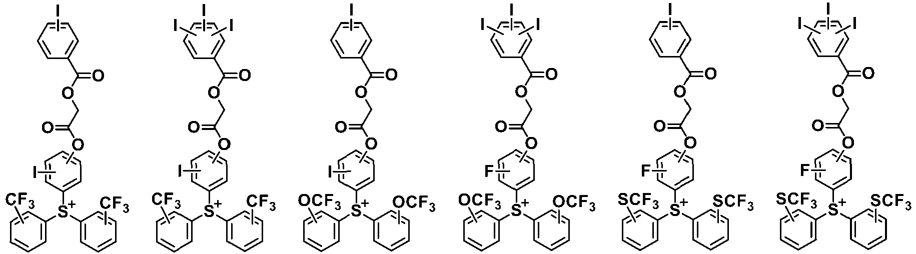

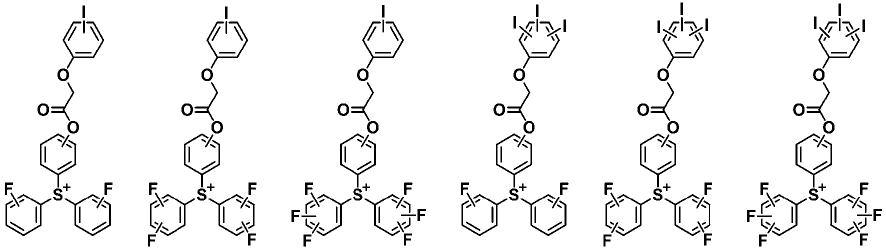

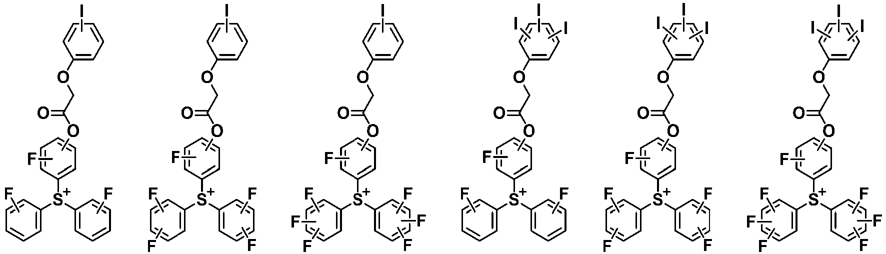

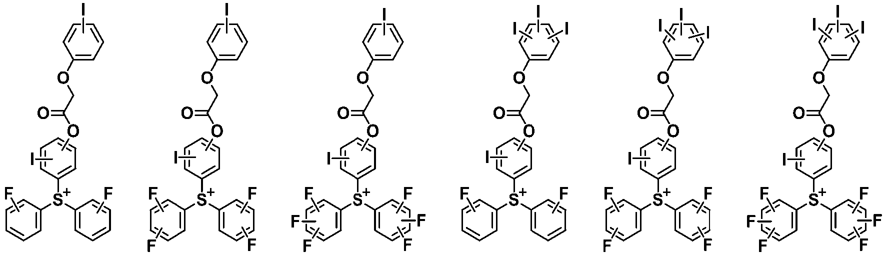

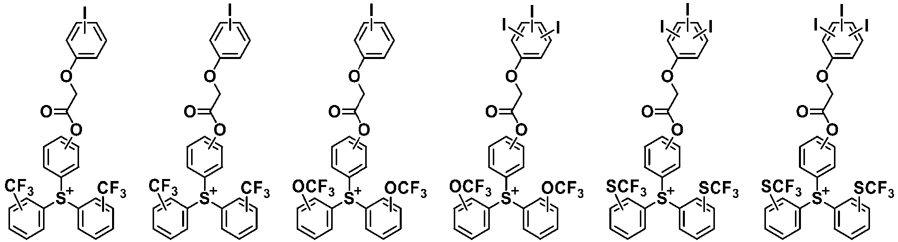

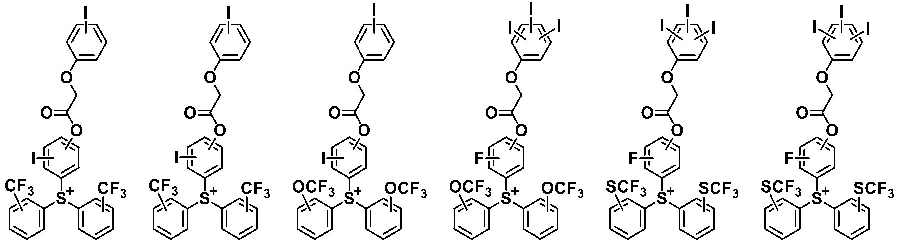

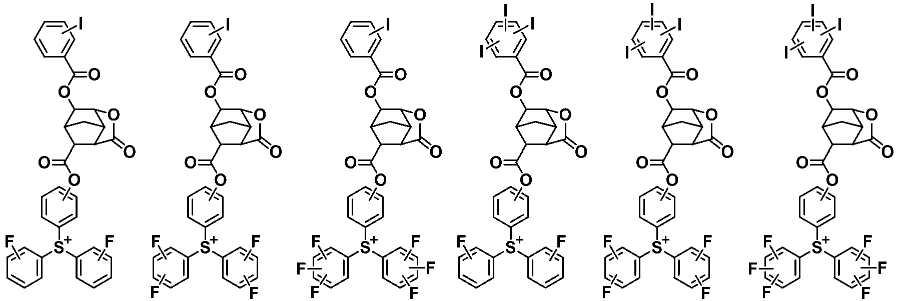

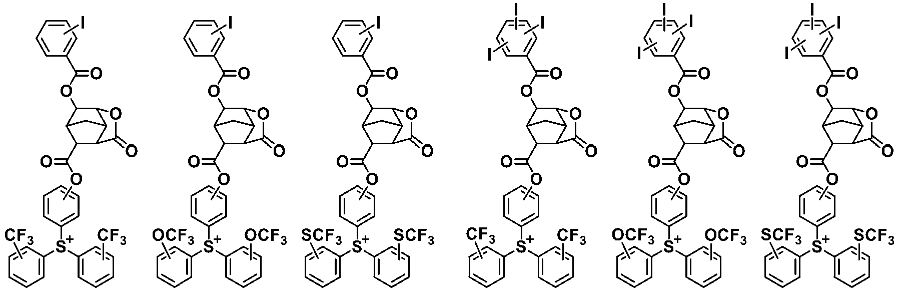

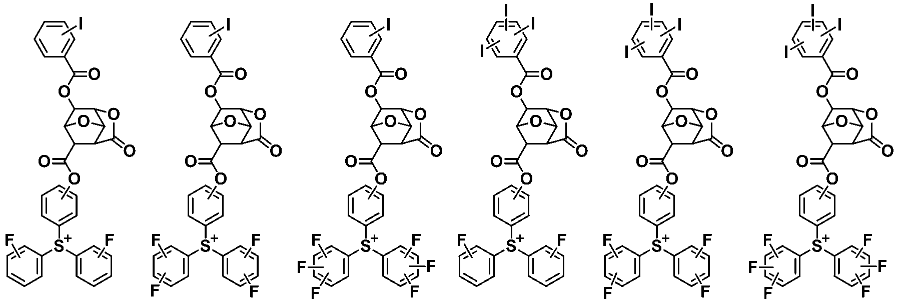

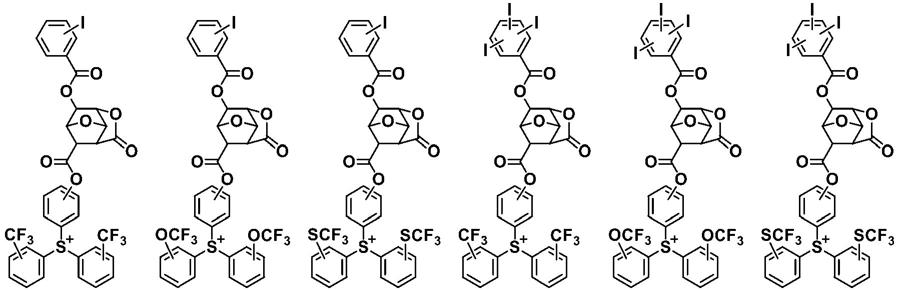

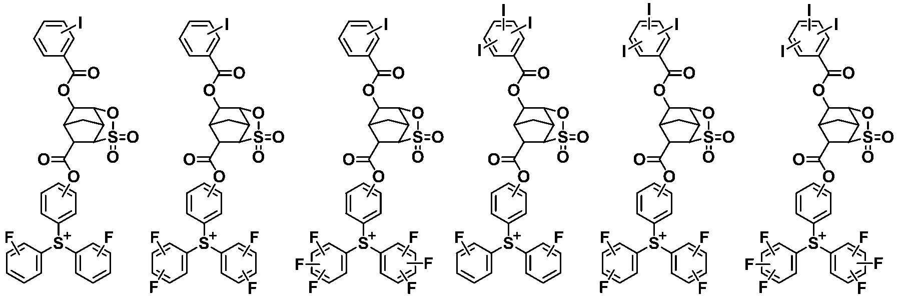

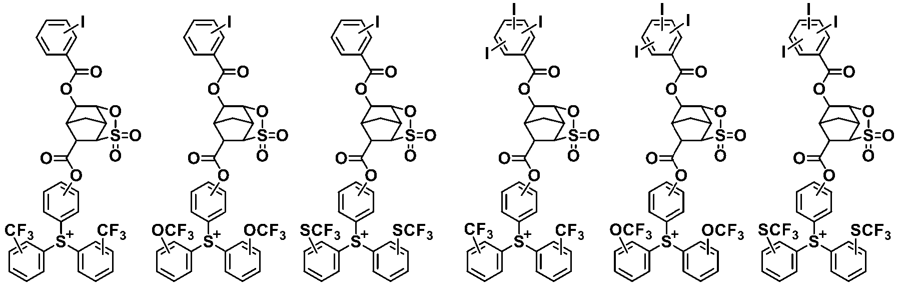

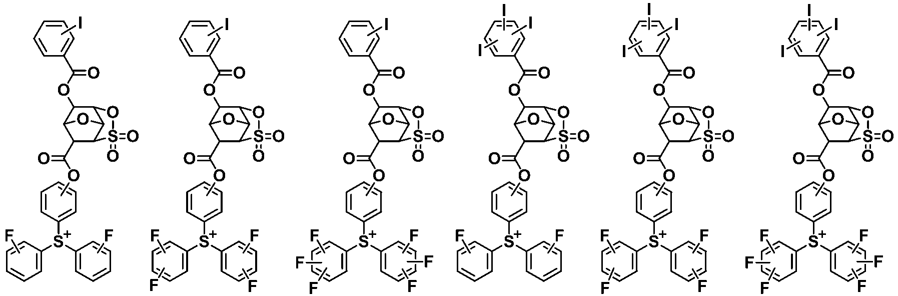

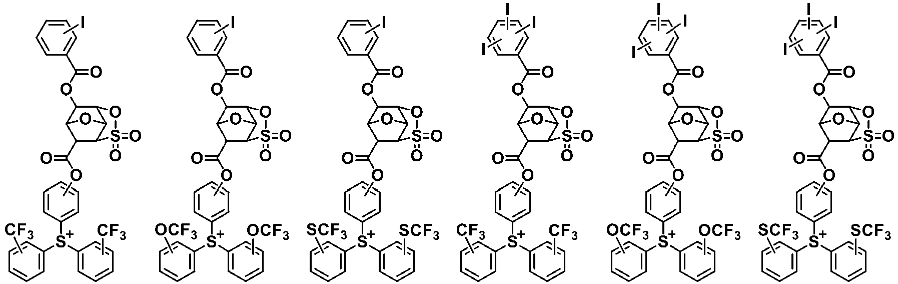

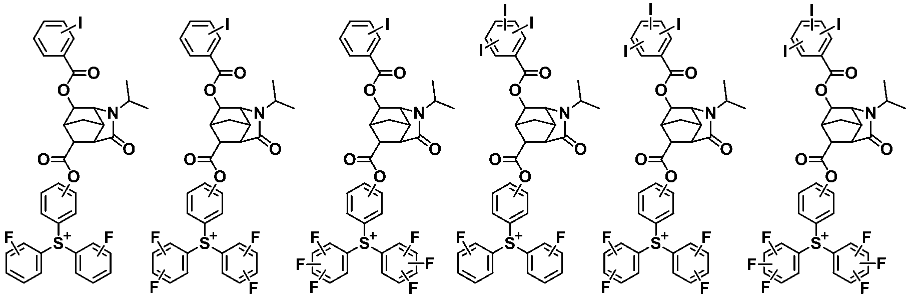

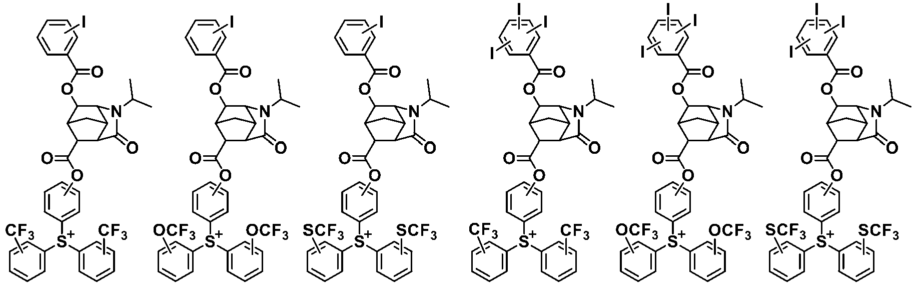

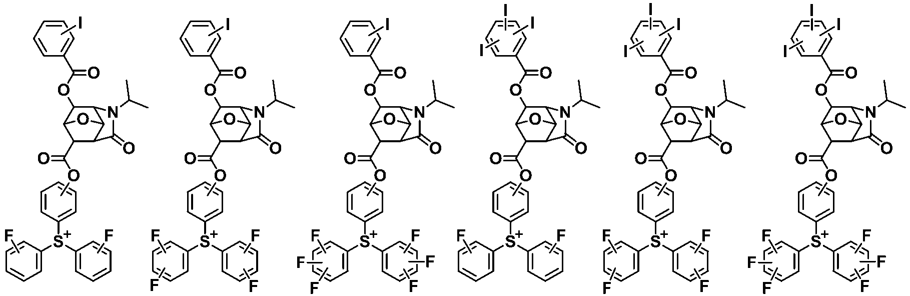

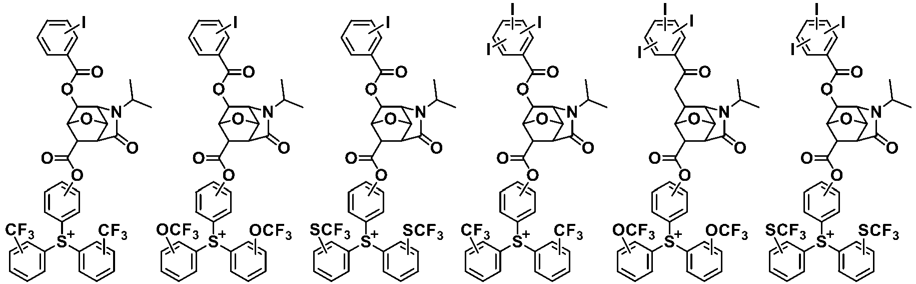

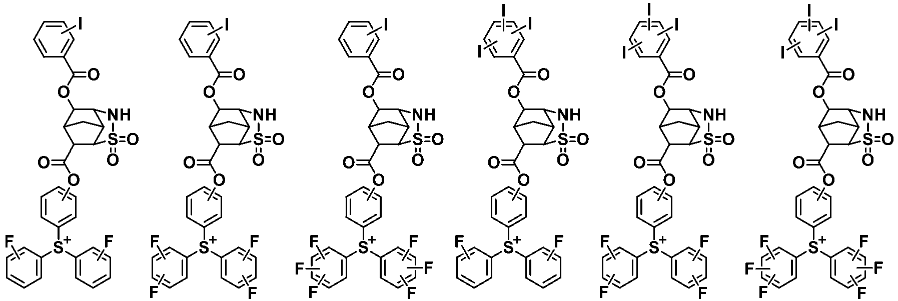

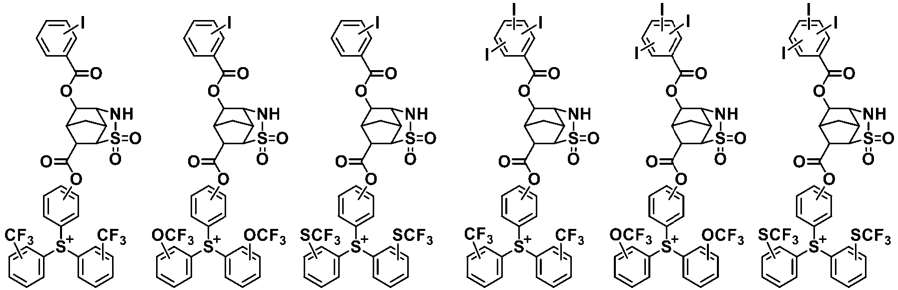

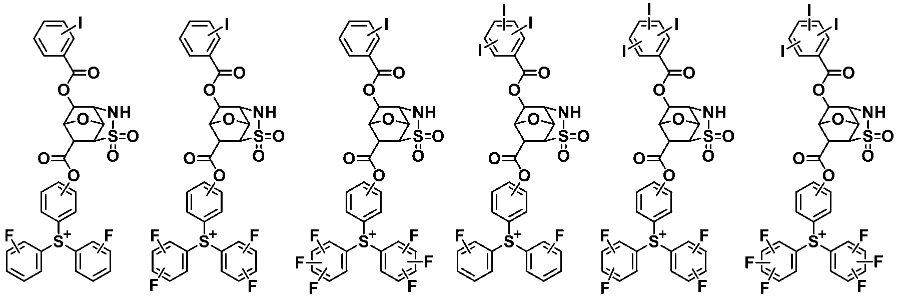

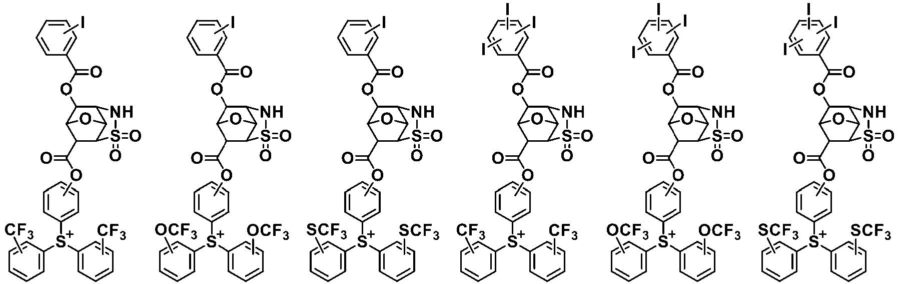

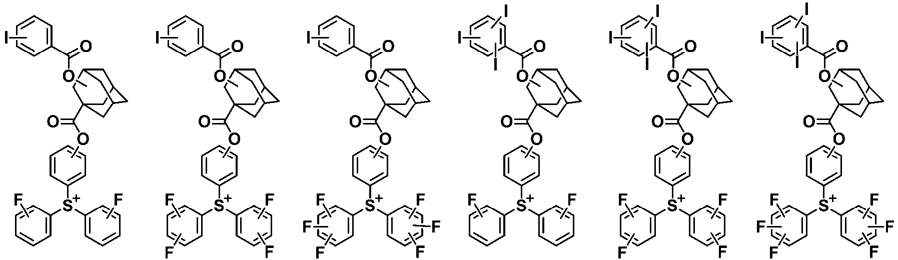

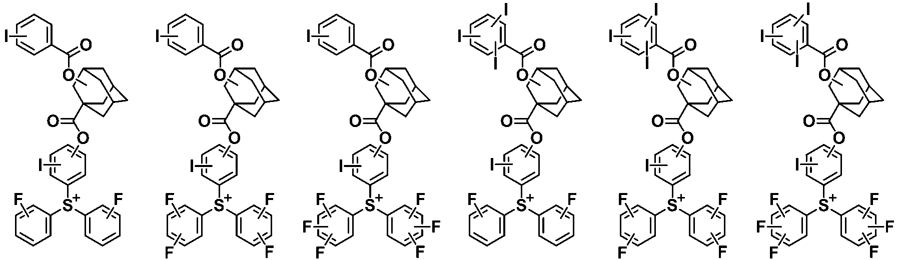

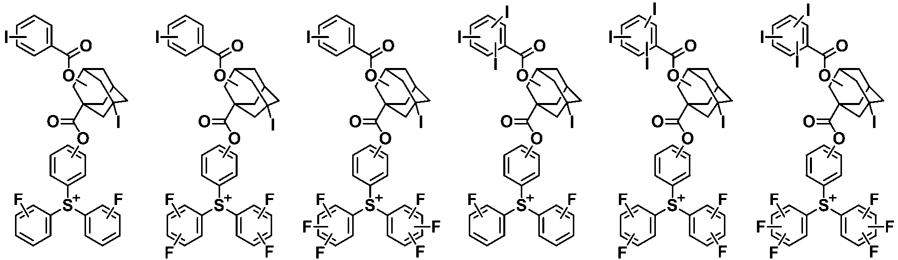

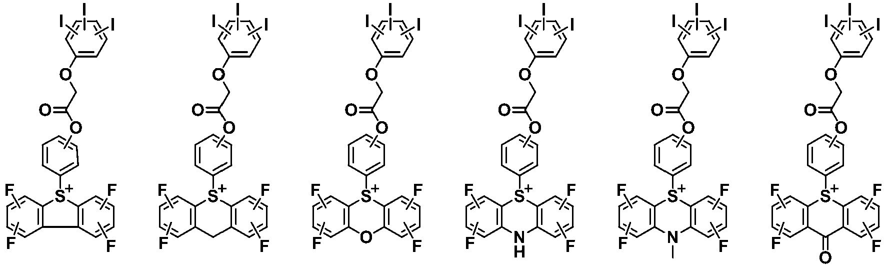

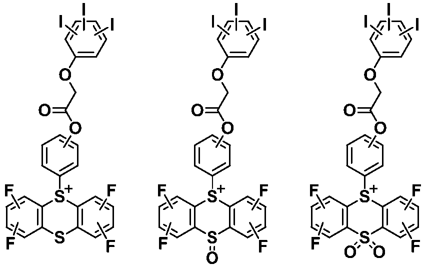

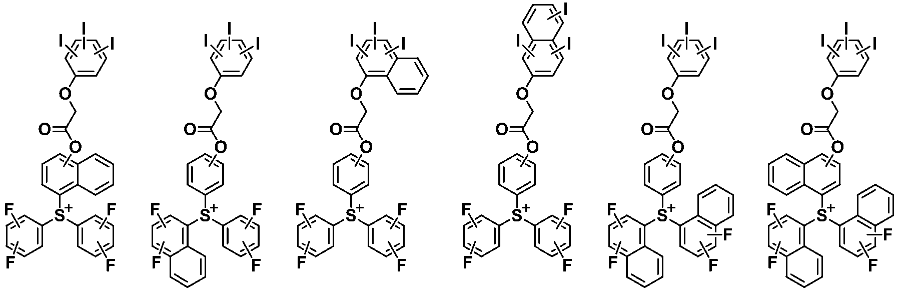

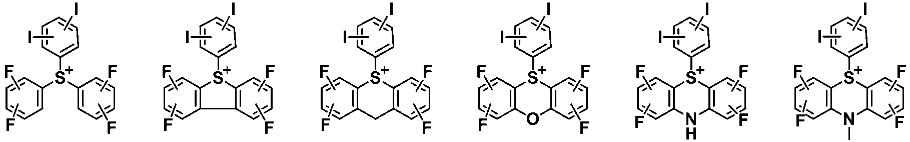

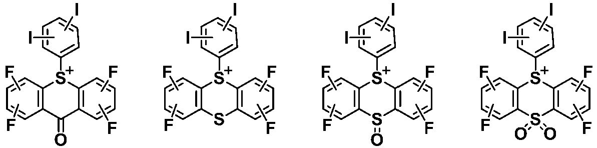

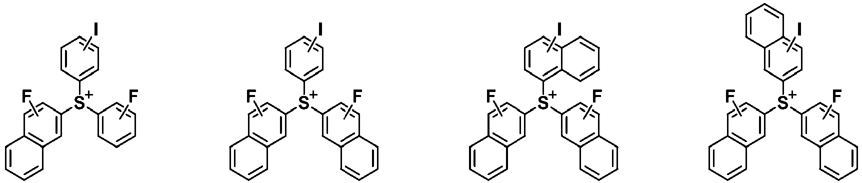

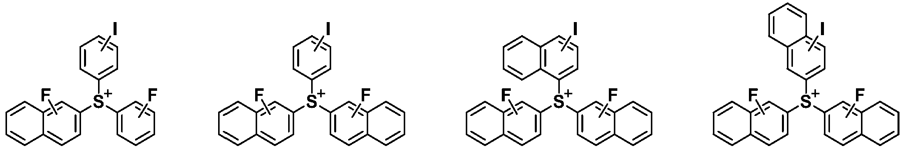

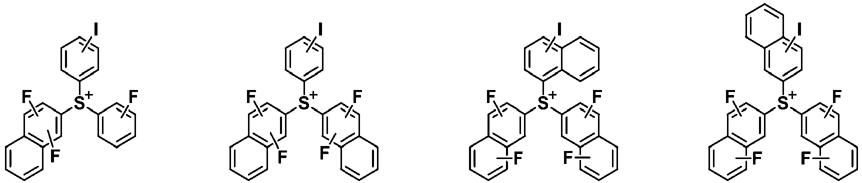

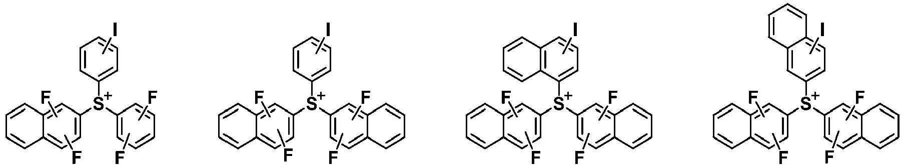

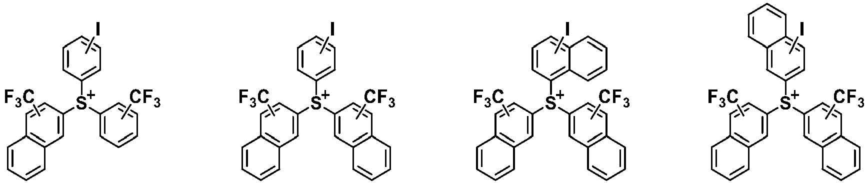

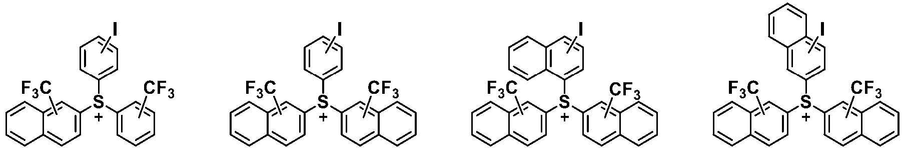

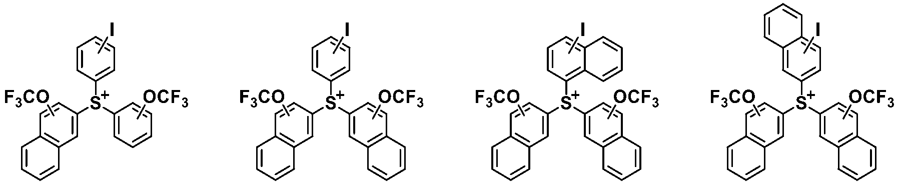

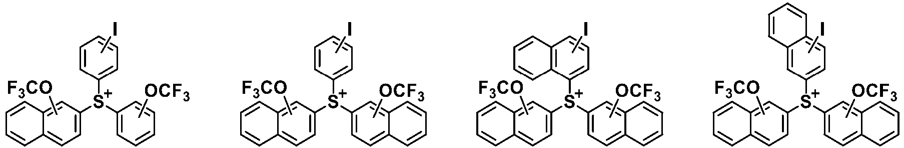

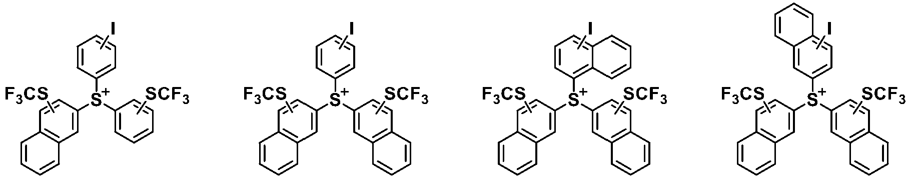

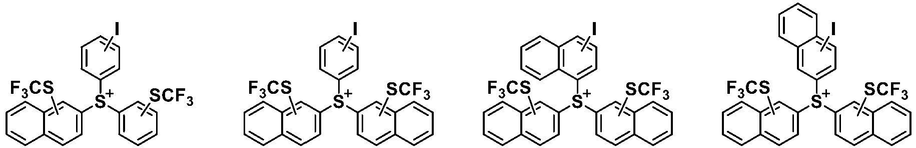

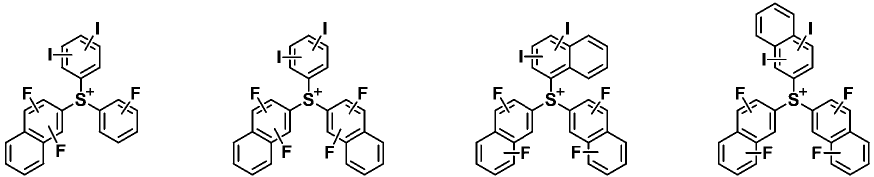

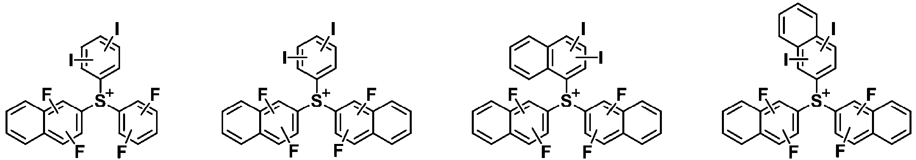

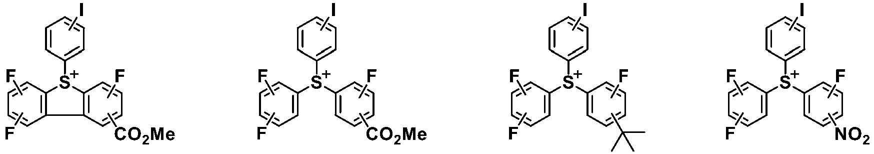

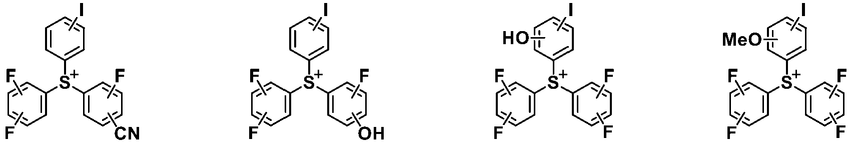

Examples of the onium salt include arbitrary combinations of anions with cations, both as exemplified above.

The onium salt having formula (A) can be synthesized by well-known methods. For example, a method of preparing an onium salt having formula (PAG-1-ex) is described.

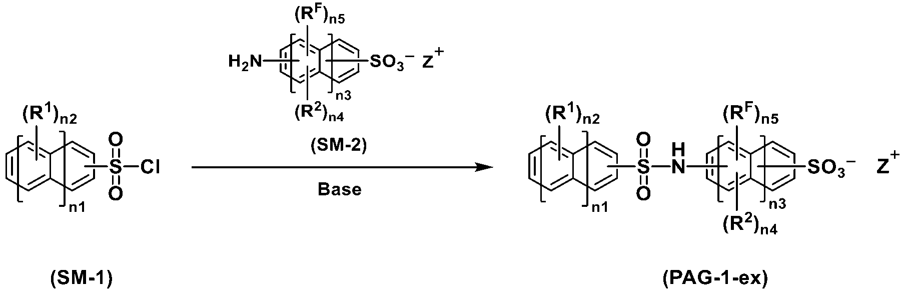

Herein n1 to n5, R¹, R², R^{F}, and Z⁺ are as defined above.

The reaction scheme shown herein is to prepare an aromatic sulfonic acid onium salt PAG-1-ex by sulfonamidation reaction of a reactant SM-1 with an amino aromatic sulfonic acid salt SM-2. The reaction can be carried out by the standard method. A solvent is typically used in the reaction. Examples of the solvent include ethers such as tetrahydrofuran (THF), diethyl ether, diisopropyl ether, di-n-butyl ether, and 1,4-dioxane, hydrocarbons such as n-hexane, n-heptane, benzene, toluene, and xylene, aprotic polar solvents such as acetonitrile, dimethyl sulfoxide (DMSO) and N,N-dimethylformamide (DMF), and chlorine organic solvents such as methylene chloride, chloroform and carbon tetrachloride. Any of these solvents may be chosen depending on reaction conditions while they may be used alone or in admixture of two or more. The preferred procedure includes adding reactant SM-1, amino aromatic sulfonic acid salt SM-2, and a base to the solvent sequentially or simultaneously and heating or cooling if necessary. Examples of the base used in the reaction include ammonia, amines such as triethylamine, pyridine, lutidine, collidine, and N,N-dimethylaniline, hydroxides such as sodium hydroxide, potassium hydroxide, and tetramethylammonium hydroxide; and carbonate salts such as potassium carbonate and sodium hydrogencarbonate. The bases may be used alone or in admixture. It is preferred from the yield aspect to monitor the progress of reaction by silica gel thin-layer chromatography (TLC). By ordinary aqueous work-up, the onium salt PAG-1-ex is recovered from the reaction mixture. The onium salt PAG-1-ex may be purified by a standard technique such as chromatography or re-crystallization if necessary.

Since the onium salt having formula (A) is an onium salt of aromatic sulfonic acid, it generates an acid having an adequate strength upon exposure to high-energy radiation. At least one group selected from branched alkyl groups, alicyclic groups and aryl groups is included as R¹. A variety of functional groups can be introduced into the aryl group. When R¹ is an aryl group, the aryl group having a functional group is preferred. When R¹ is an aryl group which has a hydrocarbyloxycarbonyl group as the functional group, the inclusion of plural heteroatoms in the form of ester bonds is effective for reducing acid diffusion. Also when R¹ is an aryl group which has a functional group containing halogen, especially fluorine, the onium salt itself has an increased solvent solubility, contributing to an improvement in uniform dispersion. In addition, the acidity of generated sulfonic acid is increased, promoting deprotection reaction of protective groups on the base polymer, and an improvement in resolution is expectable. When R¹ is an aryl group having a branched alkyl group or alicyclic group, the anion has a large excluded volume, takes a bulky structure, and generates an acid with low diffusivity, contributing to an improvement in LER. Also, a plurality of aromatic rings in the anion contribute to improved compatibility due to their interaction (π-π stacking interaction) with aromatic rings in the base polymer, and an effect of restraining excessive acid diffusion is expectable. Since the nitrogen atom inherent to the sulfonamide bond is reduced in basicity by the electron withdrawing effect of the adjoining sulfone bond, it is insufficient to trap protons of the generated acid. Since the sulfonamide bond has a plurality of heteroatoms, a lone pair and proton form a hydrogen bond, restraining excessive acid diffusion. Owing to these effects, an acid with adequate strength and controlled diffusion is generated and distributed in the resist film uniformly. Then, a chemically amplified negative resist composition comprising the inventive onium salt can form small-size patterns with satisfactory resolution and reduced LER. When the negative resist composition is developed in an alkaline developer, patterns of rectangular profile are formed due to adequate dissolution inhibition.

In the chemically amplified negative resist composition, the amount of the photoacid generator (A) is preferably 0.1 to 40 parts by weight, more preferably 1 to 20 parts by weight per 80 parts by weight of a base polymer (B) to be described just below. As long as the amount of photoacid generator (A) is in the range, an acid is generated in an amount necessary for deprotection of acid labile groups. In addition, the composition has storage stability. The photoacid generator (A) may be used alone or in admixture of two or more. (B) Base polymer

The resist composition further comprises (B) a base polymer containing a polymer comprising repeat units having the formula (B1). Notably, the polymer is referred to as polymer B and the repeat units are referred to as units B1, hereinafter. The repeat units B1 are effective for providing etch resistance, adhesion to substrates, and solubility in alkaline developer.

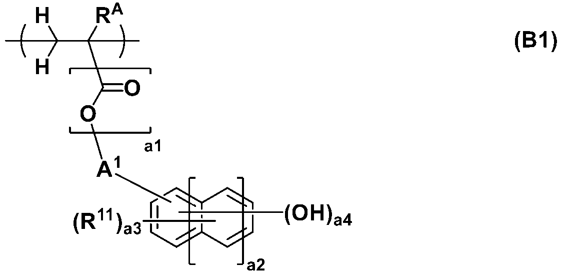

In formula (B1), a1 is 0 or 1. The subscript a2 is 0, 1 or 2. The relevant structure is a benzene ring when a2=0, a naphthalene ring when a2=1, and an anthracene ring when a2=2. The subscript a3 is an integer meeting 0 ≤ a3 ≤ 5+2(a2)-a4, and a4 is 1, 2 or 3. When a2 is 0, preferably a3 is 0, 1, 2 or 3 and a4 is 1, 2 or 3. When a2 is 1 or 2, preferably a3 is 0, 1, 2, 3 or 4 and a4 is 1, 2 or 3.

In formula (B1), R^{A} is hydrogen, fluorine, methyl or trifluoromethyl.

In formula (B1), R¹¹ is halogen, nitro, carboxy, an optionally halogenated C₁-C₆ saturated hydrocarbyl group, optionally halogenated C₁-C₆ saturated hydrocarbyloxy group or optionally halogenated C₂-C₈ saturated hydrocarbylcarbonyloxy group. The saturated hydrocarbyl group and saturated hydrocarbyl moiety in the saturated hydrocarbyloxy and saturated hydrocarbylcarbonyloxy groups may be straight, branched or cyclic. Examples thereof include alkyl groups such as methyl, ethyl, n-propyl, isopropyl, butyl, pentyl, hexyl, and structural isomers thereof; cycloalkyl groups such as cyclopropyl, cyclobutyl, cyclopentyl and cyclohexyl; and combinations thereof. A carbon count within the upper limit ensures a satisfactory solubility in alkaline developer. A plurality of R¹¹ may be identical or different when a3 is 2 or more.

In formula (B1), A¹ is a single bond or C₁-C₁₀ saturated hydrocarbylene group in which some constituent -CH₂- may be replaced by -O-. The saturated hydrocarbylene group may be straight, branched or cyclic and examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of a1=1 in formula (B1), the ether bond may be incorporated at any position excluding the position between the α- and β-carbons relative to the ester oxygen. In case of a1=0, the atom bonding to the backbone becomes an ether oxygen atom, and a second ether bond may be incorporated at any position excluding the position between the α- and β-carbons relative to the ether oxygen. Saturated hydrocarbylene groups having no more than 10 carbon atoms are desirable because of a sufficient solubility in alkaline developer.

Preferred examples of the repeat units B1 wherein a1=0 and A¹ is a single bond (meaning that the aromatic ring is directly bonded to the backbone of the polymer), that is, repeat units free of a linker: -C(=O)-O-A¹- include units derived from 3-hydroxystyrene, 4-hydroxystyrene, 5-hydroxy-2-vinylnaphthalene, and 6-hydroxy-2-vinylnaphthalene. More preferred are repeat units having the formula (B1-1): 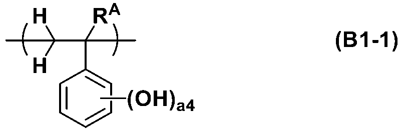 wherein R^{A} and a4 are as defined above.

Preferred examples of the repeat units B1 wherein a1=1, that is, having a linker: -C(=O)-O-A¹- are shown below, but not limited thereto. Herein R^{A} is as defined above.

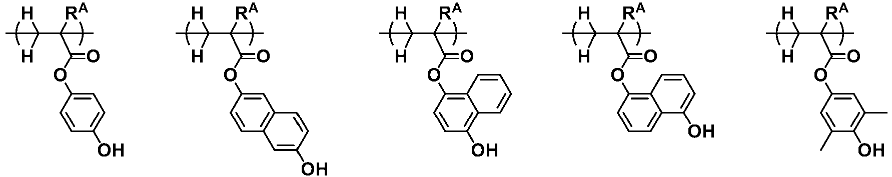

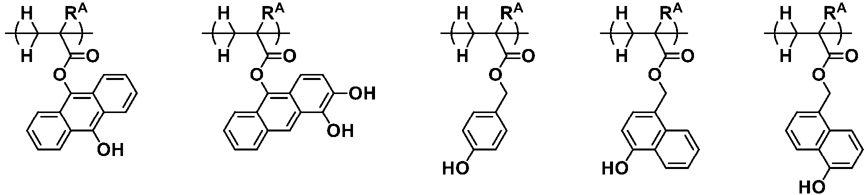

The repeat units B1 may be of one type or a combination of plural types.

The polymer B may further comprise repeat units of at least one type selected from repeat units having the formula (B2) and repeat units having the formula (B3). Notably the repeat units having formulae (B2) and (B3) are simply referred to as repeat units B2 and B3. Of the polymers B, a polymer further comprising repeat units B2 and/or B3 is referred to as polymer B'.

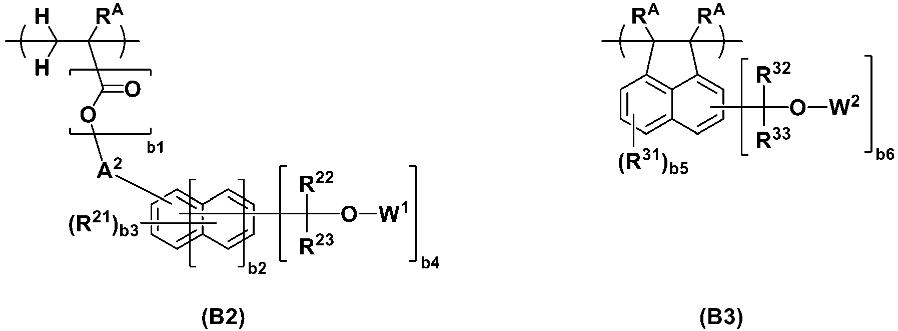

Upon exposure to high-energy radiation, the repeat unit B2 or B3 functions such that -O-W¹ or -O-W² undergoes elimination reaction under the action of an acid which is generated by the acid generator. That is, the unit B2 or B3 induces insolubilization in alkaline developer and crosslinking reaction between polymer molecules. The repeat unit B2 or B3 provides for efficient progress of negative-working reaction, leading to an improvement in resolution performance.

In formula (B2), b1 is 0 or 1, b2 is 0, 1 or 2, b3 is an integer in the range: 0 ≤ b3 ≤ 5+2(b2)-b4, and b4 is 1, 2 or 3.

In formula (B3), b5 is 0, 1 or 2, preferably 0 or 1, and b6 is 1 or 2, preferably 1.

In formulae (B2) and (B3), R^{A} is hydrogen, fluorine, methyl or trifluoromethyl. In formula (B3), R^{A} is preferably hydrogen or methyl, more preferably hydrogen.

In formula (B2), R²¹ is halogen or a C₁-C₂₀ hydrocarbyl group which may contain a heteroatom. Suitable halogen atoms include fluorine, chlorine, bromine and iodine. The C₁-C₂₀ hydrocarbyl group may be saturated or unsaturated and straight, branched or cyclic, and examples thereof are as exemplified above for the hydrocarbyl group R² in formula (A). When b3 is 2 or more, a plurality of R²¹ may be identical or different.

In formula (B2), R²² and R²³ are each independently hydrogen, a C₁-C₁₅ saturated hydrocarbyl group or a C₆-C₁₅ aryl group. The hydrocarbyl group may be substituted with a hydroxy moiety or C₁-C₆ saturated hydrocarbyloxy moiety and the aryl group may be substituted. It is excluded that R²² and R²³ are hydrogen at the same time. R²² and R²³ may bond together to form a ring with the carbon atom to which they are attached, in which some -CH₂- may be replaced by -O- or -S-. R²² and R²³ are preferably selected from alkyl groups such as methyl, ethyl, propyl, butyl and structural isomers thereof, and substituted forms of the foregoing alkyl groups in which some hydrogen is substituted by a hydroxy or saturated hydrocarbyloxy moiety. When b4 is 2 or 3, a plurality of R²² may be identical or different. When b4 is 2 or 3, a plurality of R²³ may be identical or different.

In formula (B3), R³¹ is halogen or a C₁-C₂₀ hydrocarbyl group which may contain a heteroatom. Suitable halogen atoms include fluorine, chlorine, bromine and iodine. The C₁-C₂₀ hydrocarbyl group may be saturated or unsaturated and straight, branched or cyclic. Examples thereof are as exemplified above for the hydrocarbyl group R² in formula (A). When b5 is 2, a plurality of R³¹ may be identical or different.

In formula (B3), R³² and R³³ are each independently hydrogen, a C₁-C₁₅ saturated hydrocarbyl group or a C₆-C₁₅ aryl group. The hydrocarbyl group may be substituted with a hydroxy or C₁-C₆ saturated hydrocarbyloxy moiety and the aryl group may be substituted. When b6 is 2, a plurality of R³² may be identical or different. When b6 is 2, a plurality of R³³ may be identical or different.

The C₁-C₁₅ saturated hydrocarbyl groups R³² and R³³ may be straight, branched or cyclic, and examples thereof are as exemplified above for the hydrocarbyl groups R²² and R²³.

Examples of the C₆-C₁₅ aryl groups R³² and R³³ include phenyl, naphthyl and anthryl, with phenyl being preferred. The aryl group may have a substituent, examples of which include halogen, optionally halogenated C₁-C₆ saturated hydrocarbyl moieties, and optionally halogenated C₁-C₆ saturated hydrocarbyloxy moieties.

It is excluded that R³² and R³³ are hydrogen at the same time. When one of R³² and R³³ is an optionally substituted aryl group, the preferred substituent on the other of R³² and R³³ is hydrogen.

Preferably R³² and R³³ are identical, more preferably both methyl.

R³² and R³³ may bond together to form a ring with the carbon atom to which they are attached. In the ring, some -CH₂- may be replaced by -O- or -S-. Examples of the ring include cyclopropane, cyclobutene, cyclopentane, cyclohexane, norbornane, adamantane, tricyclo[5.2.1.0^{2,6}]decane, tetracyclo[6.2.1.1^{3,6}.0^{2,7}]dodecane, oxanorbornane, and thianorbornane rings, but are not limited thereto.

In formula (B2), A² is a single bond or C₁-C₁₀ saturated hydrocarbylene group in which some constituent -CH₂- may be replaced by -O-. The saturated hydrocarbylene group may be straight, branched or cyclic and examples thereof include alkanediyl groups such as methylene, ethane-1,2-diyl, propane-1,3-diyl, butane-1,4-diyl, pentane-1,5-diyl, hexane-1,6-diyl, and structural isomers thereof; cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of b1=1 in formula (B2), the ether bond may be incorporated at any position excluding the position between the α- and β-carbons relative to the ester oxygen. In case of b1=0, the atom bonding to the backbone becomes an ether oxygen atom, and a second ether bond may be incorporated at any position excluding the position between the α- and β-carbons relative to the ether oxygen.

In formulae (B2) and (B3), W¹ and W² are each independently hydrogen, a C₁-C₁₀ aliphatic hydrocarbyl group, C₂-C₁₀ aliphatic hydrocarbylcarbonyl group, or an optionally substituted C₆-C₁₅ aryl group.

The C₁-C₁₀ aliphatic hydrocarbyl groups W¹ and W² may be saturated or unsaturated and straight, branched or cyclic. Examples thereof include C₁-C₁₀ alkyl groups such as methyl, ethyl, n-propyl, isopropyl, n-butyl, isobutyl, sec-butyl, tert-butyl, n-pentyl, neopentyl, n-hexyl, n-heptyl, n-octyl, 2-ethylhexyl, n-nonyl, and n-decyl; C₃-C₁₀ cyclic saturated hydrocarbyl groups such as cyclopentyl and cyclohexyl; C₂-C₁₀ alkenyl groups such as vinyl, 1-propenyl, 2-propenyl, butenyl and hexenyl; and C₃-C₁₀ cyclic unsaturated hydrocarbyl groups such as cyclohexenyl. The hydrocarbyl moiety in the C₂-C₁₀ aliphatic hydrocarbylcarbonyl groups W¹ and W² may be saturated or unsaturated and straight, branched or cyclic, and examples thereof include those illustrated above for the C₁-C₁₀ aliphatic hydrocarbyl groups W¹ and W², but of 1 to 9 carbon atoms. Examples of the aryl groups W¹ and W² include phenyl, naphthyl and anthryl, with phenyl being preferred. The aryl group may have a substituent, examples of which include halogen, optionally halogenated C₁-C₆ saturated hydrocarbyl moieties, and optionally halogenated C₁-C₆ saturated hydrocarbyloxy moieties. When b4 is 2 or 3, a plurality of W¹ may be identical or different. When b6 is 2 or 3, a plurality of W² may be identical or different.

Of the repeat units B2, repeat units having formula (B2-1) or (B2-2) are preferred. 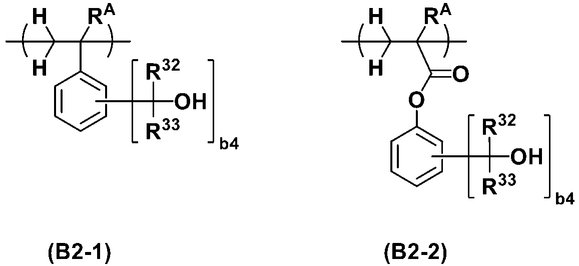 Herein b4, R^{A}, R²², and R²³ are as defined above.

Preferred examples of the repeat unit B2 are given below, but not limited thereto. Herein R^{A} is as defined above.

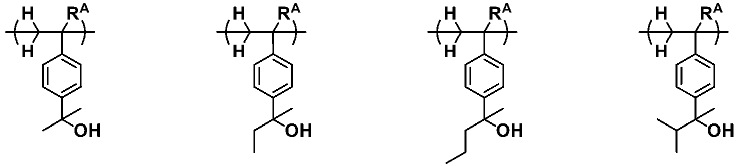

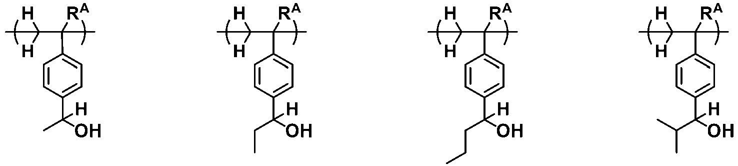

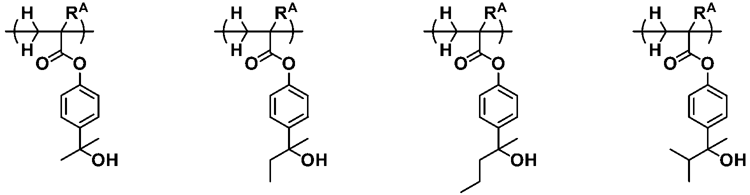

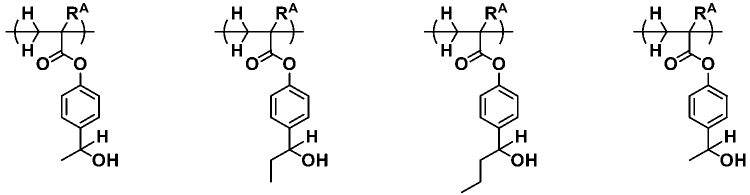

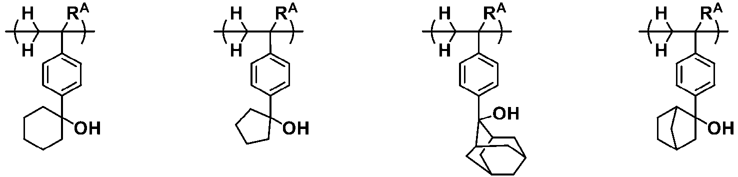

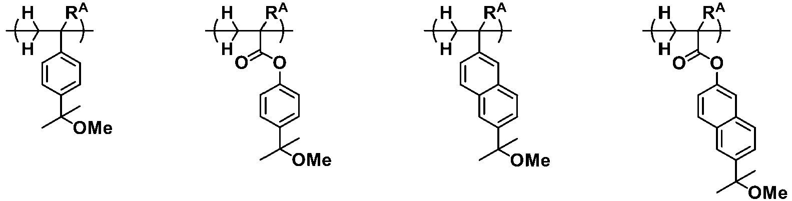

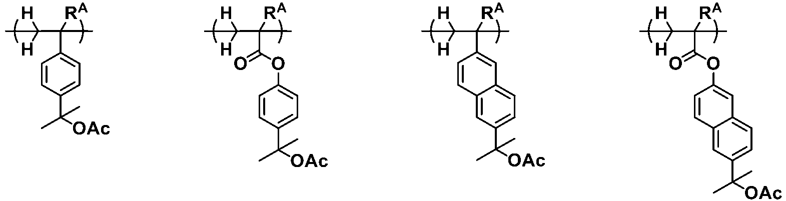

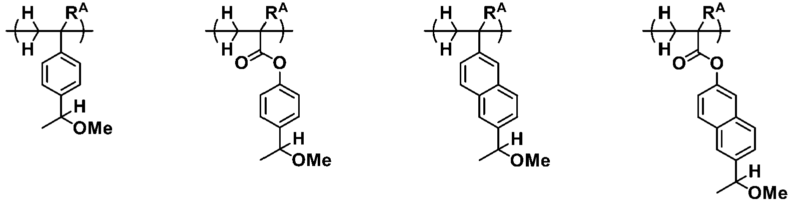

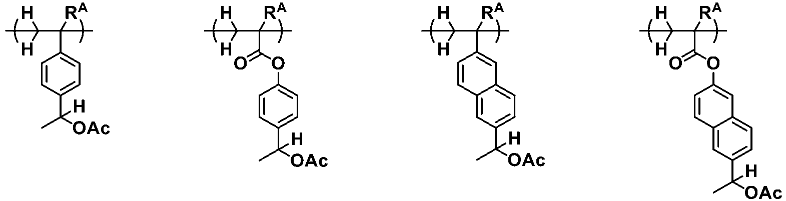

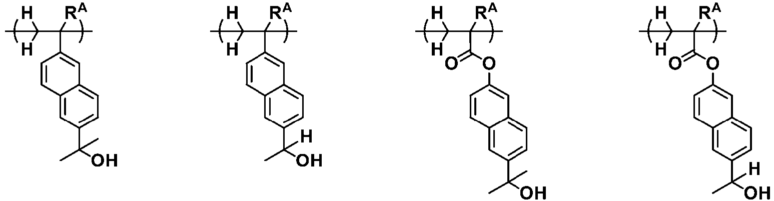

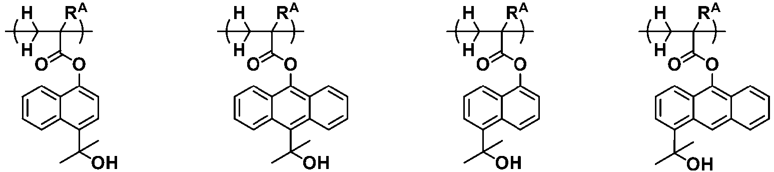

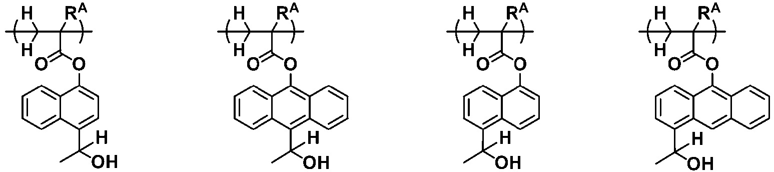

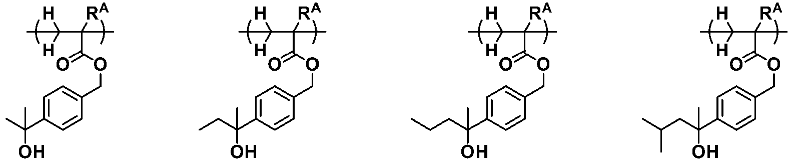

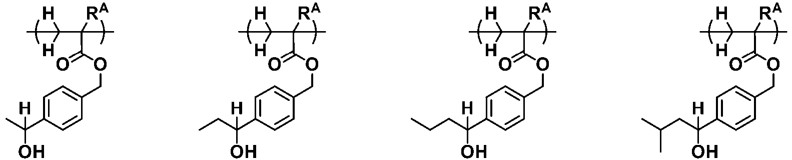

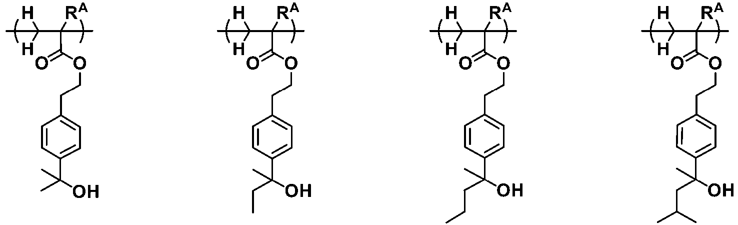

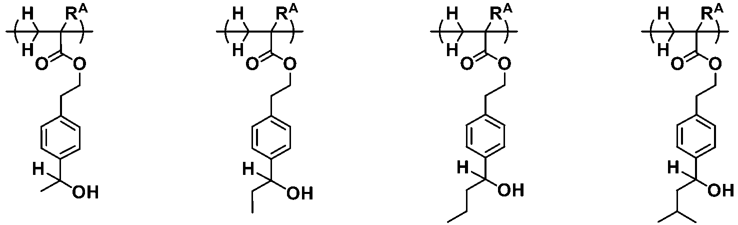

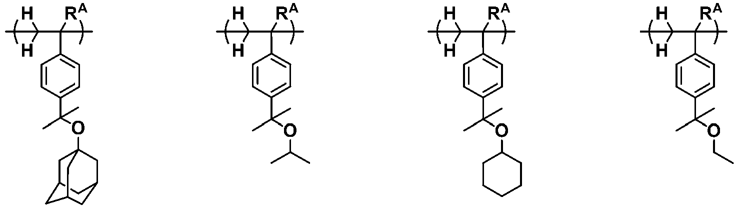

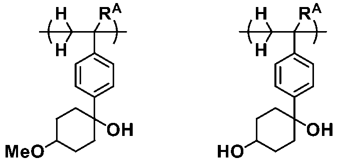

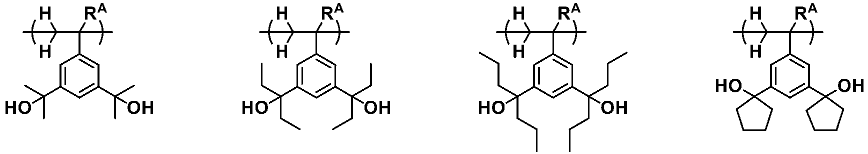

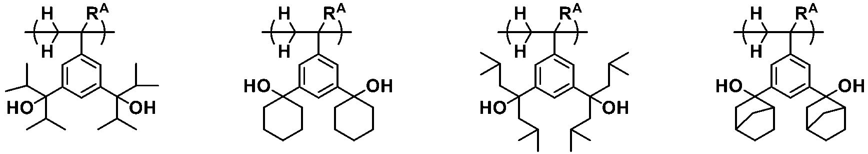

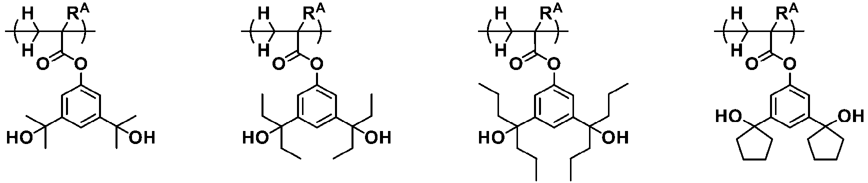

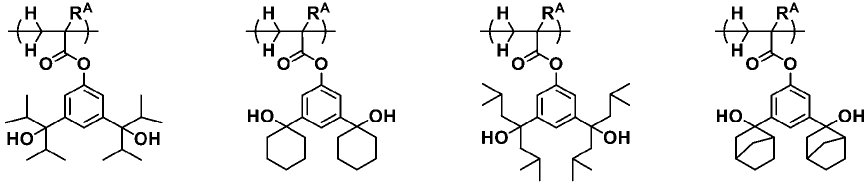

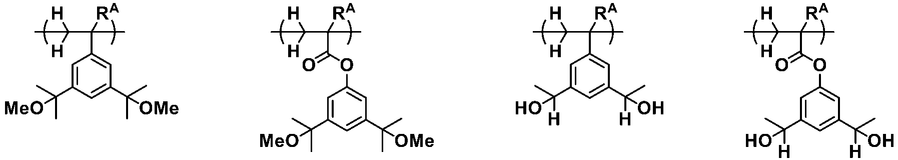

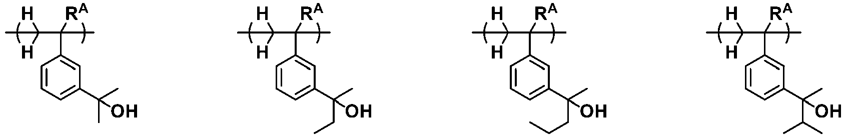

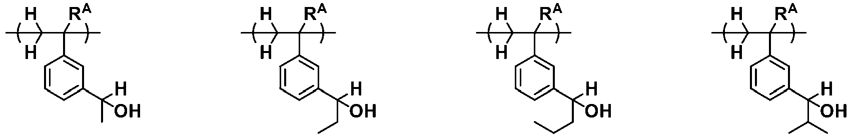

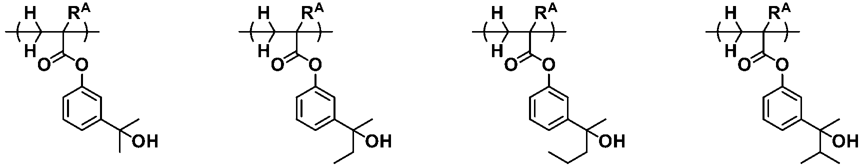

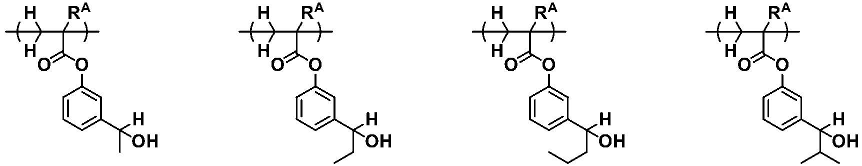

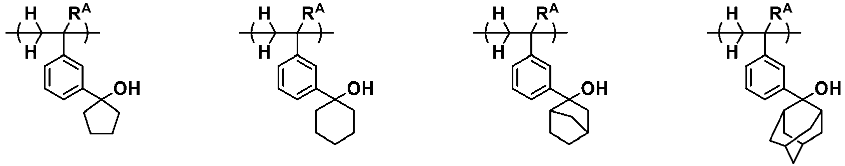

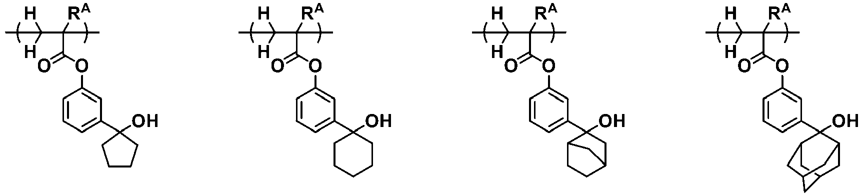

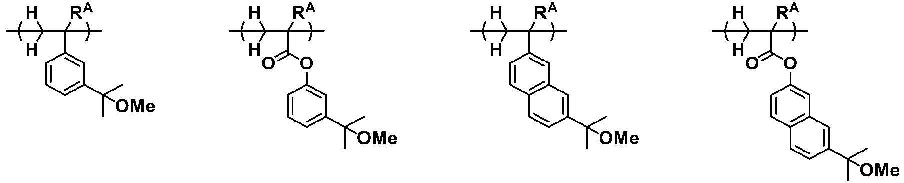

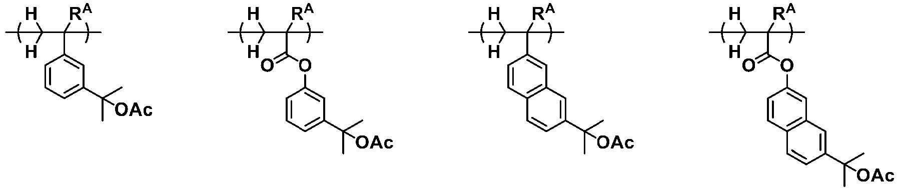

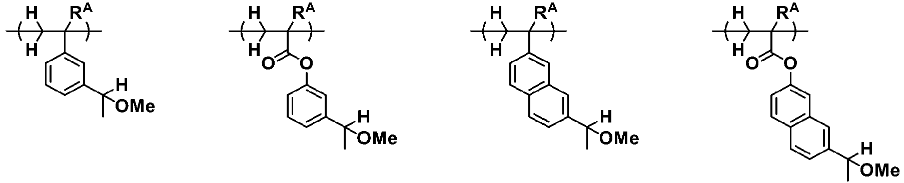

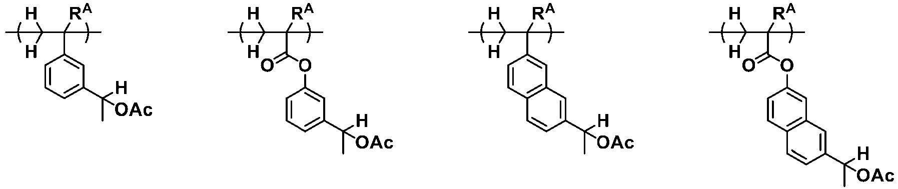

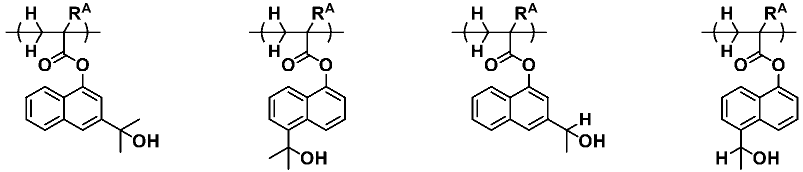

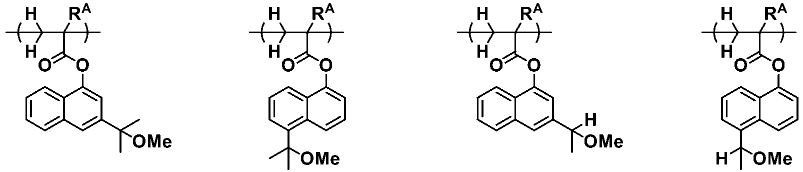

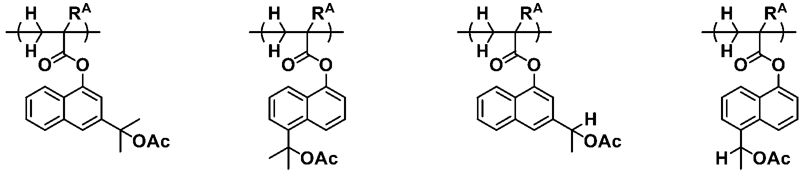

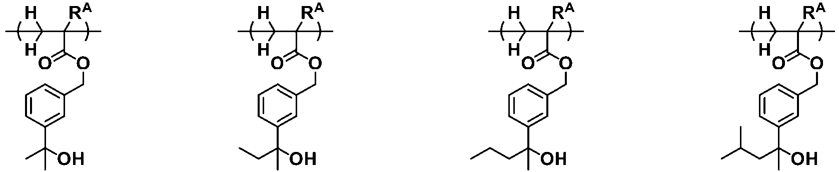

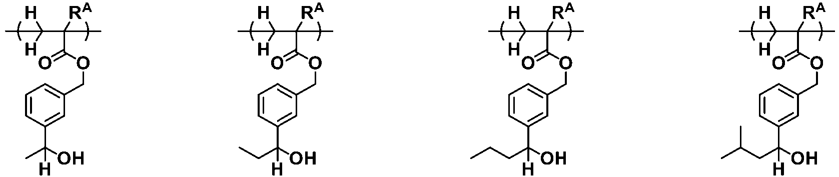

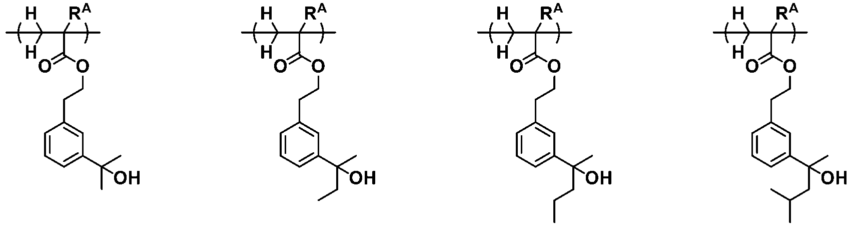

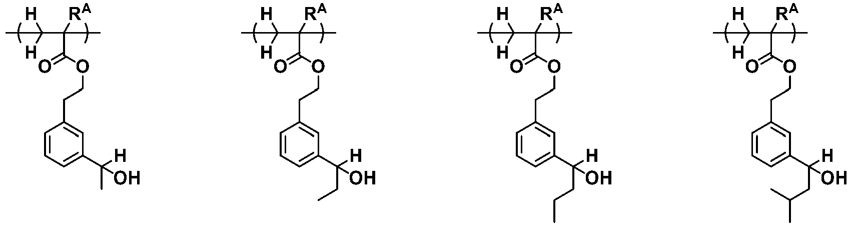

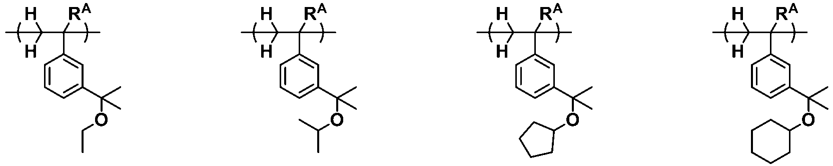

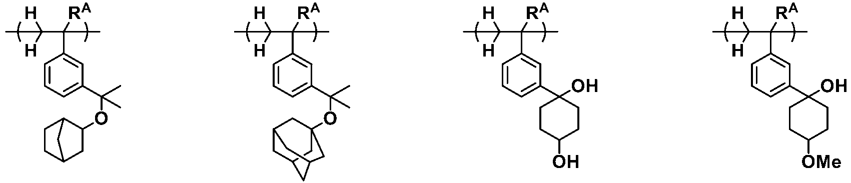

The repeat unit B2 may be of one type or a combination of plural types.

Of the repeat units B3, repeat units having formula (B3-1) are preferred. 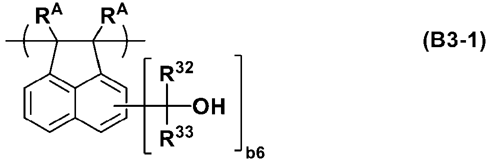 Herein b6, R^{A}, R³², and R³³ are as defined above.

Preferred examples of the repeat unit B3 are given below, but not limited thereto. Herein R^{A} is as defined above.

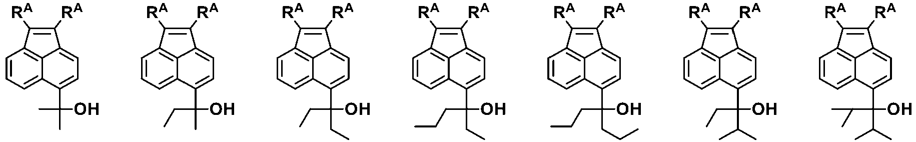

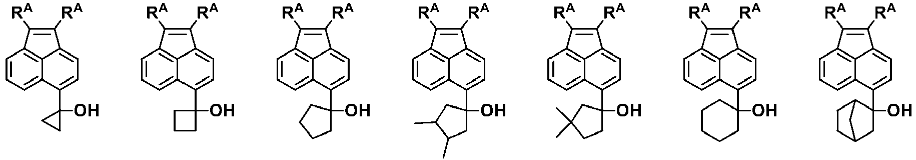

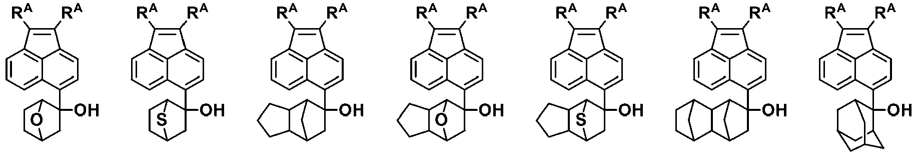

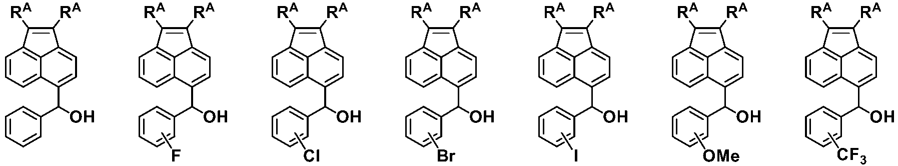

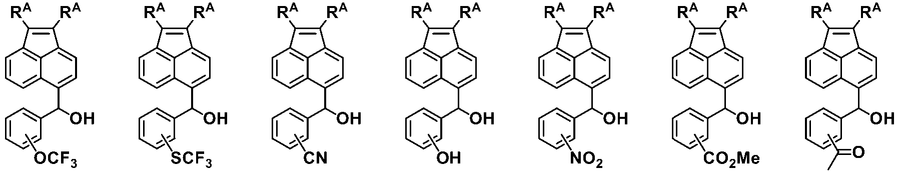

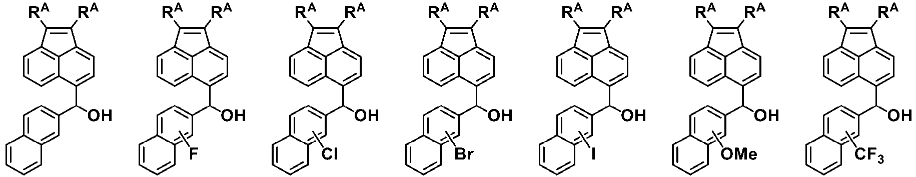

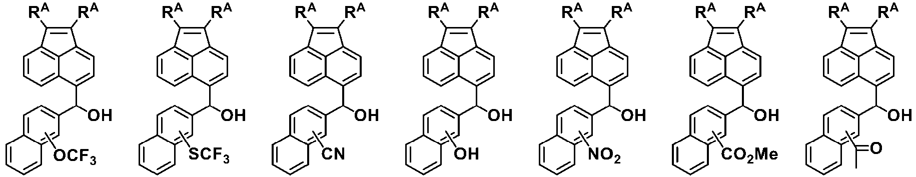

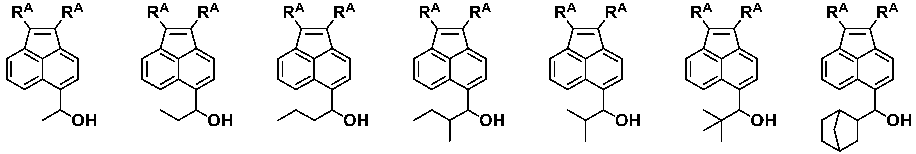

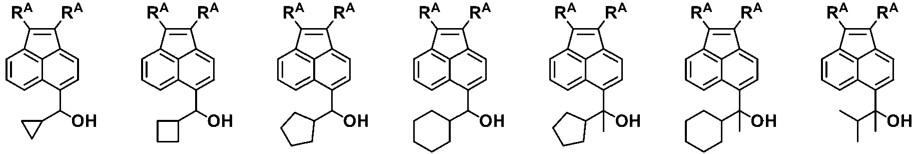

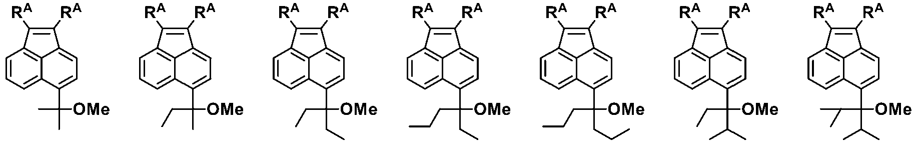

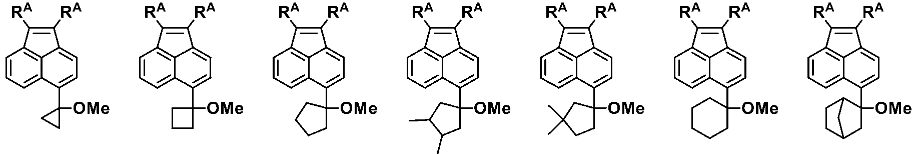

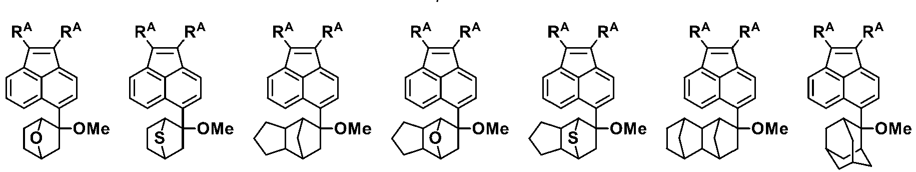

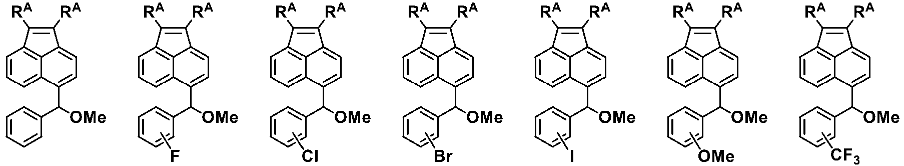

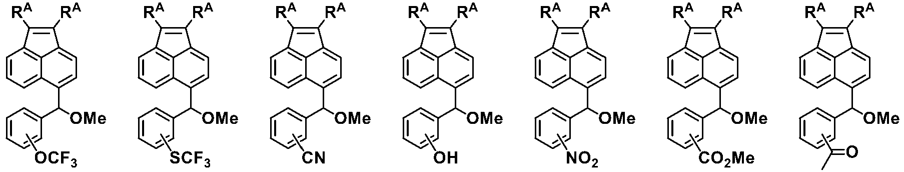

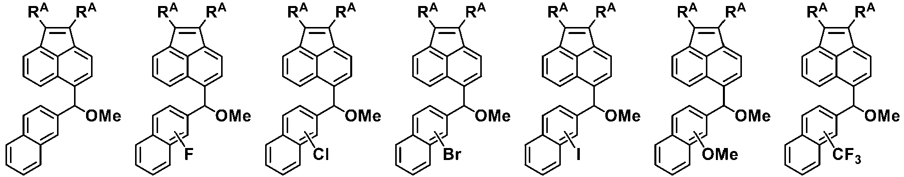

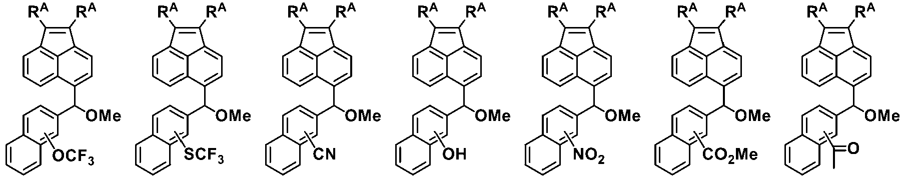

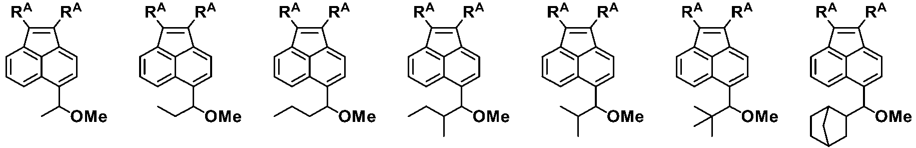

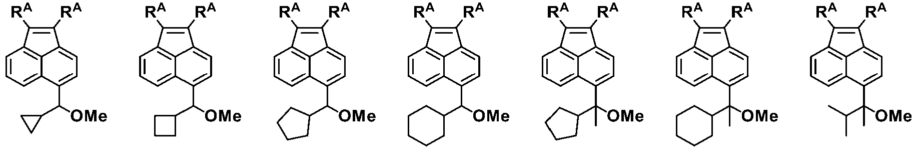

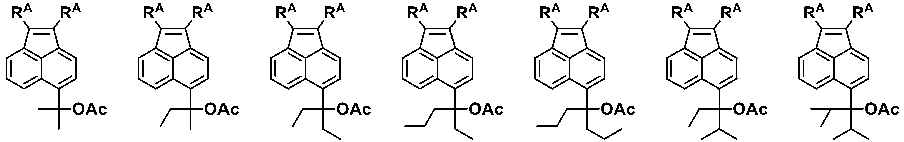

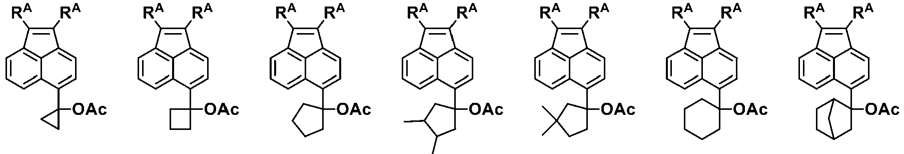

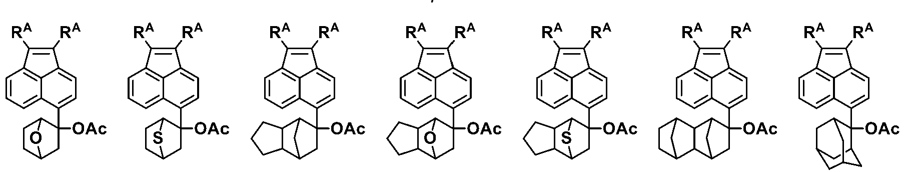

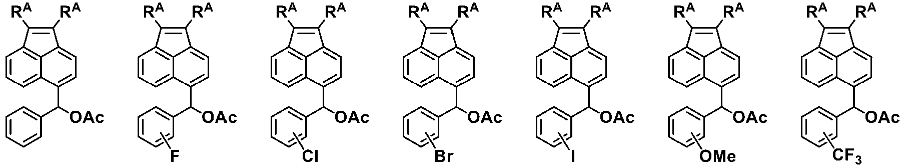

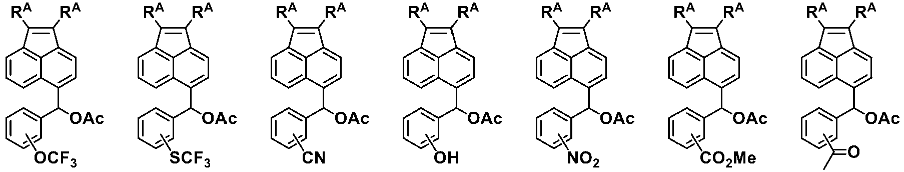

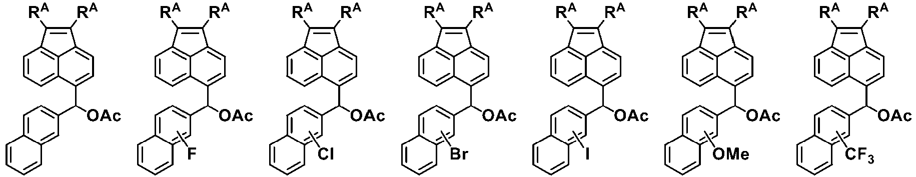

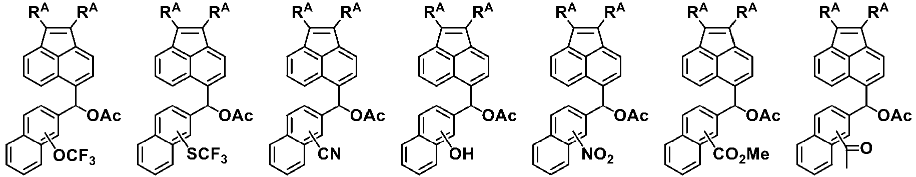

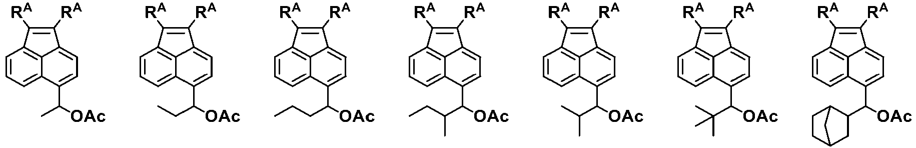

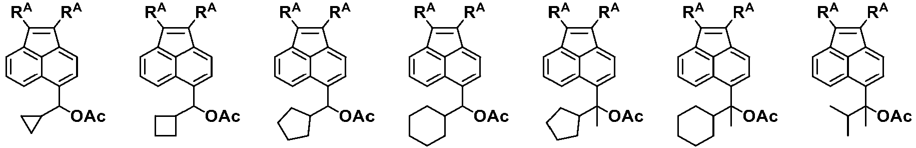

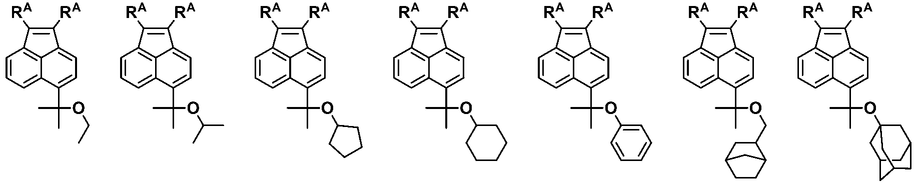

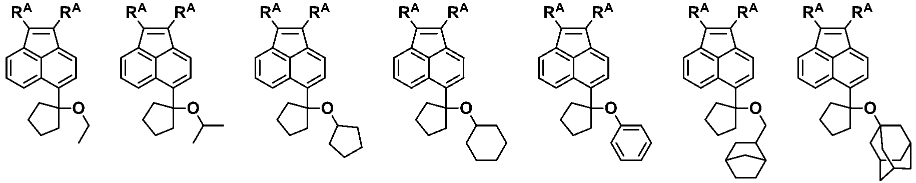

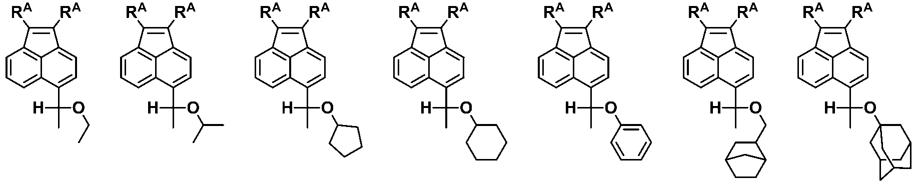

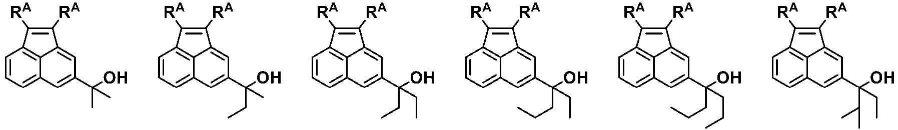

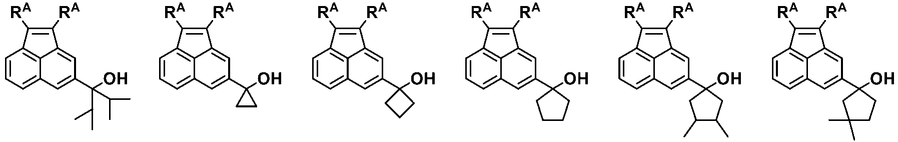

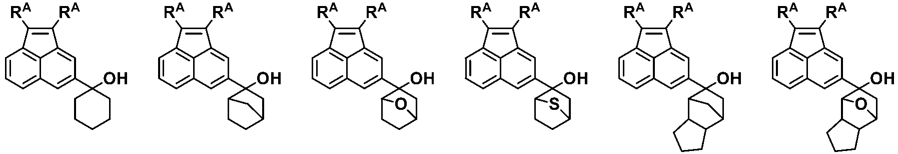

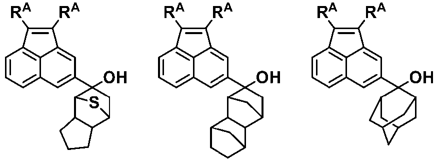

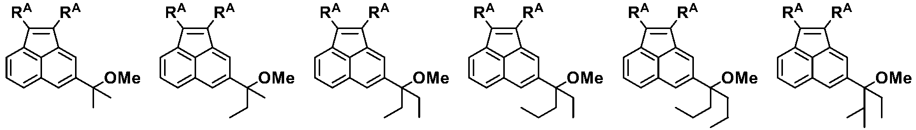

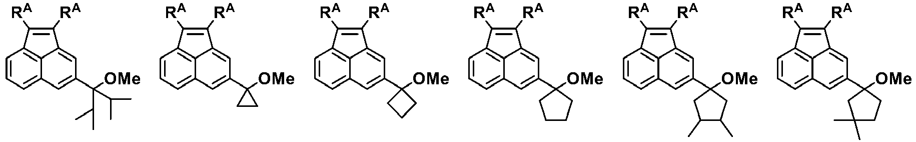

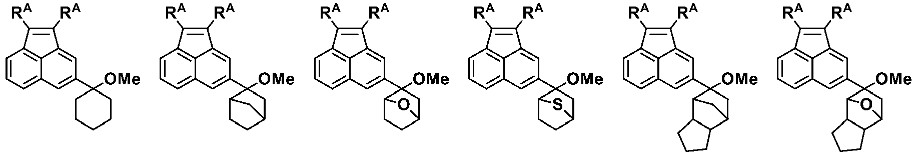

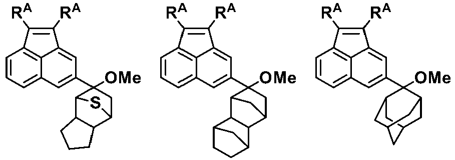

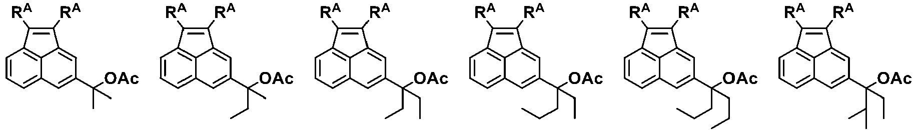

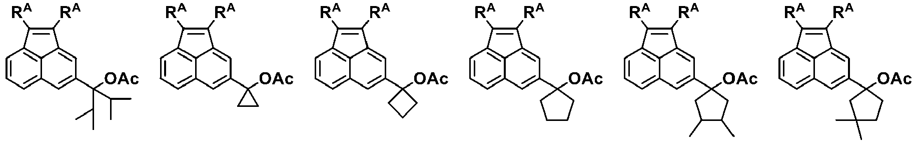

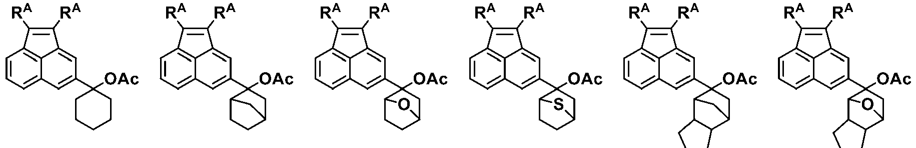

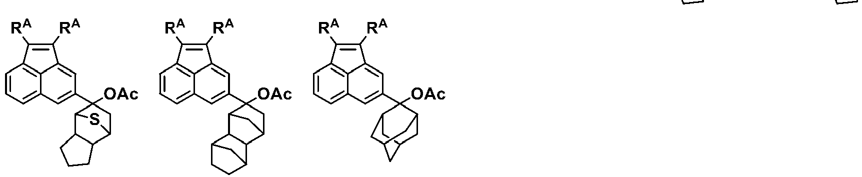

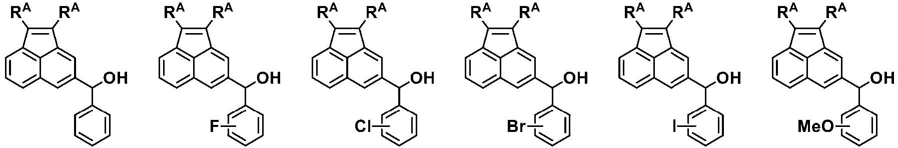

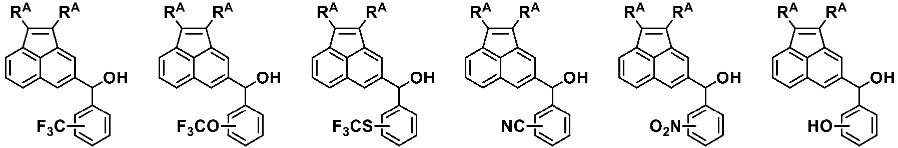

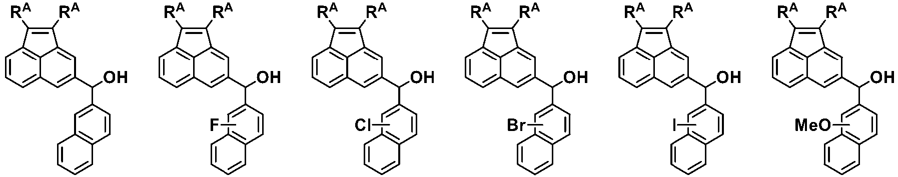

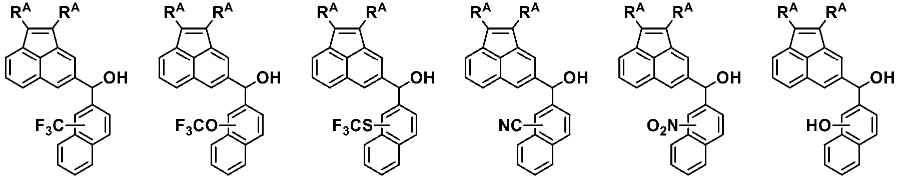

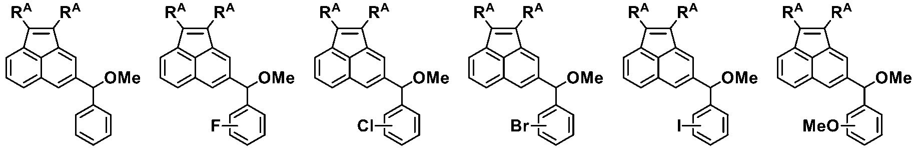

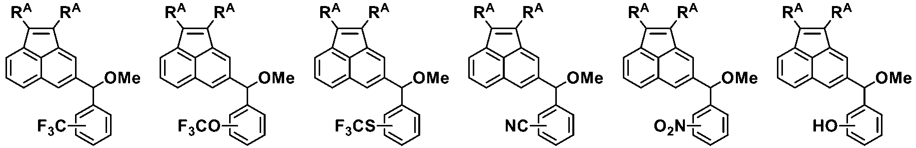

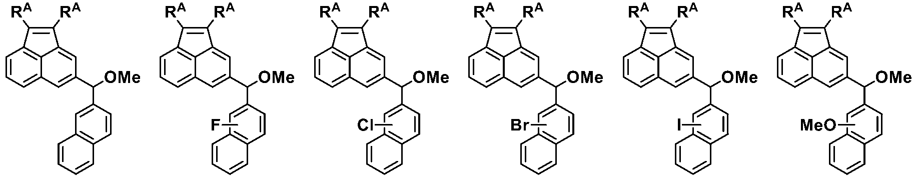

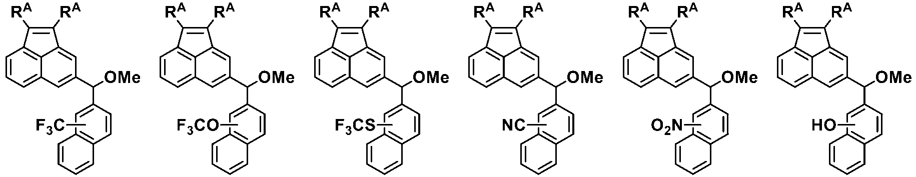

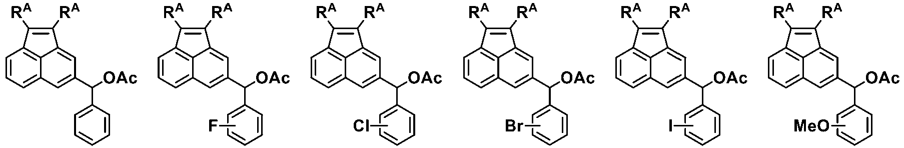

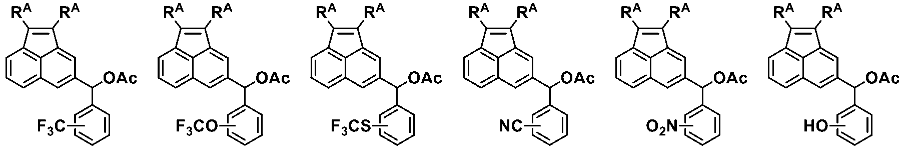

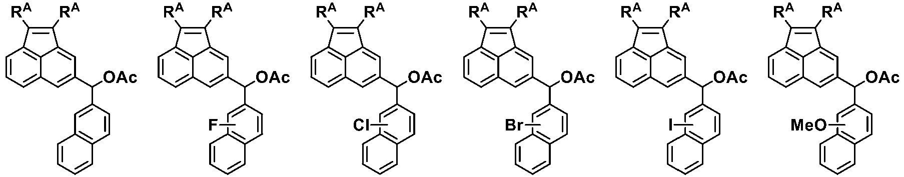

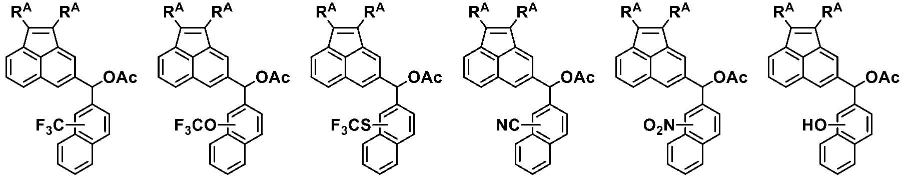

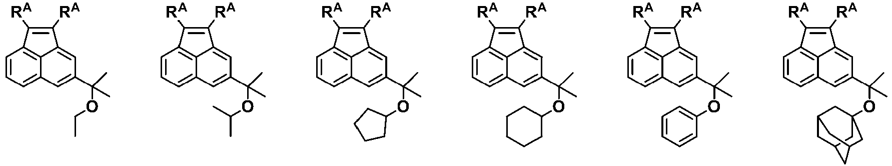

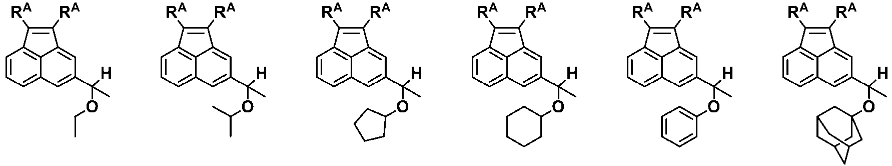

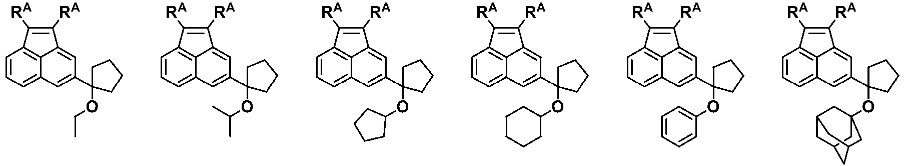

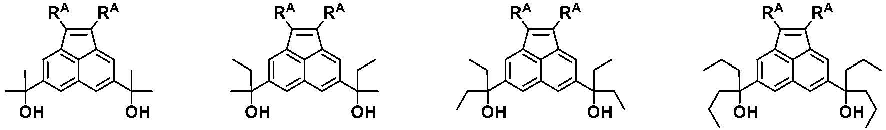

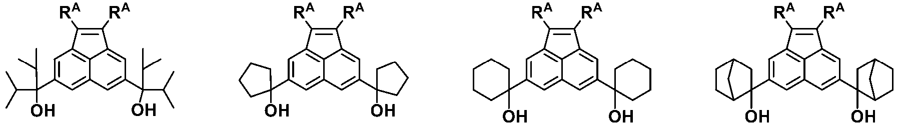

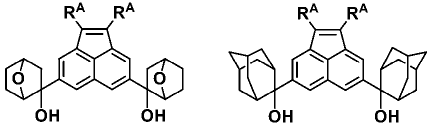

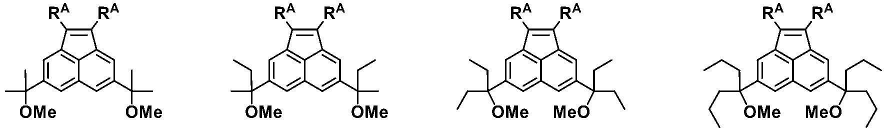

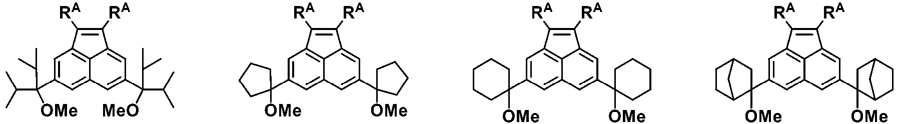

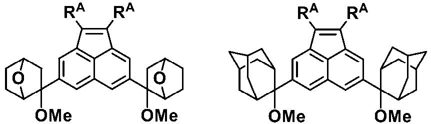

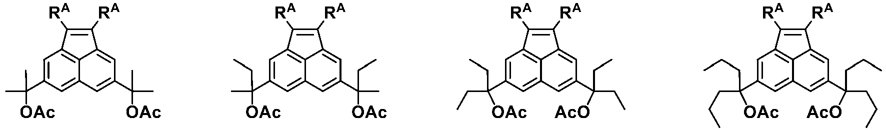

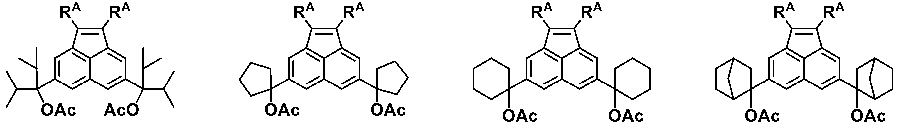

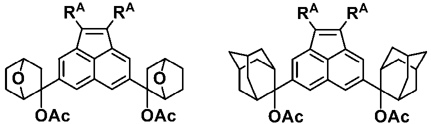

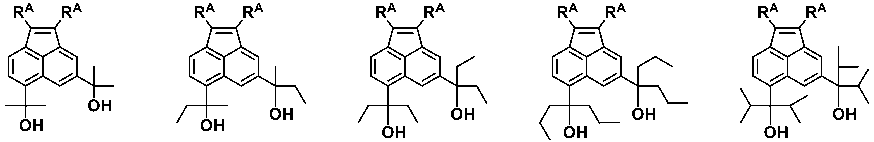

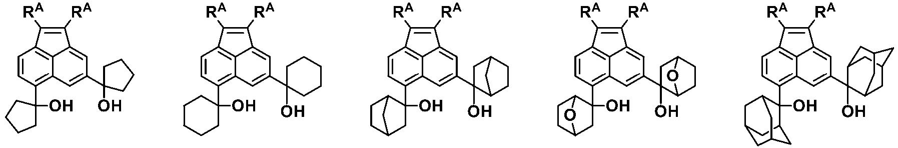

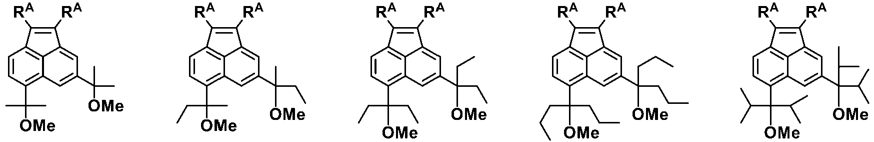

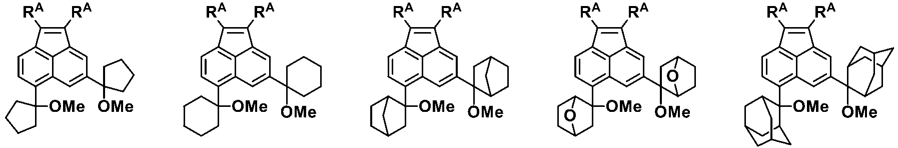

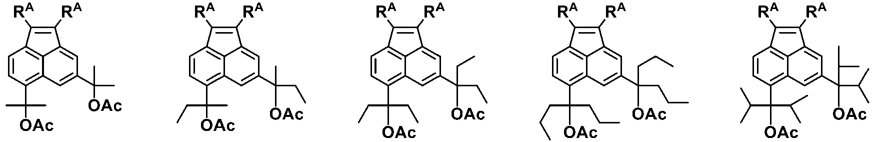

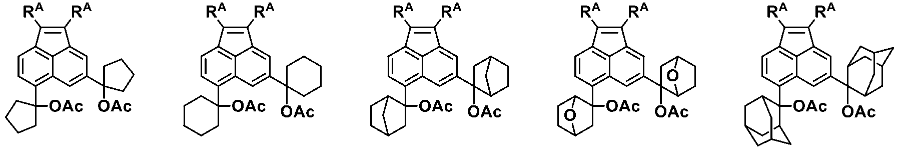

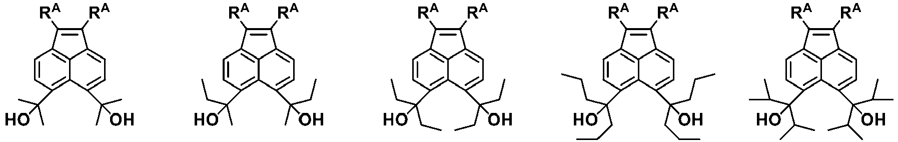

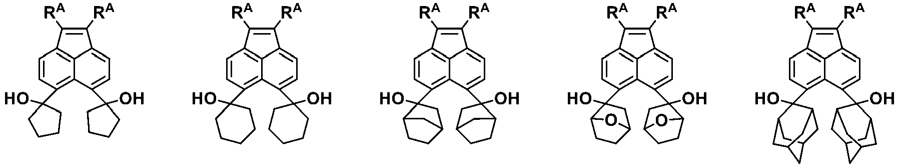

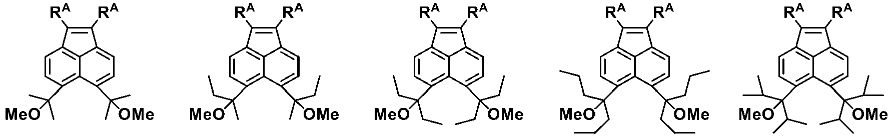

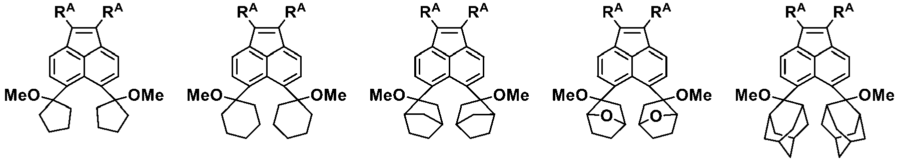

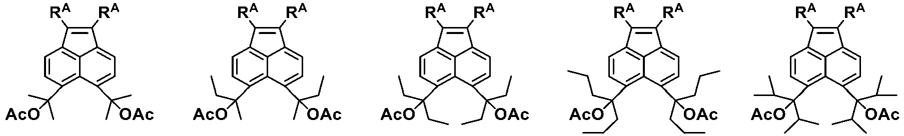

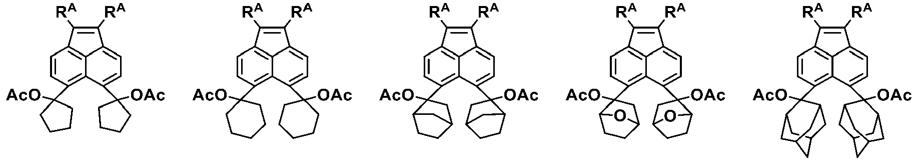

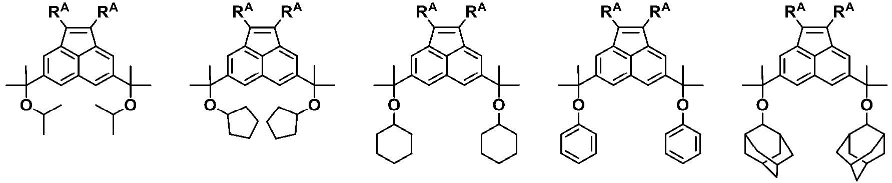

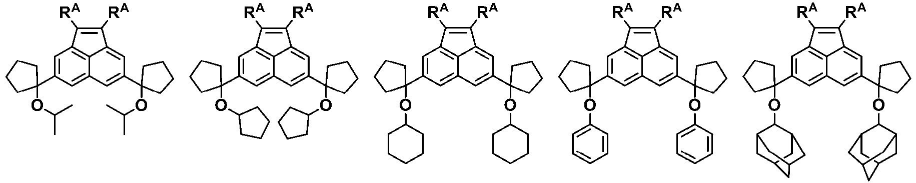

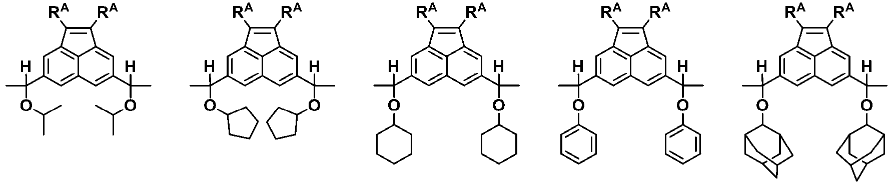

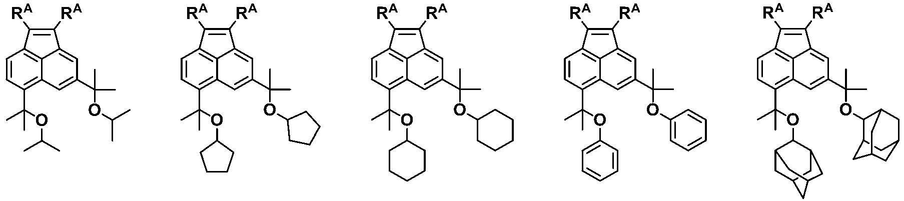

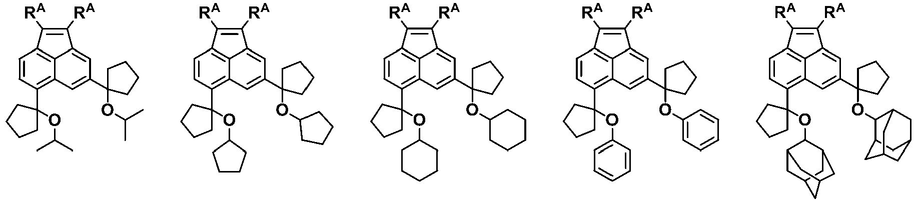

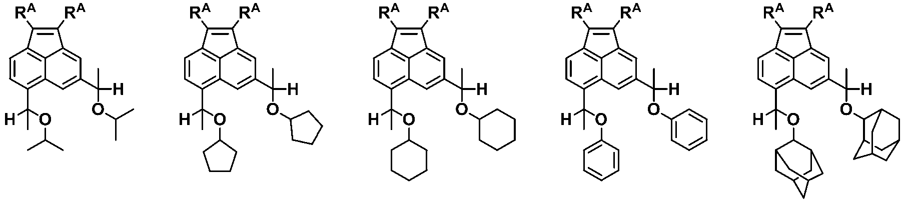

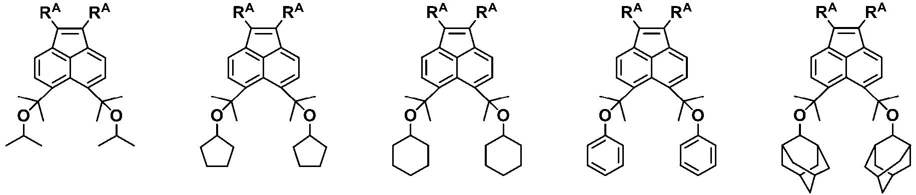

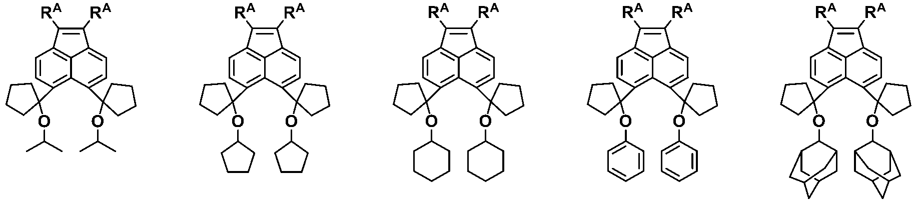

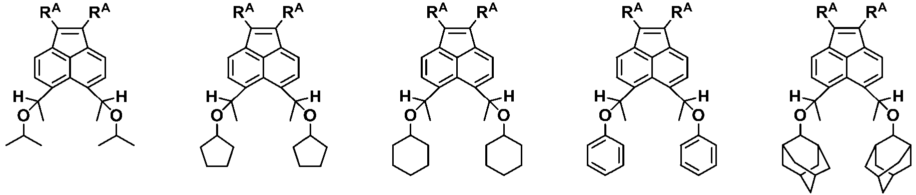

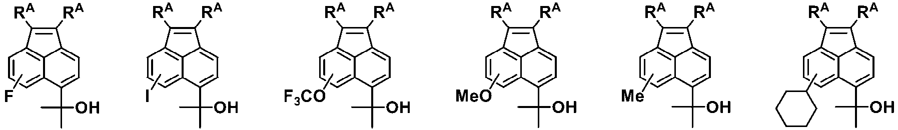

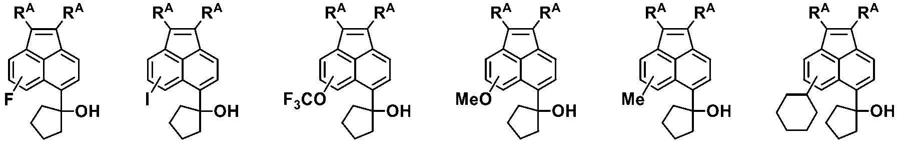

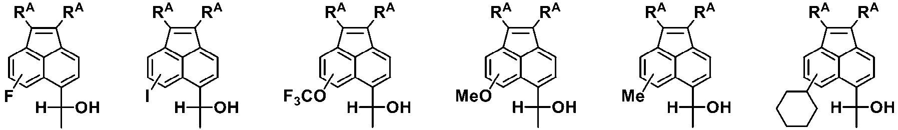

The repeat unit B3 may be of one type or a combination of plural types.

For the purpose of improving etch resistance, preferably the polymer B or B' further comprises repeat units of at least one type selected from repeat units having the formula (B4), repeat units having the formula (B5) and repeat units having the formula (B6). Notably these units are simply referred to as repeat units B4, B5 and B6.

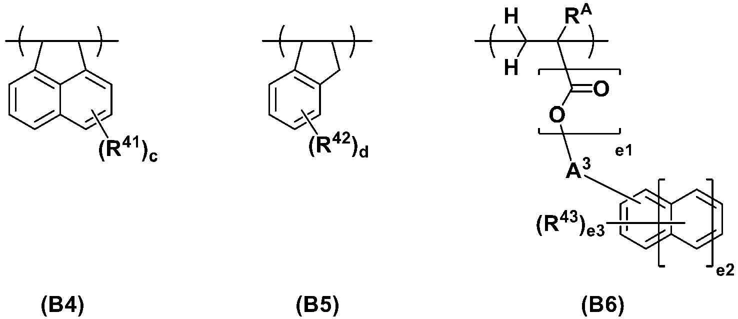

In formulae (B4) and (B5), c and d are each independently 0, 1, 2, 3 or 4.

In formulae (B4) and (B5), R⁴¹ and R⁴² are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group. The saturated hydrocarbyl group, saturated hydrocarbyloxy group, and saturated hydrocarbylcarbonyloxy group may be straight, branched or cyclic. When c is 2, 3 or 4, a plurality of R⁴¹ may be identical or different. When d is 2, 3 or 4, a plurality of R⁴² may be identical or different.

In formula (B6), e1 is 0 or 1. The subscript e2 is 0, 1 or 2; the corresponding structure represents a benzene skeleton when e2=0, a naphthalene skeleton when e2=1, and an anthracene skeleton when e2=2. The subscript e3 is 0, 1, 2, 3, 4 or 5. When e2=0, e3 is preferably 0, 1, 2 or 3. When e2=1 or 2, e3 is preferably 0, 1, 2, 3 or 4.

In formula (B6), R^{A} is hydrogen, fluorine, methyl or trifluoromethyl.

In formula (B6), R⁴³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen atom, nitro group, cyano group, C₁-C₂₀ saturated hydrocarbylsulfinyl group, or C₁-C₂₀ saturated hydrocarbylsulfonyl group. The saturated hydrocarbyl group, saturated hydrocarbyloxy group, saturated hydrocarbylcarbonyloxy group, saturated hydrocarbyloxyhydrocarbyl group, saturated hydrocarbylthiohydrocarbyl group, saturated hydrocarbylsulfinyl group, and saturated hydrocarbylsulfonyl group may be straight, branched or cyclic. When e3 is 2, 3, 4 or 5, a plurality of R⁴³ may be identical or different.

R⁴³ is preferably selected from halogen atoms such as chlorine, bromine and iodine; saturated hydrocarbyl groups such as methyl, ethyl, propyl, butyl, pentyl, hexyl, cyclopentyl, cyclohexyl, and structural isomers thereof; and saturated hydrocarbyloxy groups such as methoxy, ethoxy, propoxy, butoxy, pentyloxy, hexyloxy, cyclopentyloxy, cyclohexyloxy, and structural isomers of their hydrocarbon moiety. Inter alia, methoxy and ethoxy are most useful.

The saturated hydrocarbylcarbonyloxy group may be readily introduced into a polymer even after polymerization, by a chemical modification method and is advantageously utilized for fine adjustment of the solubility of the polymer in alkaline developer. Examples of the saturated hydrocarbylcarbonyloxy group include methylcarbonyloxy, ethylcarbonyloxy, propylcarbonyloxy, butylcarbonyloxy, pentylcarbonyloxy, hexylcarbonyloxy, cyclopentylcarbonyloxy, cyclohexylcarbonyloxy, benzoyloxy, and structural isomers of their hydrocarbon moiety. As long as the carbon count is equal to or less than 20, an appropriate effect of controlling or adjusting (typically reducing) the solubility of the polymer in alkaline developer is obtainable, and the generation of scum or development defects may be suppressed.

Of the foregoing preferred substituent groups, such substituent groups as chlorine, bromine, iodine, methyl, ethyl and methoxy are useful because the corresponding monomers may be readily prepared.

In formula (B6), A³ is a single bond or C₁-C₁₀ saturated hydrocarbylene group in which some constituent -CH₂- may be replaced by -O-. The saturated hydrocarbylene group may be straight, branched or cyclic. Examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of e1=1 in formula (B6), the ether bond may be incorporated at any position excluding the position between the α- and β-carbons relative to the ester oxygen. In case of e1=0, the atom bonding to the backbone becomes an ether oxygen atom, and a second ether bond may be incorporated at any position excluding the position between the α- and β-carbons relative to the ether oxygen. Saturated hydrocarbylene groups having no more than 10 carbon atoms are desirable because of a sufficient solubility in alkaline developer.

Preferred examples of the repeat units B6 wherein e1 is 0 and A³ is a single bond (meaning that the aromatic ring is directly bonded to the main chain of the polymer), that is, repeat units free of the linker: -C(=O)-O-A³- include units derived from styrene, 4-chlorostyrene, 4-bromostyrene, 4-methylstyrene, 4-methoxystyrene, 4-acetoxystyrene, 2-hydroxypropylstyrene, 2-vinylnaphthalene, and 3-vinylnaphthalene.

Preferred examples of the repeat units B6 wherein e1 is 1, that is, having the linker: -C(=O)-O-A³- are shown below, but not limited thereto. R^{A} is as defined above.

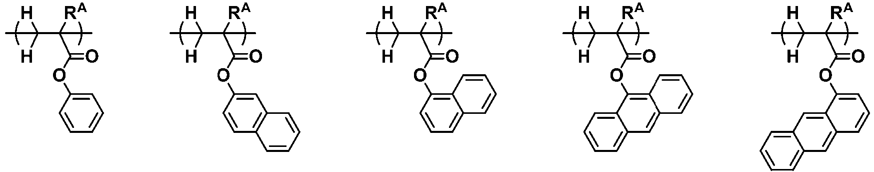

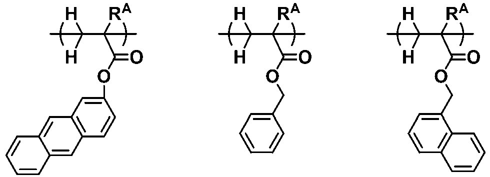

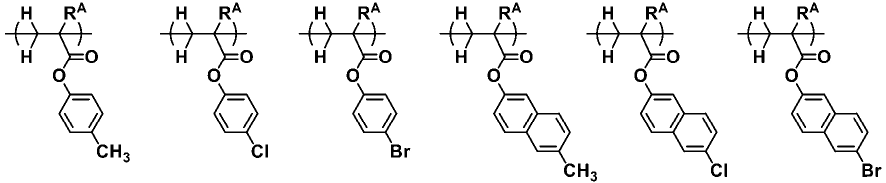

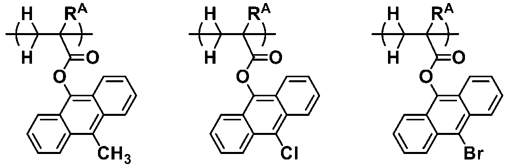

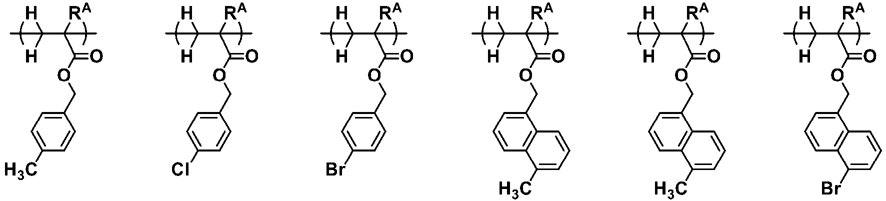

When repeat units of at least one type selected from repeat units B4 to B6 are incorporated, better performance is obtained because not only the aromatic ring possesses etch resistance, but the cyclic structure incorporated into the main chain also exerts the effect of improving resistance to etching and EB irradiation during pattern inspection step.

The repeat units B4 to B6 may be of one type or a combination of plural types.

The polymer B' may further comprise repeat units of at least one type selected from repeat units having the formula (B7), repeat units having the formula (B8), repeat units having the formula (B9), repeat units having the formula (B10), and repeat units having the formula (B11). Notably these repeat units are also referred to as repeat units B7 to B11.

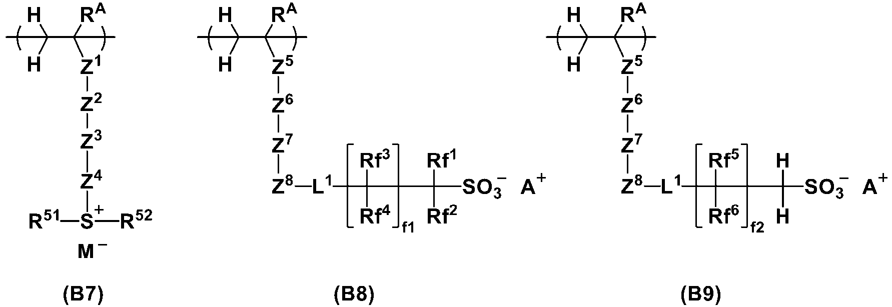

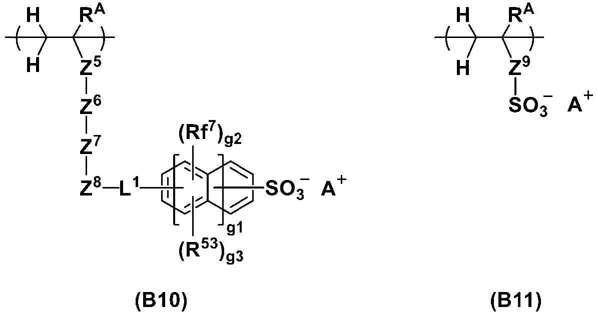

In formulae (B7) to (B11), R^{A} is each independently hydrogen, fluorine, methyl or trifluoromethyl. Z¹ is a single bond or an optionally substituted phenylene group. Z² is a single bond, **-C(=O)-O-Z²¹-, **-C(=O)-NH-Z²¹-, or **-O-Z²¹-, wherein Z²¹ is a C₁-C₆ aliphatic hydrocarbylene group, phenylene group or a divalent group obtained by combining the foregoing, which may contain halogen, carbonyl moiety, ester bond, ether bond or hydroxy moiety. Z³ is a single bond, ether bond, ester bond, amide bond, sulfonate ester bond, sulfonamide bond, carbonate bond or carbamate bond. Z⁴ is a single bond, or a C₁-C₆ aliphatic hydrocarbylene group, phenylene group or a divalent group obtained by combining the foregoing, which may contain halogen, carbonyl moiety, ester bond, ether bond or hydroxy moiety. Z⁵ is each independently a single bond, an optionally substituted phenylene, naphthylene, or *-C(=O)-O-Z⁵¹-, wherein Z⁵¹ is a C₁-C₁₀ aliphatic hydrocarbylene group which may contain halogen, hydroxy moiety, ether bond, ester bond or lactone ring, or phenylene or naphthylene group. Z⁶ is a single bond, ether bond, ester bond, amide bond, sulfonate ester bond, sulfonamide bond, carbonate bond or carbamate bond. Z⁷ is each independently a single bond, ***-Z⁷¹-C(=O)-O-, ***-C(=O)-NH-Z⁷¹-, or ***-O-Z⁷¹-, wherein Z⁷¹ is a C₁-C₂₀ hydrocarbylene group which may contain a heteroatom. Z⁸ is each independently a single bond, ****-Z⁸¹-C(=O)-O-, ****-C(=O)-NH-Z⁸¹-, or ****-O-Z⁸¹-, wherein Z⁸¹ is a C₁-C₂₀ hydrocarbylene group which may contain a heteroatom. Z⁹ is a single bond, methylene, ethylene, phenylene, fluorinated phenylene, trifluoromethyl-substituted phenylene, *-C(=O)-O-Z⁹¹-, *-C(=O)-N(H)-Z⁹¹-, or *-O-Z⁹¹-, wherein Z⁹¹ is a C₁-C₆ aliphatic hydrocarbylene group, phenylene group, fluorinated phenylene group or trifluoromethyl-substituted phenylene group, which may contain a carbonyl moiety, ester bond, ether bond or hydroxy moiety. The asterisk * designates a point of attachment to the carbon atom in the backbone, ** is a point of attachment to Z¹, *** is a point of attachment to Z⁶, and **** is a point of attachment to Z⁷.

The aliphatic hydrocarbylene group represented by Z²¹, Z⁵¹ and Z⁹¹ may be straight, branched or cyclic. Examples thereof include alkanediyl groups such as methanediyl, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, 1,1-dimethylethane-1,2-diyl, pentane-1,5-diyl, 2-methylbutane-1,2-diyl, and hexane-1,6-diyl; cycloalkanediyl groups such as cyclopropanediyl, cyclobutanediyl, cyclopentanediyl, and cyclohexanediyl; and combinations thereof.

The hydrocarbylene group which may contain a heteroatom, represented by Z⁷¹ and Z⁸¹, may be saturated or unsaturated and straight, branched or cyclic. Examples thereof are shown below, but not limited thereto. 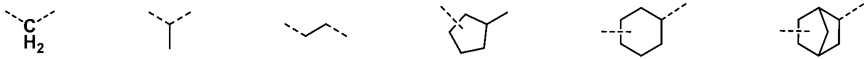 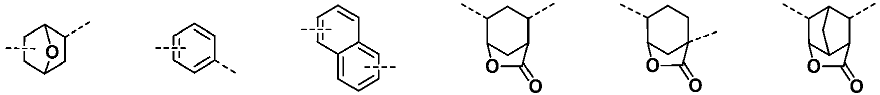 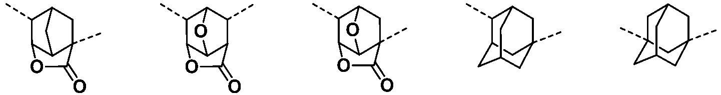 In formula (B7), R⁵¹ and R⁵² are each independently a C₁-C₂₀ hydrocarbyl group which may contain a heteroatom. The hydrocarbyl group may be saturated or unsaturated and straight, branched or cyclic. Examples thereof include C₁-C₂₀ alkyl groups such as methyl, ethyl, n-propyl, isopropyl, n-butyl, isobutyl, sec-butyl, and tert-butyl; C₃-C₂₀ cyclic saturated hydrocarbyl groups such as cyclopropyl, cyclopentyl, cyclohexyl, cyclopropylmethyl, 4-methylcyclohexyl, cyclohexylmethyl, norbornyl, and adamantyl; C₂-C₂₀ alkenyl groups such as vinyl, 1-propenyl, 2-propenyl, butenyl, and hexenyl; C₃-C₂₀ cyclic unsaturated hydrocarbyl groups such as cyclohexenyl; C₆-C₂₀ aryl groups such as phenyl, naphthyl and thienyl; C₇-C₂₀ aralkyl groups such as benzyl, 1-phenylethyl and 2-phenylethyl, and combinations thereof. Inter alia, aryl groups are preferred. In the hydrocarbyl group, some or all of the hydrogen atoms may be substituted by a moiety containing a heteroatom such as oxygen, sulfur, nitrogen or halogen and some constituent -CH₂- may be replaced by a moiety containing a heteroatom such as oxygen, sulfur or nitrogen, so that the group may contain a hydroxy, fluorine, chlorine, bromine, iodine, cyano, carbonyl, ether bond, ester bond, sulfonate ester bond, carbonate bond, lactone ring, sultone ring, carboxylic anhydride (-C(=O)-O-C(=O)-), or haloalkyl moiety.

R⁵¹ and R⁵² may bond together to form a ring with the sulfur atom to which they are attached. Examples of the ring are shown below.

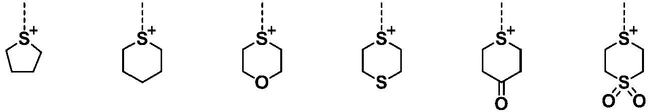

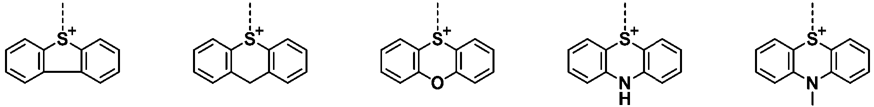

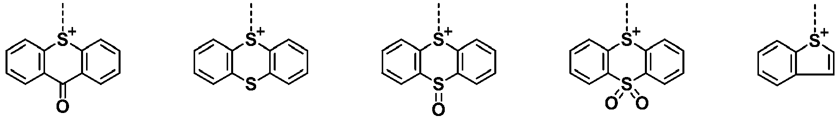

Herein the broken line designates a point of attachment to Z⁴.

Examples of the cation in repeat units B7 are shown below, but not limited thereto. Herein R^{A} is as defined above.

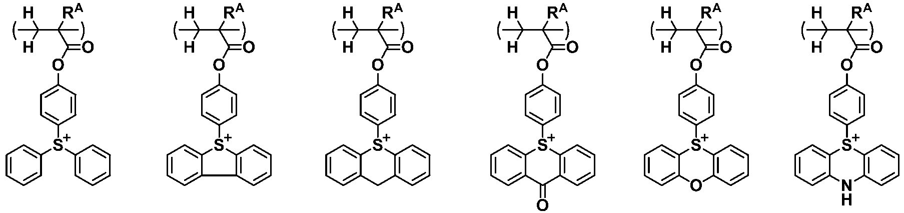

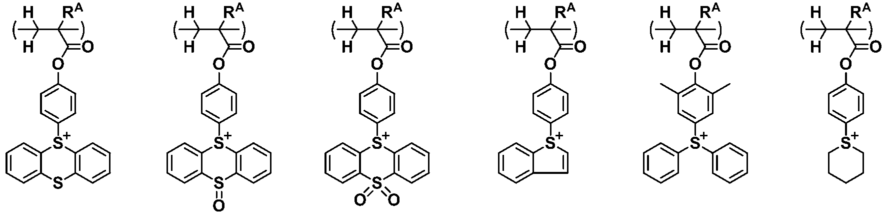

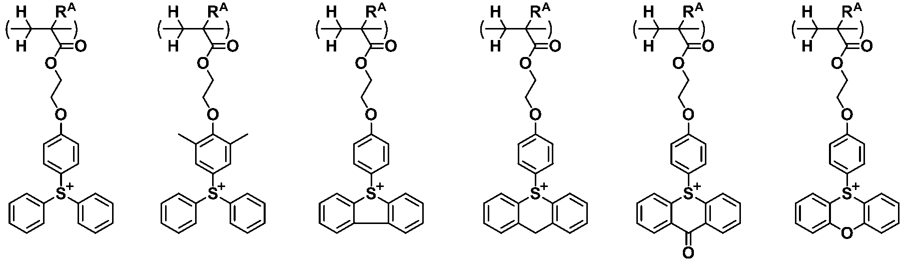

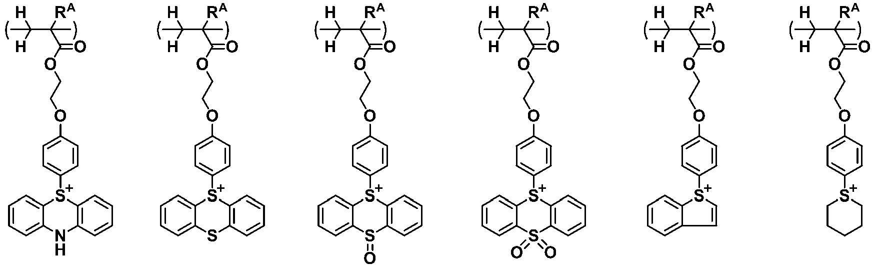

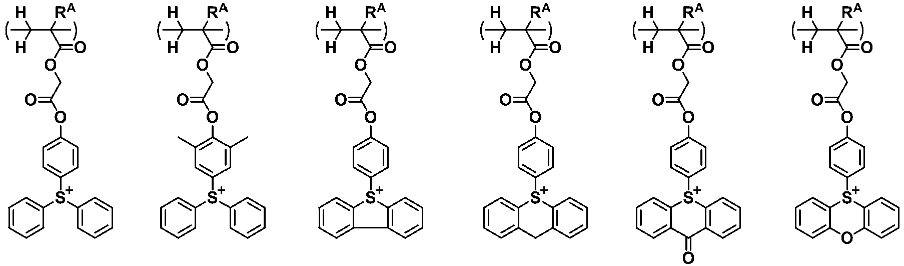

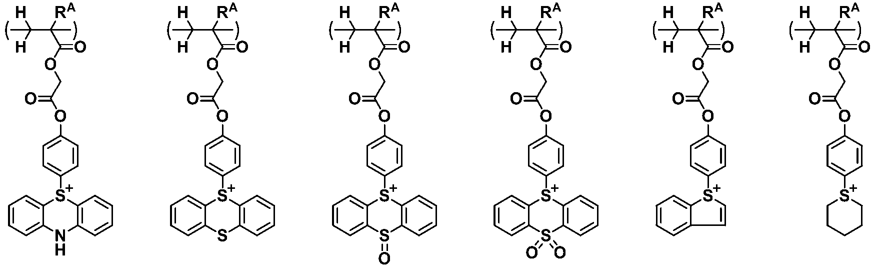

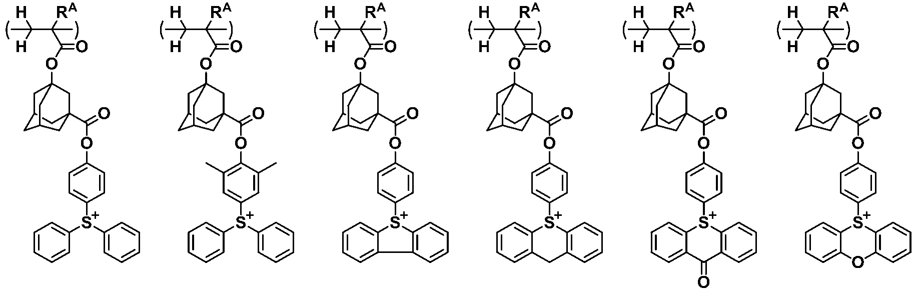

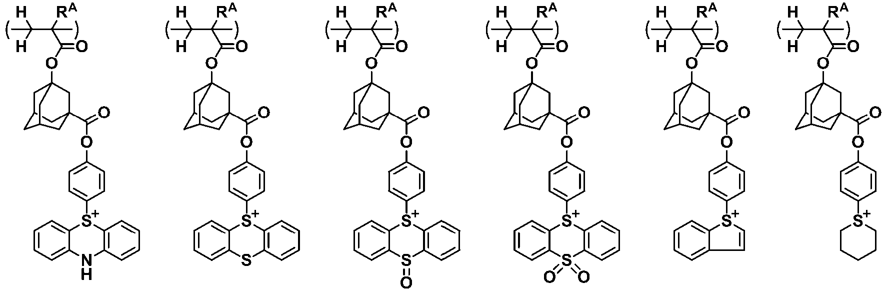

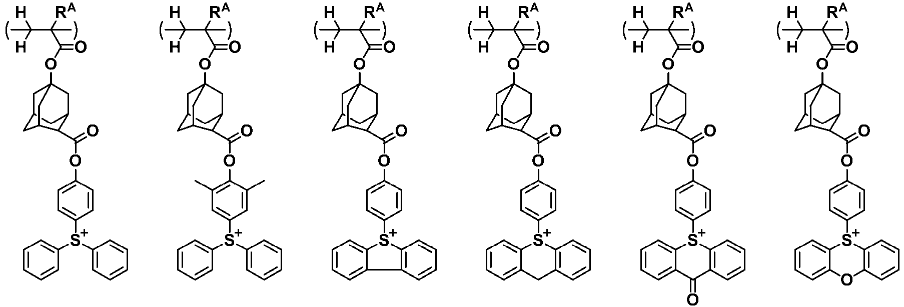

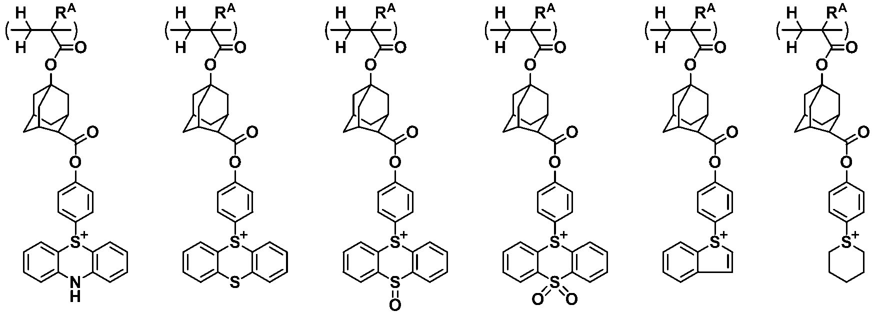

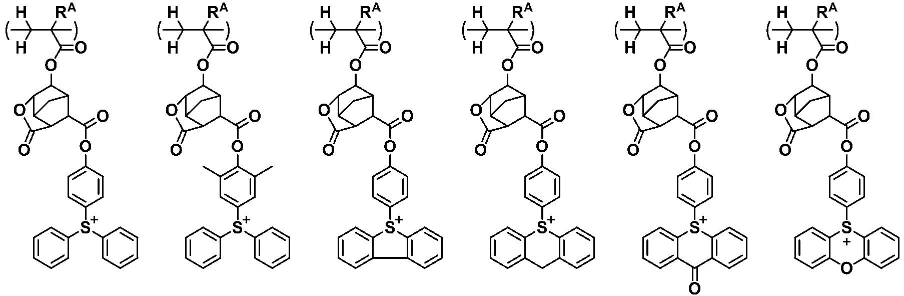

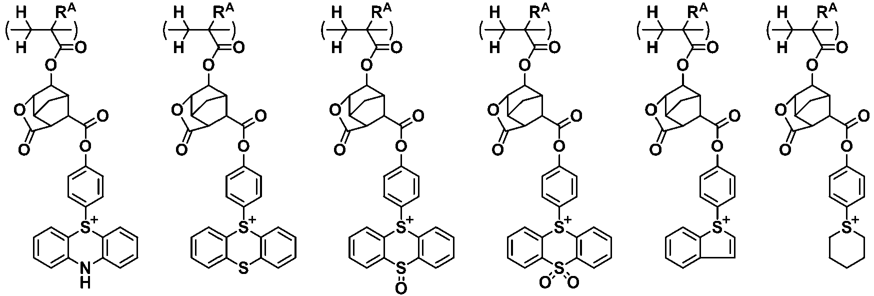

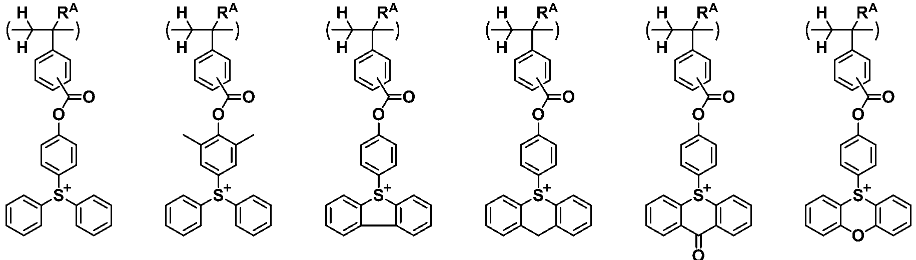

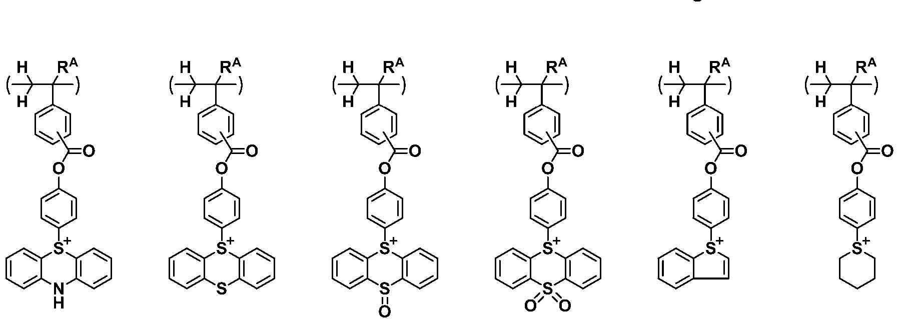

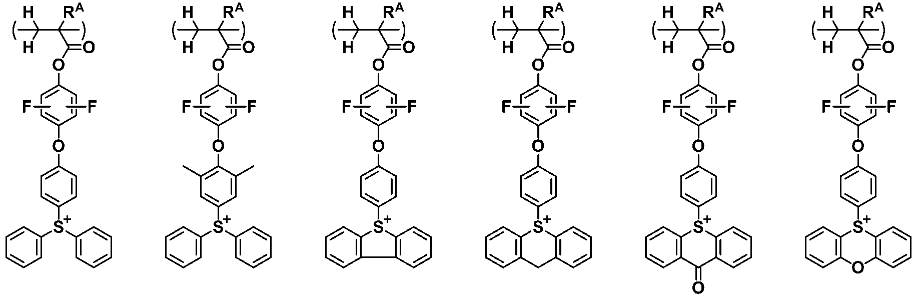

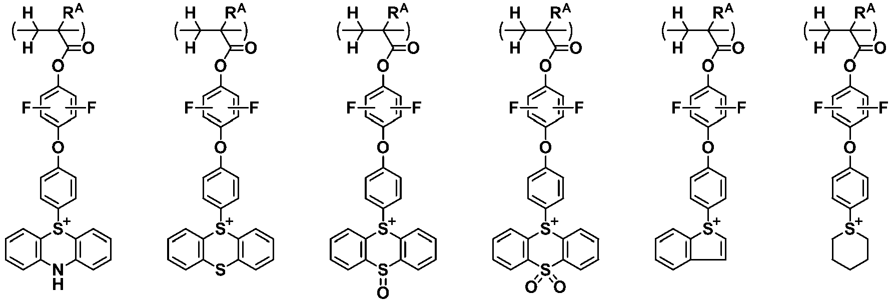

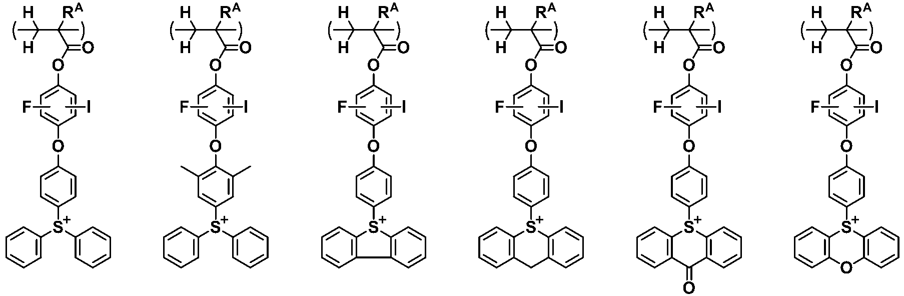

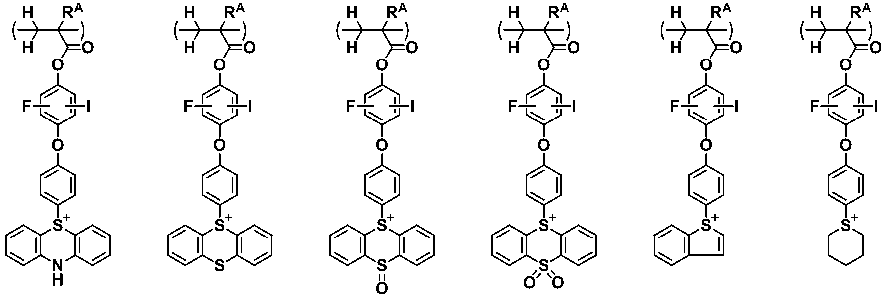

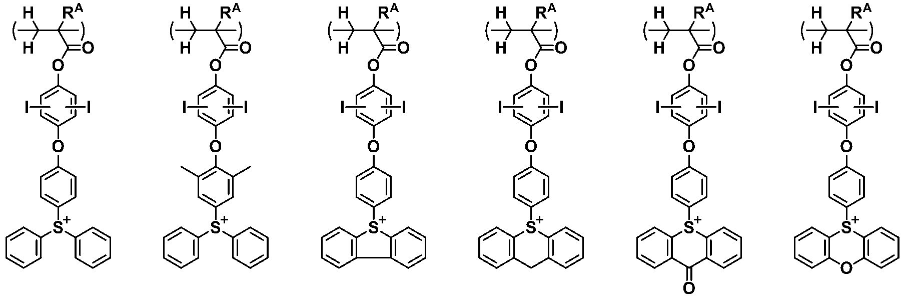

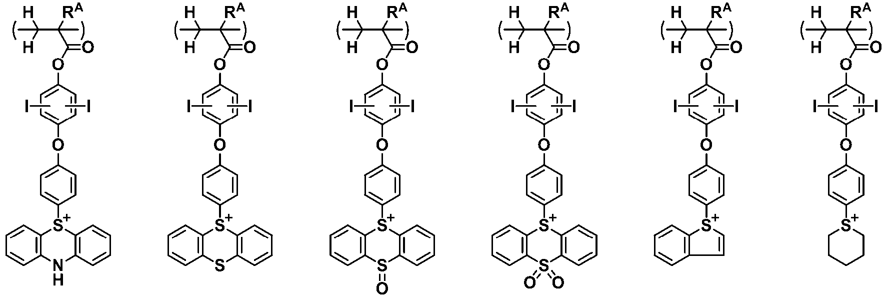

In formula (B7), M⁻ is a non-nucleophilic counter ion. Halide ions, sulfonate anions, imide anions, and methide anions are preferred. Examples of the non-nucleophilic counter ion include halide ions such as chloride and bromide ions; sulfonate anions, specifically fluoroalkylsulfonate ions such as triflate, 1,1,1-trifluoroethanesulfonate, and nonafluorobutanesulfonate, arylsulfonate ions such as tosylate, benzenesulfonate, 4-fluorobenzenesulfonate, and 1,2,3,4,5-pentafluorobenzenesulfonate, alkylsulfonate ions such as mesylate and butanesulfonate; imide ions such as bis(trifluoromethylsulfonyl)imide, bis(perfluoroethylsulfonyl)imide and bis(perfluorobutylsulfonyl)imide; and methide ions such as tris(trifluoromethylsulfonyl)methide and tris(perfluoroethylsulfonyl)methide.

Anions having the following formulae (B7-1) to (B7-4) are also useful as the non-nucleophilic counter ion.

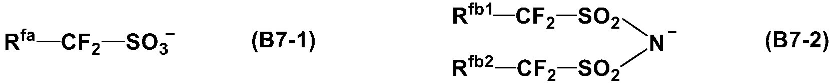

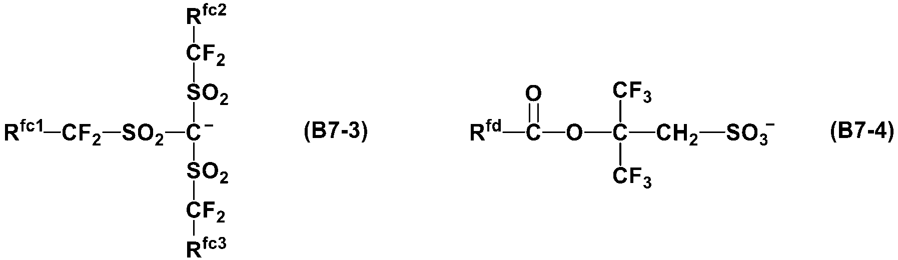

In formula (B7-1), R^{fa} is fluorine or a C₁-C₄₀ hydrocarbyl group which may contain a heteroatom. The hydrocarbyl group may be saturated or unsaturated and straight, branched or cyclic. Examples thereof are as will be exemplified below for the hydrocarbyl group R^{fa1} in formula (B7-1-1).

Of the anions of formula (B7-1), an anion having the formula (B7-1-1) is preferred.

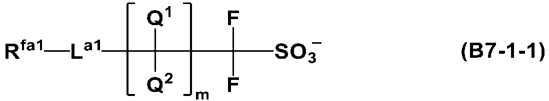

In formula (B7-1-1), Q¹ and Q² are each independently hydrogen, fluorine or a C₁-C₆ fluorinated saturated hydrocarbyl group. It is preferred for solvent solubility that at least one of Q¹ and Q² be trifluoromethyl. The subscript m is 0, 1, 2, 3 or 4, preferably 1.

R^{fa1} is a C₁-C₃₅ hydrocarbyl group which may contain a heteroatom. As the heteroatom, oxygen, nitrogen, sulfur and halogen atoms are preferred, with oxygen being most preferred. Of the hydrocarbyl groups, those groups of 6 to 30 carbon atoms are preferred from the aspect of achieving a high resolution in forming patterns of small feature size. The hydrocarbyl group may be saturated or unsaturated and straight, branched or cyclic. Examples thereof include C₁-C₃₅ alkyl groups such as methyl, ethyl, n-propyl, isopropyl, n-butyl, isobutyl, sec-butyl, tert-butyl, pentyl, neopentyl, hexyl, heptyl, 2-ethylhexyl, nonyl, undecyl, tridecyl, pentadecyl, heptadecyl, and icosyl; C₃-C₃₅ cyclic saturated hydrocarbyl groups such as cyclopentyl, cyclohexyl, 1-adamantyl, 2-adamantyl, 1-adamantylmethyl, norbornyl, norbornylmethyl, tricyclodecyl, tetracyclododecyl, tetracyclododecylmethyl, and dicyclohexylmethyl; C₂-C₃₅ unsaturated aliphatic hydrocarbyl groups such as 2-propenyl and 3-cyclohexenyl; C₆-C₃₅ aryl groups such as phenyl, 1-naphthyl, 2-naphthyl and 9-fluorenyl; and C₇-C₃₅ aralkyl groups such as benzyl and diphenylmethyl, and combinations thereof.

In the foregoing hydrocarbyl groups, some or all hydrogen may be substituted by a moiety containing a heteroatom such as oxygen, sulfur, nitrogen or halogen, or some constituent -CH₂- may be replaced by a moiety containing a heteroatom such as oxygen, sulfur or nitrogen, so that the group may contain a hydroxy, fluorine, chlorine, bromine, iodine, cyano, nitro, carbonyl, ether bond, ester bond, sulfonate ester bond, carbonate bond, lactone ring, sultone ring, carboxylic anhydride (-C(=O)-O-C(=O)-) or haloalkyl moiety. Examples of the heteroatom-containing hydrocarbyl group include tetrahydrofuryl, methoxymethyl, ethoxymethyl, methylthiomethyl, acetamidomethyl, trifluoroethyl, (2-methoxyethoxy)methyl, acetoxymethyl, 2-carboxy-1-cyclohexyl, 2-oxopropyl, 4-oxo-1-adamantyl, and 3-oxocyclohexyl.

In formula (B7-1-1), L^{a1} is a single bond, ether bond, ester bond, sulfonate ester bond, carbonate bond or carbamate bond. From the aspect of synthesis, an ether bond or ester bond is preferred, with the ester bond being more preferred.

Examples of the anion having formula (B7-1) are shown below, but not limited thereto. Herein Q¹ is as defined above.

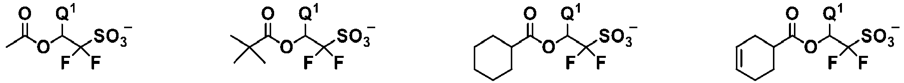

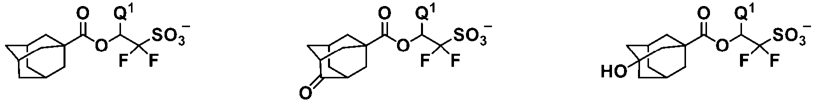

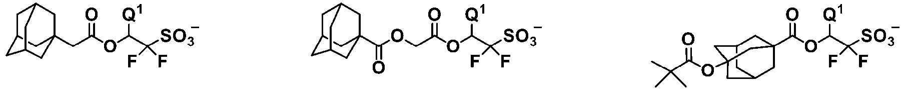

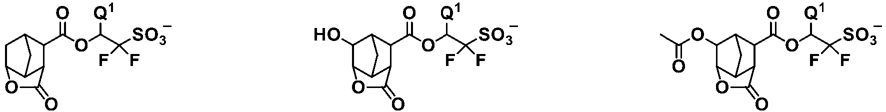

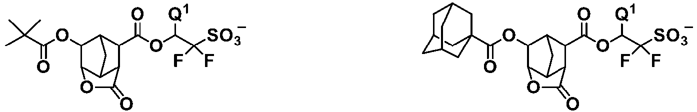

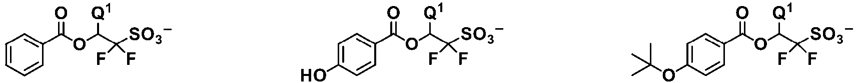

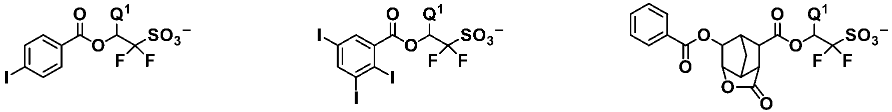

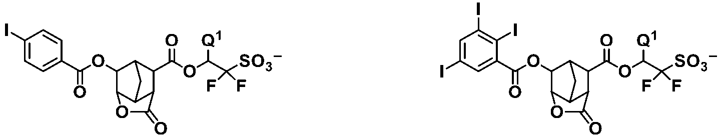

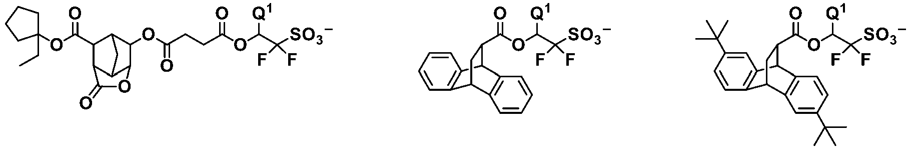

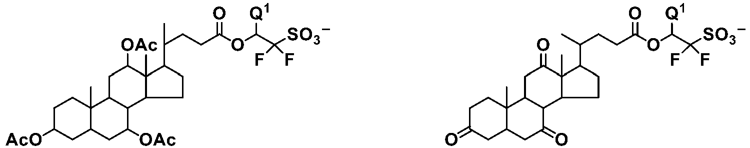

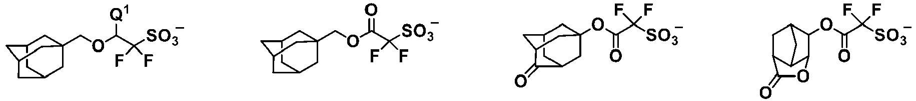

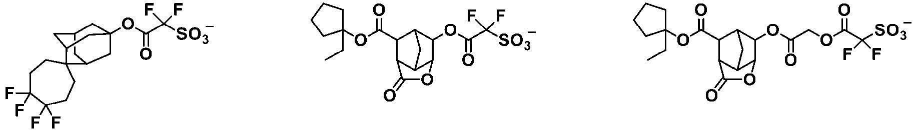

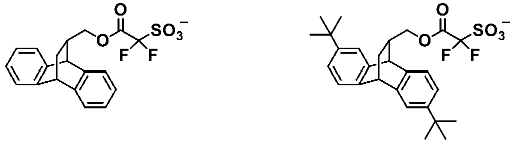

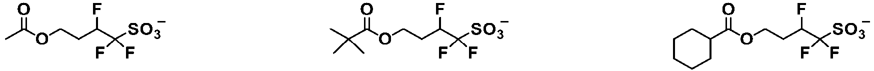

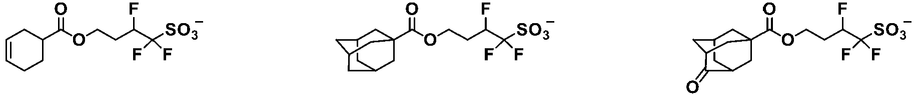

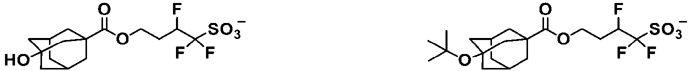

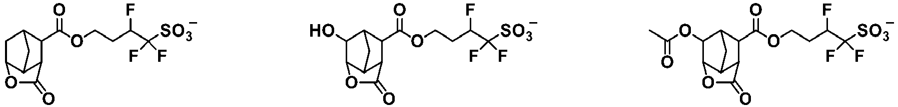

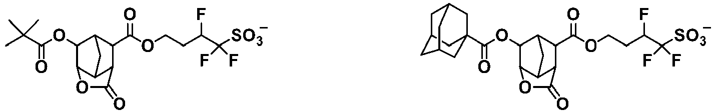

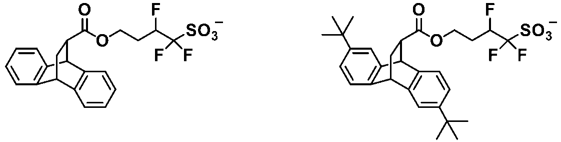

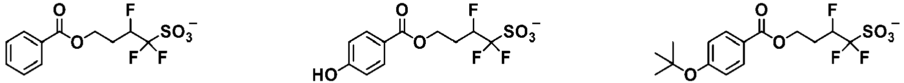

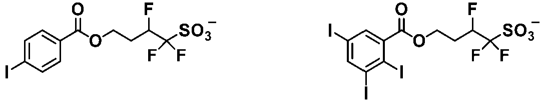

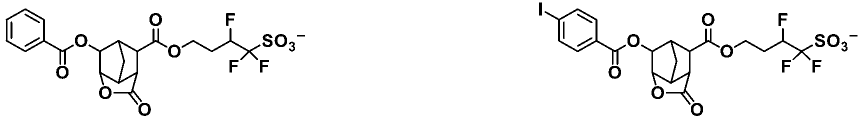

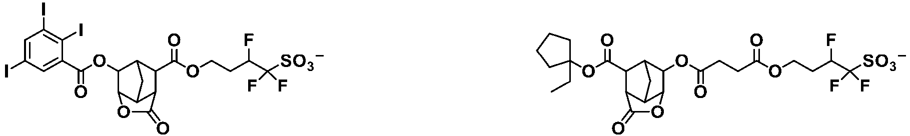

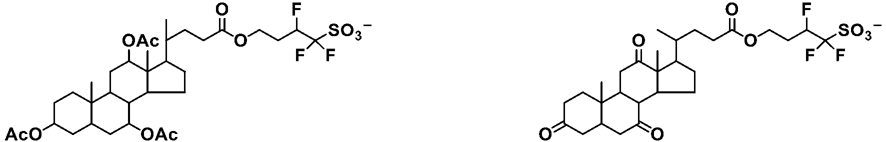

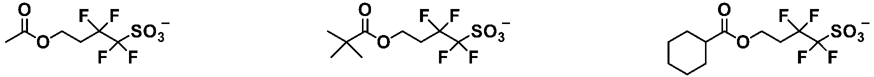

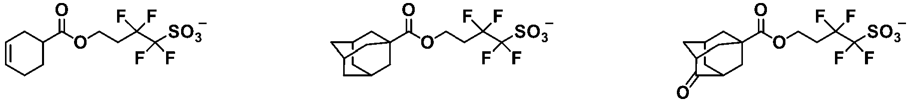

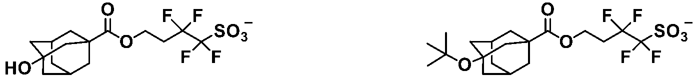

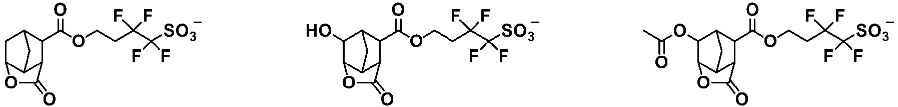

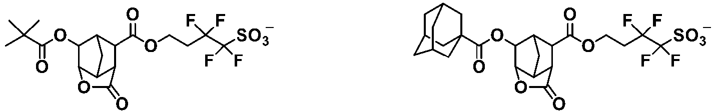

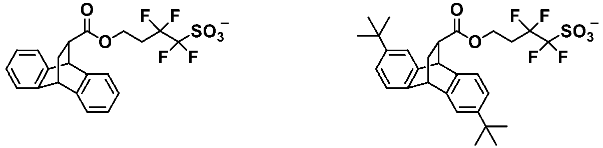

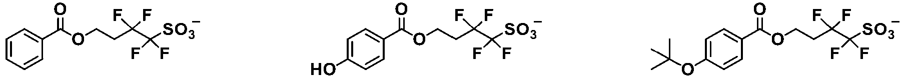

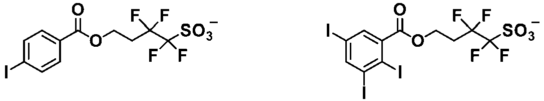

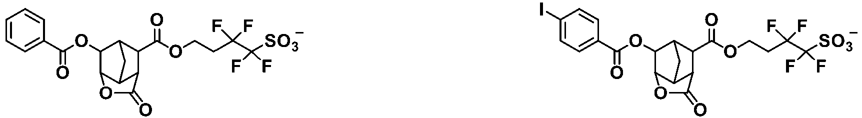

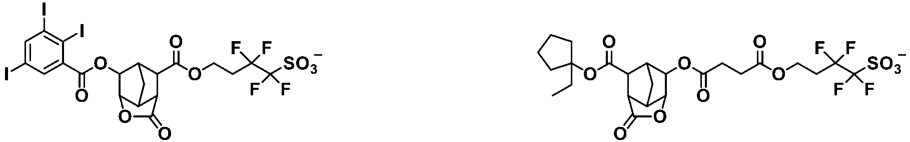

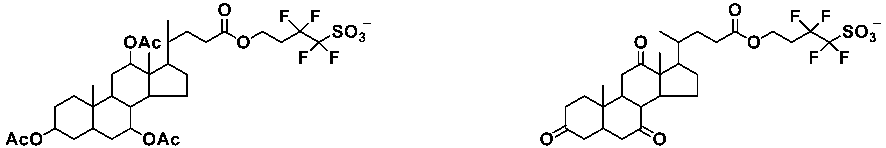

In formula (B7-2), R^{fb1} and R^{fb2} are each independently fluorine or a C₁-C₄₀ hydrocarbyl group which may contain a heteroatom. The hydrocarbyl group may be saturated or unsaturated and straight, branched or cyclic. Examples thereof are as exemplified above for R^{fa1} in formula (B7-1-1). Preferably R^{fb1} and R^{fb2} are fluorine or C₁-C₄ straight fluorinated alkyl groups. Also, R^{fb1} and R^{fb2} may bond together to form a ring with the linkage: -CF₂-SO₂-N⁻-SO₂-CF₂- to which they are attached. It is preferred that a combination of R^{fb1} and R^{fb2} be a fluorinated ethylene or fluorinated propylene group.

In formula (B7-3), R^{fc1}, R^{fc2} and R^{fc3} are each independently fluorine or a C₁-C₄₀ hydrocarbyl group which may contain a heteroatom. The hydrocarbyl group may be saturated or unsaturated and straight, branched or cyclic. Examples thereof are as exemplified for the hydrocarbyl group R^{fa1} in formula (B7-1-1). Preferably R^{fc1}, R^{fc2} and R^{fc3} are fluorine or C₁-C₄ straight fluorinated alkyl groups. Also, R^{fc1} and R^{fc2} may bond together to form a ring with the linkage: -CF₂-SO₂-C⁻-SO₂-CF₂- to which they are attached. It is preferred that a combination of R^{fc1} and R^{fc2} be a fluorinated ethylene or fluorinated propylene group.

In formula (B7-4), R^{fd} is a C₁-C₄₀ hydrocarbyl group which may contain a heteroatom. The hydrocarbyl group may be saturated or unsaturated and straight, branched or cyclic. Examples thereof are as exemplified above for the hydrocarbyl group R^{fa1} in formula (B7-1-1).

Examples of the anion having formula (B7-4) are shown below, but not limited thereto.

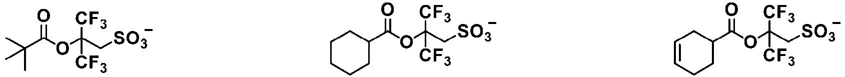

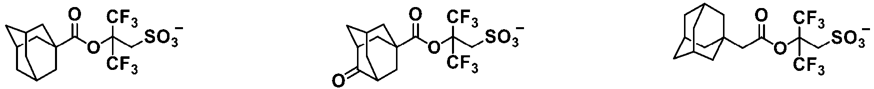

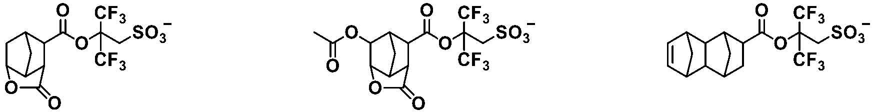

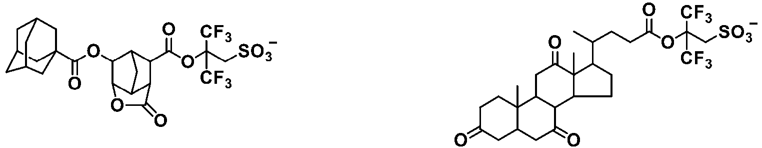

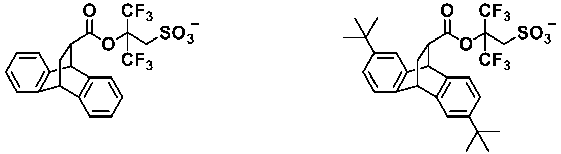

Anions having an iodized or brominated aromatic ring are also useful as the non-nucleophilic counter ion. These anions have the formula (B7-5).

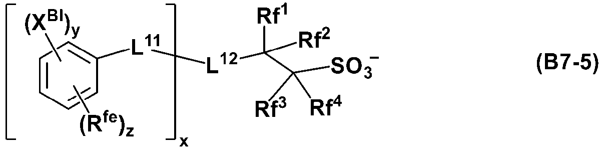

In formula (B7-5), x is 1, 2 or 3, y is 1, 2, 3, 4 or *5,* z is 0, 1, 2 or 3, and y+z is from 1 to 5. Preferably, y is 1, 2 or 3, more preferably 2 or 3, and z is 0, 1 or 2.

In formula (B7-5), X^{BI} is iodine or bromine. A plurality of X^{BI} may be identical or different when x and/or y is 2 or more.

In formula (B7-5), L¹¹ is a single bond, ether bond, ester bond, or a C₁-C₆ saturated hydrocarbylene group which may contain an ether bond or ester bond. The saturated hydrocarbylene group may be straight, branched or cyclic.

In formula (B7-5), L¹² is a single bond or a C₁-C₂₀ divalent linking group when x=1, or a C₁-C₂₀ (x+1)-valent linking group when x=2 or 3. The linking group may contain an oxygen, sulfur or nitrogen atom.

In formula (B7-5), R^{fe} is hydroxy, carboxy, fluorine, chlorine, bromine, amino group, or a C₁-C₂₀ hydrocarbyl, C₁-C₂₀ hydrocarbyloxy, C₂-C₂₀ hydrocarbylcarbonyl, C₂-C₂₀ hydrocarbyloxycarbonyl, C₂-C₂₀ hydrocarbylcarbonyloxy, or C₁-C₂₀ hydrocarbylsulfonyloxy group, which may contain fluorine, chlorine, bromine, hydroxy, amino or ether bond, or -N(R^{feA})(R^{feB}), -N(R^{feC})-C(=O)-R^{feD} or -N(R^{feC})-C(=O)-O-R^{feD}. R^{feA} and R^{feB} are each independently hydrogen or a C₁-C₆ saturated hydrocarbyl group. R^{feC} is hydrogen, or a C₁-C₆ saturated hydrocarbyl group which may contain halogen, hydroxy, C₁-C₆ saturated hydrocarbyloxy, C₂-C₆ saturated hydrocarbylcarbonyl or C₂-C₆ saturated hydrocarbylcarbonyloxy moiety. R^{feD} is a C₁-C₁₆ aliphatic hydrocarbyl group, C₆-C₁₂ aryl group or C₇-C₁₅ aralkyl group, which may contain halogen, hydroxy, C₁-C₆ saturated hydrocarbyloxy, C₂-C₆ saturated hydrocarbylcarbonyl or C₂-C₆ saturated hydrocarbylcarbonyloxy moiety. The aliphatic hydrocarbyl group may be saturated or unsaturated and straight, branched or cyclic. The hydrocarbyl, hydrocarbyloxy, hydrocarbylcarbonyl, hydrocarbyloxycarbonyl, hydrocarbylcarbonyloxy, and hydrocarbylsulfonyloxy groups may be straight, branched or cyclic. A plurality of R^{fe} may be identical or different when x and/or z is 2 or more.

Of these, R^{fe} is preferably hydroxy, -N(R^{feC})-C(=O)-R^{feD}, -N(R^{feC})-C(=O)-O-R^{feD}, fluorine, chlorine, bromine, methyl or methoxy.

In formula (B7-5), Rf¹¹ to Rf¹⁴ are each independently hydrogen, fluorine or trifluoromethyl, at least one of Rf¹¹ to Rf¹⁴ is fluorine or trifluoromethyl. Rf¹¹ and Rf¹², taken together, may form a carbonyl group. More preferably, both Rf¹³ and Rf¹⁴ are fluorine.

Examples of the anion having formula (B7-5) are shown below, but not limited thereto. X^{BI} is as defined above.

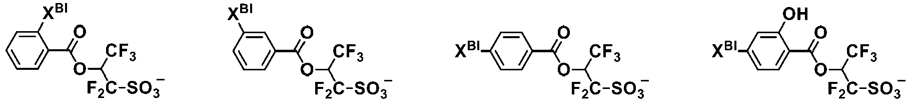

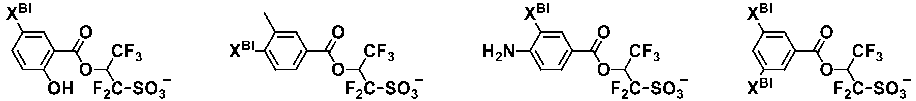

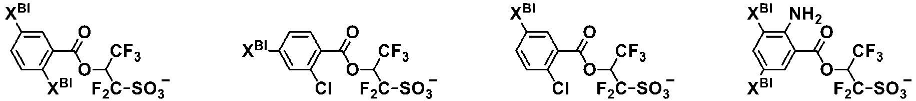

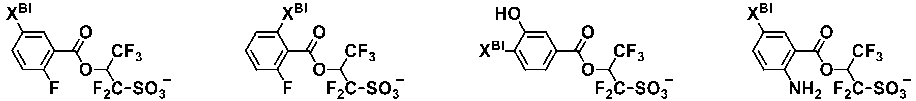

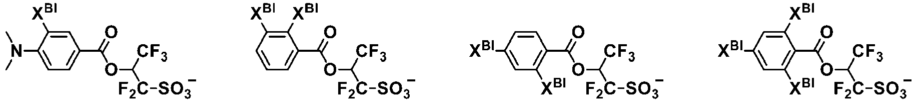

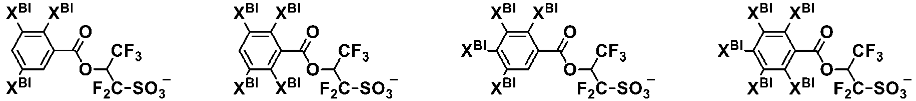

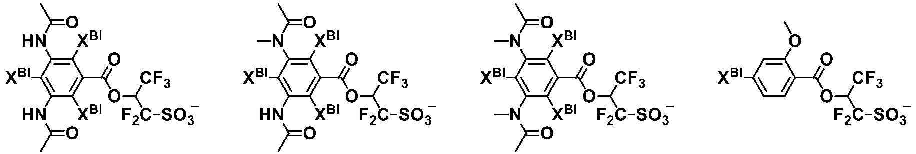

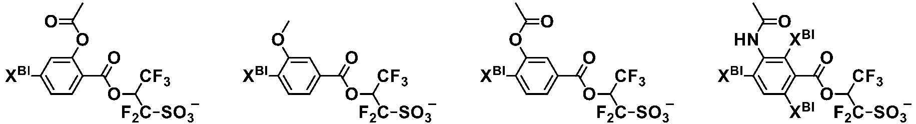

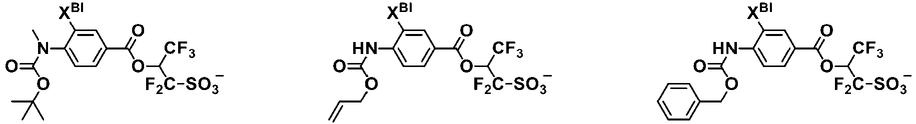

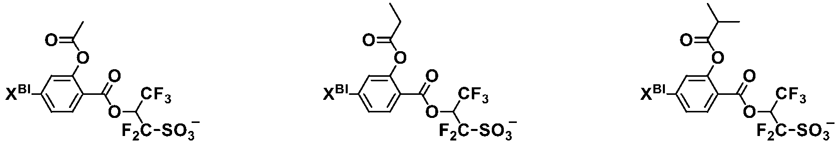

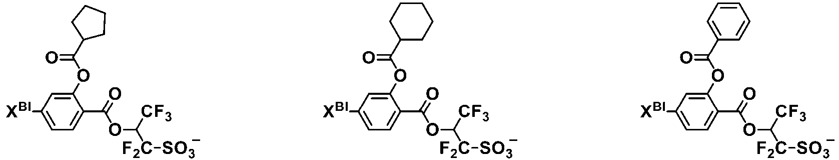

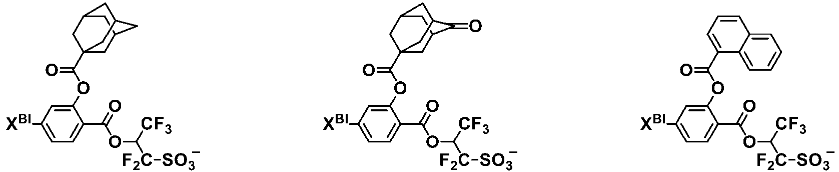

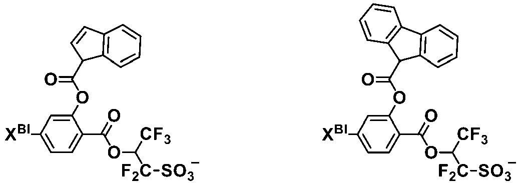

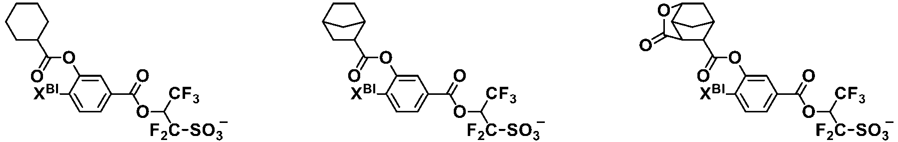

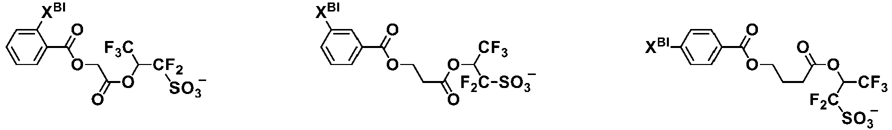

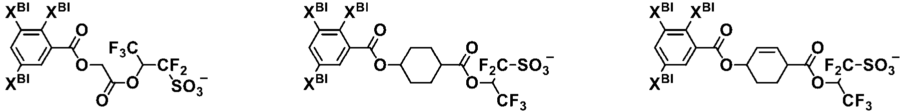

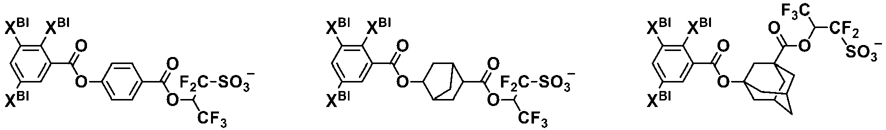

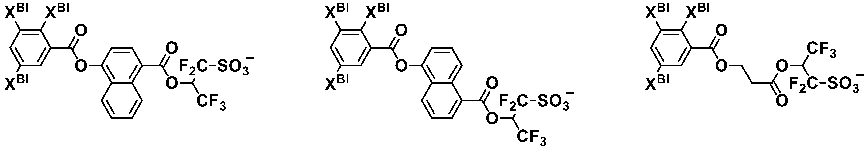

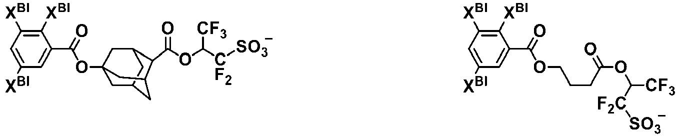

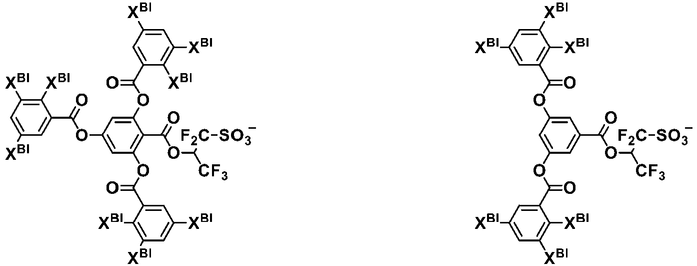

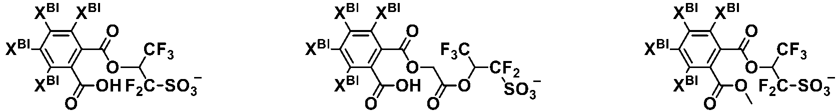

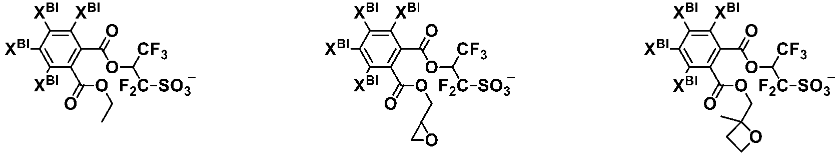

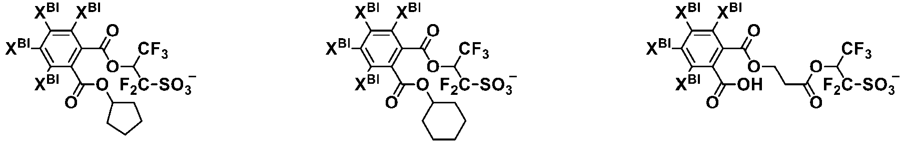

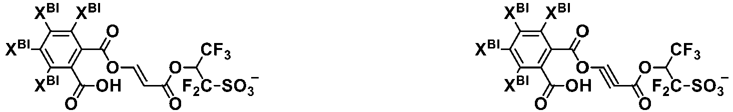

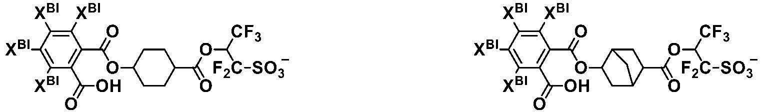

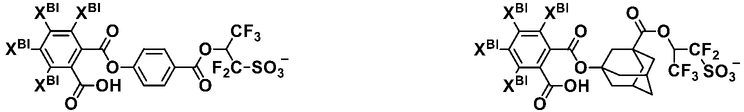

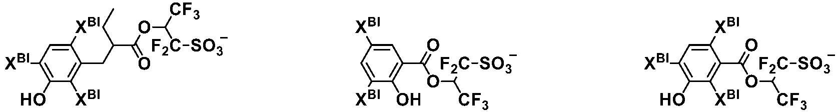

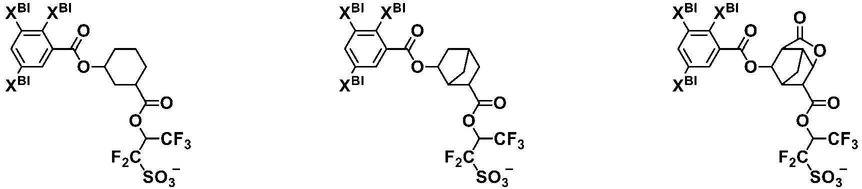

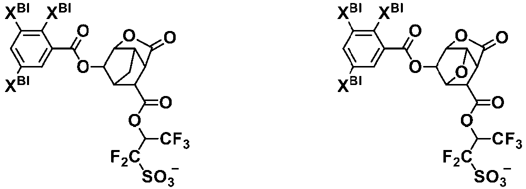

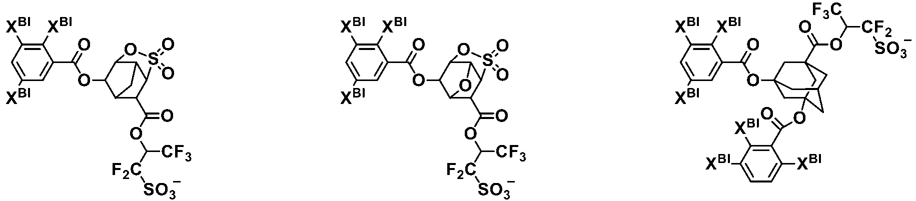

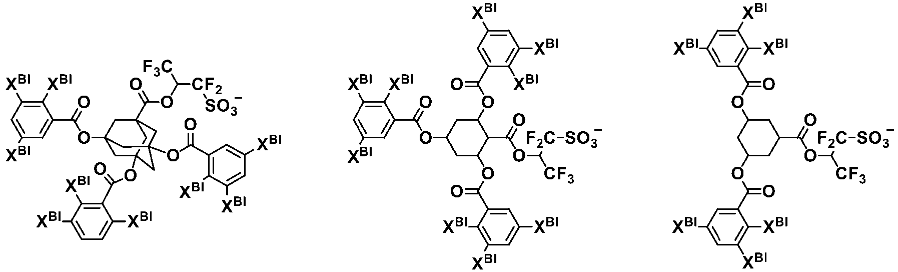

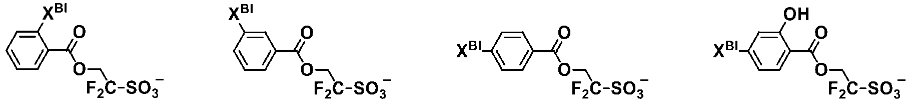

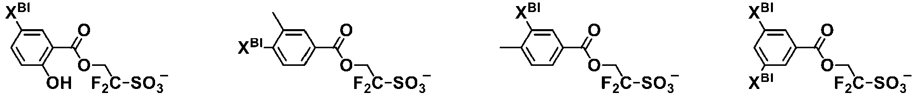

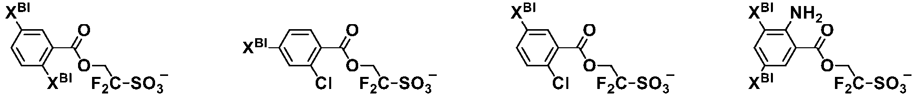

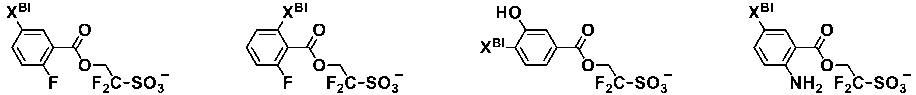

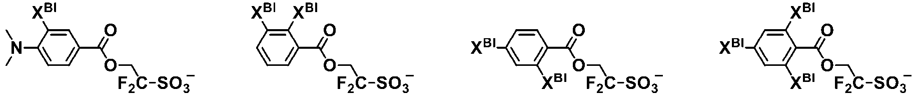

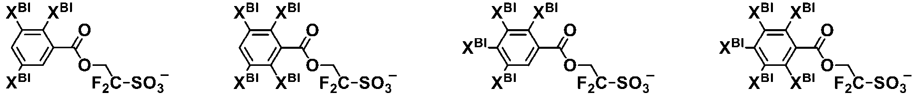

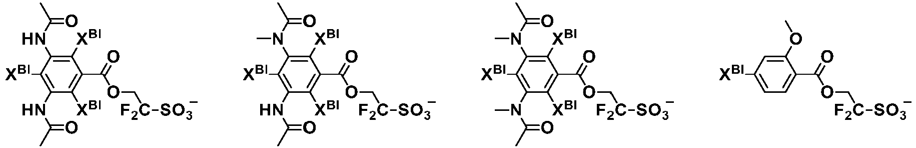

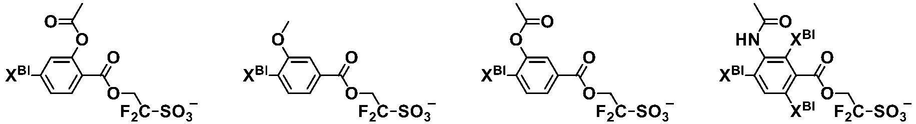

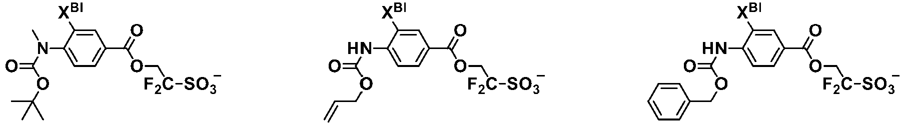

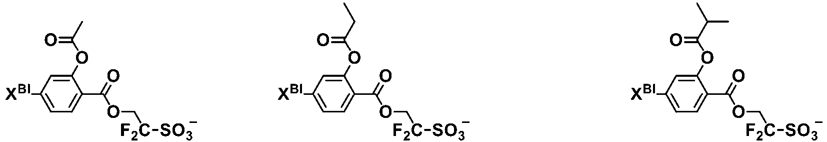

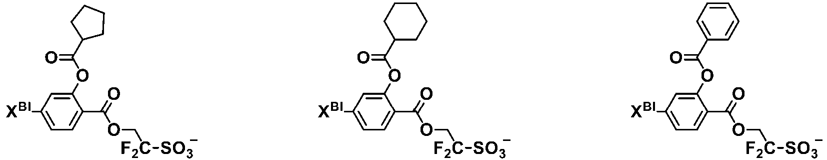

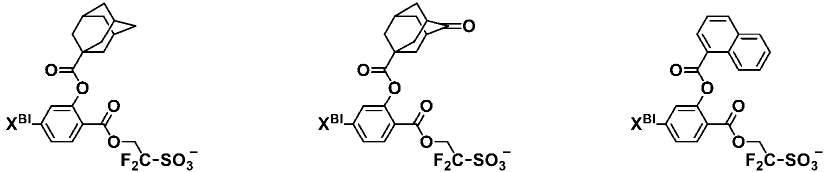

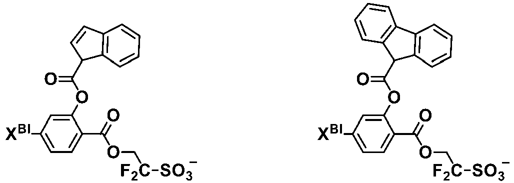

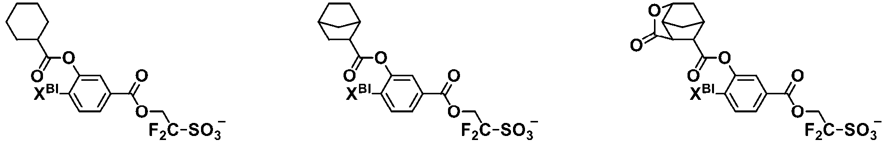

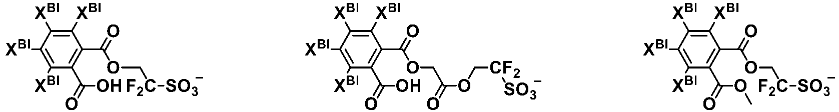

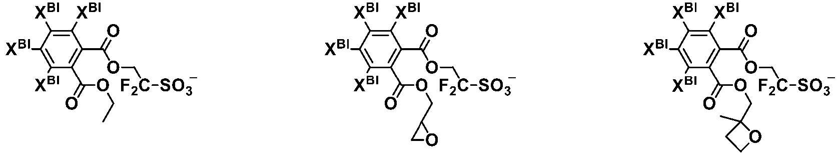

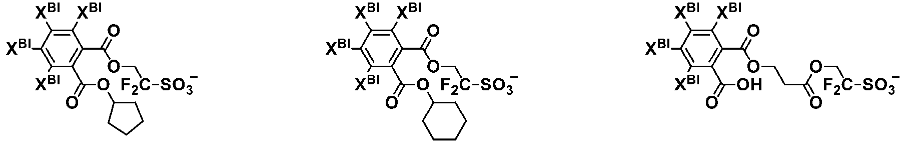

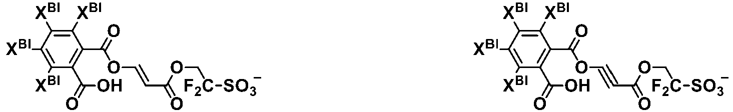

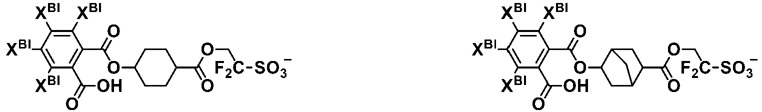

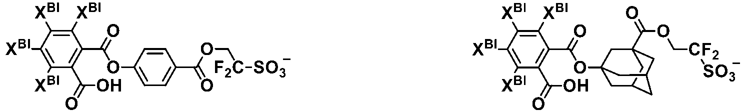

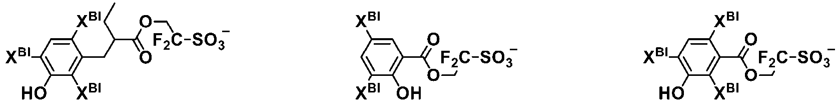

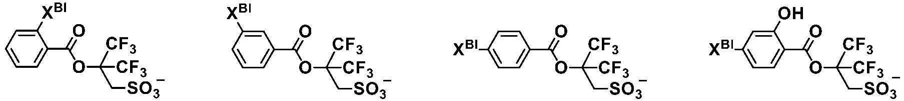

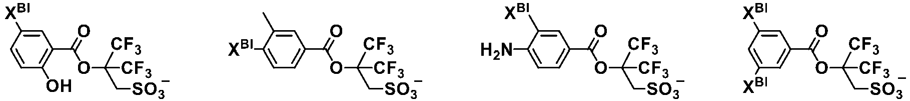

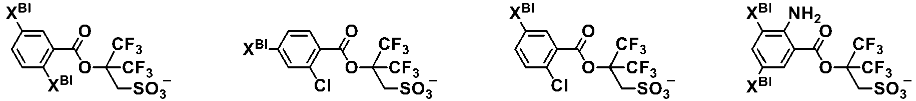

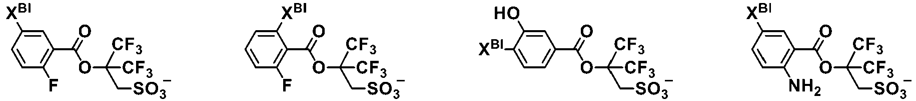

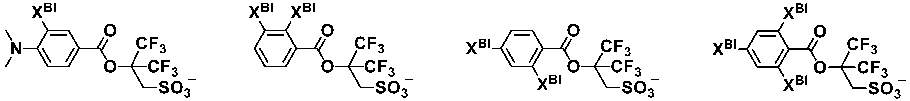

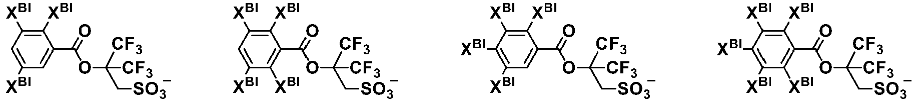

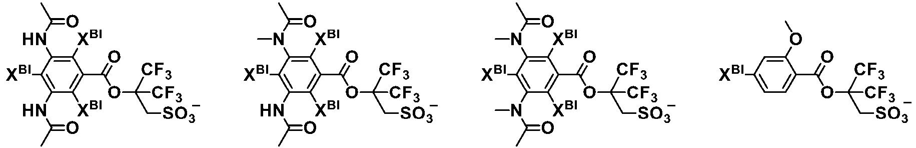

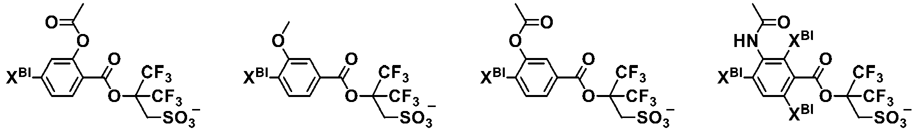

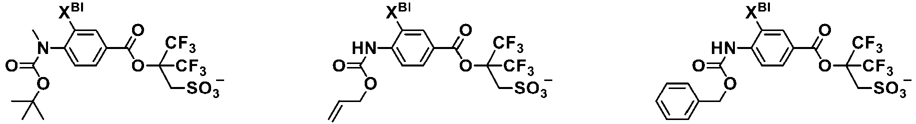

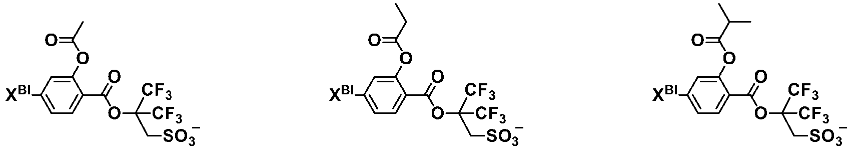

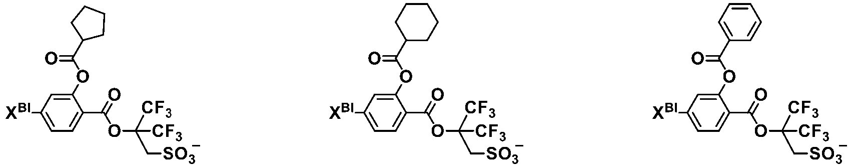

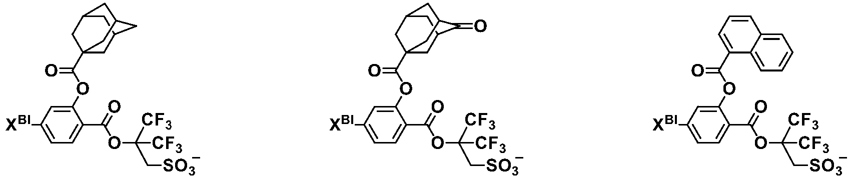

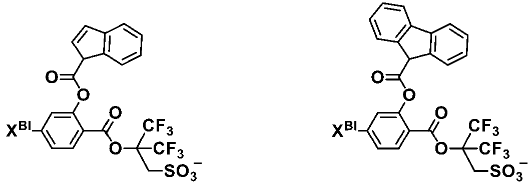

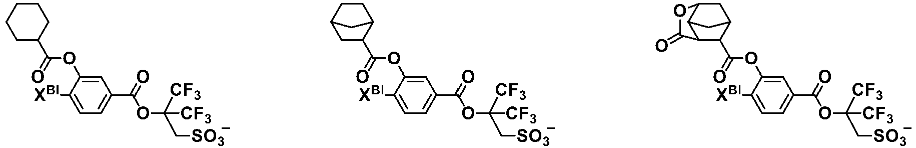

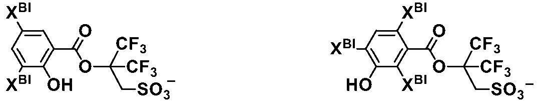

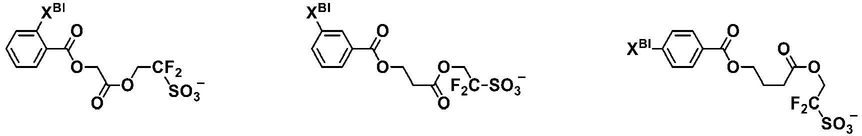

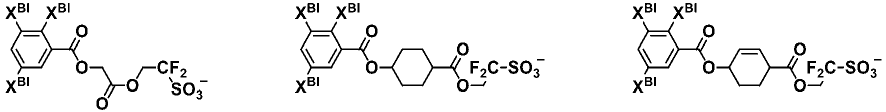

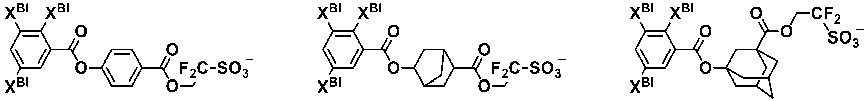

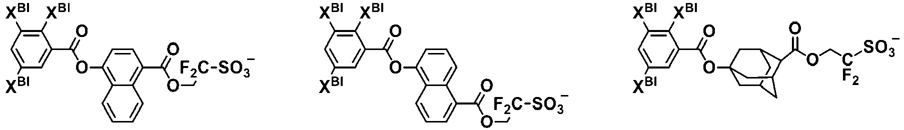

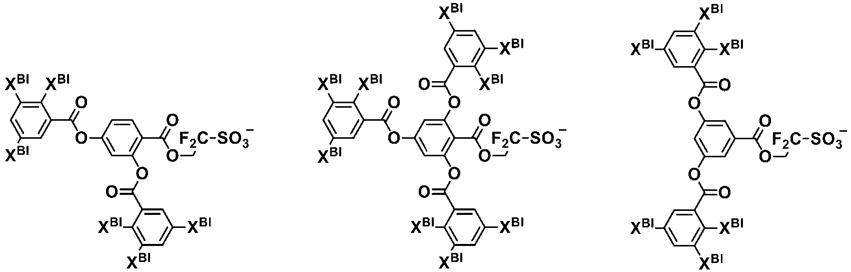

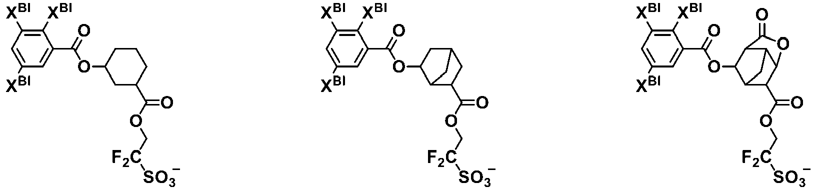

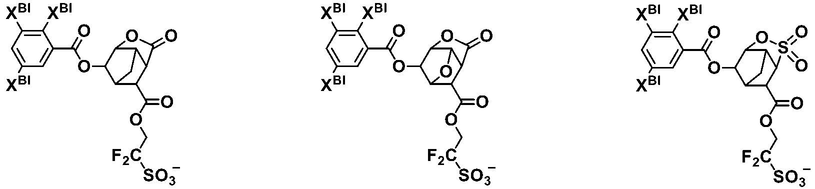

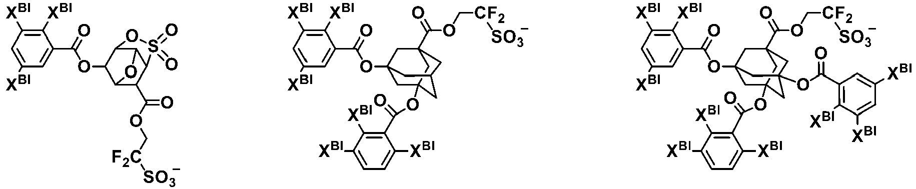

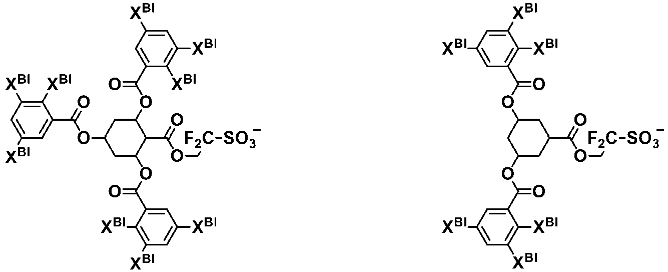

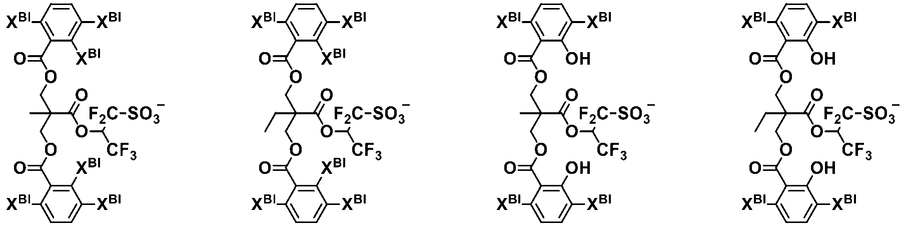

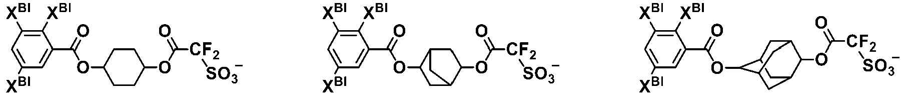

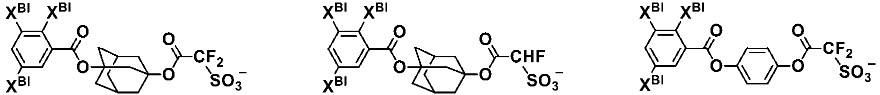

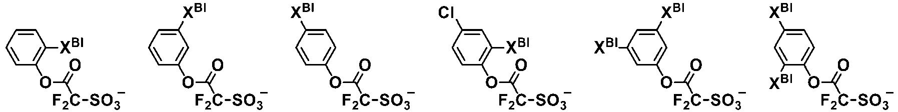

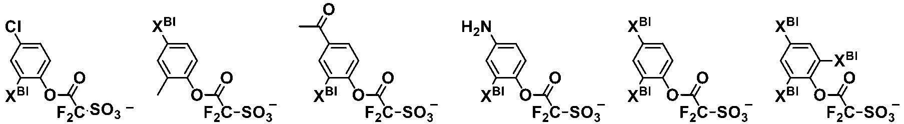

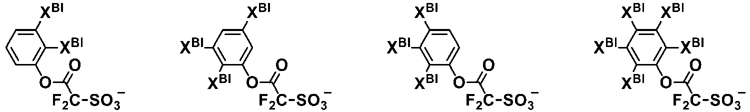

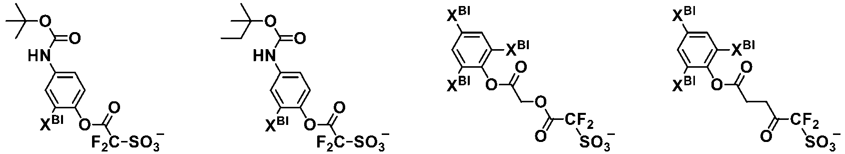

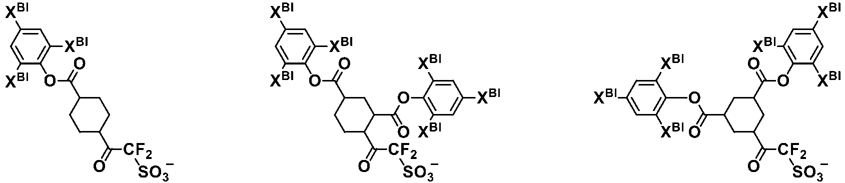

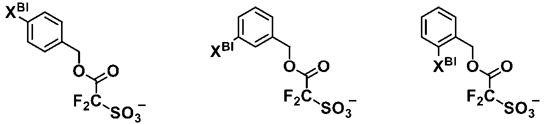

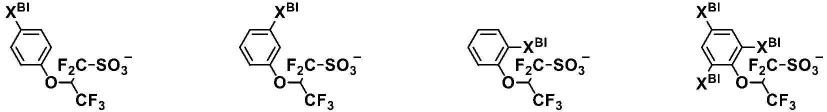

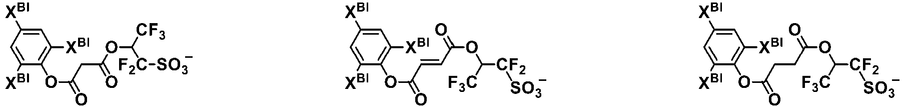

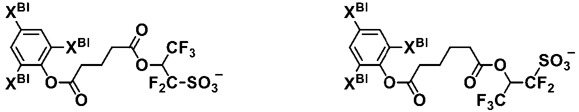

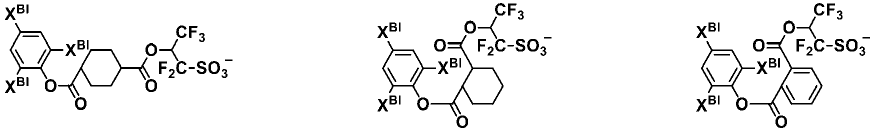

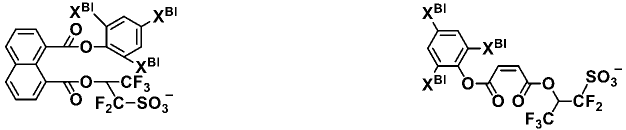

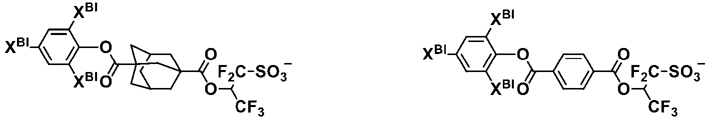

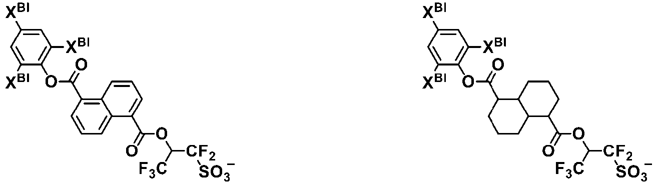

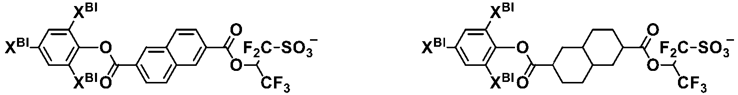

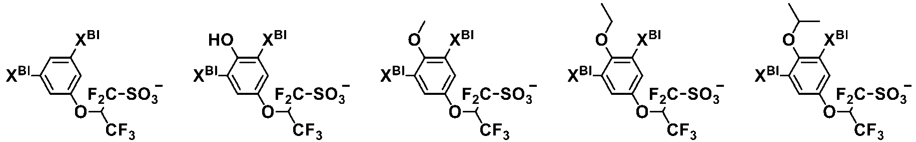

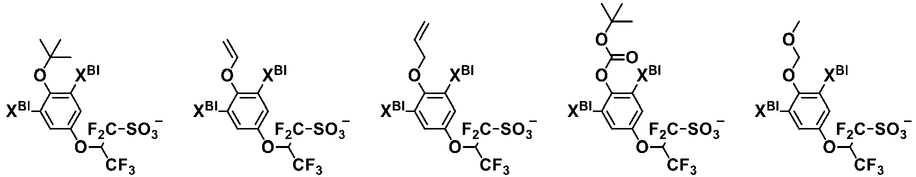

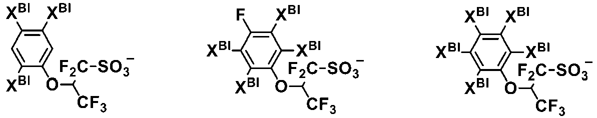

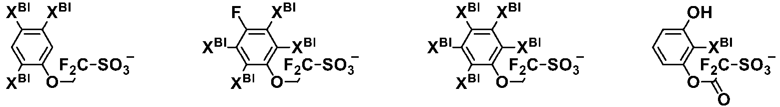

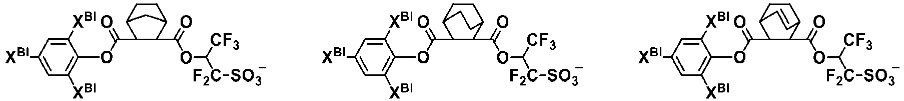

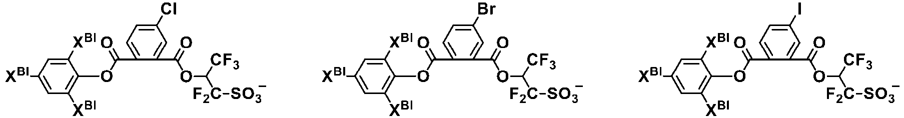

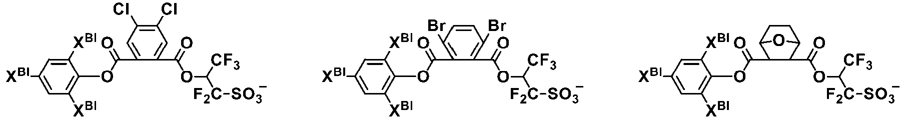

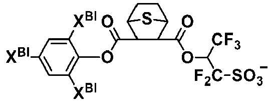

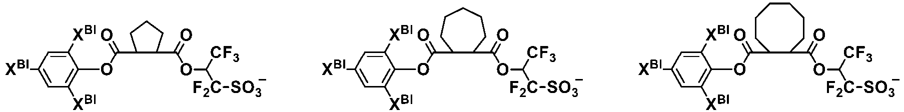

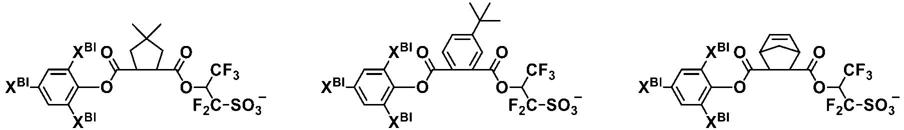

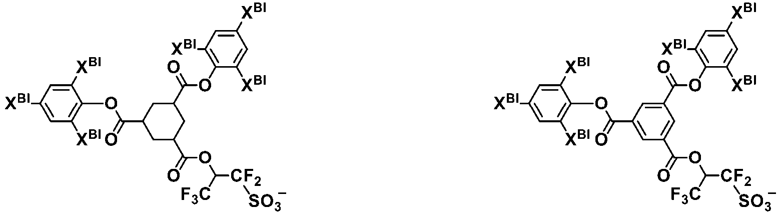

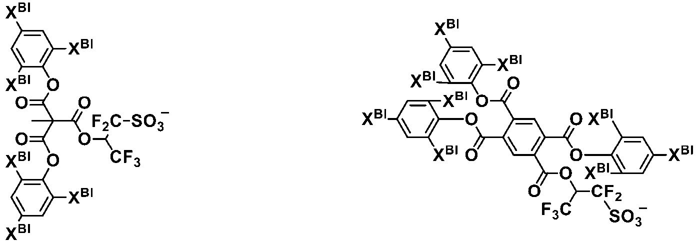

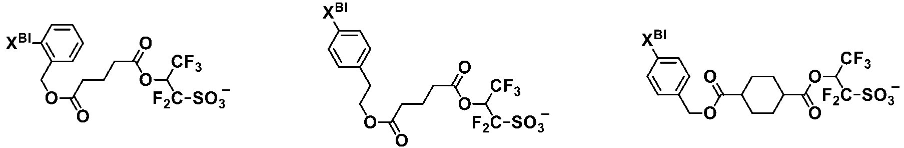

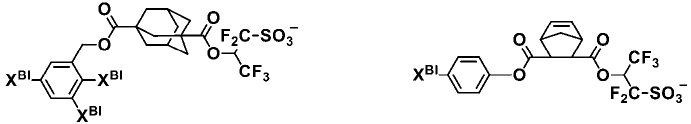

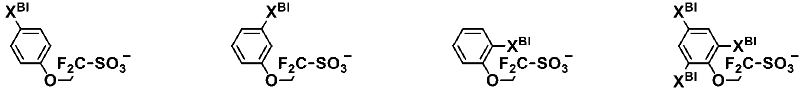

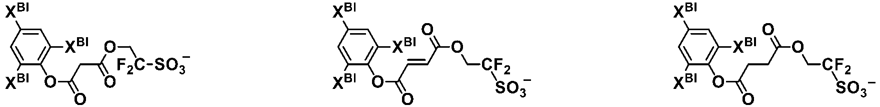

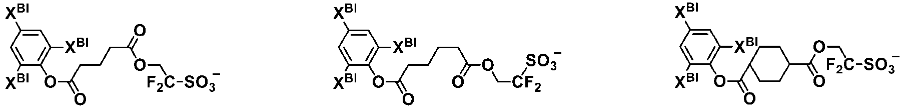

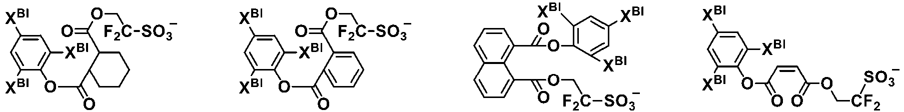

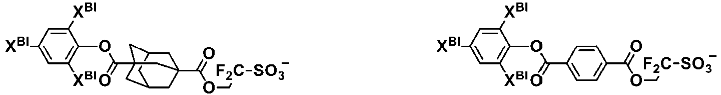

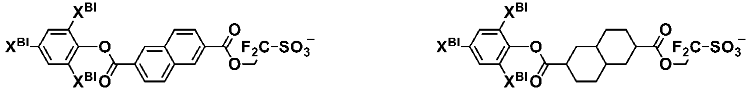

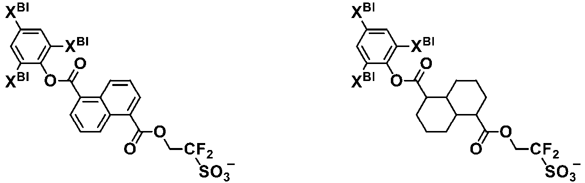

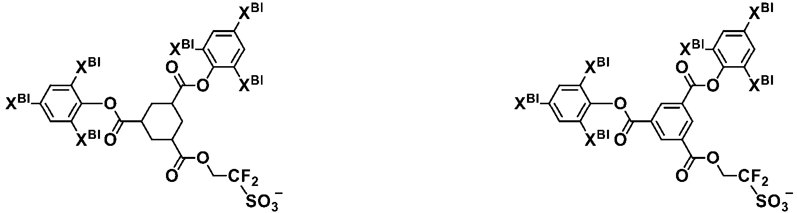

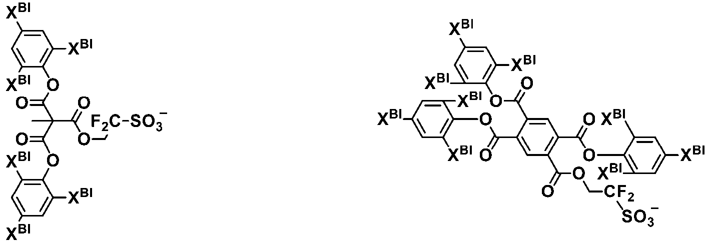

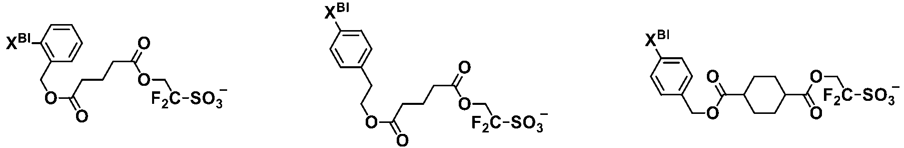

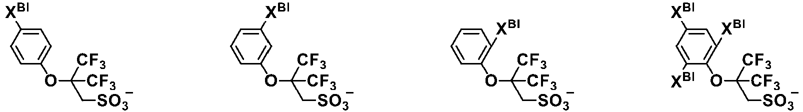

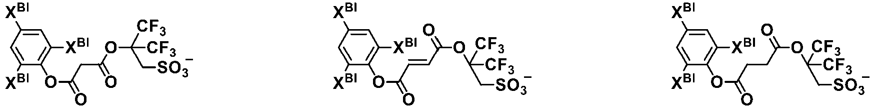

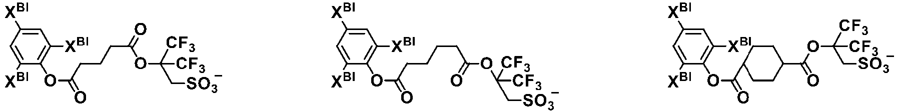

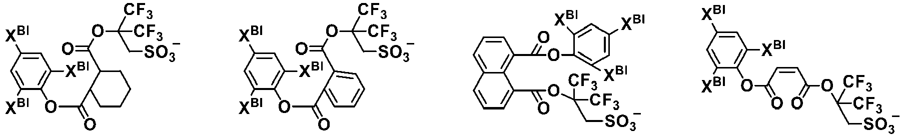

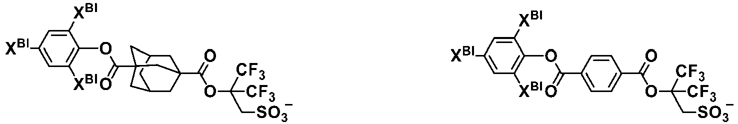

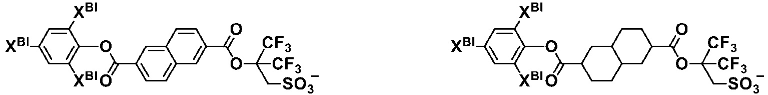

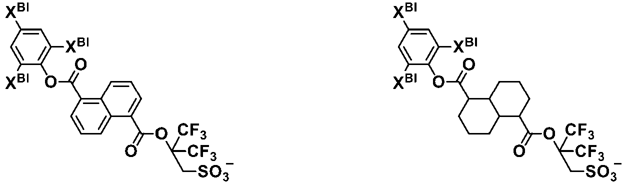

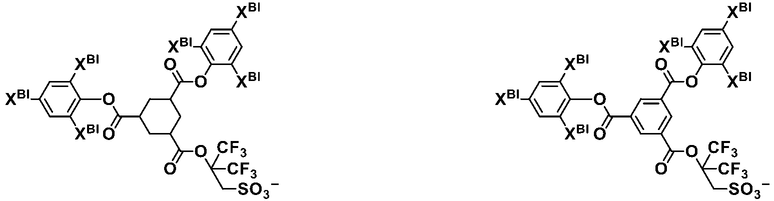

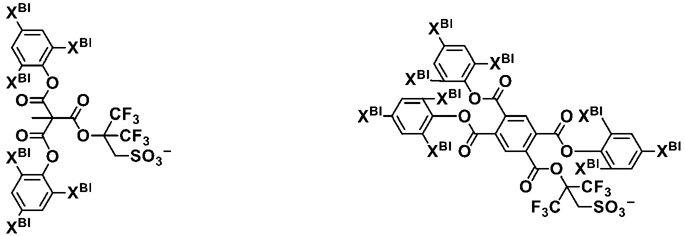

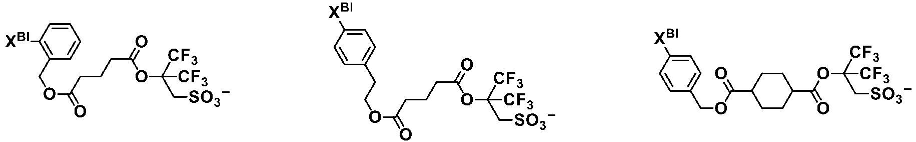

Other useful examples of the non-nucleophilic counter ion include fluorobenzenesulfonic acid anions having an iodized aromatic ring bonded thereto as described in JP 6648726, anions having an acid-catalyzed decomposition mechanism as described in WO 2021/200056 and JP-A 2021-070692, anions having a cyclic ether group as described in JP-A 2018-180525 and JP-A 2021-035935, and anions as described in JP-A 2018-092159.

Further useful examples of the non-nucleophilic counter ion include fluorine-free bulky benzenesulfonic acid anions as described in JP-A 2006-276759, JP-A 2015-117200, JP-A 2016-065016, and JP-A 2019-202974; fluorine-free benzenesulfonic acid or alkylsulfonic acid anions having an iodized aromatic group bonded thereto as described in JP 6645464.

Also useful are bissulfonic acid anions as described in JP-A 2015-206932, sulfonamide or sulfonimide anions having sulfonic acid side and different side as described in WO 2020/158366, and anions having a sulfonic acid side and a carboxylic acid side as described in JP-A 2015-024989.

In formulae (B8) and (B9), f1 and f2 are each independently 0, 1, 2 or 3, preferably 1.

In formula (B10), g1 is 0 or 1, g2 is 0, 1, 2, 3 or 4, g3 is 0, 1, 2, 3 or 4, meeting 0 ≤ g2+g3 ≤ 4 when g1=0, and 0 ≤ g2+g3 ≤ 6 when g1=1.

In formulae (B8), (B9) and (B10), L¹ is a single bond, ether bond, ester bond, carbonyl, sulfonate ester bond, carbonate bond or carbamate bond. From the aspect of synthesis, an ether bond, ester bond or carbonyl is preferred, with the ester bond or carbonyl being more preferred.

In formula (B8), Rf¹ and Rf² are each independently fluorine or a C₁-C₆ fluorinated saturated hydrocarbyl group. It is preferred that both Rf¹ and Rf² be fluorine because the generated acid has a higher acid strength. Rf³ and Rf⁴ are each independently hydrogen, fluorine or a C₁-C₆ fluorinated saturated hydrocarbyl group. It is preferred for solvent solubility that at least one of Rf³ and Rf⁴ be trifluoromethyl.

In formula (B9), Rf⁵ and Rf⁶ are each independently hydrogen, fluorine or a C₁-C₆ fluorinated saturated hydrocarbyl group. It is excluded that all Rf⁵ and Rf⁶ are hydrogen at the same time. It is preferred for solvent solubility that at least one of Rf⁵ and Rf⁶ be trifluoromethyl.

In formula (B10), Rf⁷ is fluorine, a C₁-C₆ fluorinated alkyl group, C₁-C₆ fluorinated alkoxy group, or C₁-C₆ fluorinated alkylthio group. Rf⁷ is preferably fluorine, trifluoromethyl, difluoromethyl, trifluoromethoxy, difluoromethoxy, trifluoromethylthio or difluoromethylthio, more preferably fluorine, trifluoromethyl or trifluoromethoxy. When g2 is 2, 3 or 4, a plurality of Rf⁷ may be identical or different.

In formula (B10), R⁵³ is halogen exclusive of fluorine or a C₁-C₂₀ hydrocarbyl group which may contain a heteroatom. The hydrocarbyl group may be saturated or unsaturated and straight, branched or cyclic. Examples thereof are as exemplified above for the hydrocarbyl group R² in formula (A), but not limited thereto. When g3 is 2, 3 or 4, a plurality of R⁵³ may be identical or different.

When g3 is 2, 3 or 4, a plurality of R⁵³ may bond together to form a ring with the carbon atom to which they are attached. Examples of the ring thus formed include cyclopropane, cyclobutane, cyclopentane, cyclohexane, norbornane, and adamantane rings. In the ring, some or all of the hydrogen atoms may be substituted by a moiety containing a heteroatom such as oxygen, sulfur, nitrogen or halogen, and some constituent -CH₂-may be replaced by a moiety containing a heteroatom such as oxygen, sulfur or nitrogen, so that the ring may contain a hydroxy, fluorine, chlorine, bromine, iodine, cyano, carbonyl, ether bond, ester bond, sulfonate ester bond, carbonate bond, lactone ring, sultone ring, carboxylic anhydride (-C(=O)-O-C(=O)-) or haloalkyl moiety.

Examples of the anion in repeat unit B8 are shown below, but not limited thereto. Herein R^{A} is as defined above.

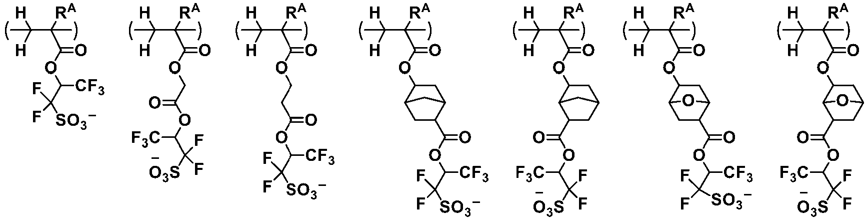

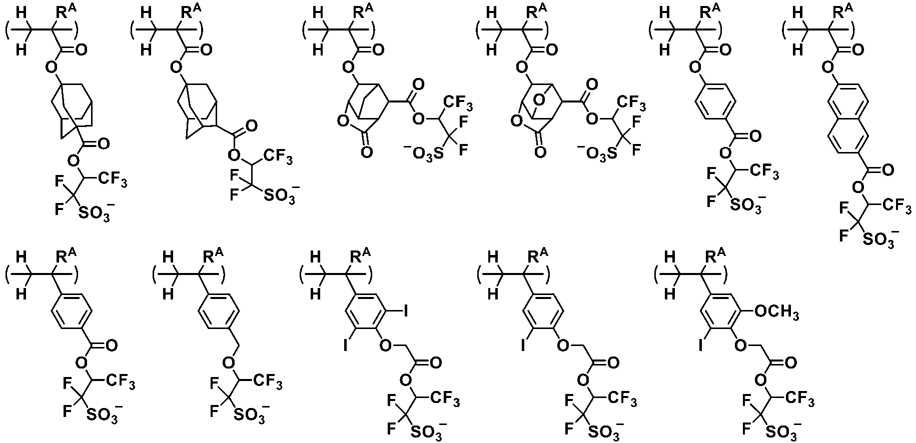

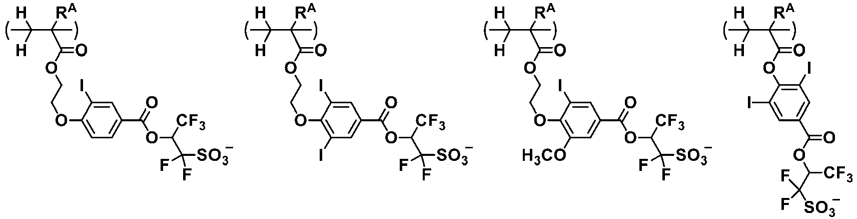

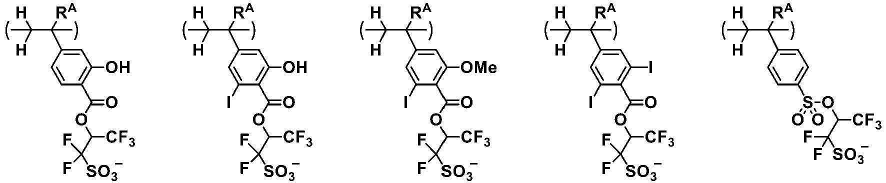

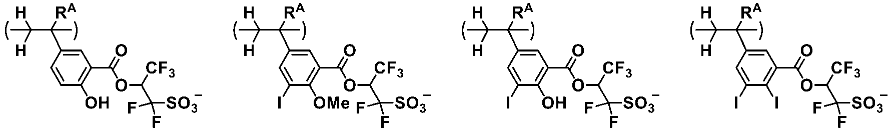

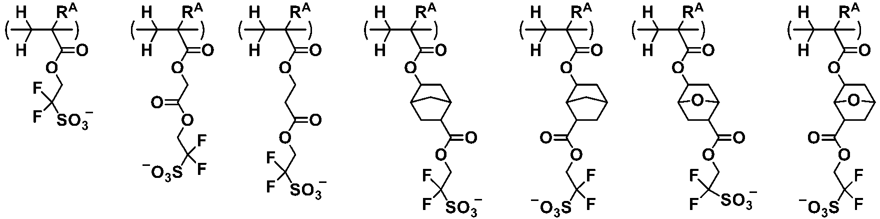

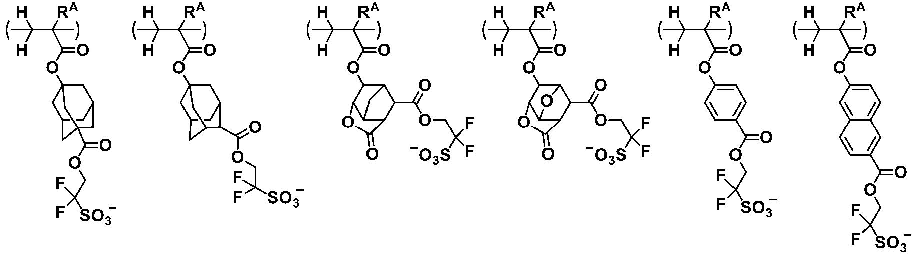

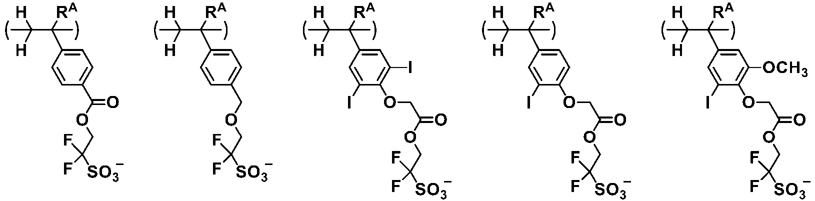

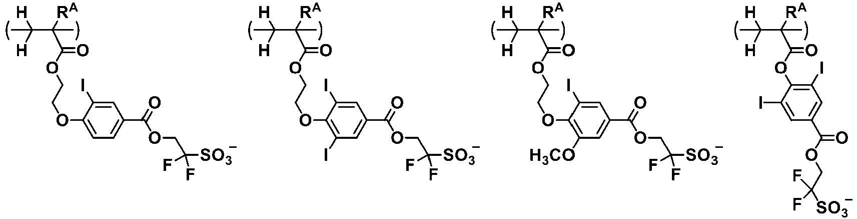

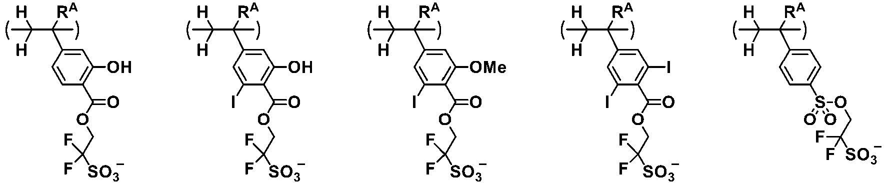

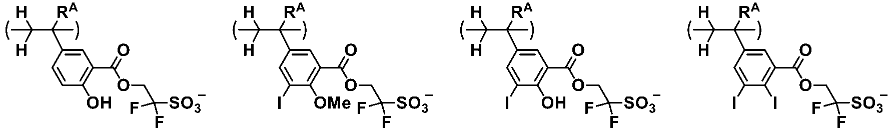

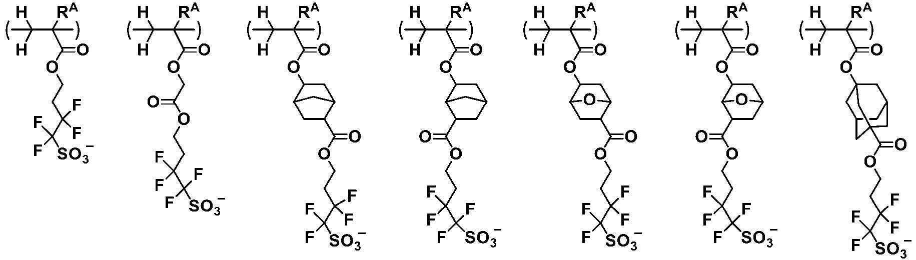

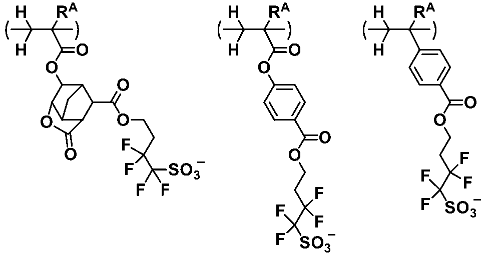

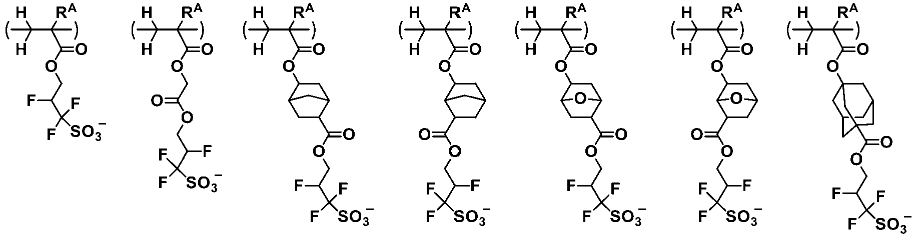

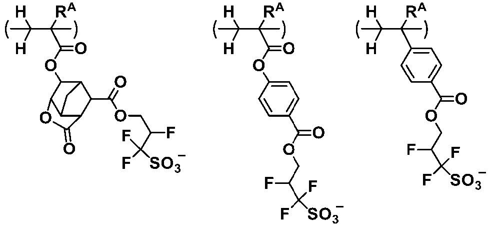

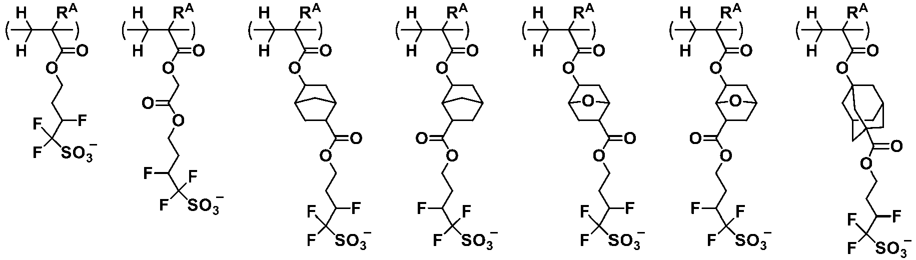

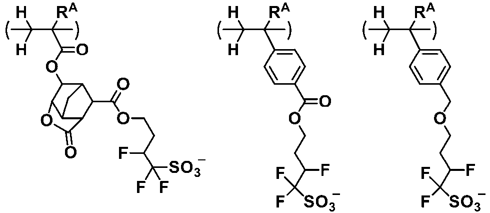

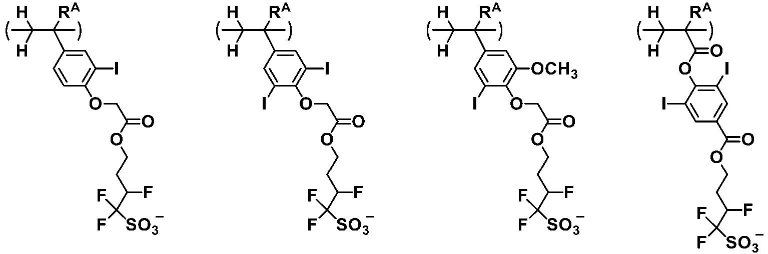

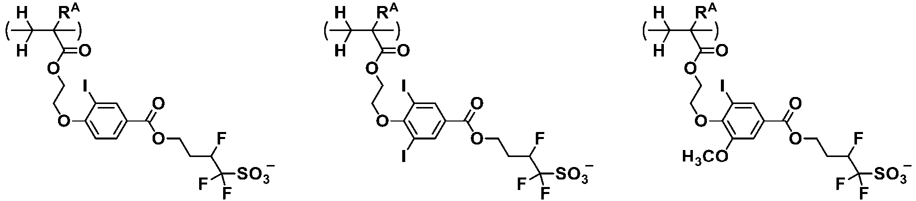

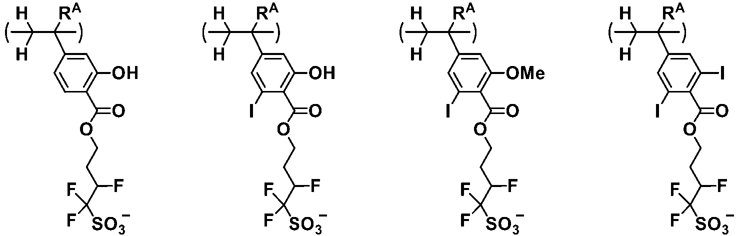

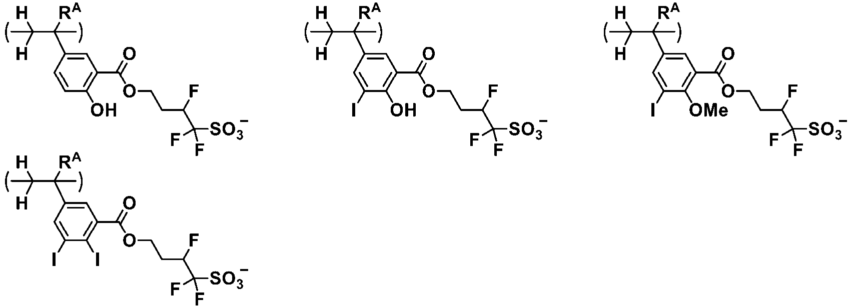

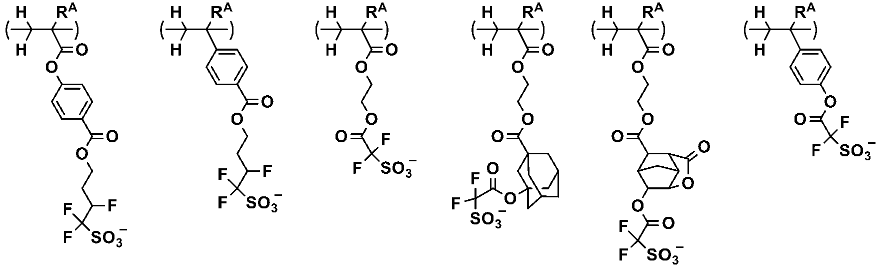

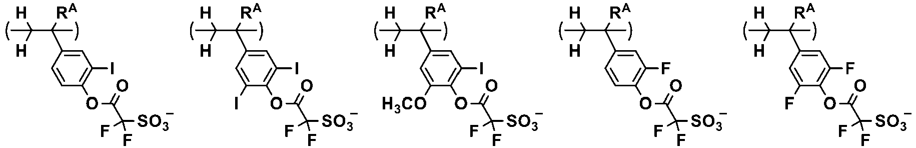

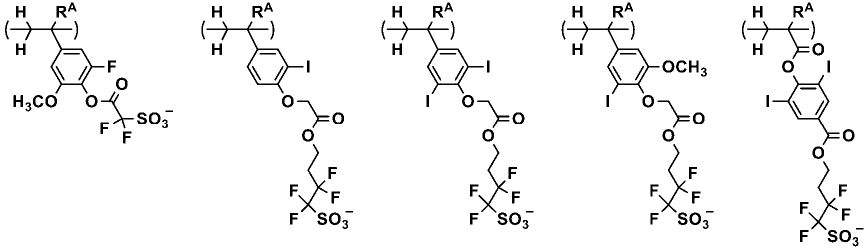

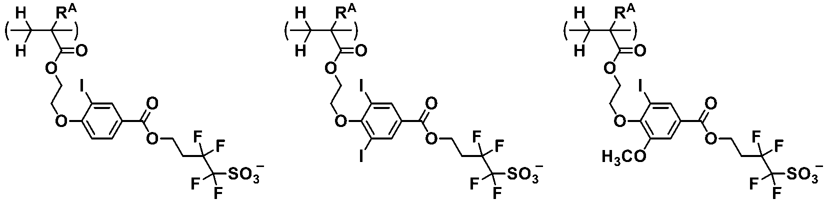

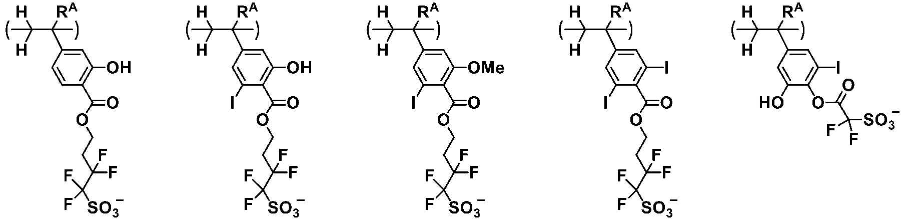

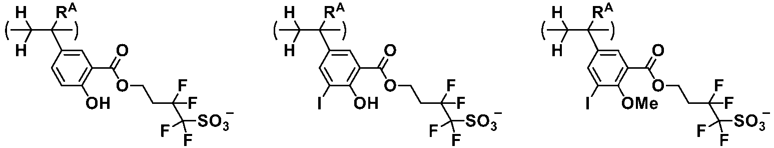

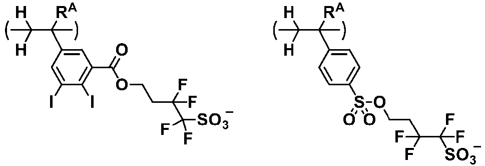

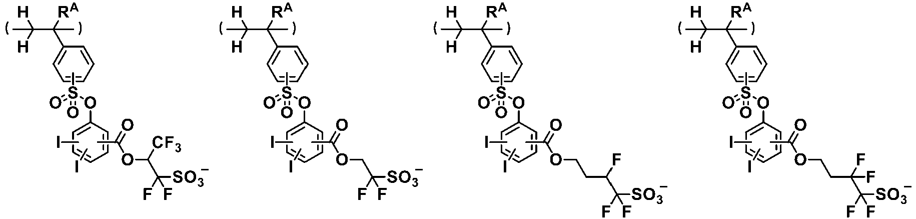

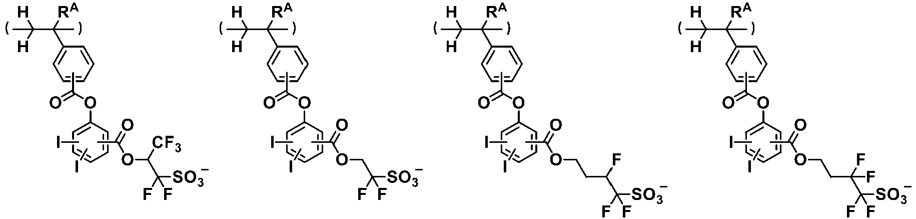

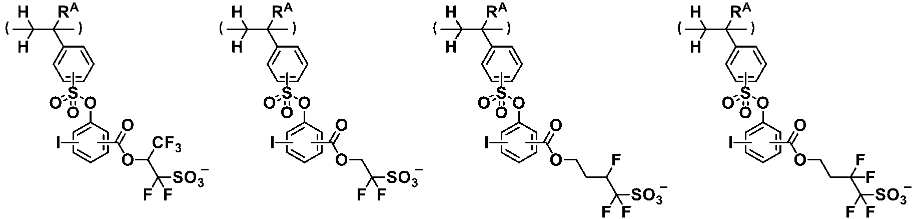

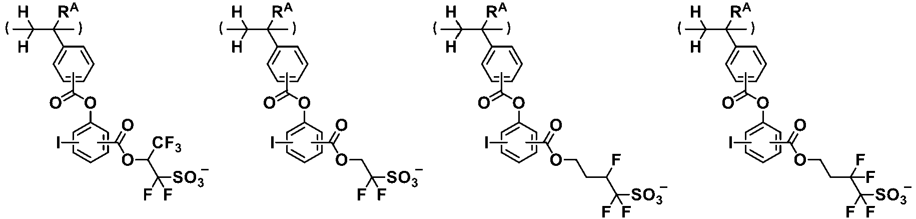

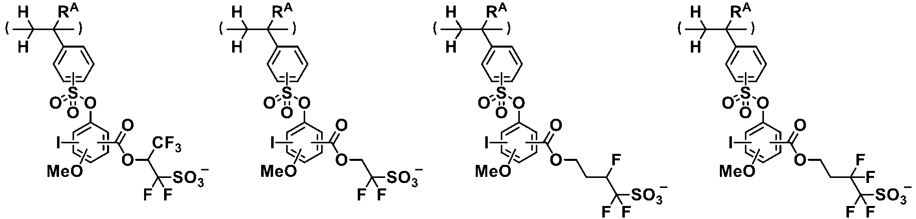

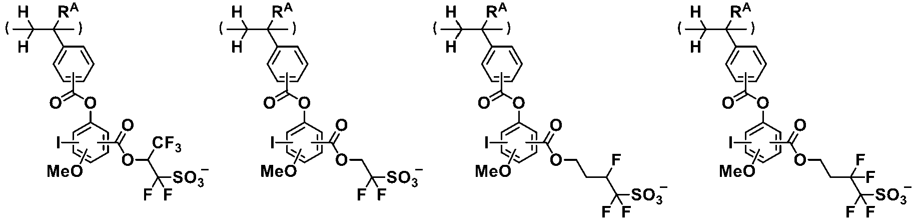

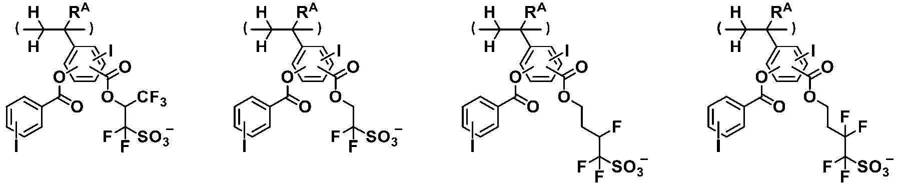

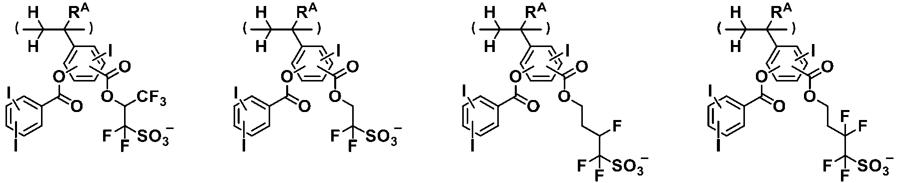

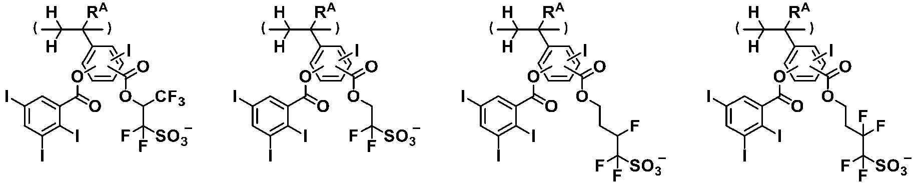

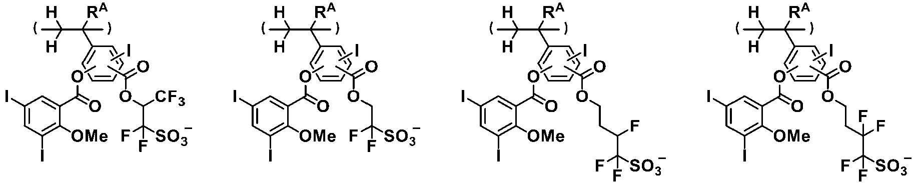

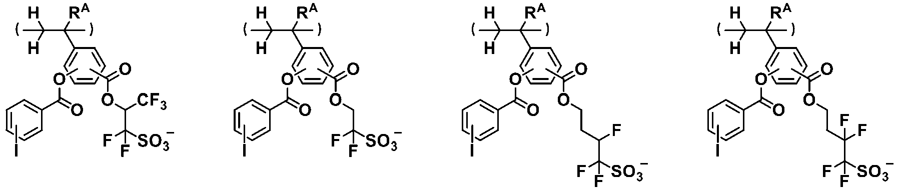

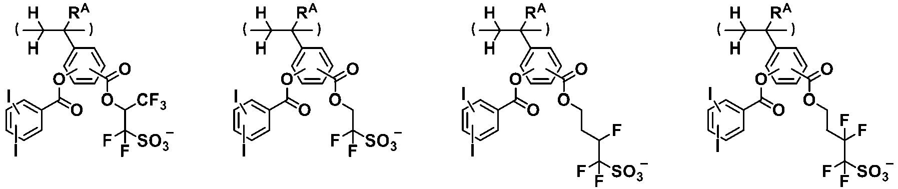

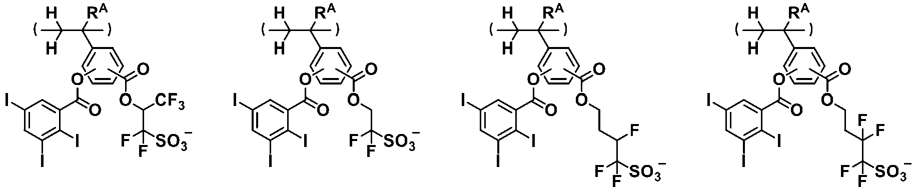

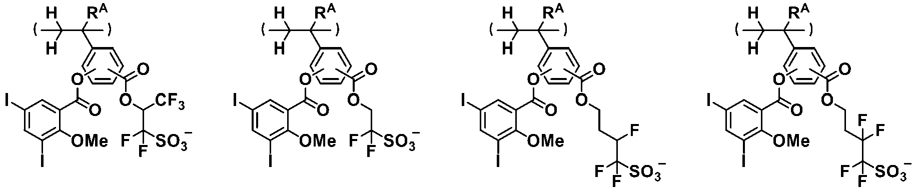

Examples of the anion in repeat unit B9 are shown below, but not limited thereto. Herein R^{A} is as defined above.

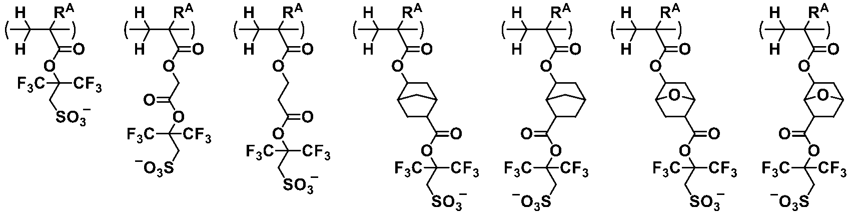

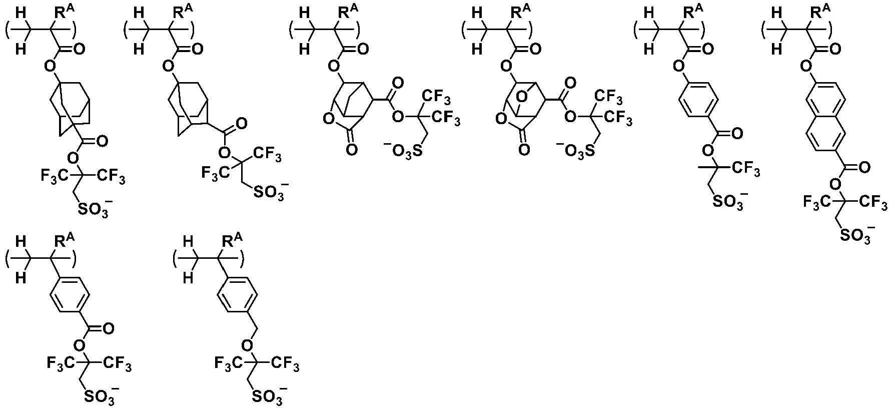

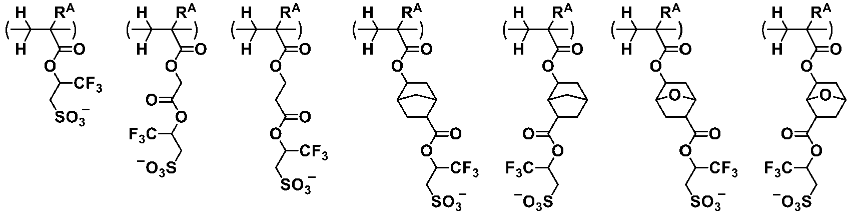

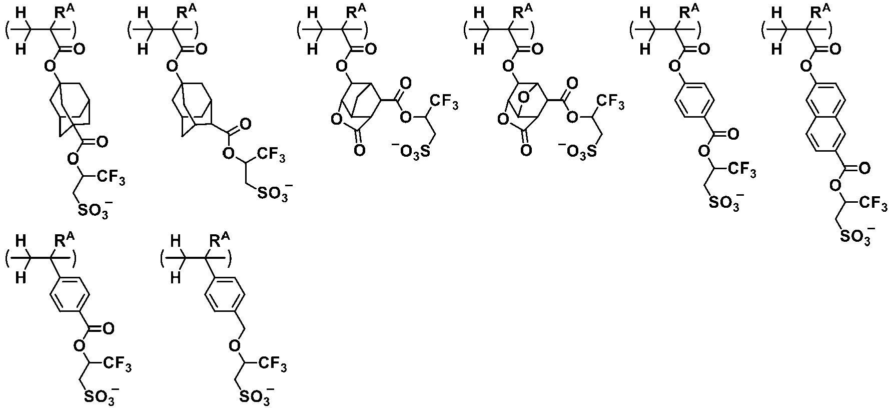

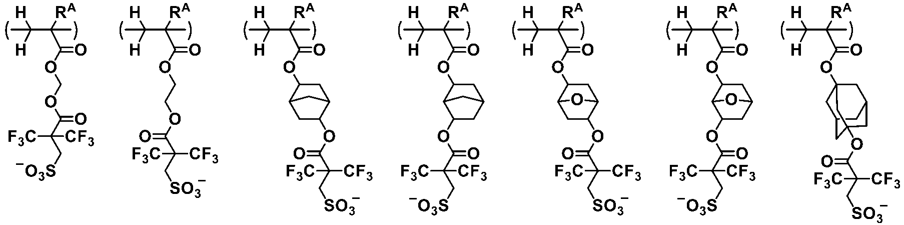

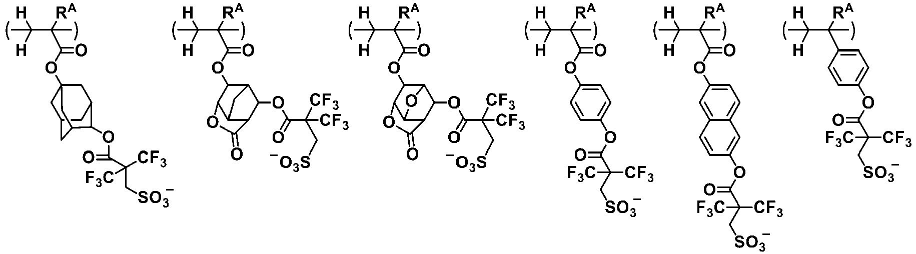

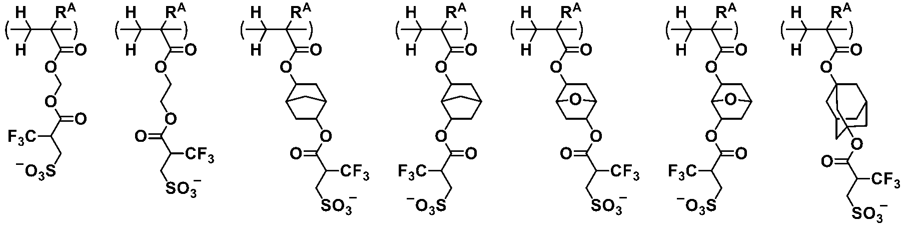

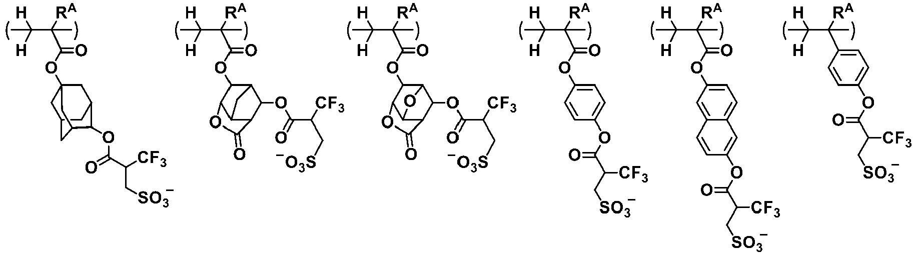

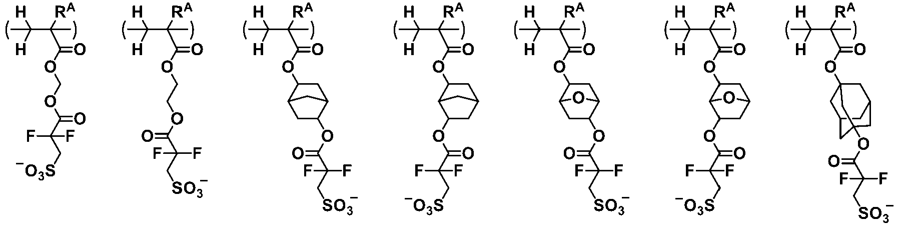

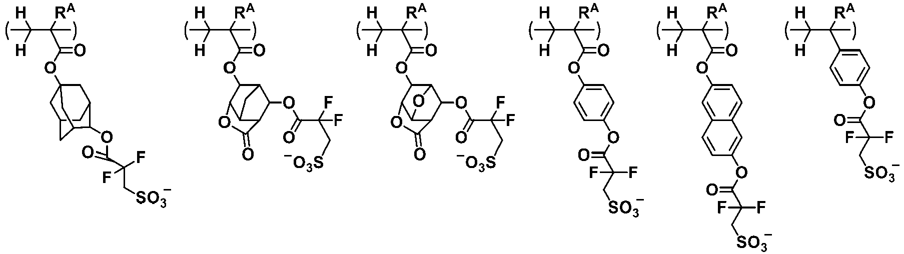

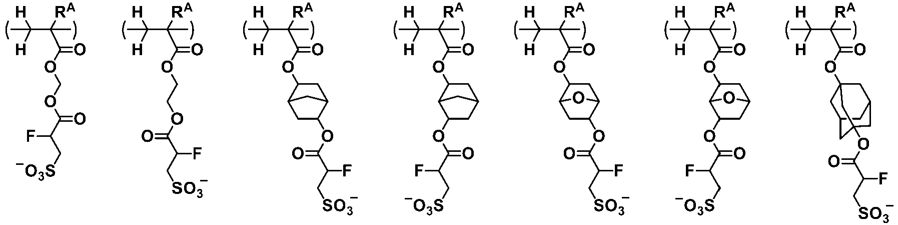

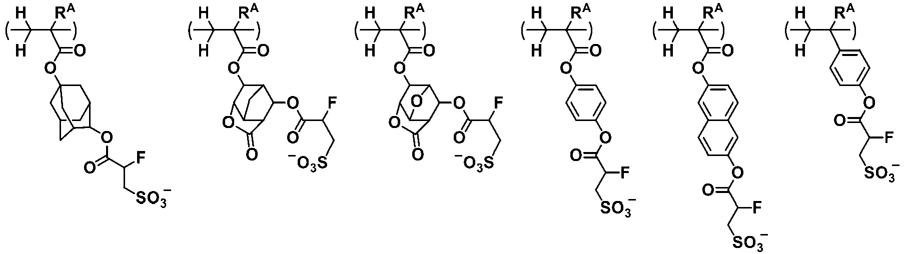

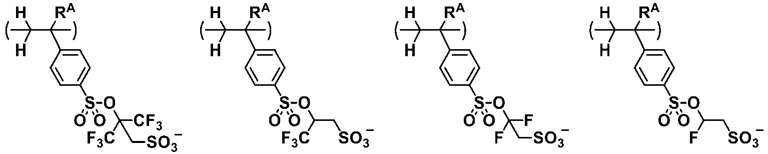

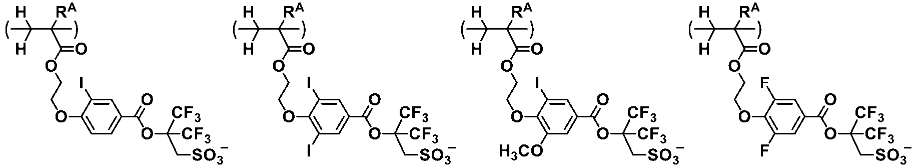

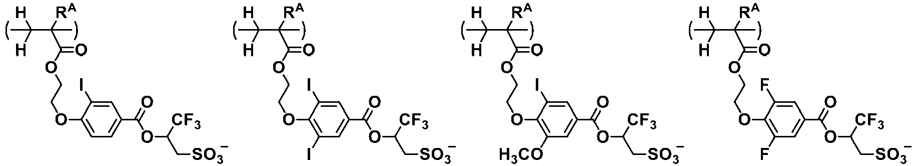

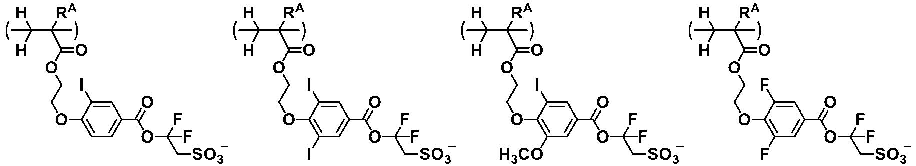

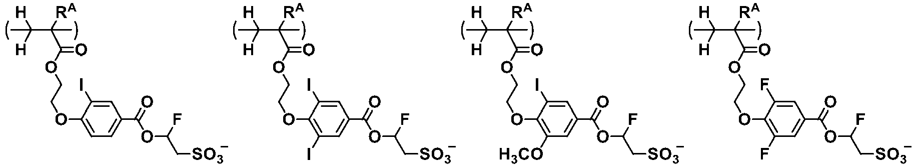

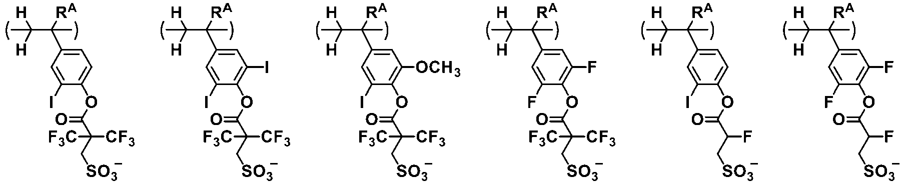

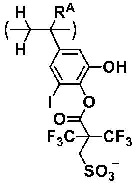

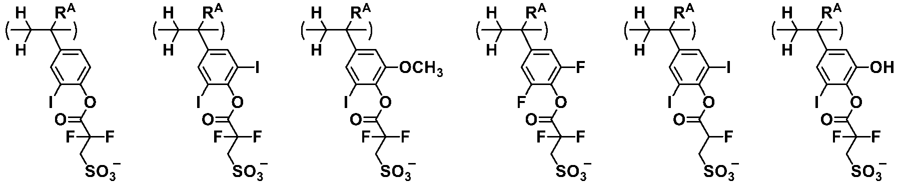

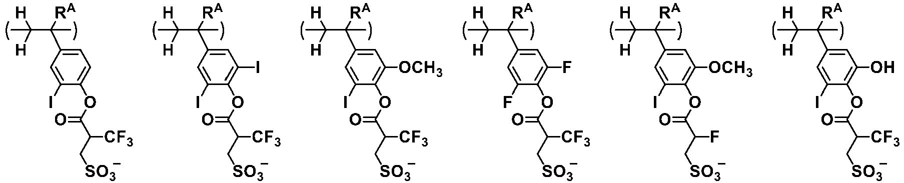

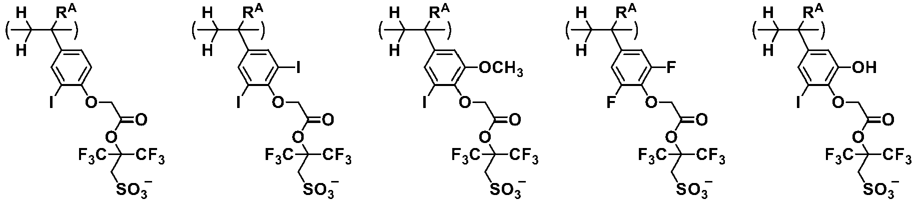

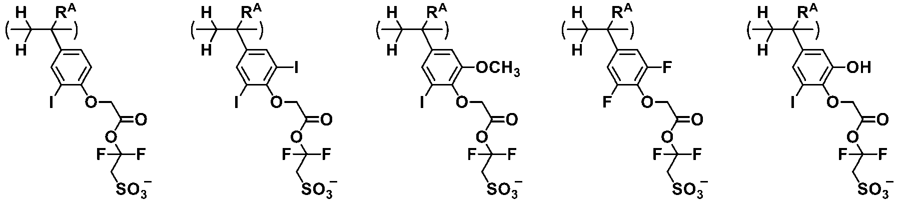

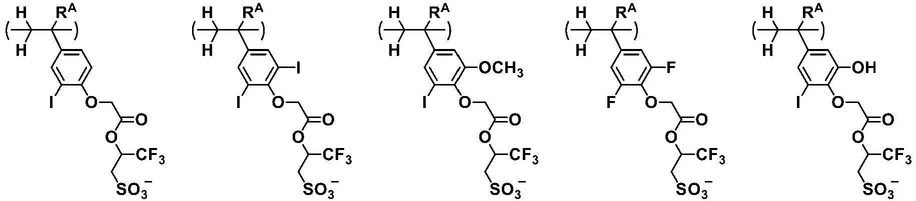

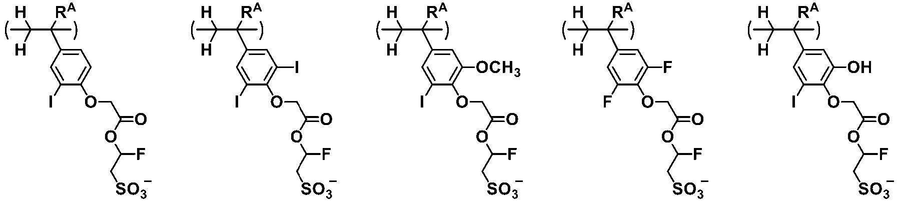

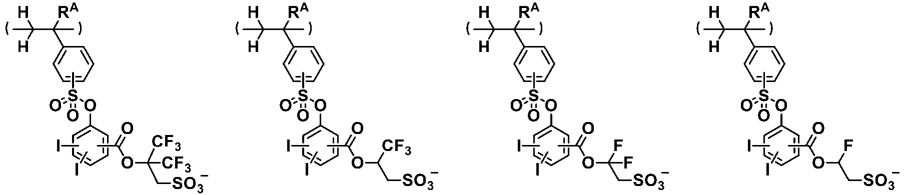

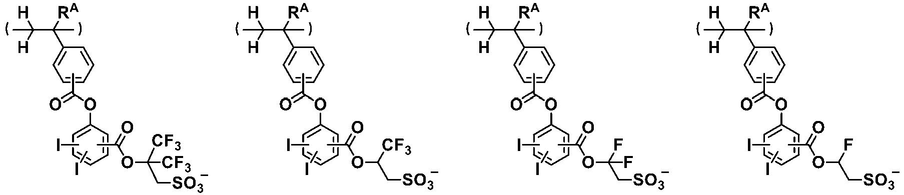

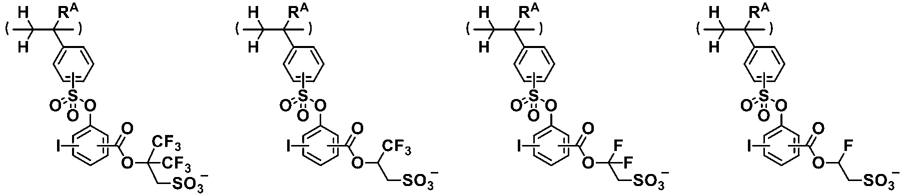

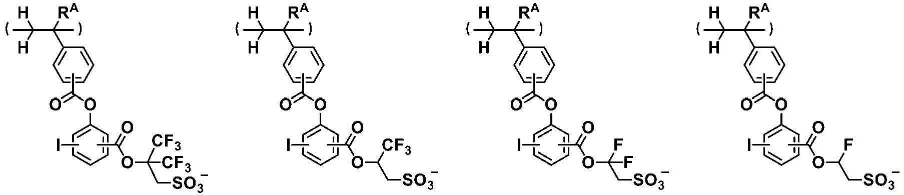

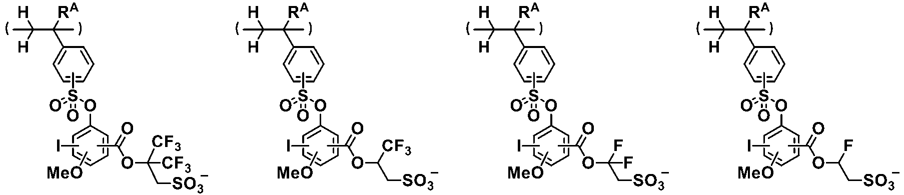

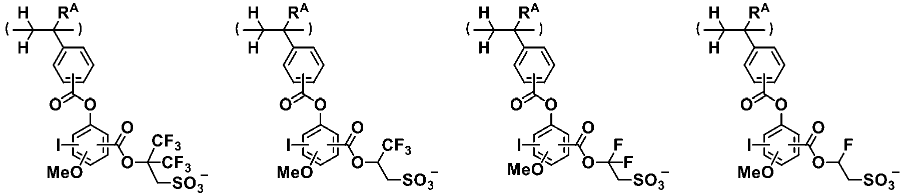

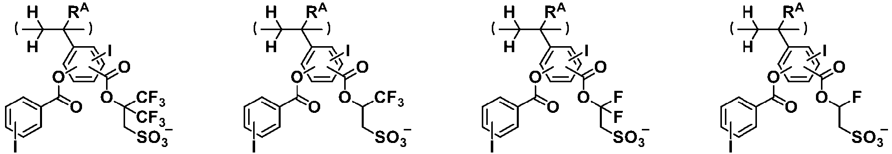

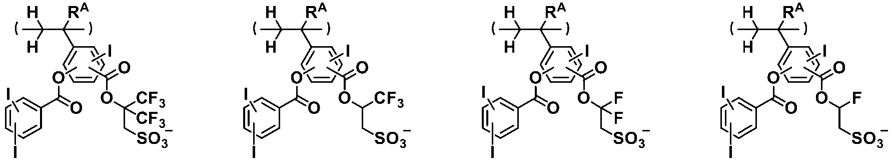

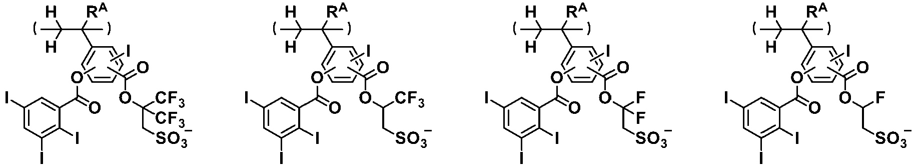

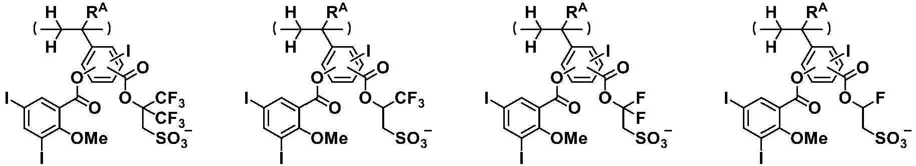

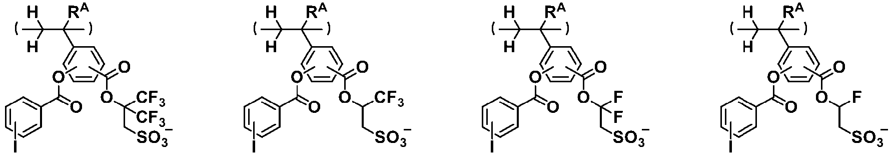

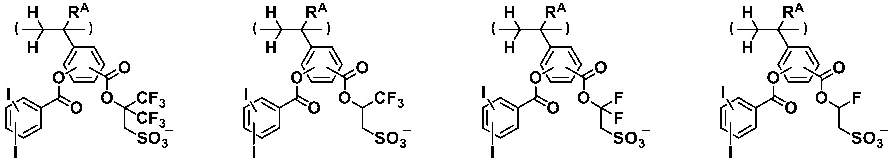

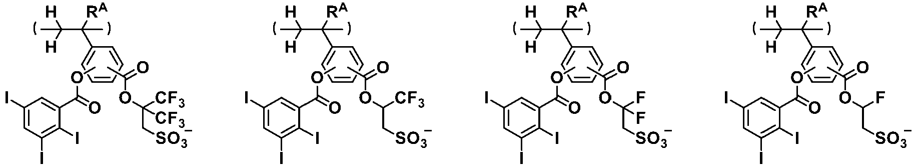

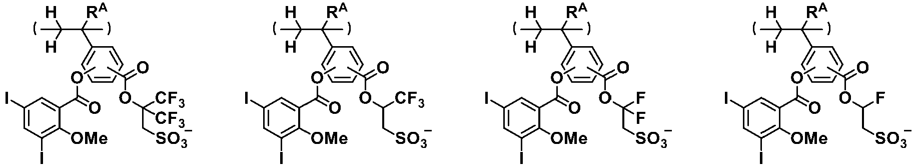

Examples of the anion in repeat unit B10 are shown below, but not limited thereto. Herein R^{A} is as defined above.

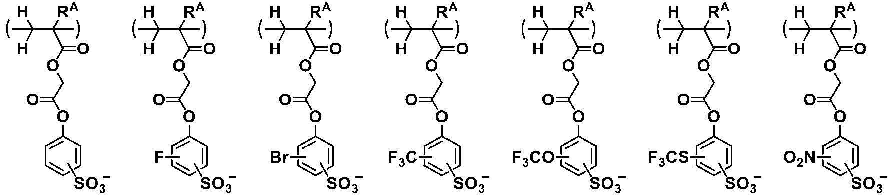

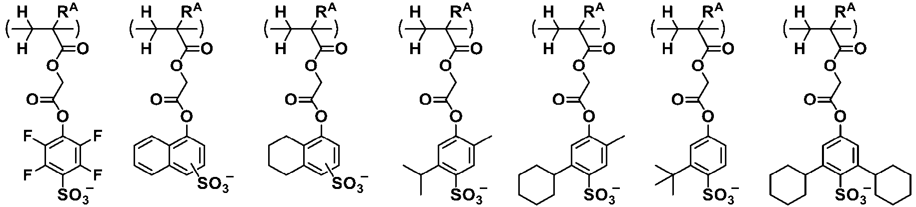

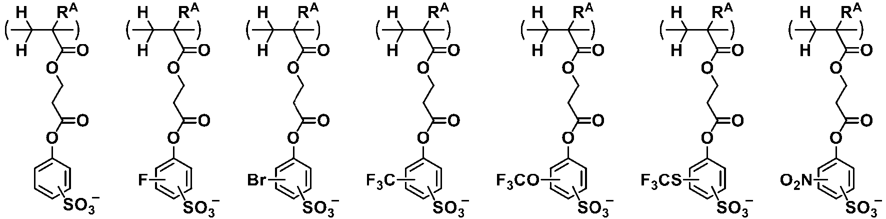

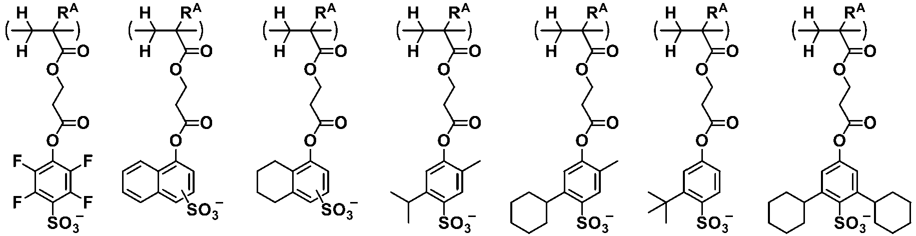

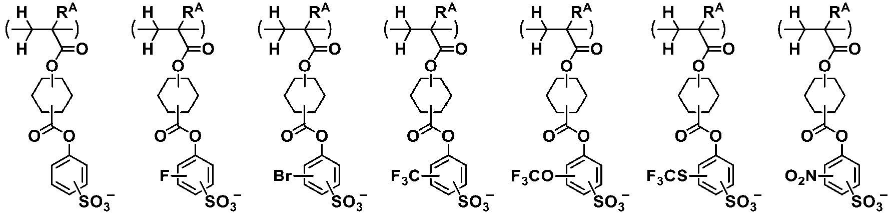

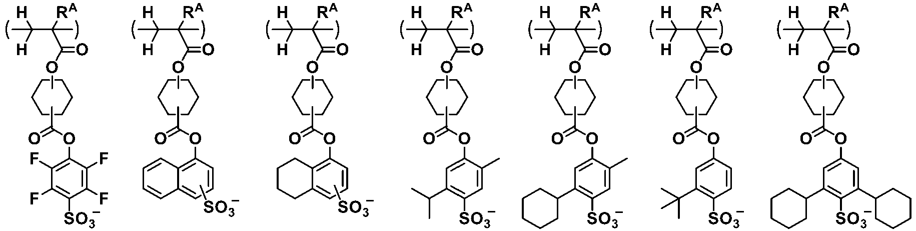

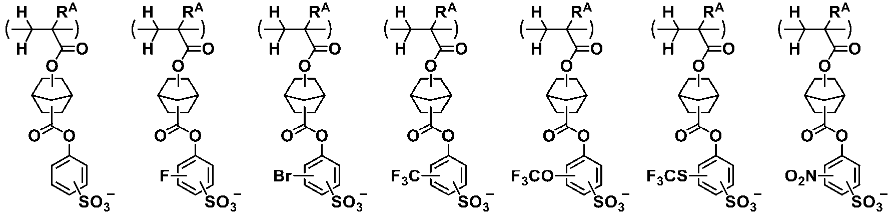

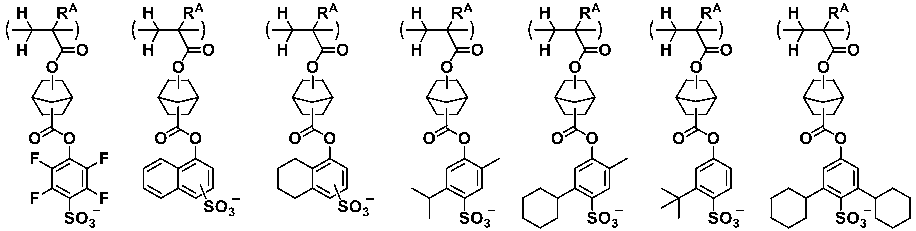

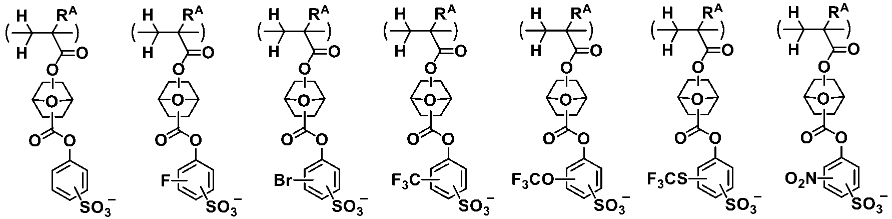

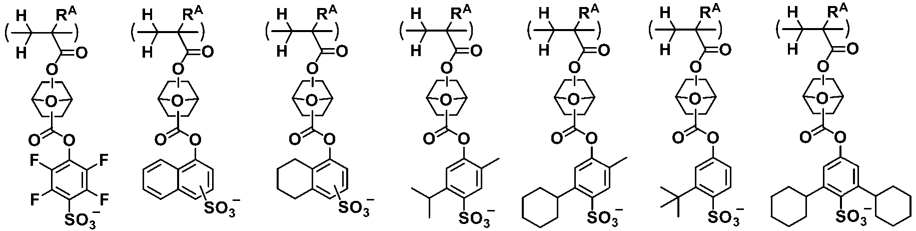

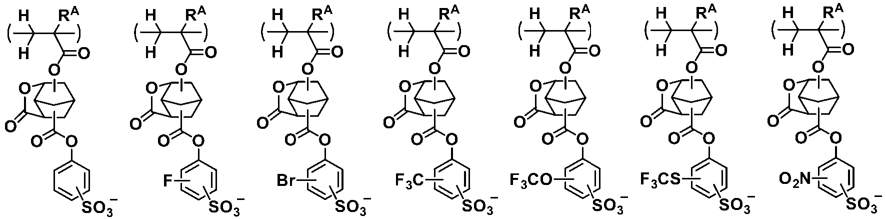

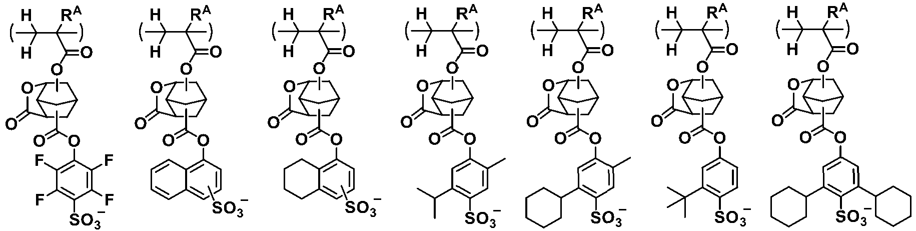

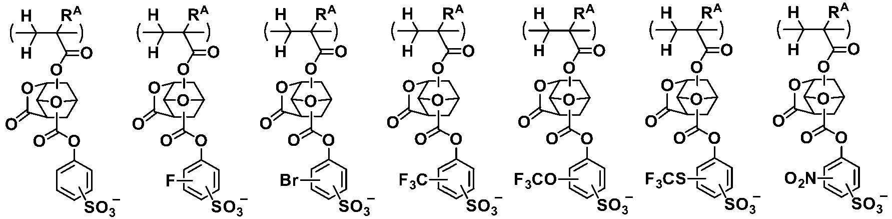

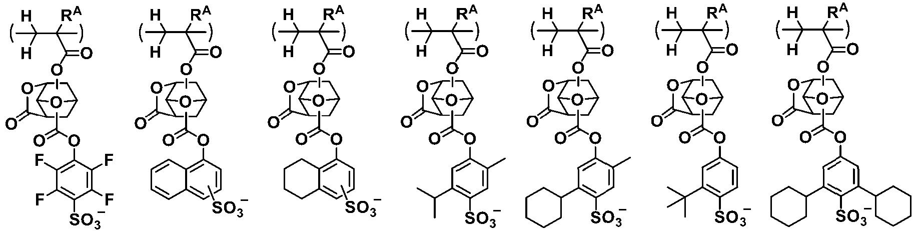

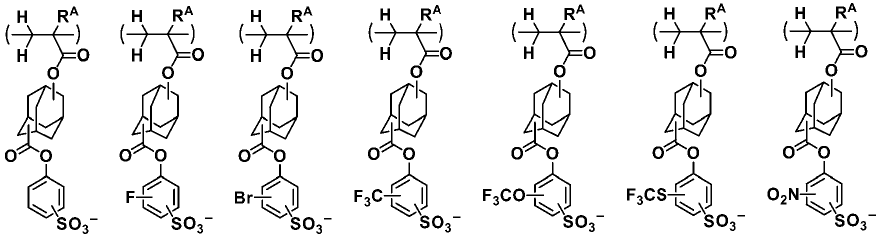

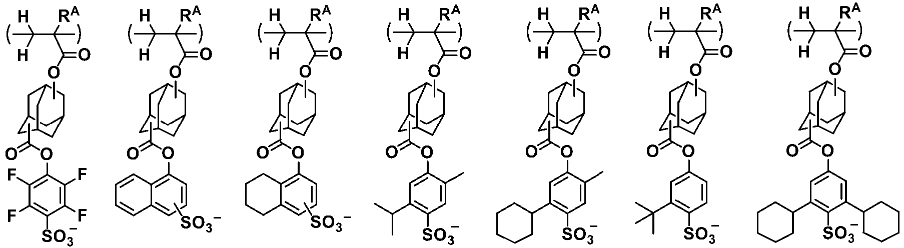

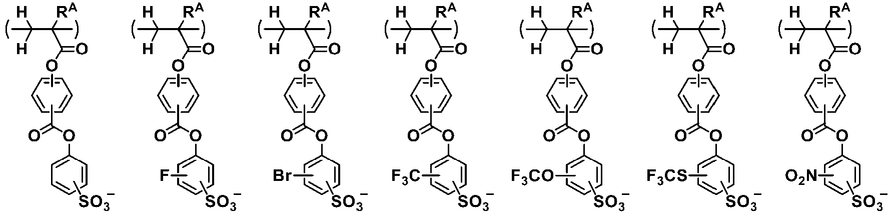

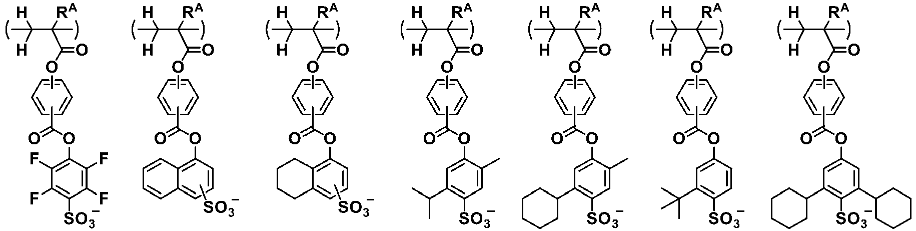

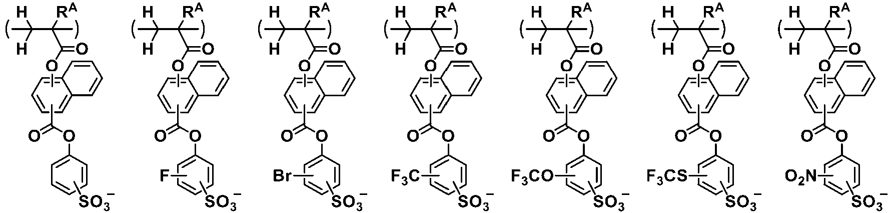

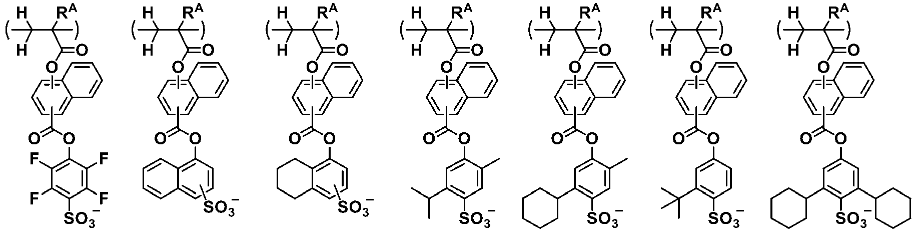

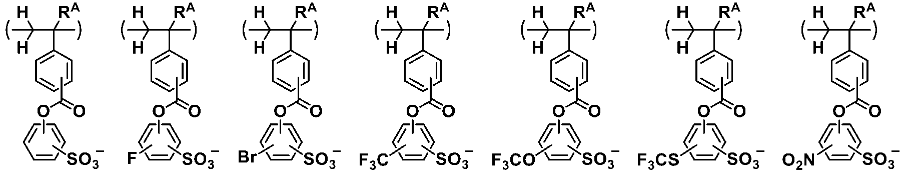

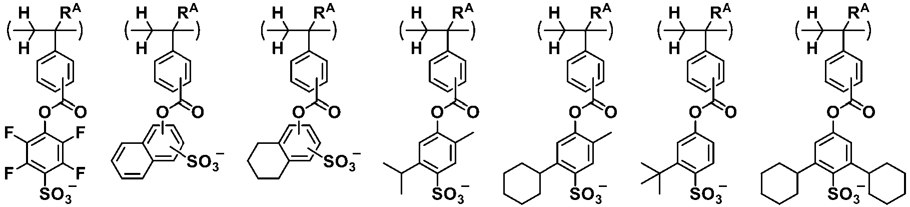

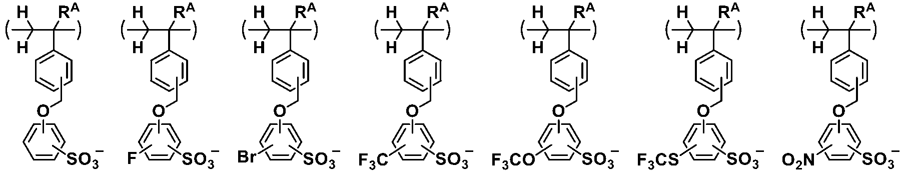

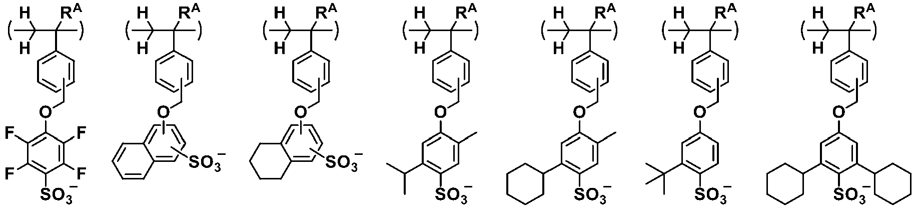

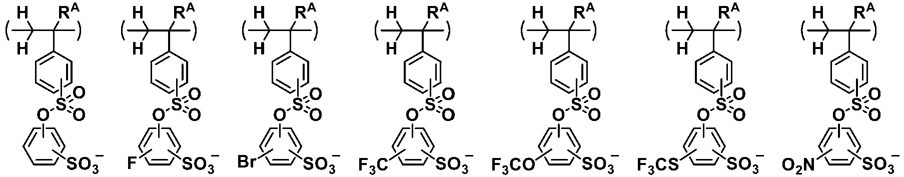

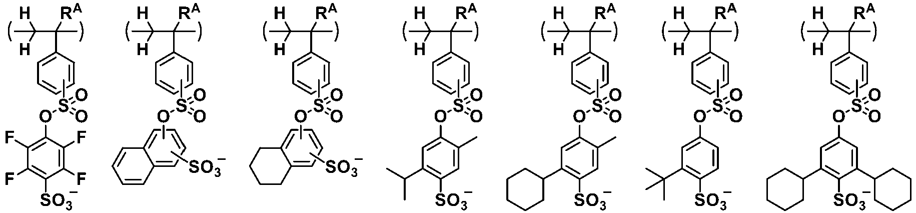

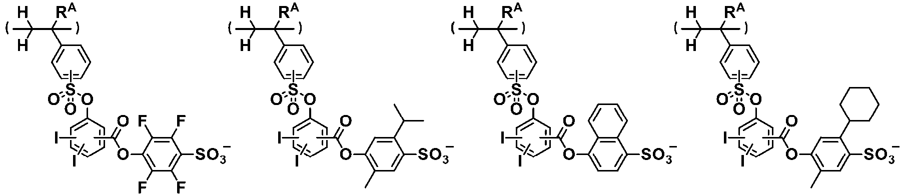

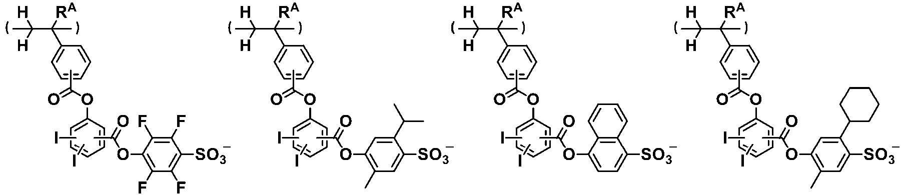

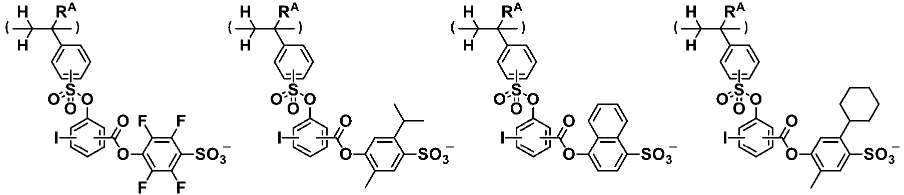

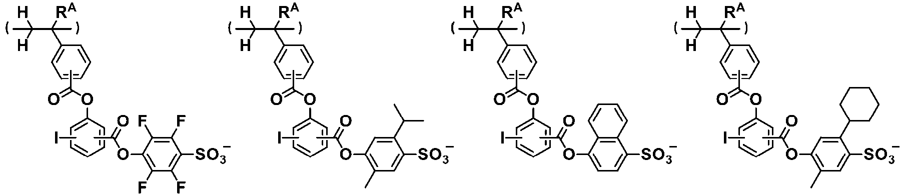

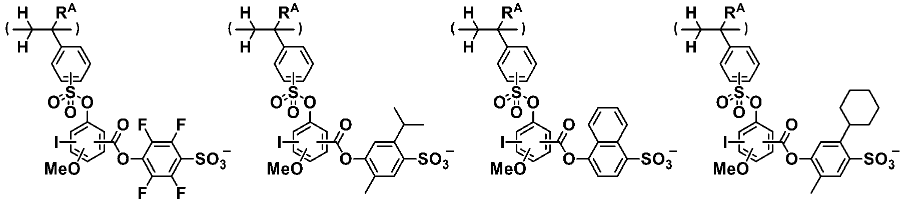

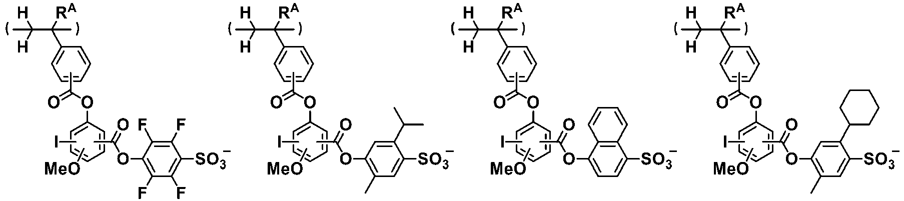

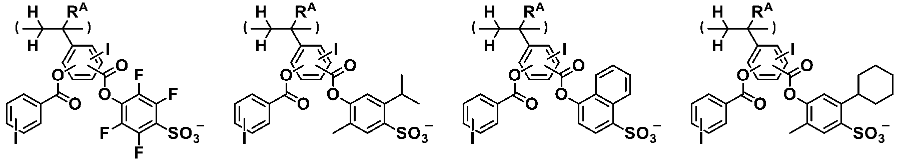

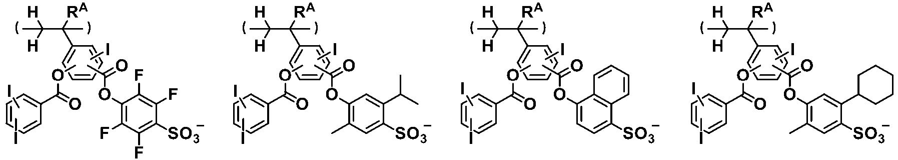

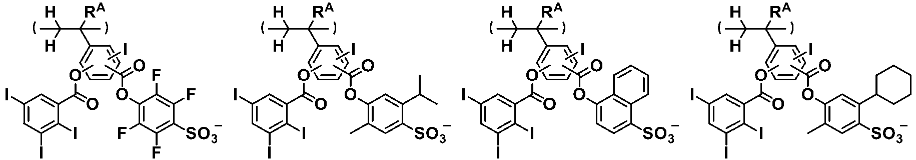

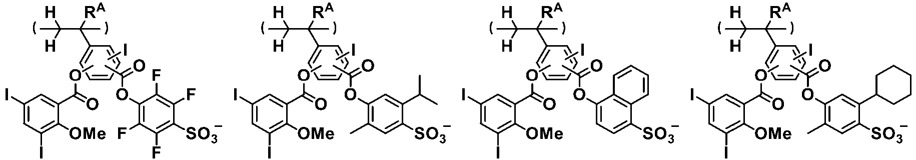

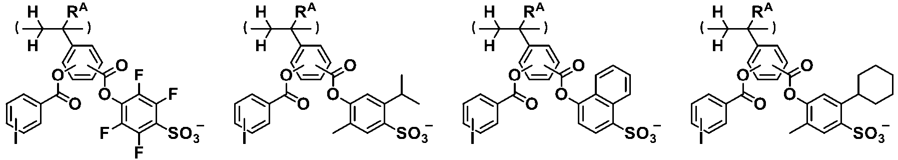

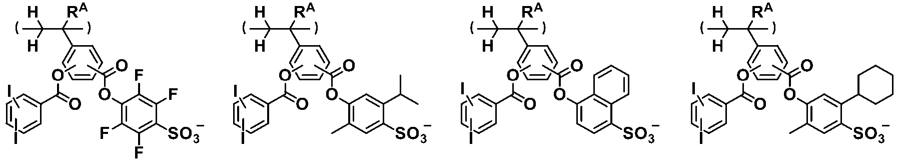

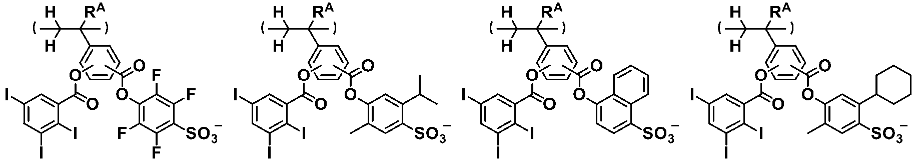

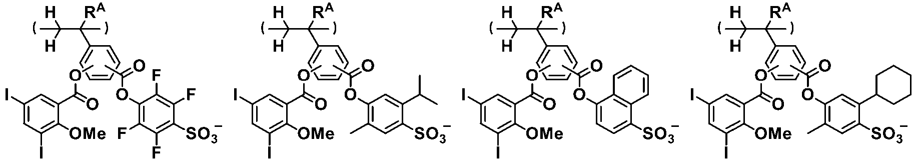

Examples of the anion in repeat unit B11 are shown below, but not limited thereto. Herein R^{A} is as defined above.

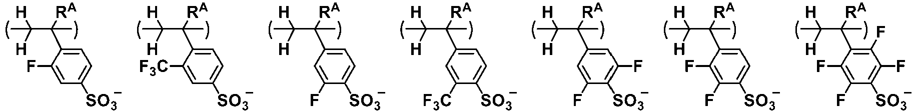

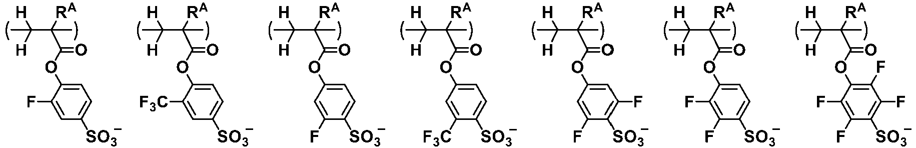

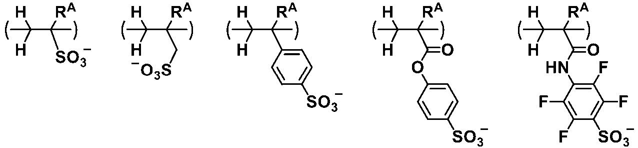

In formulae (B8) to (B11), A⁺ is an onium cation. Suitable onium cations include sulfonium, iodonium and ammonium cations, with the sulfonium and iodonium cations being preferred. Examples of the sulfonium cation include those exemplified above for the sulfonium cation having formula (Z-1) and those exemplified above for the sulfonium cation having formula (Z-3), but are not limited thereto. Examples of the iodonium cation include those exemplified above for the iodonium cation having formula (Z-2), but are not limited thereto. Examples of the ammonium cation are as will be exemplified later as the ammonium cation having formula (am-1), but not limited thereto.

Illustrative structures of repeat units B7 to B11 include arbitrary combinations of anions with cations, both as mentioned above.

The repeat units B7 to B11 are capable of generating an acid upon exposure to high-energy radiation. It is believed that binding of the relevant units to a polymer enables to appropriately control acid diffusion and to form a pattern with reduced LER. Since the acid-generating unit is bound to a polymer, the phenomenon that acid volatilizes from the exposed region and re-deposits on the unexposed region during bake in vacuum is suppressed. This is effective for reducing LER and for suppressing unwanted negative-working reaction in the unexposed region for reducing defectiveness.

Each of repeat units B7 to B11 may be of one type or a mixture of two or more types.

The polymer B or B' may further comprise (meth)acrylate units having an adhesive group such as lactone structure or hydroxy group other than phenolic hydroxy. These repeat units are effective for fine adjustment of properties of a resist film.

Examples of the (meth)acrylate unit having an adhesive group include repeat units having the following formulae (B12) to (B14), which are also referred to as repeat units B12 to B14. While these units do not exhibit acidity, they may be used as auxiliary units for providing adhesion to substrates or adjusting solubility.

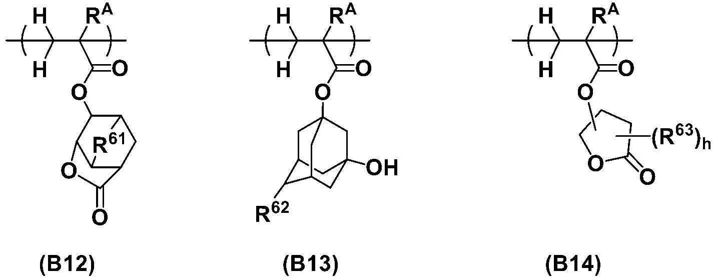

In formulae (B12) to (B14), R^{A} is each independently hydrogen, fluorine, methyl or trifluoromethyl. R⁶¹ is -O- or methylene. R⁶² is hydrogen or hydroxy. R⁶³ is a C₁-C₄ saturated hydrocarbyl group, and h is 0, 1, 2 or 3.

In polymer B, the content of repeat units B1 is preferably 30 to 95 mol%, more preferably 50 to 85 mol% of the overall units of the polymer for establishing a high contrast between regions exposed to high-energy radiation (or negative-turning regions) and unexposed regions (or non-negative-turning regions) to gain a high resolution. When the polymer further comprises repeat units B2 and/or B3, the content of repeat units B2 and B3 is preferably 5 to 70 mol%, more preferably 10 to 60 mol% for promoting negative-turning reaction. The content of repeat units B4 to B6 is preferably 0 to 30 mol%, more preferably 3 to 20 mol% for improving etch resistance. The polymer may further contain 0 to 30 mol%, preferably 0 to 20 mol% of other repeat units.

When polymer B' does not contain repeat units B7 to B11, the content of repeat units B1 is preferably 25 to 95 mol%, more preferably 40 to 85 mol% of the overall units of the polymer. The content of repeat units B4 to B6 is preferably 0 to 30 mol%, more preferably 3 to 20 mol%. The content of repeat units B2 and B3 is preferably 5 to 70 mol%, more preferably 10 to 60 mol%. The polymer may further contain 0 to 30 mol%, preferably 0 to 20 mol% of other repeat units.

When polymer B' contains repeat units B7 to B11, the content of repeat units B1 is preferably 25 to 94.5 mol%, more preferably 36 to 85 mol% of the overall units of the polymer. The content of repeat units B4 to B6 is preferably 0 to 30 mol%, more preferably 3 to 20 mol%. The content of repeat units B2 and B3 is preferably 5 to 70 mol%, more preferably 10 to 60 mol%. The total content of repeat units B1 to B6 is preferably 60 to 99.5 mol%. The content of repeat units B7 to B11 is preferably 0.5 to 20 mol%, more preferably 1 to 10 mol%. The polymer may further contain 0 to 30 mol%, preferably 0 to 20 mol% of other repeat units.

The content of repeat units B1 to B6 is preferably at least 60 mol%, more preferably at least 70 mol%, even more preferably at least 80 mol% based on the overall repeat units of the polymer. The range ensures that the chemically amplified negative resist composition has the necessary properties.

The preferred polymer B' comprises repeat units having the formula (B1-1), repeat units having the formula (B2-1), (B2-2) or (B3-1), and repeat units having the formula (B8-1), all shown below.

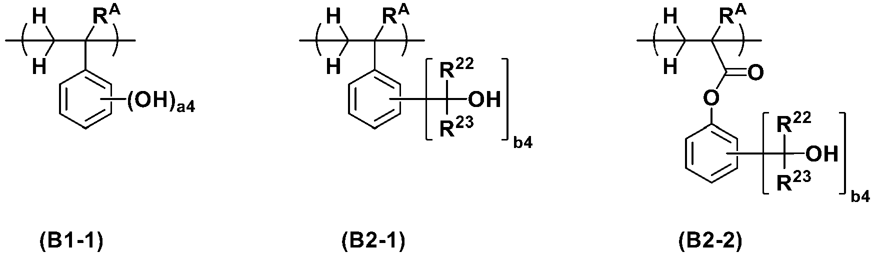

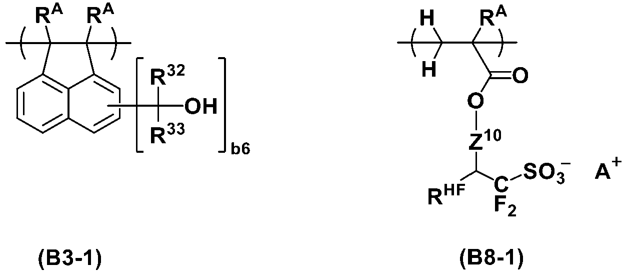

Herein, a4, b4, b6, R^{A}, R²², R²³, R³², R³³, and A⁺ are as defined above. R^{HF} is hydrogen or trifluoromethyl. Z¹⁰ is a single bond or *****-Z¹⁰¹-C(=O)-O- wherein Z¹⁰¹ is a C₁-C₂₀ hydrocarbylene group which may contain a heteroatom, and ***** designates a point of attachment to the oxygen in the formula.

When polymer B' is used as the base polymer (B), it may be a mixture of a polymer containing repeat units B7 to B14 and a polymer free of repeat units B7 to B14. In the chemically amplified negative resist composition, the polymer free of repeat units B7 to B14 is preferably present in an amount of 2 to 5,000 parts by weight, more preferably 10 to 1,000 parts by weight per 100 parts by weight of the polymer containing repeat units B7 to B14.

Reference is now made to the use of the chemically amplified negative resist composition in the fabrication of photomasks. The lithography of the advanced generation employs a coating film having a thickness of up to 150 nm, preferably up to 100 nm. Since an intense development process is often employed to minimize defects resulting from resist residues, the base polymer should preferably have a dissolution rate in alkaline developer (typically 2.38 wt% tetramethylammonium hydroxide (TMAH) aqueous solution) of up to 80 nm/sec, more preferably up to 50 nm/sec in order to form a small size pattern. When the chemically amplified negative resist composition is used in the EUV lithography process for fabricating an LSI chip from a wafer, for example, the coating film often has a thickness of up to 100 nm, in view of the necessity of patterning narrow lines of 50 nm or less. In consideration of the risk that the pattern of such thin film can be degraded by development, the polymer preferably has a dissolution rate of up to 80 nm/sec, more preferably up to 50 nm/sec.

The polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to WO 2006/121096, JP-A 2004-115630, JP-A 2008-102383, and JP-A 2008-304590.

The polymer should preferably have a Mw of 1,000 to 50,000, and more preferably 2,000 to 20,000. A Mw of at least 1,000 eliminates the risk that pattern features are rounded at their top, inviting degradations of resolution and LER. A Mw of up to 50,000 eliminates the risk that LER is increased when a pattern with a line width of up to 100 nm is formed. As used herein, Mw is measured by GPC versus polystyrene standards using tetrahydrofuran (THF) or dimethylformamide (DMF).

The polymer preferably has a narrow molecular weight distribution or dispersity (Mw/Mn) of 1.0 to 2.0, more preferably 1.0 to 1.8. A polymer with such a narrow dispersity eliminates the risk that foreign particles are left on the pattern after development and the pattern profile is aggravated.

### (C) Crosslinker

When the base polymer (B) does not contain polymer B', the negative resist composition preferably comprises a crosslinker as component (C). When the base polymer (B) contains polymer B', a crosslinker need not be added.

Suitable crosslinkers which can be used herein include epoxy compounds, melamine compounds, guanamine compounds, glycoluril compounds and urea compounds having substituted thereon at least one group selected from among methylol, alkoxymethyl and acyloxymethyl groups, isocyanate compounds, azide compounds, and compounds having a double bond such as an alkenyloxy group. These compounds may be used as an additive or introduced into a polymer side chain as a pendant. Hydroxy-containing compounds may also be used as the crosslinker.

Of the foregoing crosslinkers, examples of suitable epoxy compounds include tris(2,3-epoxypropyl) isocyanurate, trimethylolmethane triglycidyl ether, trimethylolpropane triglycidyl ether, and triethylolethane triglycidyl ether.

Examples of the melamine compound include hexamethylol melamine, hexamethoxymethyl melamine, hexamethylol melamine compounds having 1 to 6 methylol groups methoxymethylated and mixtures thereof, hexamethoxyethyl melamine, hexaacyloxymethyl melamine, hexamethylol melamine compounds having 1 to 6 methylol groups acyloxymethylated and mixtures thereof.

Examples of the guanamine compound include tetramethylol guanamine, tetramethoxymethyl guanamine, tetramethylol guanamine compounds having 1 to 4 methylol groups methoxymethylated and mixtures thereof, tetramethoxyethyl guanamine, tetraacyloxyguanamine, tetramethylol guanamine compounds having 1 to 4 methylol groups acyloxymethylated and mixtures thereof.

Examples of the glycoluril compound include tetramethylol glycoluril, tetramethoxyglycoluril, tetramethoxymethyl glycoluril, tetramethylol glycoluril compounds having 1 to 4 methylol groups methoxymethylated and mixtures thereof, tetramethylol glycoluril compounds having 1 to 4 methylol groups acyloxymethylated and mixtures thereof.

Examples of the urea compound include tetramethylol urea, tetramethoxymethyl urea, tetramethylol urea compounds having 1 to 4 methylol groups methoxymethylated and mixtures thereof, and tetramethoxyethyl urea.

Suitable isocyanate compounds include tolylene diisocyanate, diphenylmethane diisocyanate, hexamethylene diisocyanate and cyclohexane diisocyanate.

Suitable azide compounds include 1,1'-biphenyl-4,4'-bisazide, 4,4'-methylidenebisazide, and 4,4'-oxybisazide.

Examples of the alkenyloxy-containing compound include ethylene glycol divinyl ether, triethylene glycol divinyl ether, 1,2-propanediol divinyl ether, 1,4-butanediol divinyl ether, tetramethylene glycol divinyl ether, neopentyl glycol divinyl ether, trimethylol propane trivinyl ether, hexanediol divinyl ether, 1,4-cyclohexanediol divinyl ether, pentaerythritol trivinyl ether, pentaerythritol tetravinyl ether, sorbitol tetravinyl ether, sorbitol pentavinyl ether, and trimethylol propane trivinyl ether.

An appropriate amount of the crosslinker (C) used is 0.1 to 50 parts, and more preferably 1 to 30 parts by weight per 80 parts by weight of the base polymer (B). As long as the amount of the crosslinker is in the range, the risk of resolution being reduced by forming bridges between pattern features is mitigated. The crosslinkers may be used alone or in admixture.

### (D) Fluorinated polymer

The negative resist composition may further comprise a fluorinated polymer for the purposes of enhancing contrast, preventing chemical flare of acid upon exposure to high-energy radiation, preventing mixing of acid from an anti-charging film in the step of coating an anti-charging film-forming material on a resist film, and suppressing unexpected unnecessary pattern degradation. The fluorinated polymer contains repeat units of at least one type selected from repeat units having the formula (D1), repeat units having the formula (D2), repeat units having the formula (D3), and repeat units having the formula (D4), and may contain repeat units of at least one type selected from repeat units having the formula (D5) and repeat units having the formula (D6). It is noted that repeat units having formulae (D1), (D2), (D3), (D4), (D5), and (D6) are also referred to as repeat units D1, D2, D3, D4, D5, and D6, respectively, hereinafter. Since the fluorinated polymer also has a surface active function, it can prevent insoluble residues from re-depositing onto the substrate during the development step and is thus effective for preventing development defects.

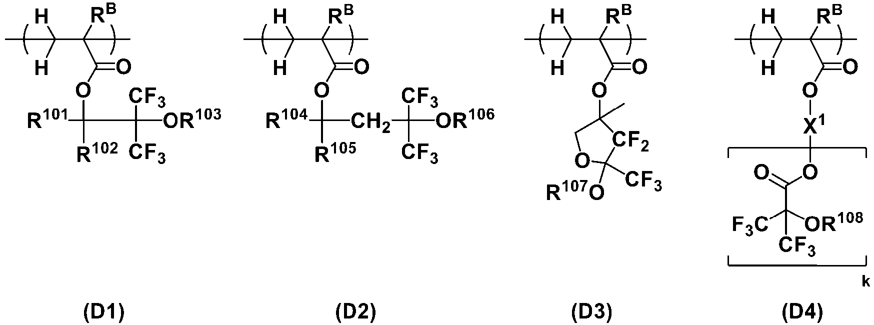

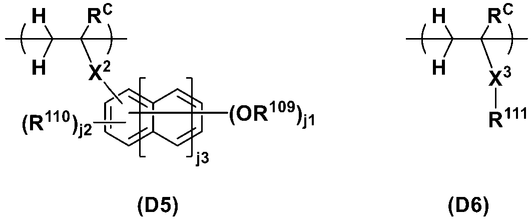

In formulae (D1) to (D6), j1 is 1, 2 or 3, j2 is an integer satisfying: 0 ≤ j2 ≤ 5+2(j3)j1, j3 is 0 or 1, and k is 1, 2 or 3. R^{B} is each independently hydrogen, fluorine, methyl or trifluoromethyl. R^{C} is each independently hydrogen or methyl. R¹⁰¹, R¹⁰², R¹⁰⁴ and R¹⁰⁵ are each independently hydrogen or a C₁-C₁₀ saturated hydrocarbyl group. R¹⁰³, R¹⁰⁶, R¹⁰⁷ and R¹⁰⁸ are each independently hydrogen, a C₁-C₁₅ hydrocarbyl group or fluorinated hydrocarbyl group, or an acid labile group, with the proviso that an ether bond or carbonyl moiety may intervene in a carbon-carbon bond in the hydrocarbyl groups or fluorinated hydrocarbyl groups represented by R¹⁰³, R¹⁰⁶, R¹⁰⁷ and R¹⁰⁸. R¹⁰⁹ is hydrogen or a C₁-C₅ straight or branched hydrocarbyl group in which a heteroatom-containing moiety may intervene in a carbon-carbon bond. R¹¹⁰ is a C₁-C₅ straight or branched hydrocarbyl group in which a heteroatom-containing moiety may intervene in a carbon-carbon bond. When j2 is 2 or more, a plurality of R¹¹⁰ may be identical or different. R¹¹¹ is a C₁-C₂₀ saturated hydrocarbyl group in which at least one hydrogen is substituted by fluorine and some constituent -CH₂- may be replaced by an ester bond or ether bond. X¹ is a C₁-C₂₀ (k+1)-valent hydrocarbon group or C₁-C₂₀ (k+1)-valent fluorinated hydrocarbon group. X² is a single bond, *-C(=O)-O- or *-C(=O)-NH- wherein * designates a point of attachment to the carbon atom in the backbone. X³ is a single bond, -O-, *-C(=O)-O-X³¹-X³²- or *-C(=O)-NH-X³¹-³²-, wherein X³¹ is a single bond or a C₁-C₁₀ saturated hydrocarbylene group, X³² is a single bond, ester bond, ether bond or sulfonamide bond, and * designates a point of attachment to the carbon atom in the backbone.

In formulae (D1) and (D2), examples of the C₁-C₁₀ saturated hydrocarbyl group represented by R¹⁰¹, R¹⁰², R¹⁰⁴ and R¹⁰⁵ include C₁-C₁₀ alkyl groups such as methyl, ethyl, n-propyl, isopropyl, n-butyl, isobutyl, sec-butyl, tert-butyl, n-pentyl, n-hexyl, n-heptyl, n-octyl, n-nonyl, and n-decyl, and C₃-C₁₀ cyclic saturated hydrocarbyl groups such as cyclopropyl, cyclobutyl, cyclopentyl, cyclohexyl, adamantyl, and norbornyl. Inter alia, C₁-C₆ saturated hydrocarbyl groups are preferred.

In formulae (D1) to (D4), the C₁-C₁₅ hydrocarbyl group represented by R¹⁰³, R¹⁰⁶, R¹⁰⁷ and R¹⁰⁸ may be straight, branched or cyclic and examples thereof include C₁-C₁₅ alkyl, C₂-C₁₅ alkenyl and C₂-C₁₅ alkynyl groups, with the alkyl groups being preferred. Suitable alkyl groups include methyl, ethyl, n-propyl, isopropyl, n-butyl, isobutyl, sec-butyl, n-pentyl, n-hexyl, n-heptyl, n-octyl, n-nonyl, n-decyl, n-undecyl, n-dodecyl, n-tridecyl, n-tetradecyl and n-pentadecyl. The fluorinated hydrocarbyl groups correspond to the foregoing hydrocarbyl groups in which some or all carbon-bonded hydrogen atoms are substituted by fluorine atoms.

In formula (D4), examples of the C₁-C₂₀ (k+1)-valent hydrocarbon group X¹ include the foregoing C₁-C₂₀ alkyl groups and C₃-C₂₀ cyclic saturated hydrocarbyl groups, with "k" number of hydrogen atoms being eliminated. Examples of the C₁-C₂₀ (k+1)-valent fluorinated hydrocarbon group X¹ include the foregoing (k+1)-valent hydrocarbon groups in which at least one hydrogen atom is substituted by fluorine.

Examples of the repeat units D1 to D4 are given below, but not limited thereto. Herein R^{B} is as defined above.

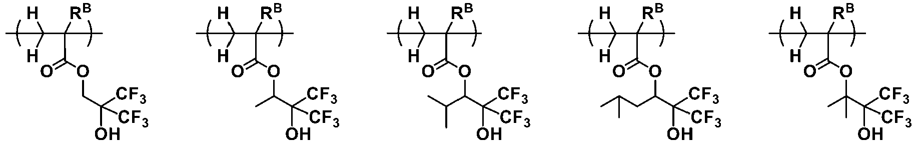

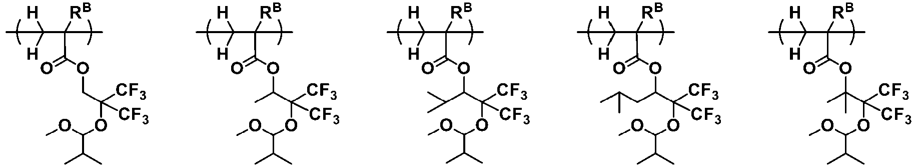

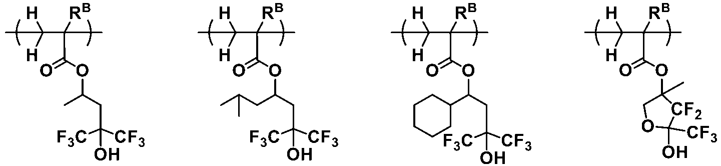

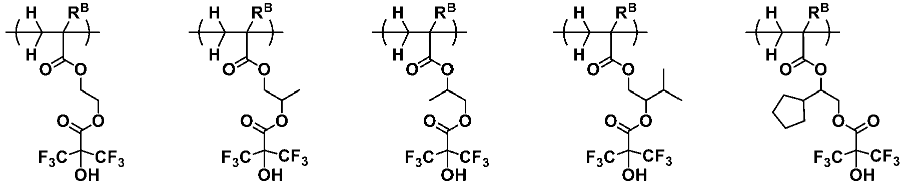

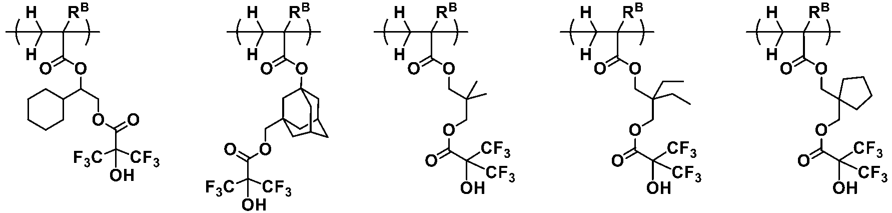

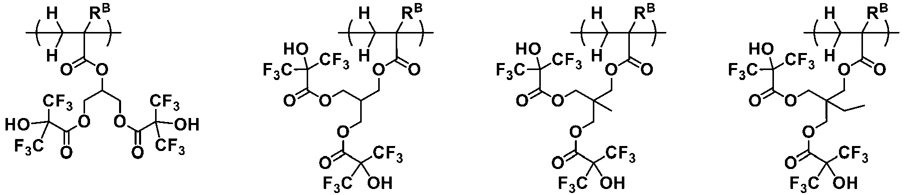

In formula (D5), examples of the C₁-C₅ hydrocarbyl groups R¹⁰⁹ and R¹¹⁰ include alkyl, alkenyl and alkynyl groups, with the alkyl groups being preferred. Suitable alkyl groups include methyl, ethyl, n-propyl, isopropyl, n-butyl, isobutyl, sec-butyl, and n-pentyl. In these groups, a moiety containing a heteroatom such as oxygen, sulfur or nitrogen may intervene in a carbon-carbon bond.

In formula (D5), -OR¹⁰⁹ is preferably a hydrophilic group. In this case, R¹⁰⁹ is preferably hydrogen or a C₁-C₅ alkyl group in which oxygen intervenes in a carbon-carbon bond.

In formula (D5), X² is preferably *-C(=O)-O- or *-C(=O)-NH-. Also preferably R^{C} is methyl. The inclusion of carbonyl in X² enhances the ability to trap the acid originating from the anti-charging film. A polymer wherein R^{D} is methyl is a robust polymer having a high glass transition temperature (Tg) which is effective for suppressing acid diffusion. As a result, the resist film is improved in stability with time, and neither resolution nor pattern profile is degraded.

Examples of the repeat unit D5 are given below, but not limited thereto. Herein R^{C} is as defined above.

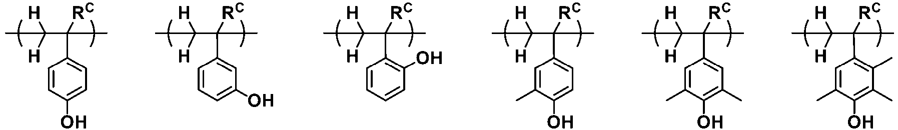

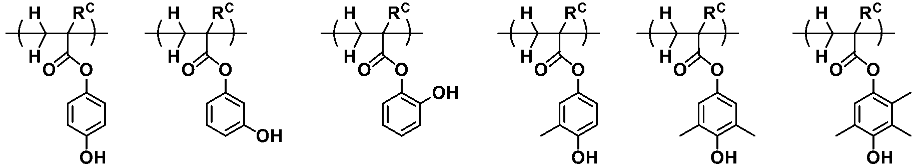

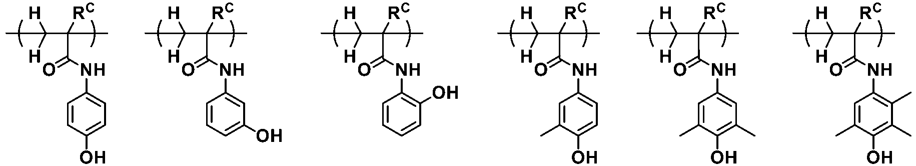

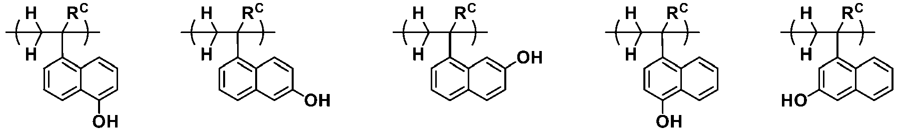

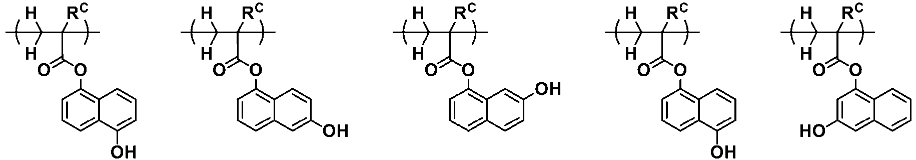

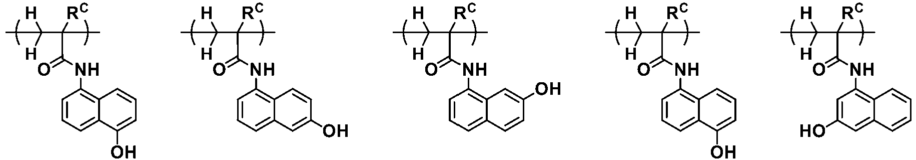

In formula (D6), the C₁-C₁₀ saturated hydrocarbylene group X³ may be straight, branched or cyclic and examples thereof include methanediyl, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, and 1,1-dimethylethane-1,2-diyl.

The C₁-C₂₀ saturated hydrocarbyl group having at least one hydrogen substituted by fluorine, represented by R¹¹¹, may be straight, branched or cyclic and examples thereof include C₁-C₂₀ alkyl groups and C₃-C₂₀ cyclic saturated hydrocarbyl groups in which at least one hydrogen is substituted by fluorine.

Examples of the repeat unit D6 are given below, but not limited thereto. Herein R^{C} is as defined above.

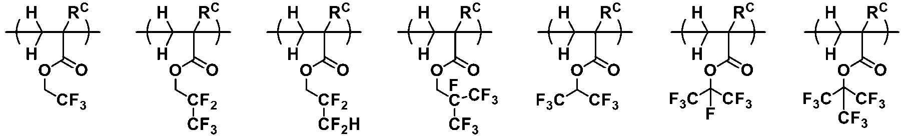

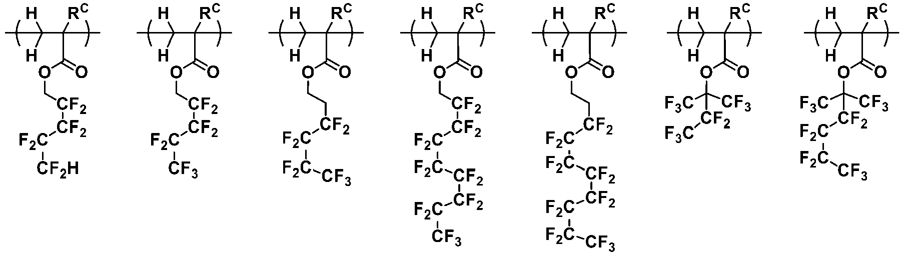

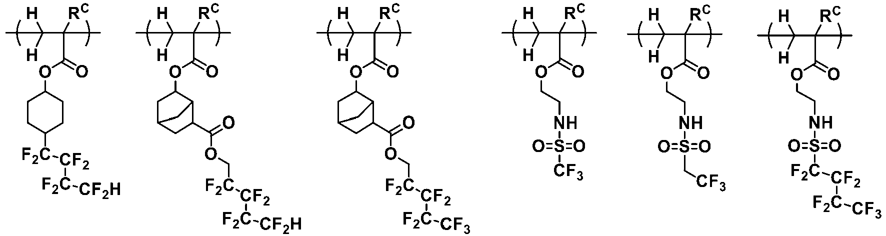

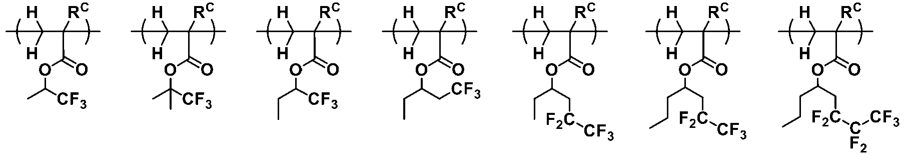

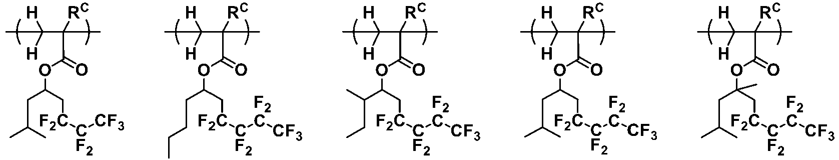

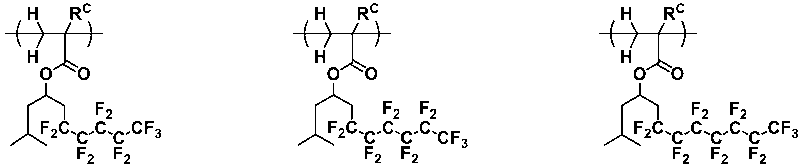

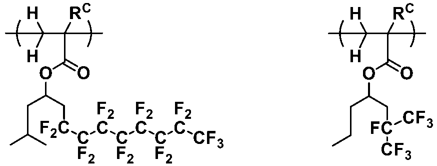

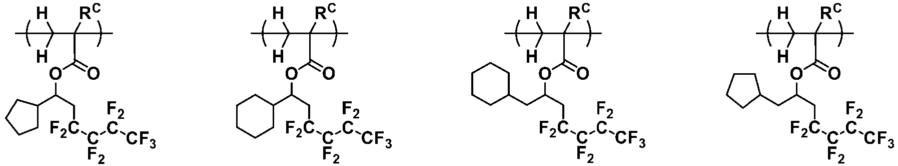

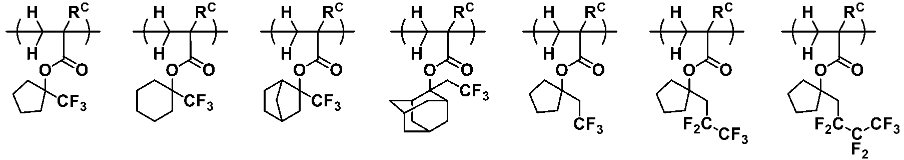

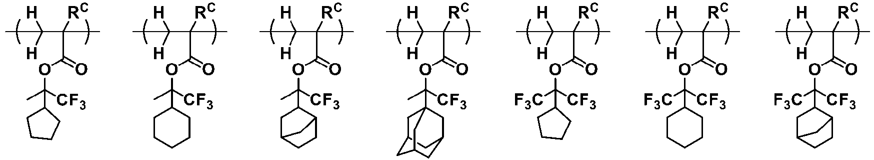

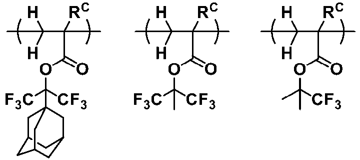

The repeat units D1 to D4 are preferably incorporated in an amount of 15 to 95 mol%, more preferably 20 to 85 mol% based on the overall repeat units of the fluorinated polymer. The repeat unit D5 and/or D6 is preferably incorporated in an amount of 5 to 85 mol%, more preferably 15 to 80 mol% based on the overall repeat units of the fluorinated polymer. Each of repeat units D1 to D6 may be used alone or in admixture.

The fluorinated polymer may comprise additional repeat units as well as the repeat units D1 to D6. Suitable additional repeat units include those described in USP 9,091,918 (JP-A 2014-177407, paragraphs [0046]-[0078]). When the fluorinated polymer comprises additional repeat units, their content is preferably up to 50 mol% based on the overall repeat units.

The fluorinated polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630.

The fluorinated polymer should preferably have a Mw of 2,000 to 50,000, and more preferably 3,000 to 20,000. A fluorinated polymer with a Mw of less than 2,000 helps acid diffusion, degrading resolution and detracting from age stability. A polymer with too high Mw has a reduced solubility in solvent, with a risk of leaving coating defects. The fluorinated polymer preferably has a dispersity (Mw/Mn) of 1.0 to 2.2, more preferably 1.0 to 1.7.

In the negative resist composition, the fluorinated polymer (D) is preferably used in an amount of 0.01 to 30 parts, more preferably 0.1 to 20 parts, even more preferably 0.5 to 10 parts by weight per 80 parts by weight of the base polymer (B). The fluorinated polymer may be used alone or in admixture.

### (E) Quencher

The negative resist composition preferably contains a quencher as component (E). As used herein, the quencher refers to a compound capable of trapping the acid generated by the PAG in the resist composition to prevent the acid from diffusing to the unexposed region for thereby forming the desired pattern.

The quencher is typically selected from conventional basic compounds. Conventional basic compounds include primary, secondary, and tertiary aliphatic amines, mixed amines, aromatic amines, heterocyclic amines, nitrogen-containing compounds with carboxy group, nitrogen-containing compounds with sulfonyl group, nitrogen-containing compounds with hydroxy group, nitrogen-containing compounds with hydroxyphenyl group, alcoholic nitrogen-containing compounds, amide derivatives, imide derivatives, and carbamate derivatives. Also included are primary, secondary, and tertiary amine compounds, specifically amine compounds having a hydroxy group, ether bond, ester bond, lactone ring, cyano group, or sulfonate ester bond as described in JP-A 2008-111103, paragraphs [0146]-[0164], and compounds having a carbamate group as described in JP 3790649. Inter alia, tris[2-(methoxymethoxy)ethyl]amine, tris[2-(methoxymethoxy)ethyl]amine-N-oxide, dibutylaminobenzoic acid, morpholine derivatives, and imidazole derivatives are preferred. Addition of a basic compound is effective for further suppressing the diffusion rate of acid in the resist film or correcting the pattern profile.

Onium salts such as sulfonium, iodonium and ammonium salts of carboxylic acids which are not fluorinated at α-position as described in USP 8,795,942 (JP-A 2008-158339) may also be used as the quencher. While an α-fluorinated sulfonic acid, imide acid, and methide acid are necessary to deprotect the acid labile group, an α-non-fluorinated carboxylic acid is released by salt exchange with an α-non-fluorinated onium salt. An α-non-fluorinated carboxylic acid functions as a quencher because it does not induce substantial deprotection reaction.

Examples of the onium salt of α-non-fluorinated carboxylic acid include compounds having the formula (E1).

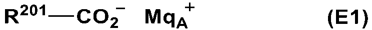

In formula (E1), R²⁰¹ is hydrogen or a C₁-C₄₀ hydrocarbyl group which may contain a heteroatom, exclusive of the hydrocarbyl group in which the hydrogen bonded to the carbon atom at α-position of the carboxy group is substituted by fluorine or fluoroalkyl.

The hydrocarbyl group R²⁰¹ may be saturated or unsaturated and straight, branched or cyclic. Examples thereof include C₁-C₄₀ alkyl groups such as methyl, ethyl, n-propyl, isopropyl, n-butyl, sec-butyl, tert-butyl, n-pentyl, tert-pentyl, n-hexyl, n-octyl, 2-ethylhexyl, n-nonyl, n-decyl; C₃-C₄₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decyl, adamantyl, and adamantylmethyl; C₂-C₄₀ alkenyl groups such as vinyl, allyl, propenyl, butenyl and hexenyl; C₃-C₄₀ cyclic unsaturated aliphatic hydrocarbyl groups such as cyclohexenyl; C₆-C₄₀ aryl groups such as phenyl, naphthyl, alkylphenyl groups (e.g., 2-methylphenyl, 3-methylphenyl, 4-methylphenyl, 4-ethylphenyl, 4-tert-butylphenyl, 4-n-butylphenyl), dialkylphenyl groups (e.g., 2,4-dimethylphenyl and 2,4,6-triisopropylphenyl), alkylnaphthyl groups (e.g., methylnaphthyl and ethylnaphthyl), dialkylnaphthyl groups (e.g., dimethylnaphthyl and diethylnaphthyl); and C₇-C₄₀ aralkyl groups such as benzyl, 1-phenylethyl and 2-phenylethyl.

In the foregoing hydrocarbyl groups, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy moiety, cyano moiety, carbonyl moiety, ether bond, thioether bond, ester bond, sulfonate ester bond, carbonate bond, lactone ring, sultone ring, carboxylic anhydride (-C(=O)-O-C(=O)-) or haloalkyl moiety. Suitable heteroatom-containing hydrocarbyl groups include heteroaryl groups such as thienyl; alkoxyphenyl groups such as 4-hydroxyphenyl, 4-methoxyphenyl, 3-methoxyphenyl, 2-methoxyphenyl, 4-ethoxyphenyl, 4-tert-butoxyphenyl, 3-tert-butoxyphenyl; alkoxynaphthyl groups such as methoxynaphthyl, ethoxynaphthyl, n-propoxynaphthyl and n-butoxynaphthyl; dialkoxynaphthyl groups such as dimethoxynaphthyl and diethoxynaphthyl; and aryloxoalkyl groups, typically 2-aryl-2-oxoethyl groups such as 2-phenyl-2-oxoethyl, 2-(1-naphthyl)-2-oxoethyl and 2-(2-naphthyl)-2-oxoethyl.

In formula (E1), Mq_{A}⁺ is an onium cation. The onium cation is preferably selected from sulfonium, iodonium and ammonium cations, more preferably sulfonium and iodonium cations. Exemplary sulfonium cations include those described in JP-A 2024-003744, paragraphs [0102]-[0125] and JP-A 2023-169812, paragraphs [0070]-[0085], and those having formula (A2), but are not limited thereto. Exemplary iodonium cations include those described in JP-A 2024-000259, paragraph [0181], but are not limited thereto.

The ammonium cation preferably has the formula (am-1).

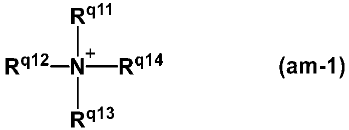

In formula (am-1), R^{q11} to R^{q14} are each independently a C₁-C₄₀ hydrocarbyl group which may contain a heteroatom. Any two of R^{q11} to R^{q14} may bond together to form a ring with the nitrogen atom to which they are attached. Examples of the hydrocarbyl group are as exemplified above for the hydrocarbyl group R² in formula (A).

Examples of the ammonium cation having formula (am-1) are shown below, but not limited thereto.

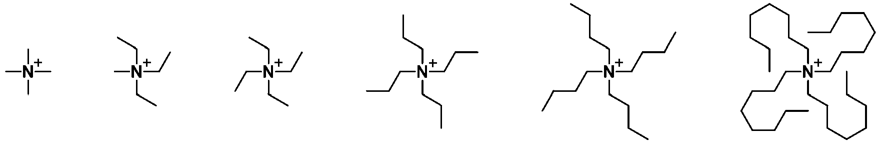

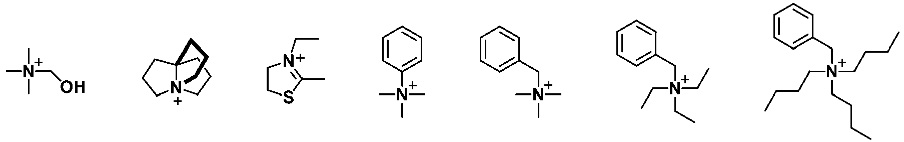

Examples of the anion in the onium salt having formula (E1) are shown below, but not limited thereto.

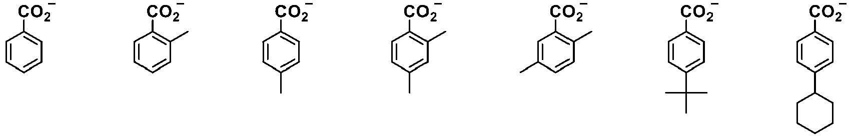

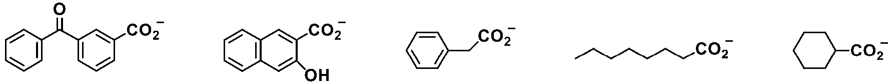

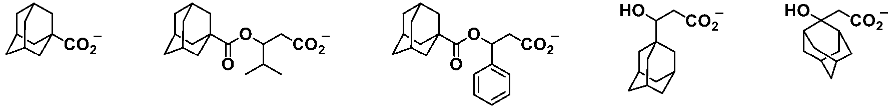

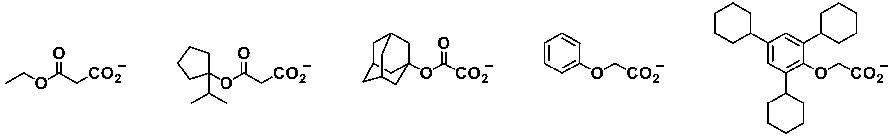

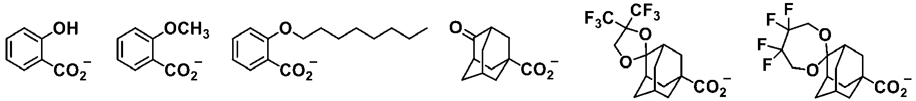

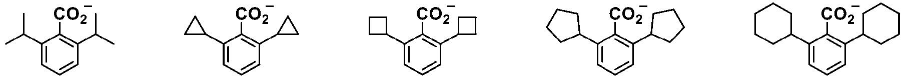

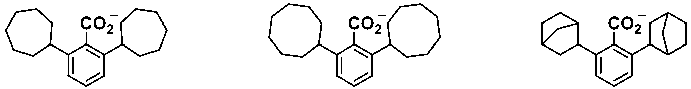

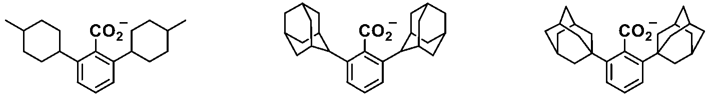

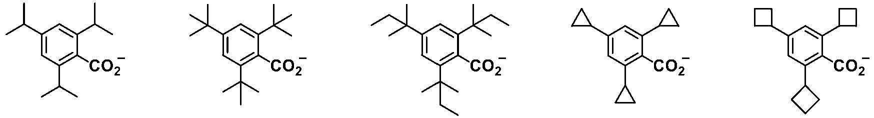

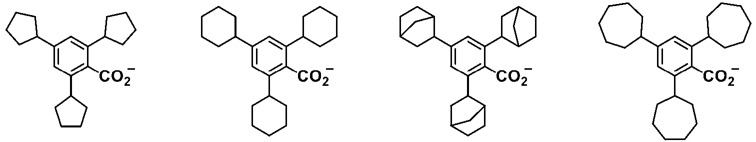

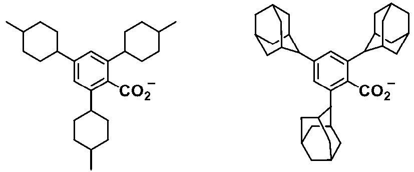

A sulfonium salt of iodized benzene ring-containing carboxylic acid having the formula (E2) is also useful as the quencher.

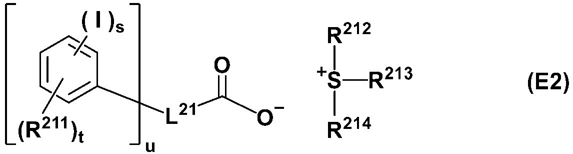

In formula (E2), s is 1, 2, 3, 4 or 5, t is 0, 1, 2 or 3, s+t is from 1 to 5, and u is 1, 2 or 3.

In formula (E2), R²¹¹ is hydroxy, fluorine, chlorine, bromine, amino, nitro, cyano, or a C₁-C₆ saturated hydrocarbyl, C₁-C₆ saturated hydrocarbyloxy, C₂-C₆ saturated hydrocarbylcarbonyloxy or C₁-C₄ saturated hydrocarbylsulfonyloxy group, in which some or all hydrogen may be substituted by halogen, or -N(R^{211A})-C(=O)-R^{211B},

or -N(R^{211A})-C(=O)-O-R^{211B}. R^{211A} is hydrogen or a C₁-C₆ saturated hydrocarbyl group. R^{211B} is a C₁-C₆ saturated hydrocarbyl or C₂-C₈ unsaturated aliphatic hydrocarbyl group. A plurality of R²¹¹ may be identical or different when t and/or u is 2 or 3.

In formula (E2), L²¹ is a single bond or a C₁-C₂₀ (u+1)-valent linking group which may contain at least one moiety selected from ether bond, carbonyl moiety, ester bond, amide bond, sultone ring, lactam ring, carbonate bond, halogen, hydroxy moiety, and carboxy moiety. The saturated hydrocarbyl, saturated hydrocarbyloxy, saturated hydrocarbylcarbonyloxy, and saturated hydrocarbylsulfonyloxy groups may be straight, branched or cyclic.

In formula (E2), R²¹², R²¹³ and R²¹⁴ are each independently halogen, or a C₁-C₂₀ hydrocarbyl group which may contain a heteroatom. The hydrocarbyl group may be saturated or unsaturated and straight, branched or cyclic. Examples thereof include C₁-C₂₀ alkyl, C₂-C₂₀ alkenyl, C₆-C₂₀ aryl, and C₇-C₂₀ aralkyl groups. In these groups, some or all hydrogen may be substituted by hydroxy, carboxy, halogen, oxo, cyano, nitro, sultone ring, sulfo, or sulfonium salt-containing moiety, or some -CH₂- may be replaced by an ether bond, ester bond, carbonyl moiety, amide bond, carbonate bond or sulfonate ester bond. Also, R²¹² and R²¹³ may bond together to form a ring with the sulfur atom to which they are attached.

Examples of the compound having formula (E2) are as described in JP-A 2017-219836. The compound having formula (E2) exerts a sensitizing effect due to remarkable absorption and an acid diffusion-controlling effect.

A nitrogen-containing carboxylic acid salt compound having the formula (E3) is also useful as the quencher.

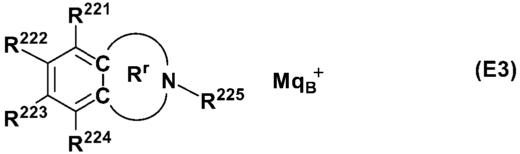

In formula (E3), R²²¹ to R²²⁴ are each independently hydrogen, -L²²-CO₂⁻, or a C₁-C₂₀ hydrocarbyl group which may contain a heteroatom. R²²¹ and R²²², R²²² and R²²³, or R²²³ and R²²⁴ may bond together to form a ring with the carbon atom to which they are attached. L²² is a single bond or a C₁-C₂₀ hydrocarbylene group which may contain a heteroatom. R²²⁵ is hydrogen or a C₁-C₂₀ hydrocarbyl group which may contain a heteroatom.

In formula (E3), the ring R^{r} is a C₂-C₆ ring containing the carbon and nitrogen atoms in the formula, in which some or all of the carbon-bonded hydrogen atoms may be substituted by a C₁-C₂₀ hydrocarbyl group or -L²²-CO₂⁻ and in which some carbon may be replaced by sulfur, oxygen or nitrogen. The ring may be alicyclic or aromatic and is preferably a 5- or 6-membered ring. Suitable rings include pyridine, pyrrole, pyrrolidine, piperidine, pyrazole, imidazoline, pyridazine, pyrimidine, pyrazine, imidazoline, oxazole, thiazole, morpholine, thiazine, and triazole rings.

The carboxylic onium salt having formula (E3) has at least one -L²²-CO₂⁻. That is, at least one of R²²¹ to R²²⁴ is -L²²-CO₂⁻, and/or at least one of hydrogen atoms bonded to carbon atoms in the ring R^{r} is substituted by -L²²-CO₂⁻.

In formula (E3), Mq_{B}⁺ is a sulfonium, iodonium or ammonium cation, with the sulfonium cation being preferred. Examples of the sulfonium cation include those described in JP-A 2024-003744, paragraphs [0102]-[0125], and JP-A 2023-169812, paragraphs [0070]-[0085], and those exemplified above as the sulfonium cation having formula (Z-3), but are not limited thereto.

Examples of the anion in the compound having formula (E3) are shown below, but not limited thereto.

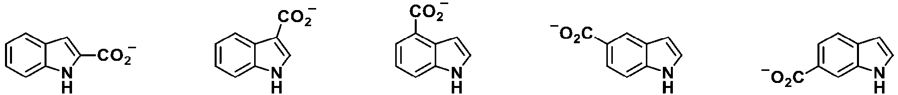

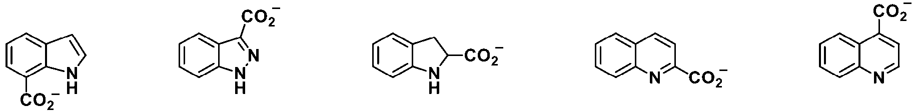

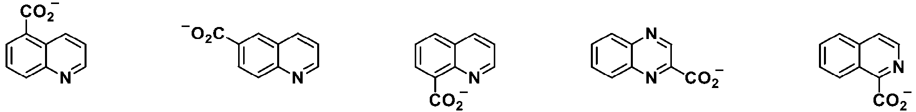

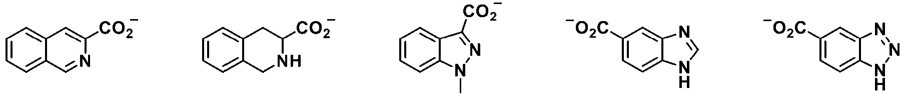

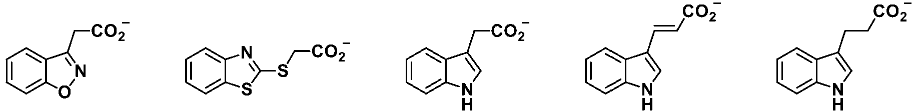

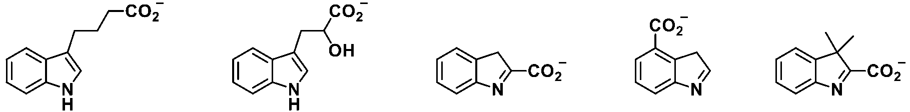

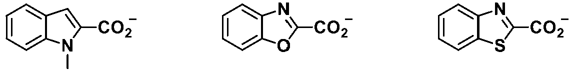

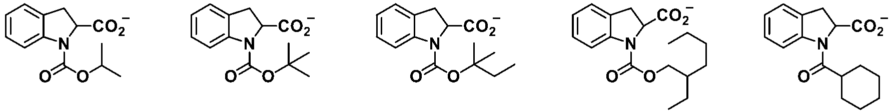

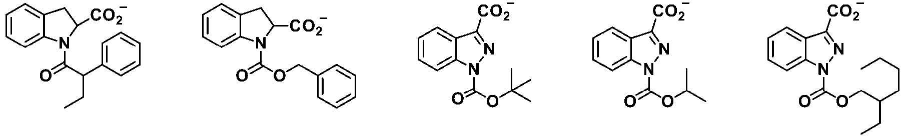

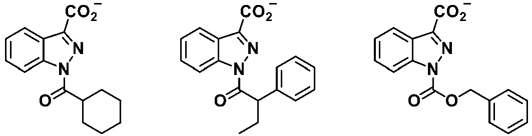

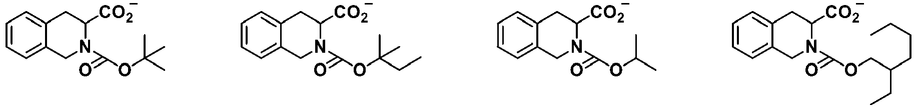

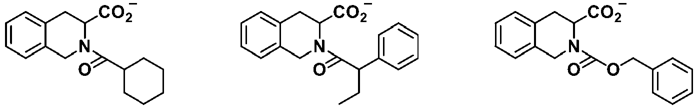

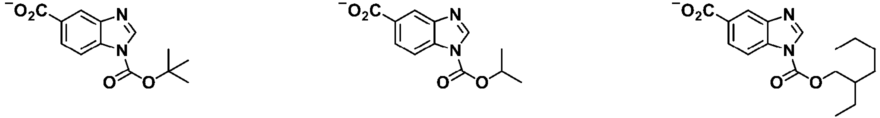

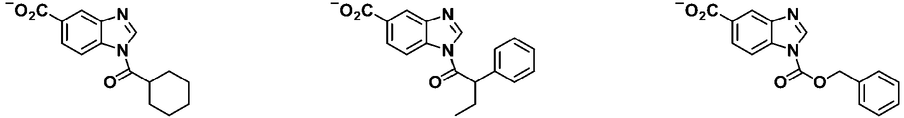

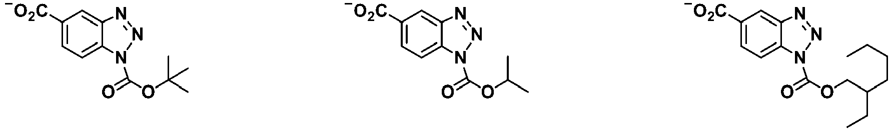

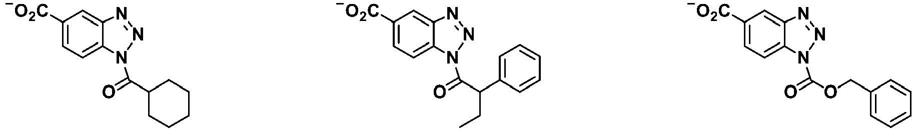

Weak acid betaine compounds are also useful as the quencher. Non-limiting examples thereof are shown below.

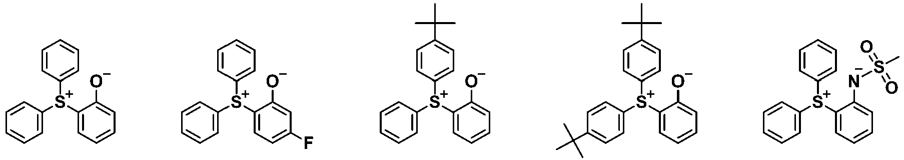

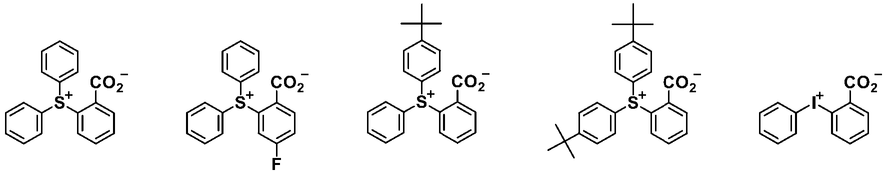

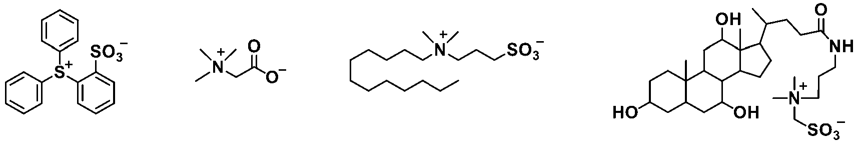

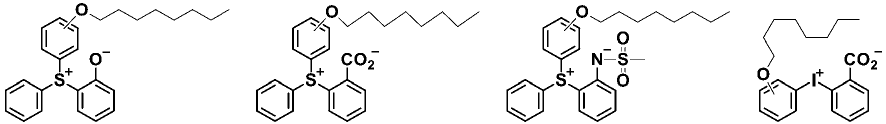

Also useful are quenchers of polymer type as described in USP 7,598,016 (JP-A 2008-239918). The polymeric quencher segregates at the resist surface after coating and thus enhances the rectangularity of resist pattern. When a protective film is applied as is often the case in the immersion lithography, the polymeric quencher is also effective for preventing a film thickness loss of resist pattern or rounding of pattern top.

When used, the quencher (E) is preferably added in an amount of 0 to 50 parts, more preferably 0.1 to 40 parts by weight per 80 parts by weight of the base polymer (B). The quencher may be used alone or in admixture.

When the chemically amplified negative resist composition contains both the PAG (A) and the quencher (E), the weight ratio of the PAG to the quencher, (A)/(E) is preferably less than 6/1, more preferably less than 5/1, even more preferably less than 4/1. As long as the weight ratio of the PAG to the quencher is in the range, the resist composition is able to fully suppress acid diffusion, leading to improved resolution and dimensional uniformity.

### (F) Organic solvent

The chemically amplified negative resist composition may further comprise an organic solvent as component (F). The organic solvent used herein is not particularly limited as long as the components are soluble therein. Examples of the organic solvent are described in JP-A 2008-111103, paragraphs [0144] to [0145] (USP 7,537,880). Specifically, exemplary solvents include ketones such as cyclohexanone, cyclopentanone, methyl-2-n-pentyl ketone and 2-heptanone; alcohols such as 3-methoxybutanol, 3-methyl-3-methoxybutanol, 1-methoxy-2-propanol, 1-ethoxy-2-propanol, and diacetone alcohol; ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate (PGMEA), propylene glycol monoethyl ether acetate, ethyl lactate (EL), ethyl pyruvate, butyl acetate, methyl 3-methoxypropionate, ethyl 3-ethoxypropionate, t-butyl acetate, t-butyl propionate, and propylene glycol mono-t-butyl ether acetate; and lactones such as γ-butyrolactone (GBL), and mixtures thereof.

Of the above organic solvents, it is recommended to use 1-ethoxy-2-propanol, PGMEA, PGME, cyclohexanone, EL, GBL, and mixtures thereof.

In the negative resist composition, the organic solvent (F) is preferably used in an amount of 200 to 10,000 parts, more preferably 400 to 6,000 parts by weight per 80 parts by weight of the base polymer (B). The organic solvent may be used alone or in admixture.

### (G) Other photoacid generator

In addition to the PAG in the form of the onium salt having formula (A), the chemically amplified negative resist composition may further comprise another photoacid generator (PAG) as component (G). The other PAG used herein may be any compound capable of generating an acid upon exposure to high-energy radiation. Suitable PAGs include sulfonium salts, iodonium salts, sulfonyldiazomethane, N-sulfonyloxyimide, and oxime-O-sulfonate acid generators.

Suitable other PAGs include nonafluorobutane sulfonate, partially fluorinated sulfonates described in JP-A 2012-189977, paragraphs [0247]-[0251], partially fluorinated sulfonates described in JP-A 2013-101271, paragraphs [0261]-[0265], and those described in JP-A 2008-111103, paragraphs [0122]-[0142] and JP-A 2010-215608, paragraphs [0080]-[0081]. Among others, arenesulfonate and alkanesulfonate type PAGs are preferred because they generate acids having an appropriate strength to deprotect the acid labile group in repeat unit B2.

The preferred PAGs are salt compounds having an anion of the structure shown below.

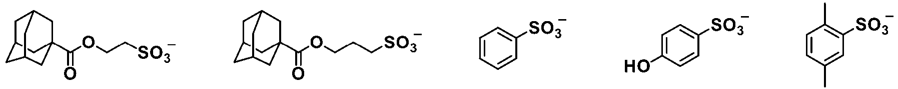

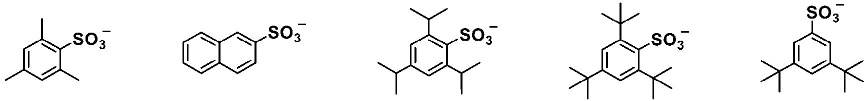

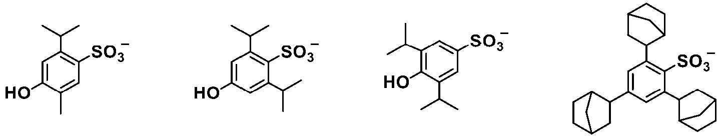

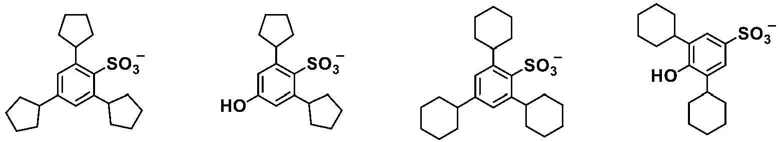

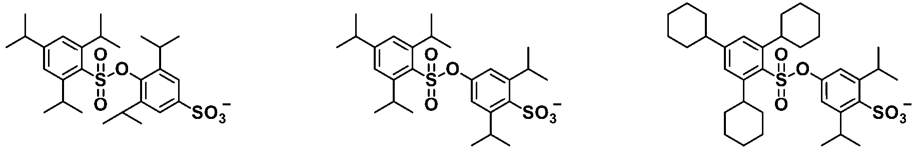

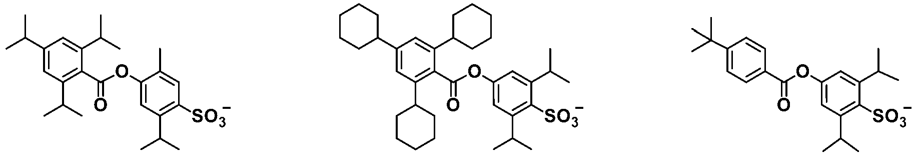

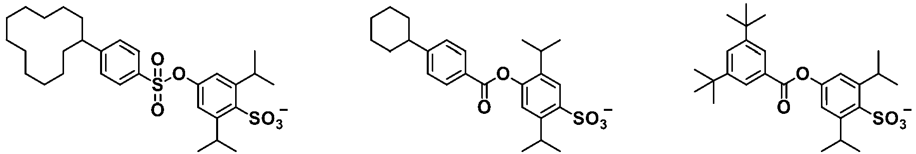

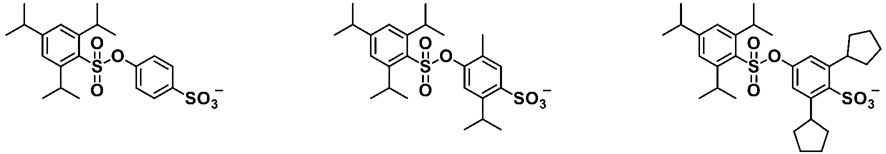

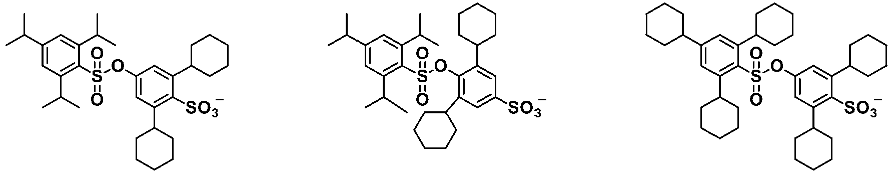

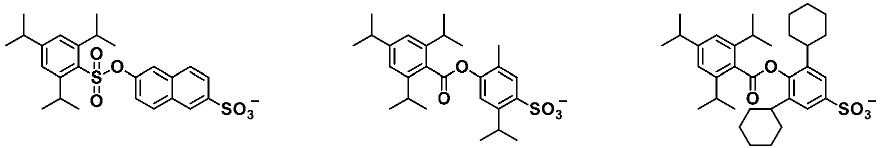

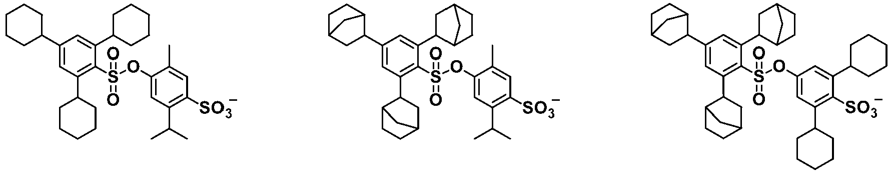

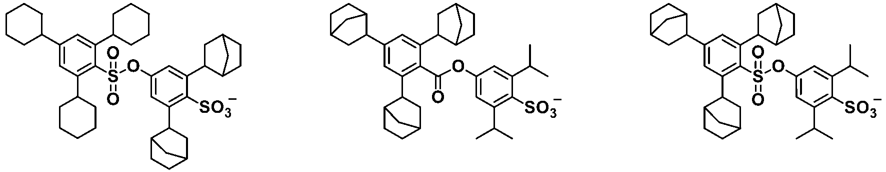

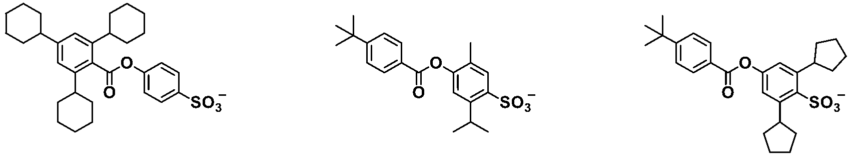

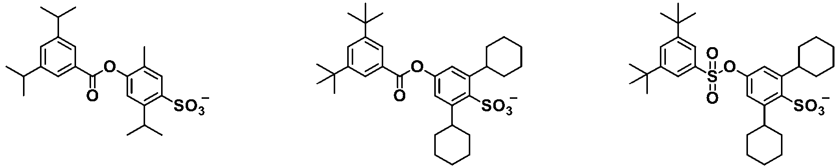

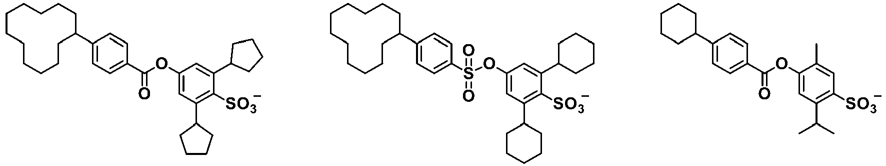

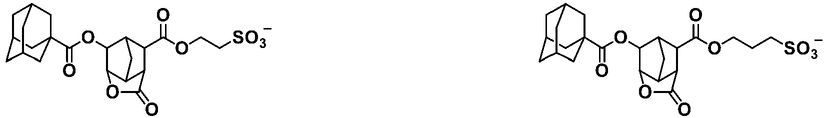

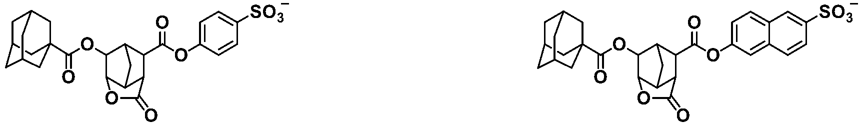

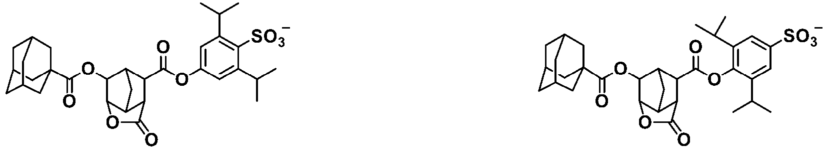

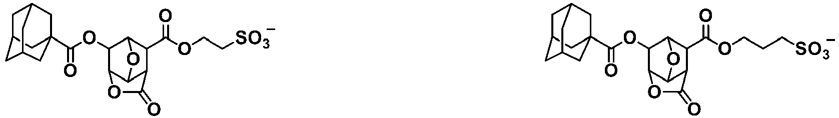

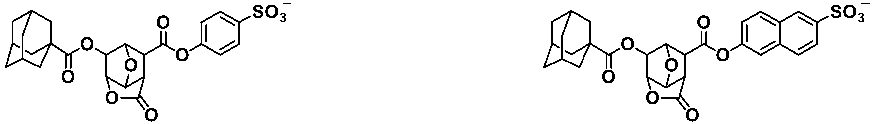

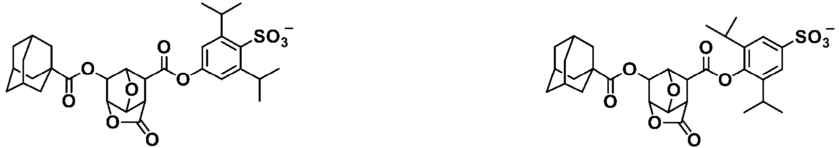

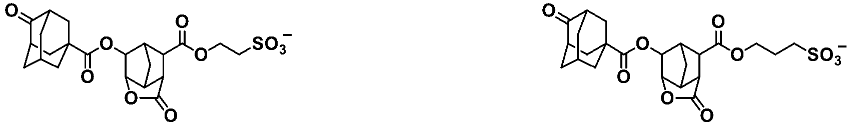

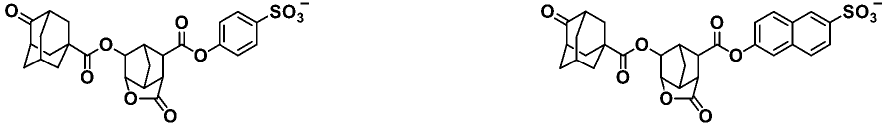

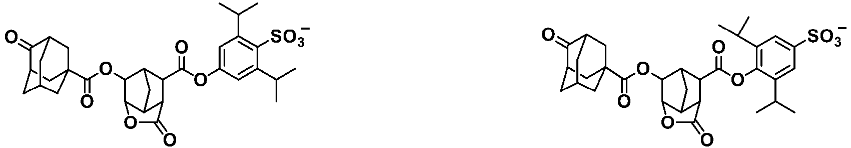

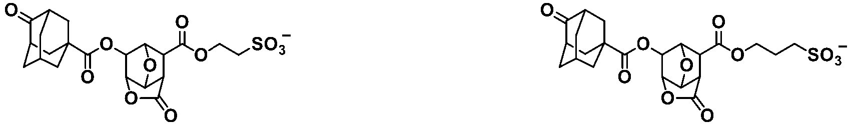

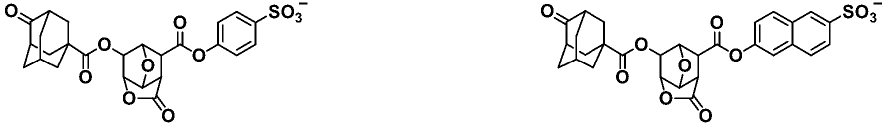

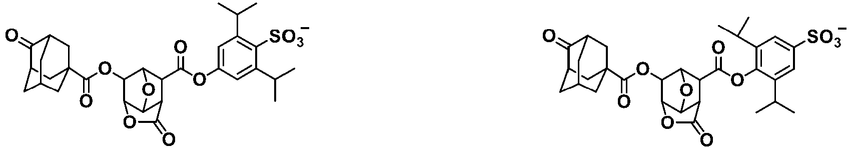

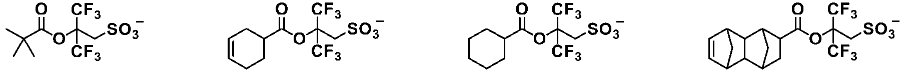

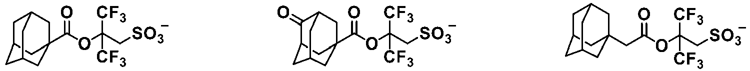

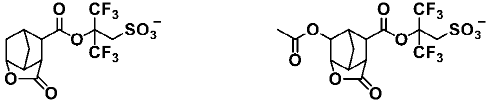

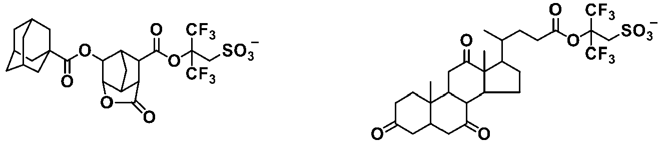

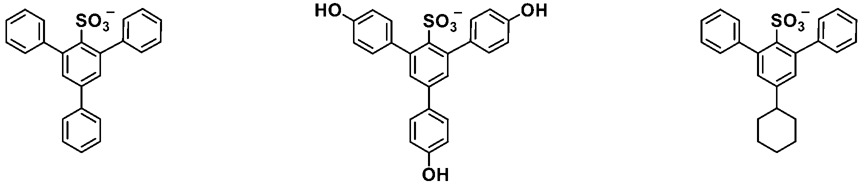

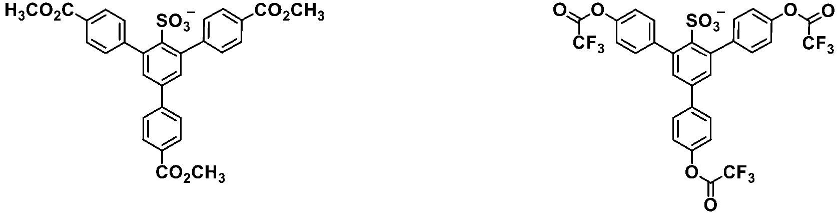

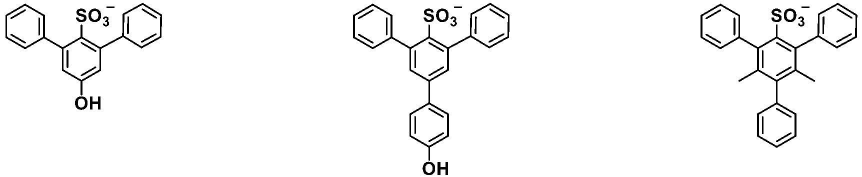

Also preferred as the PAG is a salt compound containing an anion having the formula (G1).

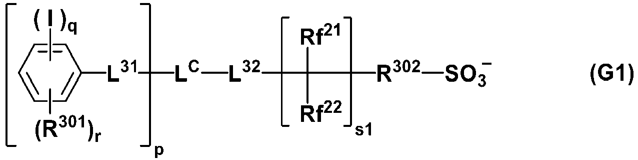

In formula (G1), p is 1, 2 or 3, q is 1, 2, 3, 4 or 5, r is 0, 1, 2 or 3, and s1 is 0 or 1.

In formula (G1), L³¹ is a single bond, ether bond, ester bond, sulfonate ester bond, carbonate bond or carbamate bond.

In formula (G1), L³² is an ether bond, ester bond, sulfonate ester bond, carbonate bond or carbamate bond.

In formula (G1), L^{C} is a single bond or a C₁-C₂₀ hydrocarbylene group when p=1. L^{C} is a C₁-C₂₀ (p+1)-valent hydrocarbon group when p=2 or 3. The hydrocarbylene group and (p+1)-valent hydrocarbon group may contain at least one moiety selected from ether bond, carbonyl moiety, ester bond, amide bond, sultone ring, lactam ring, carbonate bond, halogen, hydroxy moiety and carboxy moiety.

The C₁-C₂₀ hydrocarbylene group L^{C} may be saturated or unsaturated and straight, branched or cyclic. Examples thereof include C₁-C₂₀ alkanediyl groups such as methanediyl, ethane-1,1-diyl, ethane-1,2-diyl, propane-1,3-diyl, butane-1,4-diyl, pentane-1,5-diyl, hexane-1,6-diyl, heptane-1,7-diyl, octane-1,8-diyl, nonane-1,9-diyl, decane-1,10-diyl, undecane-1,11-diyl, dodecane-1,12-diyl; C₃-C₂₀ cyclic saturated hydrocarbylene groups such as cyclopentanediyl, cyclohexanediyl, norbornanediyl and adamantanediyl; C₂-C₂₀ unsaturated aliphatic hydrocarbylene groups such as vinylene and propene-1,3-diyl; C₆-C₂₀ arylene groups such as phenylene and naphthylene; and combinations thereof. The C₁-C₂₀ (p+1)-valent hydrocarbon group L^{C} may be saturated or unsaturated and straight, branched or cyclic. Examples thereof include those exemplified above for the C₁-C₂₀ hydrocarbylene group, with one or two hydrogen atoms being eliminated.

In formula (G1), Rf²¹ and Rf²² are each independently hydrogen, fluorine or trifluoromethyl, at least one being fluorine or trifluoromethyl.

In formula (G1), R³⁰¹ is hydroxy, carboxy, a C₁-C₆ saturated hydrocarbyl group, C₁-C₆ saturated hydrocarbyloxy group, C₂-C₆ saturated hydrocarbylcarbonyloxy group, fluorine, chlorine, bromine, -N(R^{301A})(R^{301B}), -N(R^{301C})-C(=O)-R^{301D} or -N(R^{301C})-C(=O)-O-R^{301D}. R^{301A} and R^{301B} are each independently hydrogen or a C₁-C₆ saturated hydrocarbyl group. R^{301C} is hydrogen or a C₁-C₆ saturated hydrocarbyl group. R^{301D} is a C₁-C₆ saturated hydrocarbyl group or C₂-C₈ unsaturated aliphatic hydrocarbyl group.

The C₁-C₆ saturated hydrocarbyl group represented by R³⁰¹, R^{301A}, R^{301B}, R^{301C} and R^{301D} may be straight, branched or cyclic. Examples thereof include C₁-C₆ alkyl groups such as methyl, ethyl, n-propyl, isopropyl, n-butyl, isobutyl, sec-butyl, tert-butyl, n-pentyl, and n-hexyl; and C₃-C₆ cyclic saturated hydrocarbyl groups such as cyclopropyl, cyclobutyl, cyclopentyl, and cyclohexyl. Examples of the saturated hydrocarbyl moiety in the C₁-C₆ saturated hydrocarbyloxy group represented by R³⁰¹ are as exemplified above for the saturated hydrocarbyl group. Examples of the saturated hydrocarbyl moiety in the C₂-C₆ saturated hydrocarbylcarbonyloxy group represented by R³⁰¹ are as exemplified above for the C₁-C₆ saturated hydrocarbyl group, but of 1 to 5 carbon atoms.

The C₂-C₈ unsaturated aliphatic hydrocarbyl group represented by R^{301D} may be straight, branched or cyclic and examples thereof include C₂-C₈ alkenyl groups such as vinyl, propenyl, butenyl, and hexenyl; C₂-C₈ alkynyl groups such as ethynyl, propynyl, and butynyl; and C₃-C₈ cyclic unsaturated aliphatic hydrocarbyl groups such as cyclohexenyl and norbornenyl.

In formula (G1), R³⁰² is a C₁-C₂₀ saturated hydrocarbylene group or C₆-C₂₀ arylene group. Some or all of the hydrogen atoms in the saturated hydrocarbylene group may be substituted by halogen other than fluorine. Some or all of the hydrogen atoms in the arylene group may be substituted by a substituent selected from C₁-C₂₀ saturated hydrocarbyl groups, C₁-C₂₀ saturated hydrocarbyloxy groups, C₆-C₁₄ aryl groups, halogen, and hydroxy.

The C₁-C₂₀ saturated hydrocarbylene group represented by R³⁰² may be straight, branched or cyclic. Examples thereof C₁-C₂₀ alkanediyl groups such as methanediyl, ethane-1,1-diyl, ethane-1,2-diyl, propane-1,3-diyl, butane-1,4-diyl, pentane-1,5-diyl, hexane-1,6-diyl, heptane-1,7-diyl, octane-1,8-diyl, nonane-1,9-diyl, decane-1,10-diyl undecane-1,11-diyl and dodecane-1,12-diyl; and C₃-C₂₀ cyclic saturated hydrocarbylene groups such as cyclopentanediyl, cyclohexanediyl, norbornanediyl and adamantanediyl.

Examples of the C₆-C₂₀ arylene group represented by R³⁰² include phenylene, naphthylene, phenanthrenediyl, and anthracenediyl. The C₁-C₂₀ saturated hydrocarbyl moiety and hydrocarbyl moiety in the C₁-C₂₀ hydrocarbyloxy moiety, which are substituents on the arylene group, may be straight, branched or cyclic and examples thereof include C₁-C₂₀ alkyl groups such as methyl, ethyl, n-propyl, isopropyl, n-butyl, isobutyl, sec-butyl, tert-butyl, n-pentyl, n-hexyl, n-octyl, n-nonyl, n-decyl, undecyl, dodecyl, tridecyl, tetradecyl, pentadecyl, heptadecyl, octadecyl, nonadecyl, and icosyl; and C₃-C₂₀ cyclic saturated hydrocarbyl groups such as cyclopropyl, cyclopentyl, cyclohexyl, cyclopropylmethyl, 4-methylcyclohexyl, cyclohexylmethyl, norbornyl and adamantyl. Examples of the C₆-C₁₄ arylene moiety which is a substituent on the arylene group include phenylene, naphthylene, phenanthrenediyl and anthracenediyl.

Of the anions having formula (G1), anions having the formula (G2) are preferred.

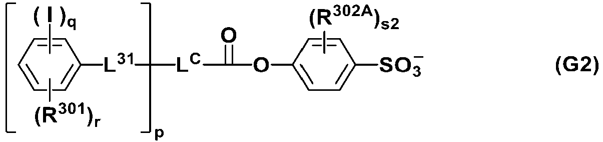

In formula (G2), p, q, r, L³¹, L^{C}, and R³⁰¹ are as defined above. The subscript s2 is 1, 2, 3 or 4. R^{302A} is a C₁-C₁₄ saturated hydrocarbyl group, C₁-C₁₄ saturated hydrocarbyloxy group, C₆-C₁₄ aryl group, halogen or hydroxy group. When s2 is 2, 3 or 4, a plurality of R^{302A} may be identical or different.

Examples of the anion having formula (G1) are shown below, but not limited thereto.

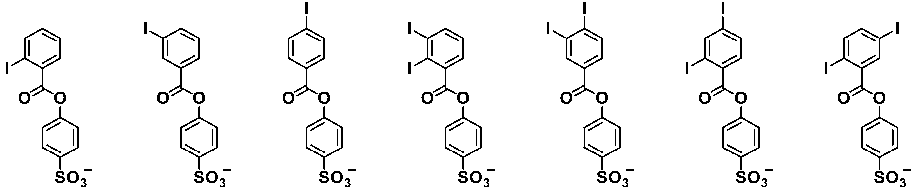

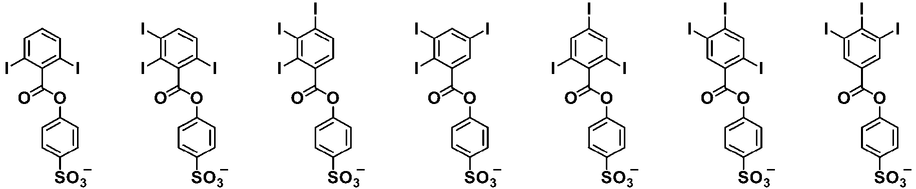

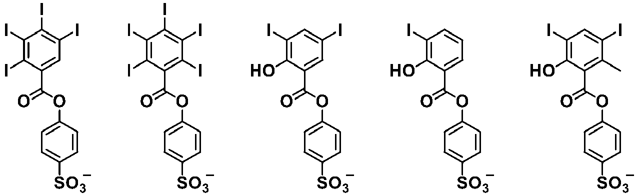

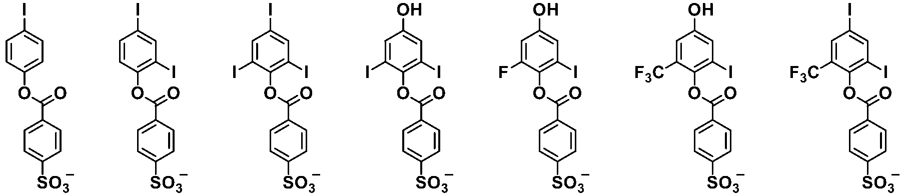

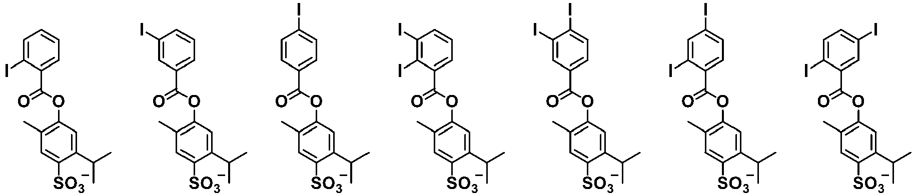

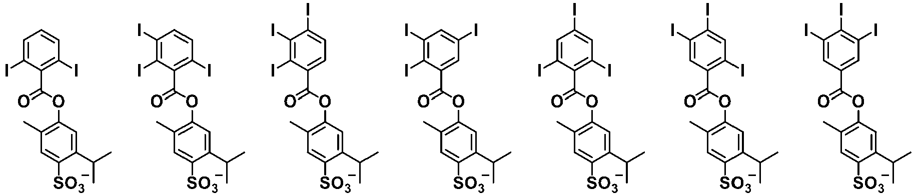

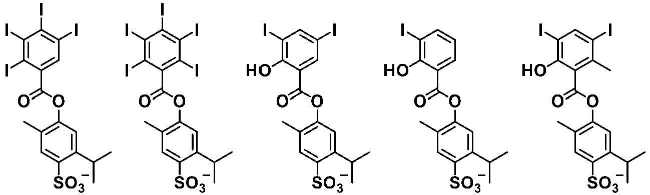

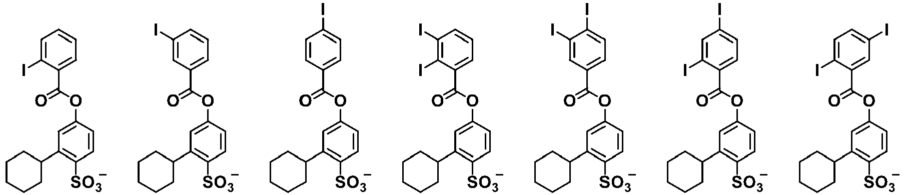

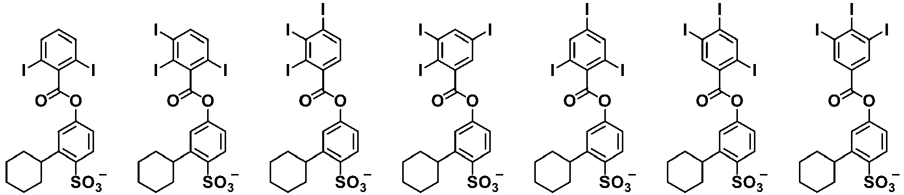

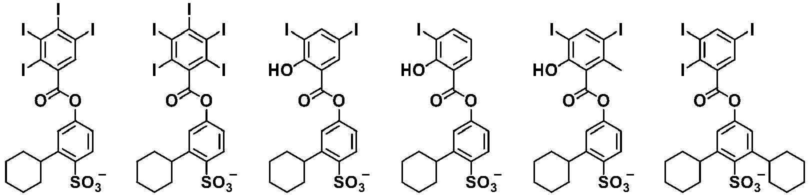

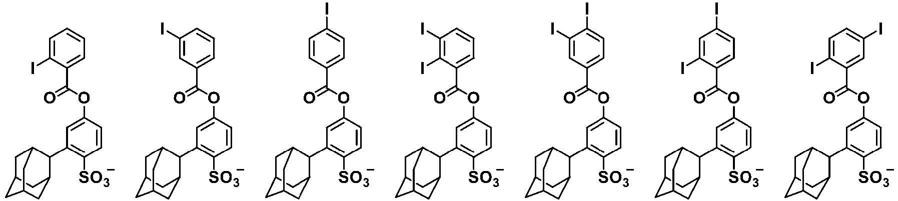

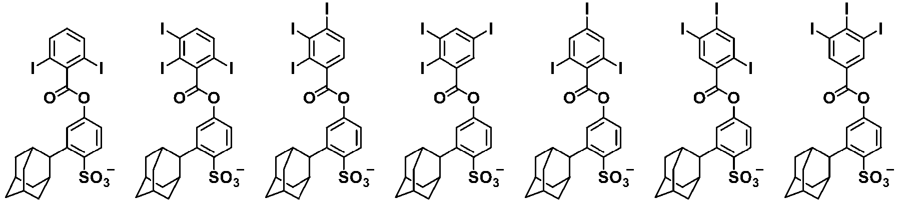

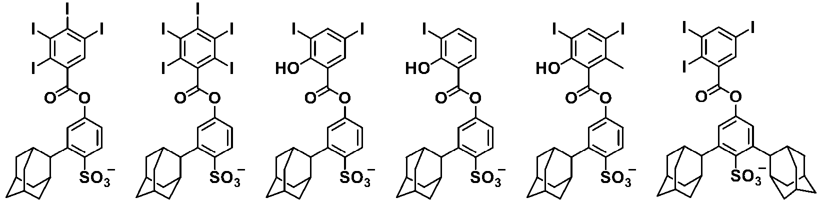

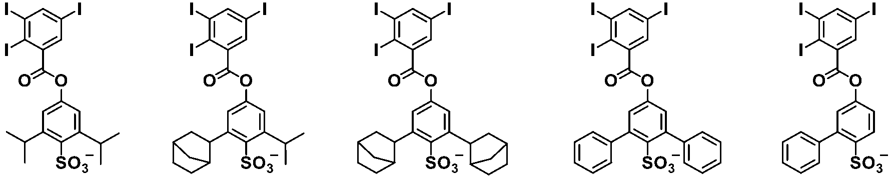

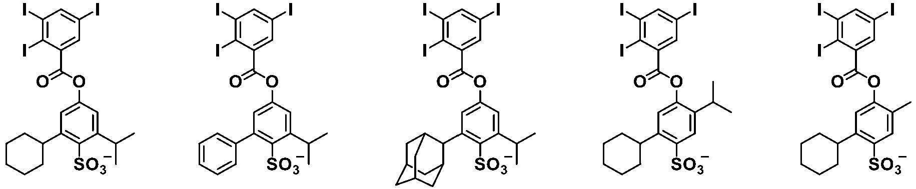

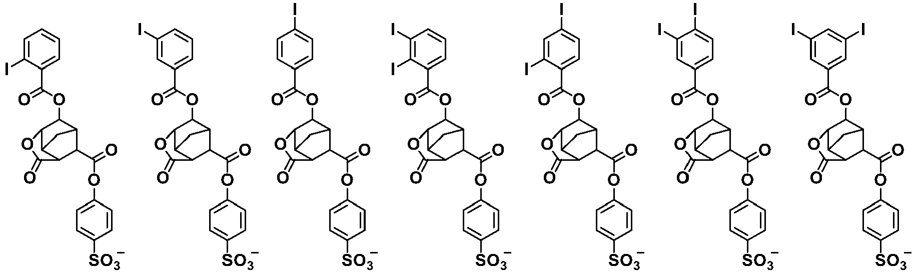

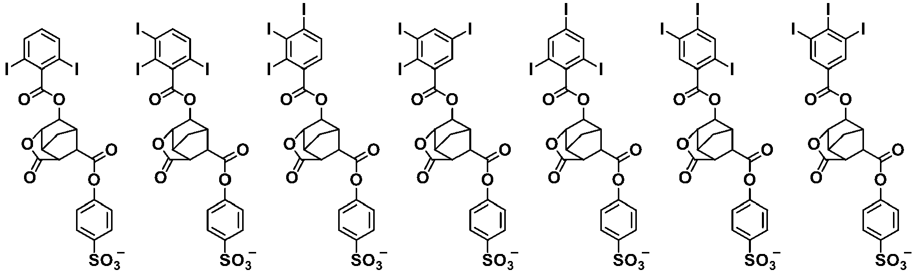

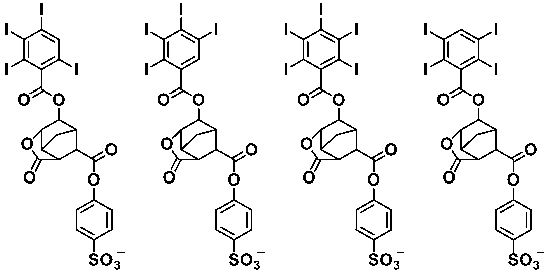

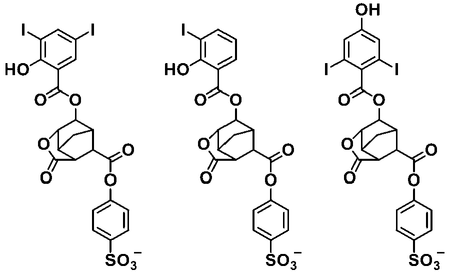

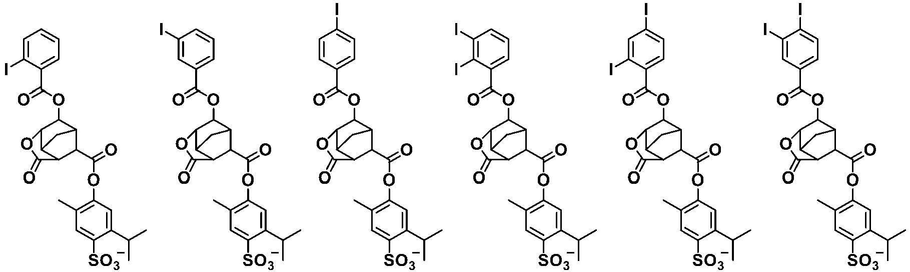

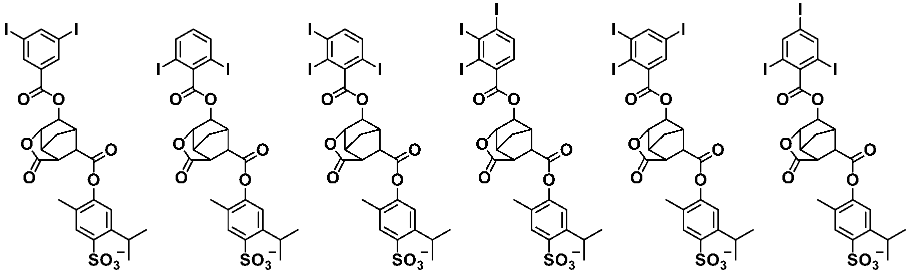

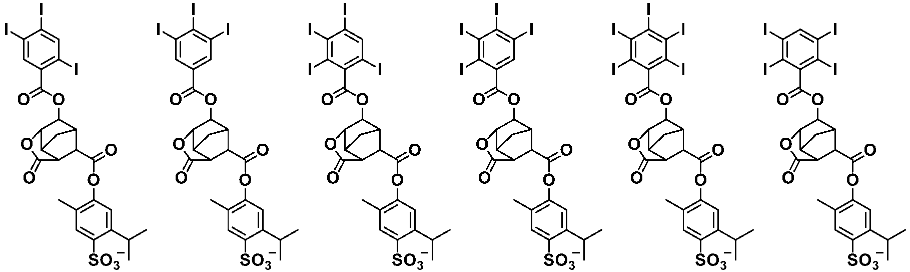

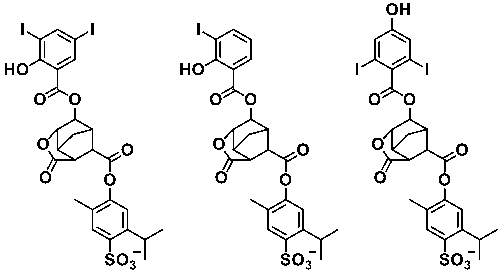

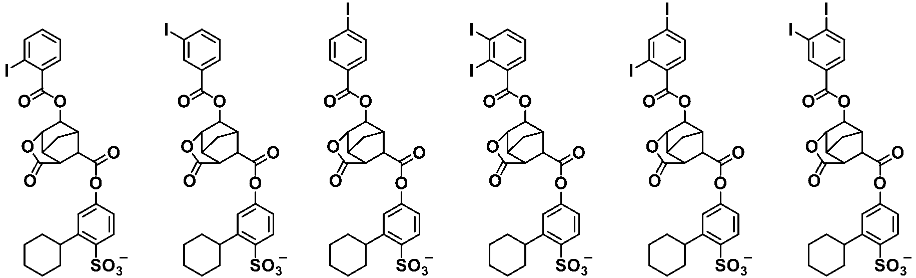

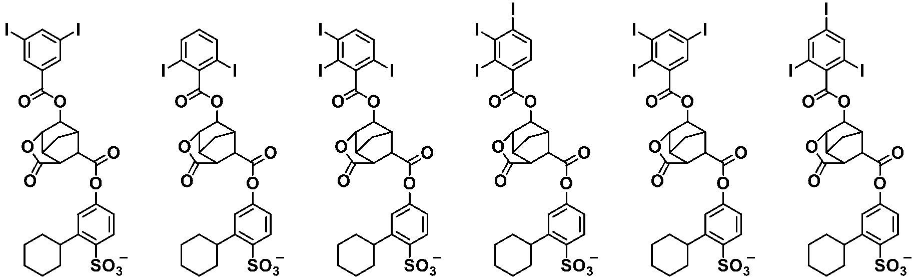

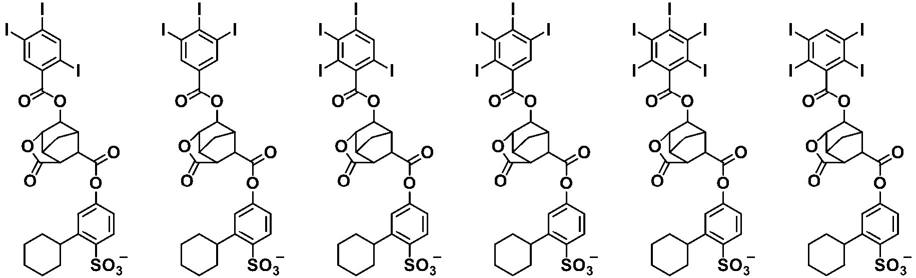

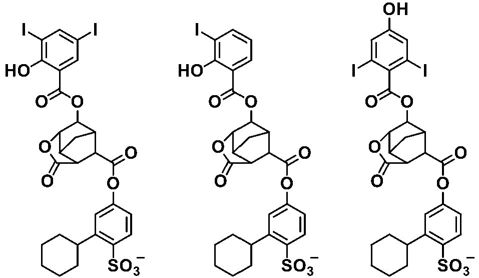

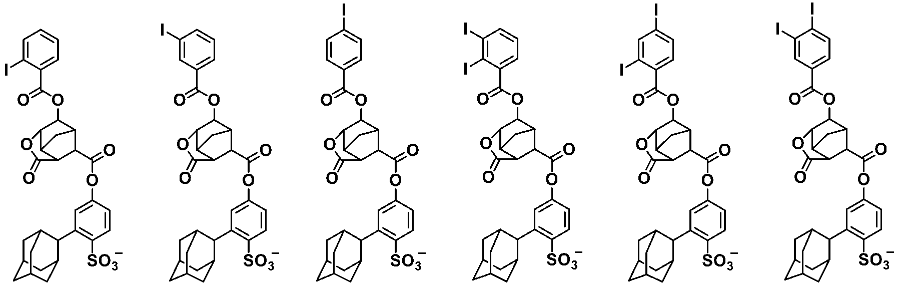

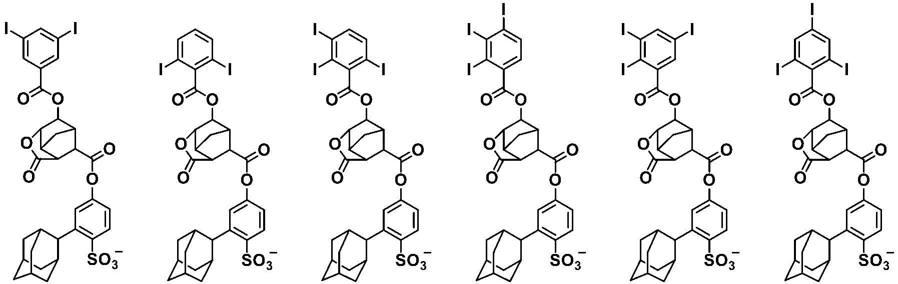

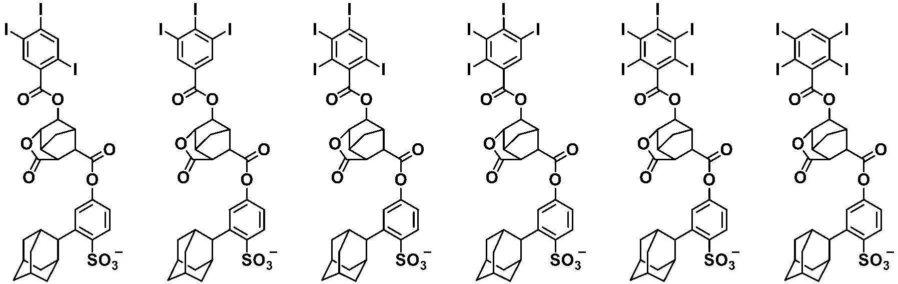

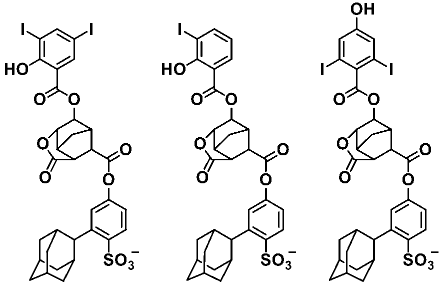

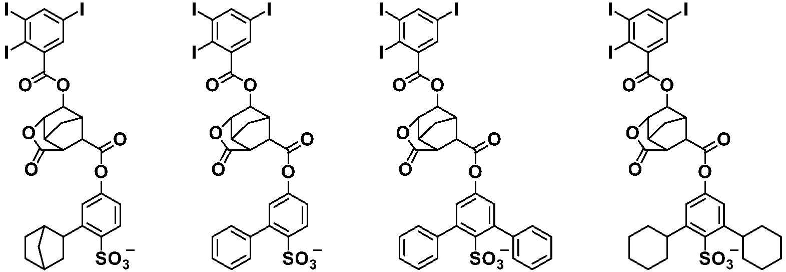

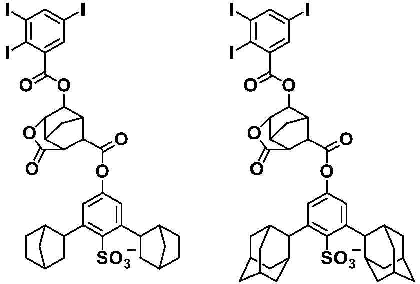

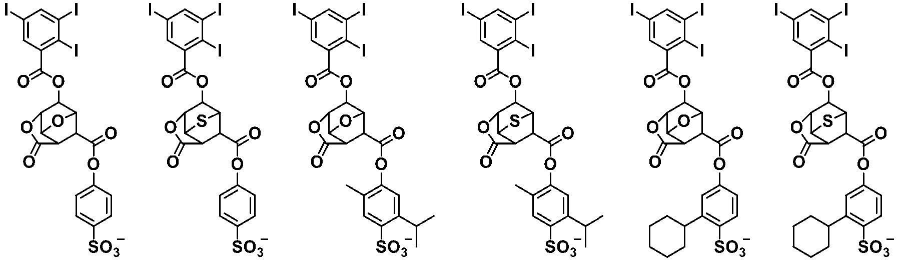

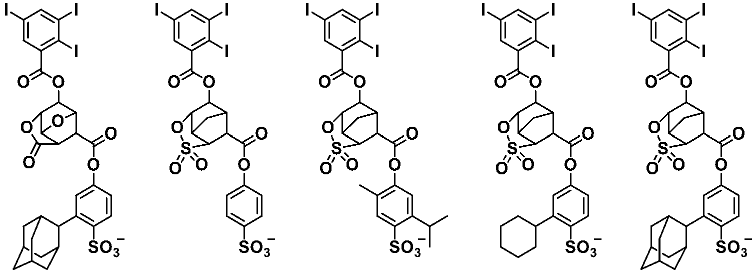

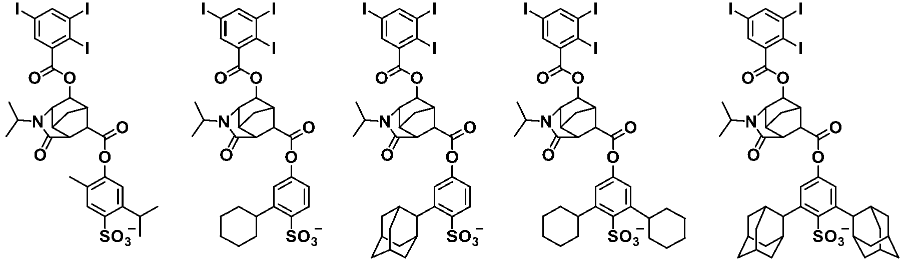

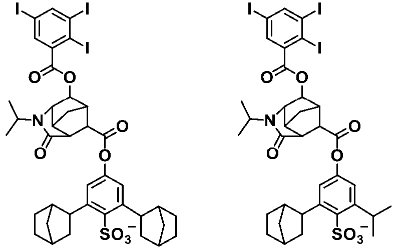

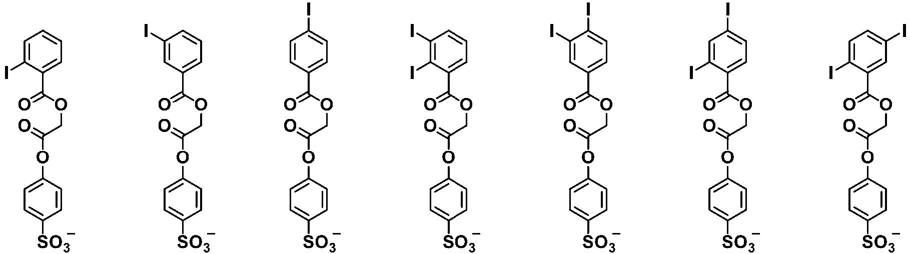

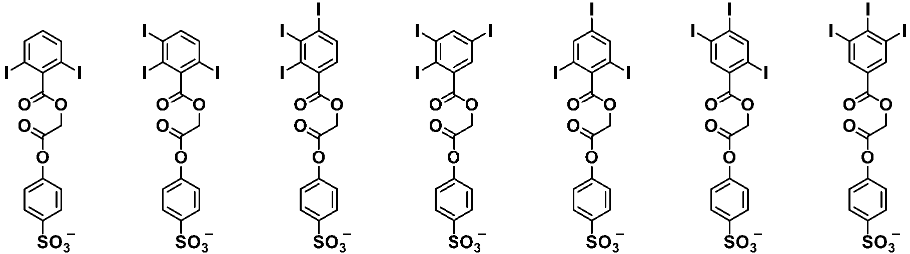

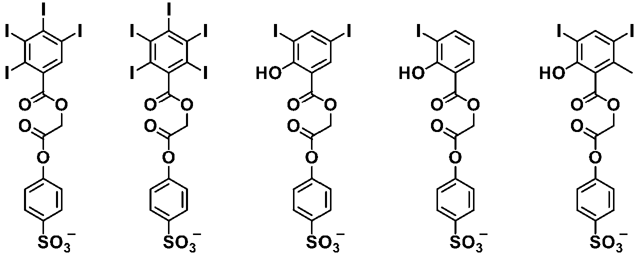

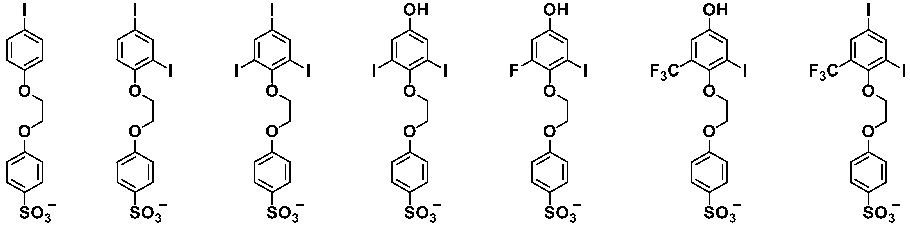

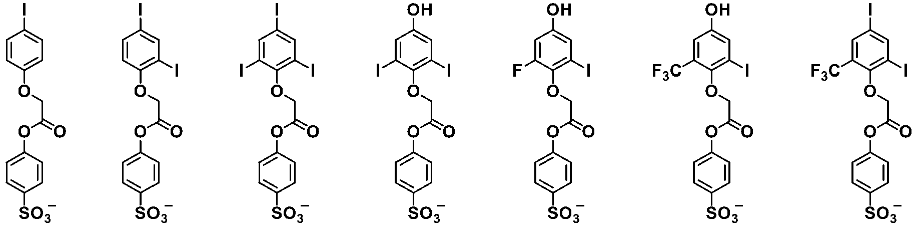

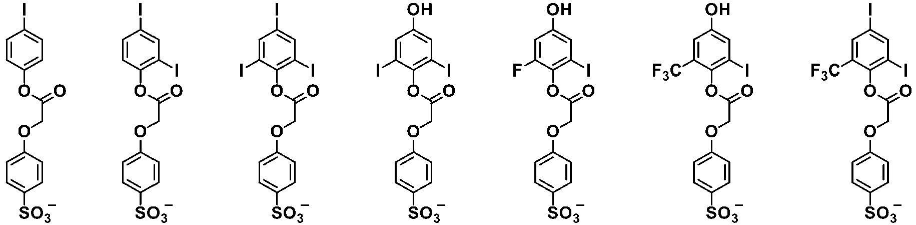

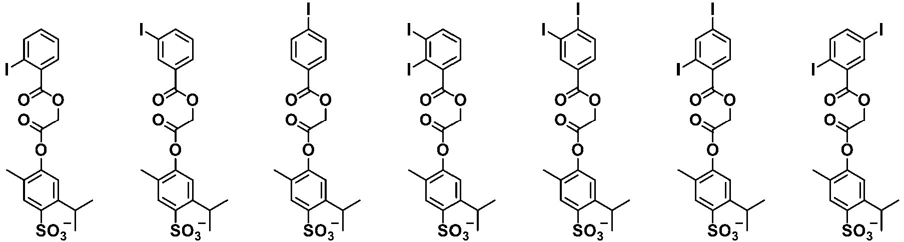

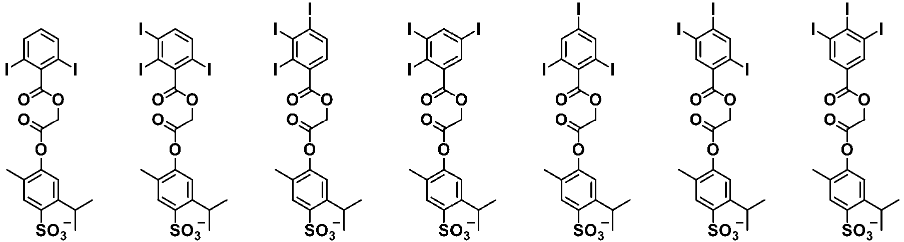

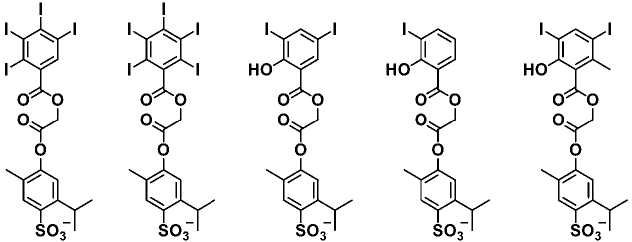

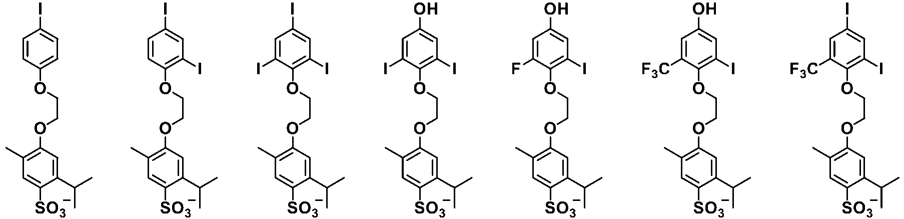

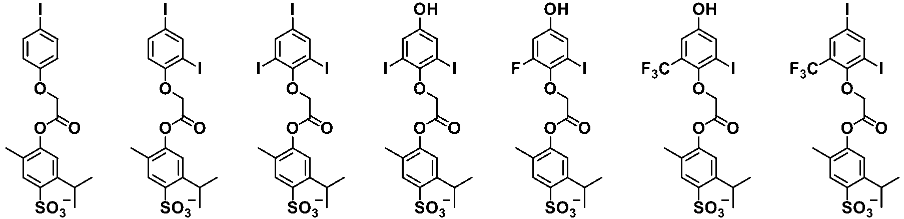

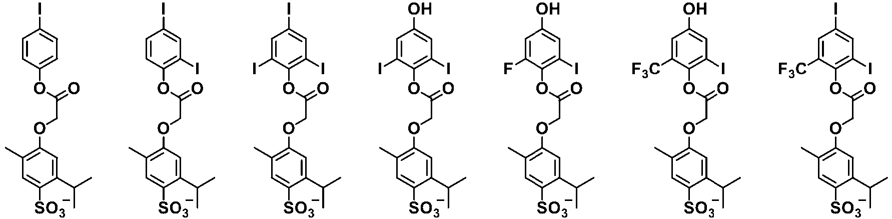

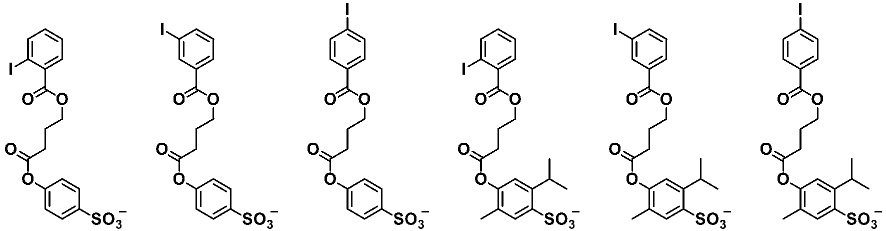

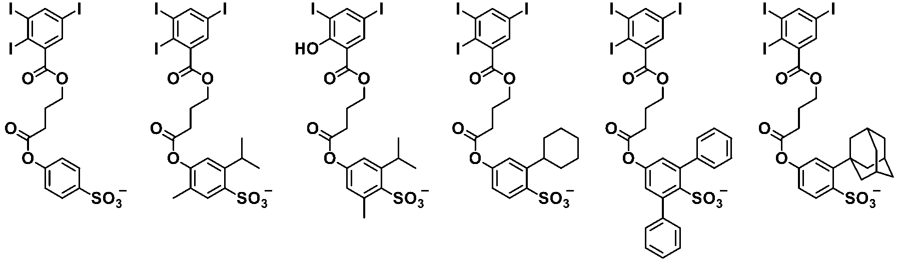

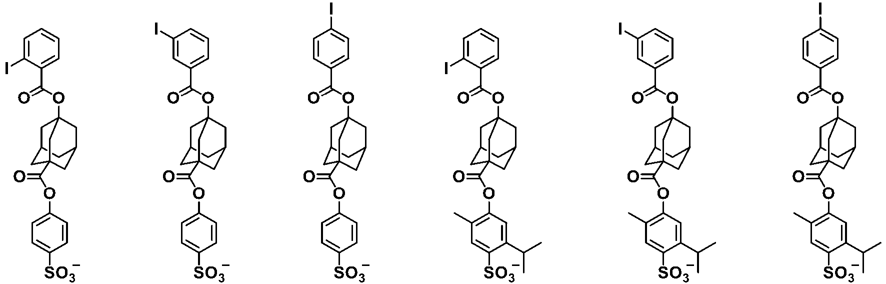

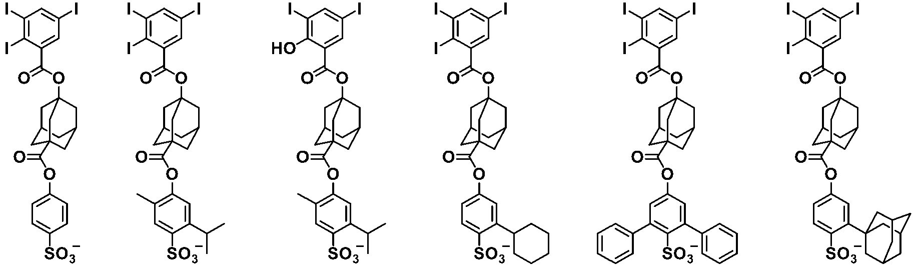

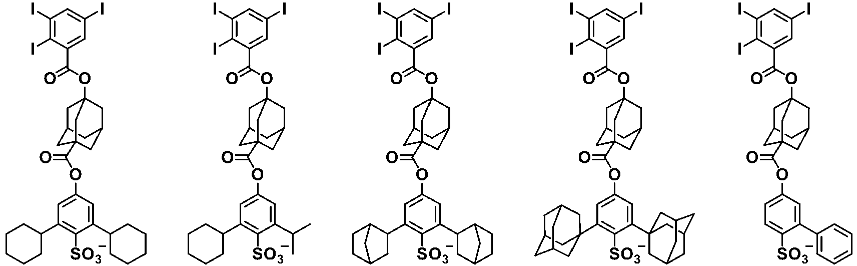

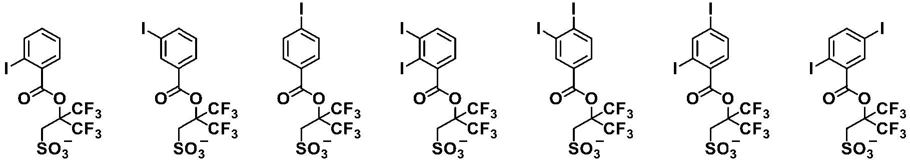

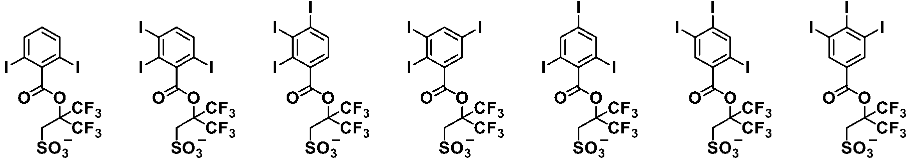

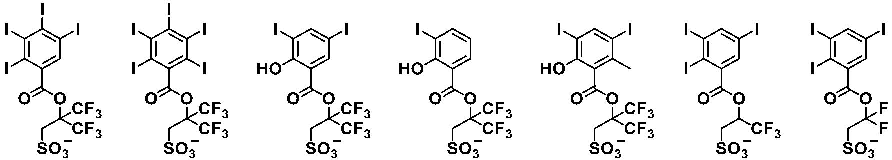

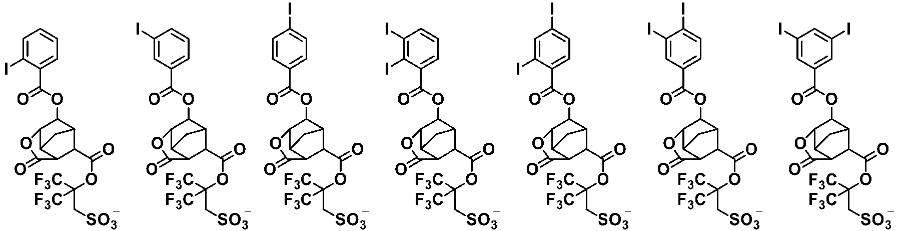

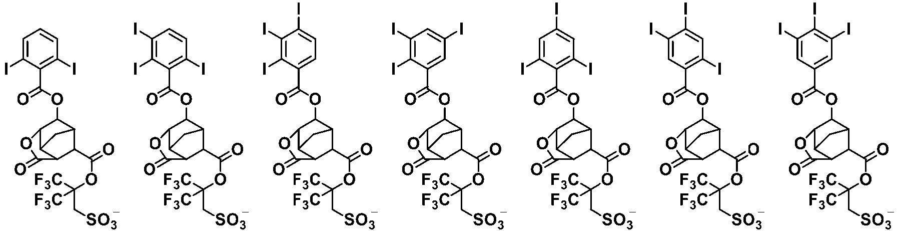

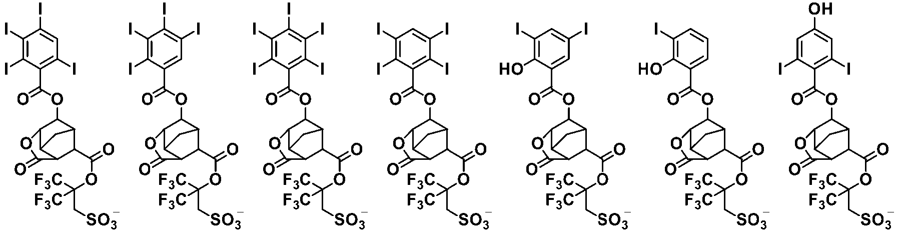

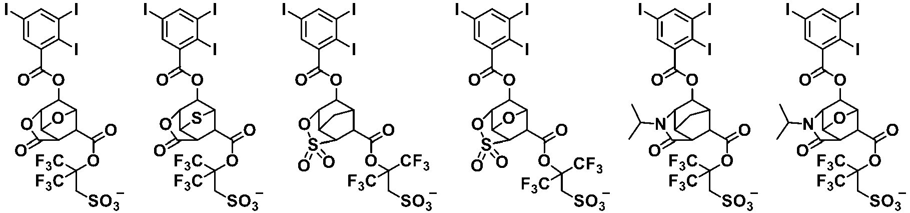

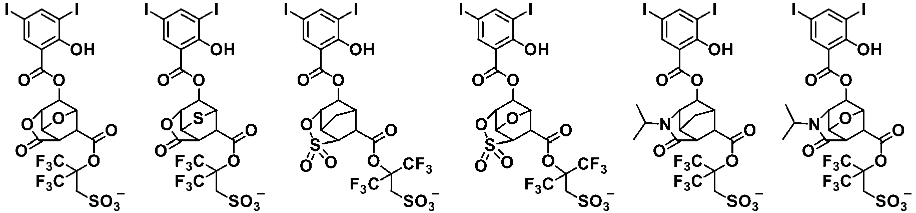

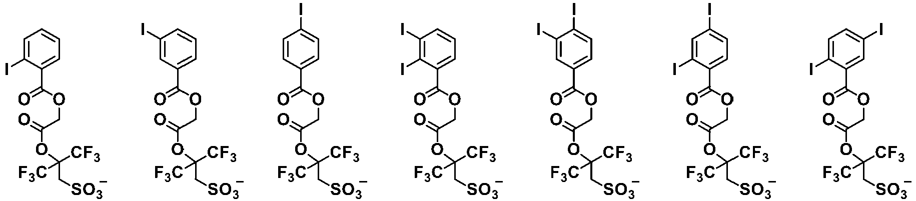

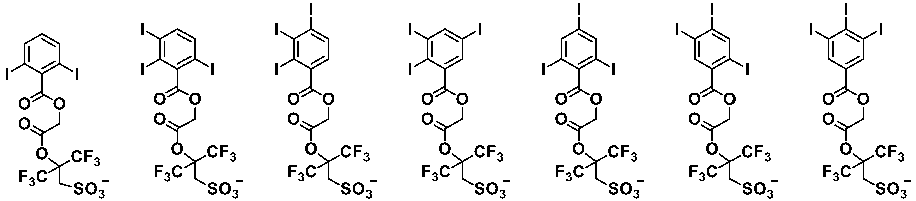

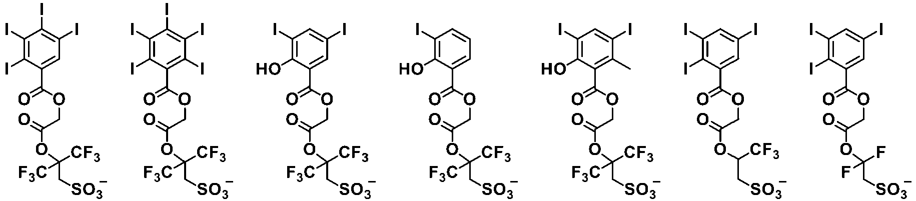

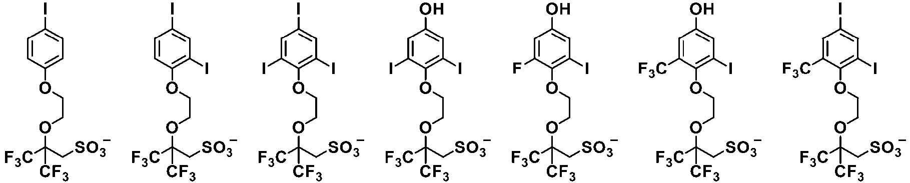

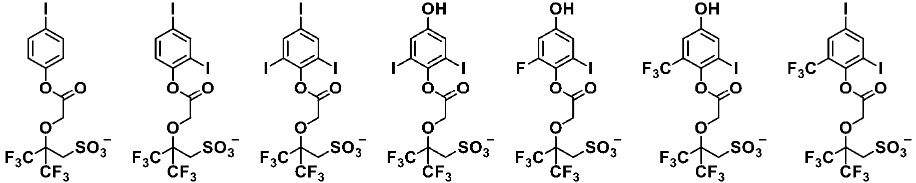

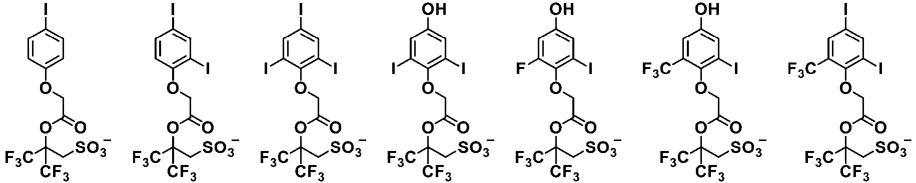

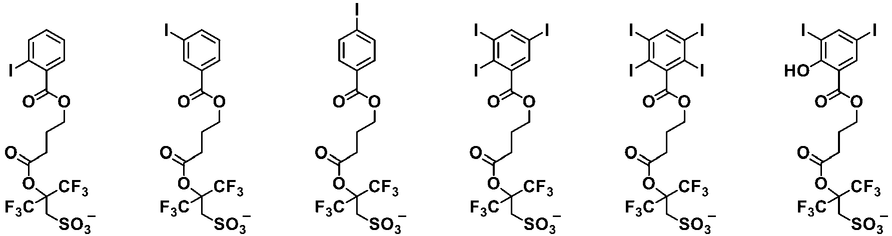

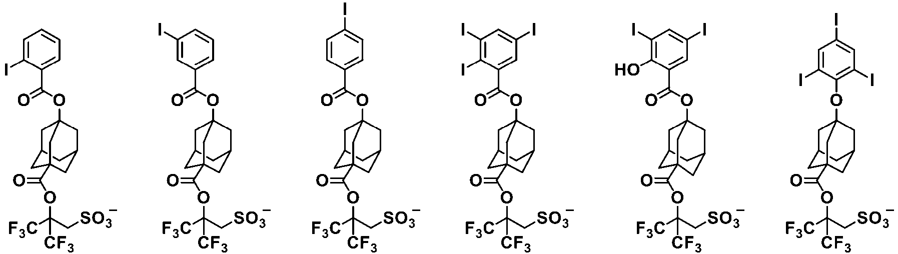

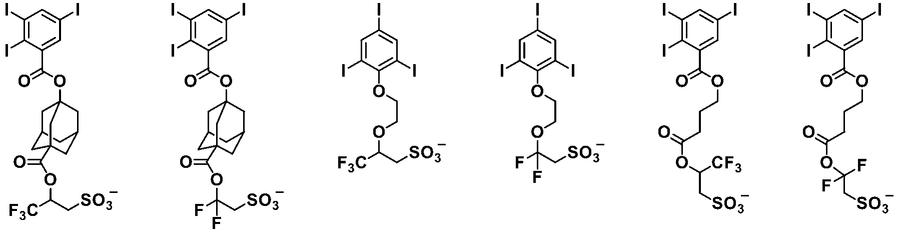

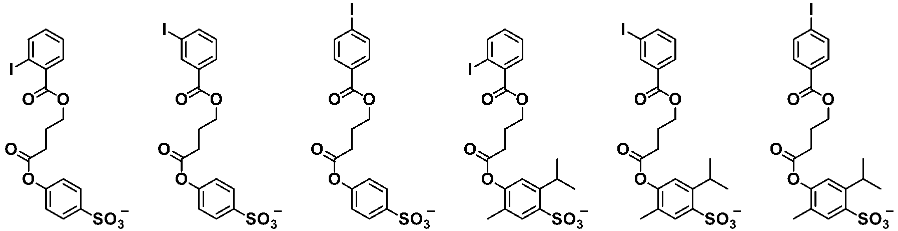

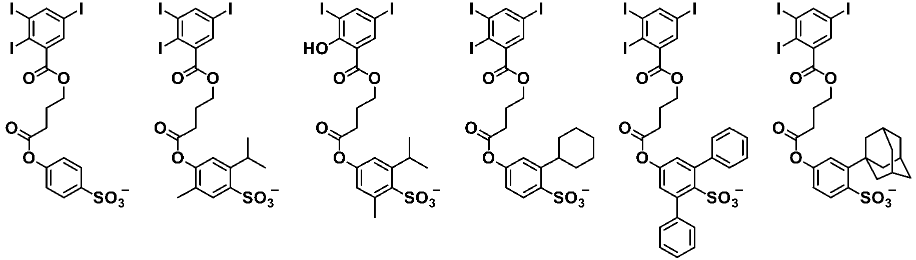

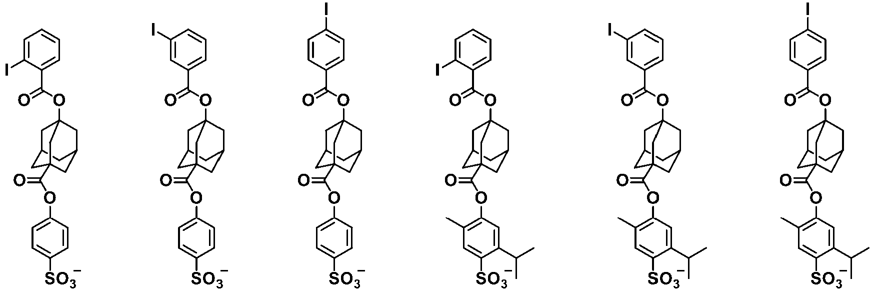

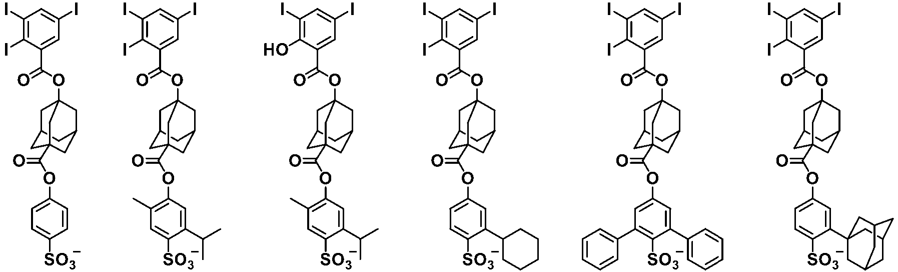

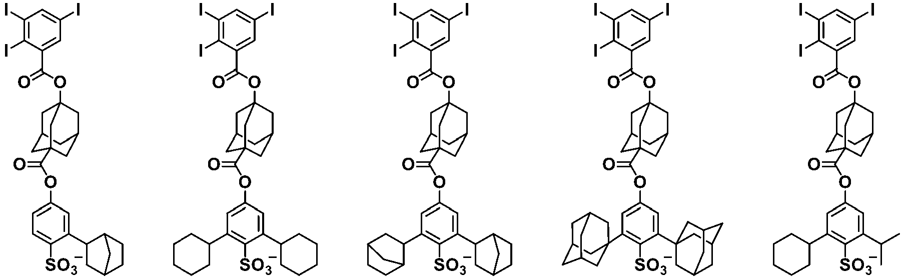

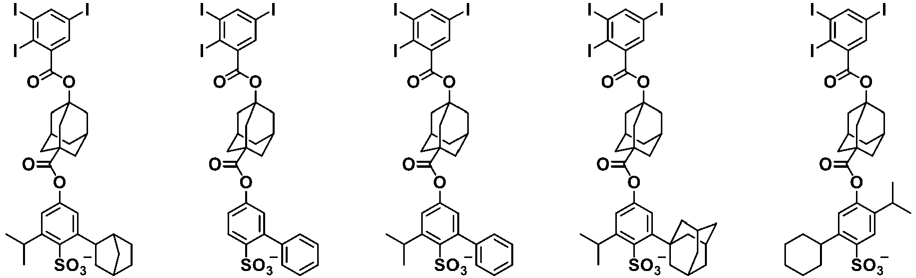

Preferred examples of the cation that pairs with the anion include sulfonium and iodonium cations. Examples of the sulfonium cation are as exemplified above for the sulfonium cation having formula (Z-1) and the sulfonium cation having formula (Z-3), but not limited thereto. Examples of the iodonium cation are as exemplified above for the iodonium cation having formula (Z-2), but not limited thereto.

The other PAG generates an acid having a pKa value of preferably -2.0 or larger, more preferably -1.0 or larger. The upper limit of pKa is preferably 2.0. Notably, the pKa value is computed using pKa DB in software ACD/Chemsketch ver: 9.04 of Advanced Chemistry Development Inc.

When the resist composition contains the other PAG (G), the amount of the PAG (G) used is preferably 1 to 10 parts, more preferably 1 to 5 parts by weight per 80 parts by weight of the base polymer (B). The inclusion of the other PAG provides for appropriate adjustment of the amount of acid generated in the exposed region and the degree of dissolution inhibition in the unexposed region. The other PAG may be used alone or in admixture.

### (H) Surfactant

The negative resist composition may contain any conventional surfactants for facilitating to coat the composition to the substrate. Exemplary surfactants include PF-636 (Omnova Solutions Inc.) and FC-4430 (3M) as well as a number of known surfactants as described in JP-A 2004-115630. Any suitable one may be chosen therefrom. The amount of the surfactant (H) added is preferably 0 to 5 parts by weight per 80 parts by weight of the base polymer (B). The surfactant may be used alone or in admixture.

### Process

Another embodiment of the invention is a resist pattern forming process comprising the steps of applying the negative resist composition defined above onto a substrate to form a resist film thereon, exposing the resist film patternwise to high-energy radiation, and developing the resist film in an alkaline developer to form a resist pattern.

Pattern formation using the negative resist composition of the invention may be performed by well-known lithography processes. In general, the resist composition is first applied onto a substrate for IC fabrication (e.g., Si, SiO, SiO₂, SiN, SiON, TiN, WSi, BPSG, SOG, organic antireflective coating, etc.) or a substrate for mask circuit fabrication (e.g., Cr, CrO, CrON, MoSi₂, Si, SiO, SiO₂, SiON, SiONC, CoTa, NiTa, TaBN, SnO₂, etc.) by a suitable coating technique such as spin coating. The coating is prebaked on a hotplate preferably at a temperature of 60 to 150°C for 1 to 20 minutes, more preferably at 80 to 140°C for 1 to 10 minutes to form a resist film of 0.03 to 2 µm thick.

Then the resist film is exposed patternwise to high-energy radiation such as UV, deep-UV, excimer laser (KrF, ArF), EUV of wavelength 3 to 15 nm, x-ray, γ-ray or synchrotron radiation or EB. The resist composition of the invention is especially effective in the EUV or EB lithography.

On use of UV, deep-UV, EUV, excimer laser, x-ray, γ-ray or synchrotron radiation as the high-energy radiation, the resist film is exposed through a mask having a desired pattern, preferably in a dose of 1 to 500 mJ/cm², more preferably 10 to 400 mJ/cm².

On use of EB, a pattern may be written directly in a dose of preferably 1 to 500 µC/cm², more preferably 10 to 400 µC/cm².

The exposure may be performed by conventional lithography whereas the immersion lithography of holding a liquid, typically water between the mask and the resist film may be employed if desired. In the case of immersion lithography, a protective film which is insoluble in water may be used.

The resist film is then baked (PEB) on a hotplate preferably at 60 to 150°C for 1 to 20 minutes, more preferably at 80 to 140°C for 1 to 10 minutes.

Thereafter, the resist film is developed with a developer in the form of an aqueous base solution, for example, 0.1 to 5 wt%, preferably 2 to 3 wt% aqueous solution of tetramethylammonium hydroxide (TMAH) preferably for 0.1 to 3 minutes, more preferably 0.5 to 2 minutes by conventional techniques such as dip, puddle and spray techniques. In this way, a desired resist pattern is formed on the substrate.

From the negative resist composition, a pattern with a high resolution and minimal LER can be formed. The resist composition is effectively applicable to a substrate, specifically a substrate having a surface layer of material to which a resist film is less adherent and which is likely to invite pattern stripping or pattern collapse, and particularly a substrate having sputter deposited on its outermost surface metallic chromium or a chromium compound containing at least one light element selected from oxygen, nitrogen and carbon or a substrate having an outermost surface layer of SiO, SiOₓ, or a tantalum, molybdenum, cobalt, nickel, tungsten or tin compound. The substrate to which the negative resist composition is applied is most typically a photomask blank which may be either of transmission or reflection type.

The mask blank of transmission type is typically a photomask blank having a light-shielding film of chromium-based material. It may be either a photomask blank for binary masks or a photomask blank for phase shift masks. In the case of the binary mask-forming photomask blank, the light-shielding film may include an antireflection layer of chromium-based material and a light-shielding layer. In one example, the antireflection layer on the surface layer side is entirely composed of a chromium-based material. In an alternative example, only a surface side portion of the antireflection layer on the surface layer side is composed of a chromium-based material and the remaining portion is composed of a silicon compound-based material which may contain a transition metal. In the case of the phase shift mask-forming photomask blank, it may include a phase shift film and a chromium-based light-shielding film thereon.

Photomask blanks having an outermost layer of chromium base material are well known as described in JP-A 2008-026500 and JP-A 2007-302873 and the references cited therein. Although the detail description is omitted herein, the following layer construction may be employed when a light-shielding film including an antireflective layer and a light-shielding layer is composed of chromium base materials.

In the example where a light-shielding film including an antireflective layer and a light-shielding layer is composed of chromium base materials, layers may be stacked in the order of an antireflective layer and a light-shielding layer from the outer surface side, or layers may be stacked in the order of an antireflective layer, a light-shielding layer, and an antireflective layer from the outer surface side. Each of the antireflective layer and the light-shielding layer may be composed of multiple sub-layers. When the sub-layers have different compositions, the composition may be graded discontinuously or continuously from sub-layer to sub-layer. The chromium base material used herein may be metallic chromium or a material consisting of metallic chromium and a light element such as oxygen, nitrogen or carbon. Examples used herein include metallic chromium, chromium oxide, chromium nitride, chromium carbide, chromium oxynitride, chromium oxycarbide, chromium nitride carbide, and chromium oxide nitride carbide.

The mask blank of reflection type includes a substrate, a multilayer reflective film formed on one major surface (front surface) of the substrate, for example, a multilayer reflective film of reflecting exposure radiation such as EUV radiation, and an absorber film formed on the multilayer reflective film, for example, an absorber film of absorbing exposure radiation such as EUV radiation to reduce reflectivity. From the reflection type mask blank (reflection type mask blank for EUV lithography), a reflection type mask (reflection type mask for EUV lithography) having an absorber pattern (patterned absorber film) formed by patterning the absorber film is produced. The EUV radiation used in the EUV lithography has a wavelength of 13 to 14 nm, typically about 13.5 nm.

The multilayer reflective film is preferably formed contiguous to one major surface of a substrate. An underlay film may be disposed between the substrate and the multilayer reflective film as long as the benefits of the invention are not lost. The absorber film may be formed contiguous to the multilayer reflective film while a protective film (protective film for the multilayer reflective film) may be disposed between the multilayer reflective film and the absorber film, preferably contiguous to the multilayer reflective film, more preferably contiguous to the multilayer reflective film and the absorber film. The protective film is used for protecting the multilayer reflective film in a cleaning, tailoring or otherwise processing step. Also preferably, the protective film has an additional function of protecting the multilayer reflective film or preventing the multilayer reflective film from oxidation during the step of patterning the absorber film by etching. Besides, an electroconductive film, which is used for electrostatic chucking of the reflection type mask to an exposure tool, may be disposed below the other major surface (back side surface) which is opposed to the one major surface of the substrate, preferably contiguous to the other major surface. It is provided herein that a substrate has one major surface which is a front or upper side surface and another major surface which is a back or lower side surface. The terms "front and back" sides or "upper and lower" sides are used for the sake of convenience. One or another major surface may be either of the two major surfaces (film-bearing surfaces) of a substrate, and in this sense, front and back or upper and lower are exchangeable. Specifically, the multilayer reflective film may be formed by any of the methods of JP-A 2021-139970 and the references cited therein.

The resist pattern forming process is successful in forming patterns having a very high resolution, reduced LER, rectangularity, and fidelity even on a substrate (typically mask blank of transmission or reflection type) whose outermost surface is made of a material tending to affect resist pattern profile such as a chromium, silicon or tantalum-containing material.

### EXAMPLES

Examples of the invention are given below by way of illustration and not by way of limitation. The abbreviation "pbw" is parts by weight. Analysis is made by time-of-flight mass spectrometry (TOF-MS) using MALDI TOF-MS: S3000 by JEOL Ltd.

### [1] Synthesis of onium salts

### Example 1-1

### Synthesis of onium salt PAG-1

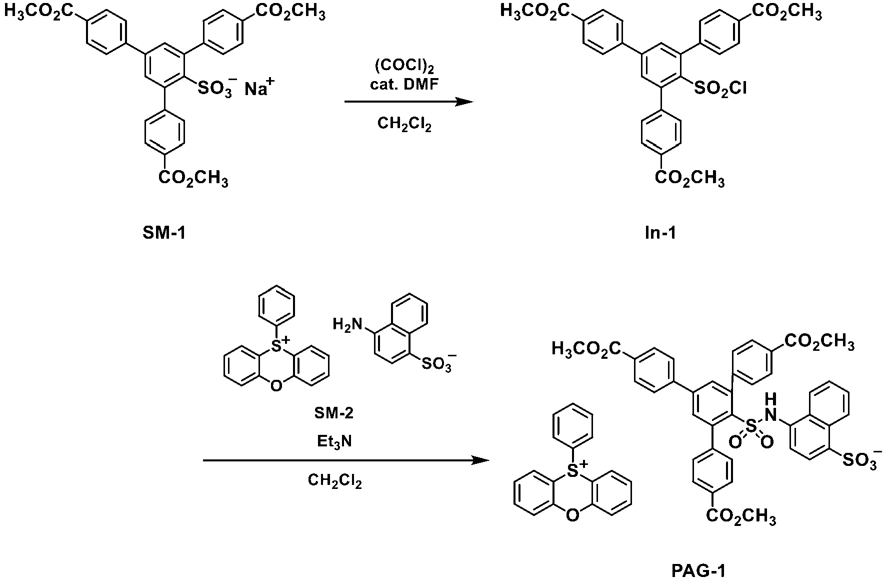

### (1) Synthesis of Intermediate In-1

In a reactor under nitrogen atmosphere, 14.5 g of reactant SM-1 and 0.2 g of N,N-dimethylformamide were dissolved in 100 g of methylene chloride. After the reactor was heated at a temperature of 40°C, 9.5 g of oxalyl chloride was added dropwise to the solution, which was aged in the reactor at a temperature of 40°C for 2 hours. After aging, the reaction solution was cooled down and 50 g of water was added to quench the reaction. The desired compound was extracted with 50 g of methylene chloride. This was followed by ordinary aqueous workup, solvent distillation, and recrystallization from hexane, obtaining 13.7 g of Intermediate In-1 as white crystals (yield 95%).

### (2) Synthesis of onium salt PAG-1

In a reactor under nitrogen atmosphere, 5.8 g of Intermediate In-1 and 5.0 g of reactant SM-2 were suspended in 70 g of methylene chloride. 1.4 g of triethylamine was added dropwise to the suspension, which was aged at room temperature for 10 hours.

At the end of aging, 30 g of water was added to quench the reaction. The target compound was extracted with 30 g of methylene chloride. This was followed by ordinary aqueous workup, solvent distillation, and purification by silica gel chromatography, obtaining 8.6 g of onium salt PAG-1 as white crystals (yield 83%).

PAG-1 was analyzed by TOF-MS, with the results shown below.

MALDI TOF-MS:
positive M⁺ 277 (corresponding to C₁₈H₁₃OS⁺)
negative M⁻ 764 (corresponding to C₄₀H₃₀NO₁₁S₂⁻)

### Examples 1-2 to 1-8

### Synthesis of PAG-2 to PAG-8

Onium salts PAG-2 to PAG-8 shown below were synthesized by well-known organic synthesis reaction using corresponding reactants.

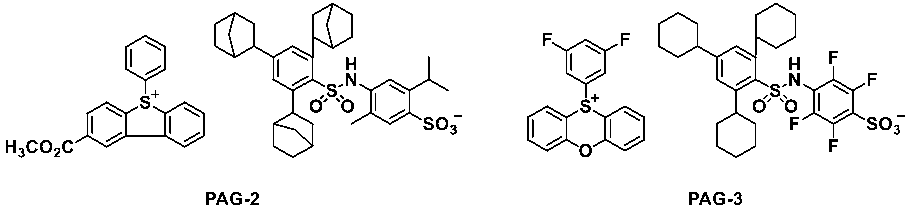

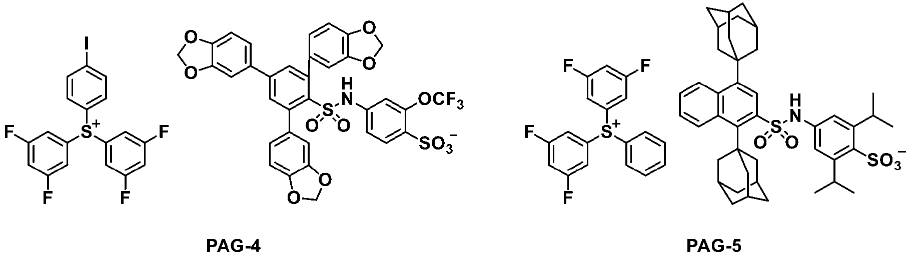

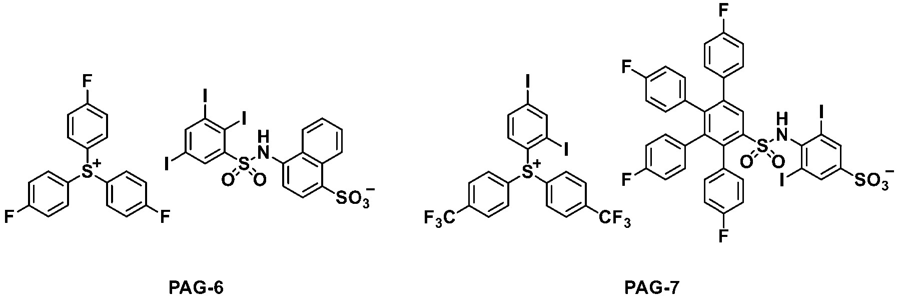

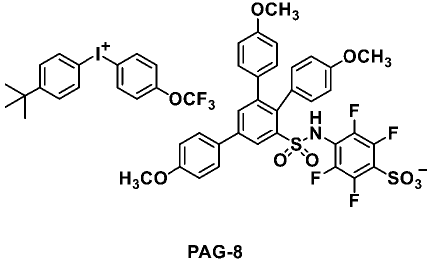

### [2] Preparation of chemically amplified negative resist compositions

### Examples 1-1 to 1-54 and Comparative Examples 1-1 to 1-10

Chemically amplified negative resist compositions (R-1 to R-54, CR-1 to CR-10) were prepared by dissolving selected components in an organic solvent in accordance with the formulation shown in Tables 1 to 3, and filtering the solution through a UPE filter and/or nylon filter with a pore size of 10 nm, 5 nm, 3 nm or 1 nm. The organic solvent was a mixture of 790 pbw of PGMEA, 1,580 pbw of EL, and 1,580 pbw of PGME.

To some compositions, fluorinated polymer (Polymers FP-1 to FP-5) as additive, tetramethoxymethylglycoluril (TMGU) as crosslinker, and PF-636 (Omnova Solutions Inc.) as surfactant were added.

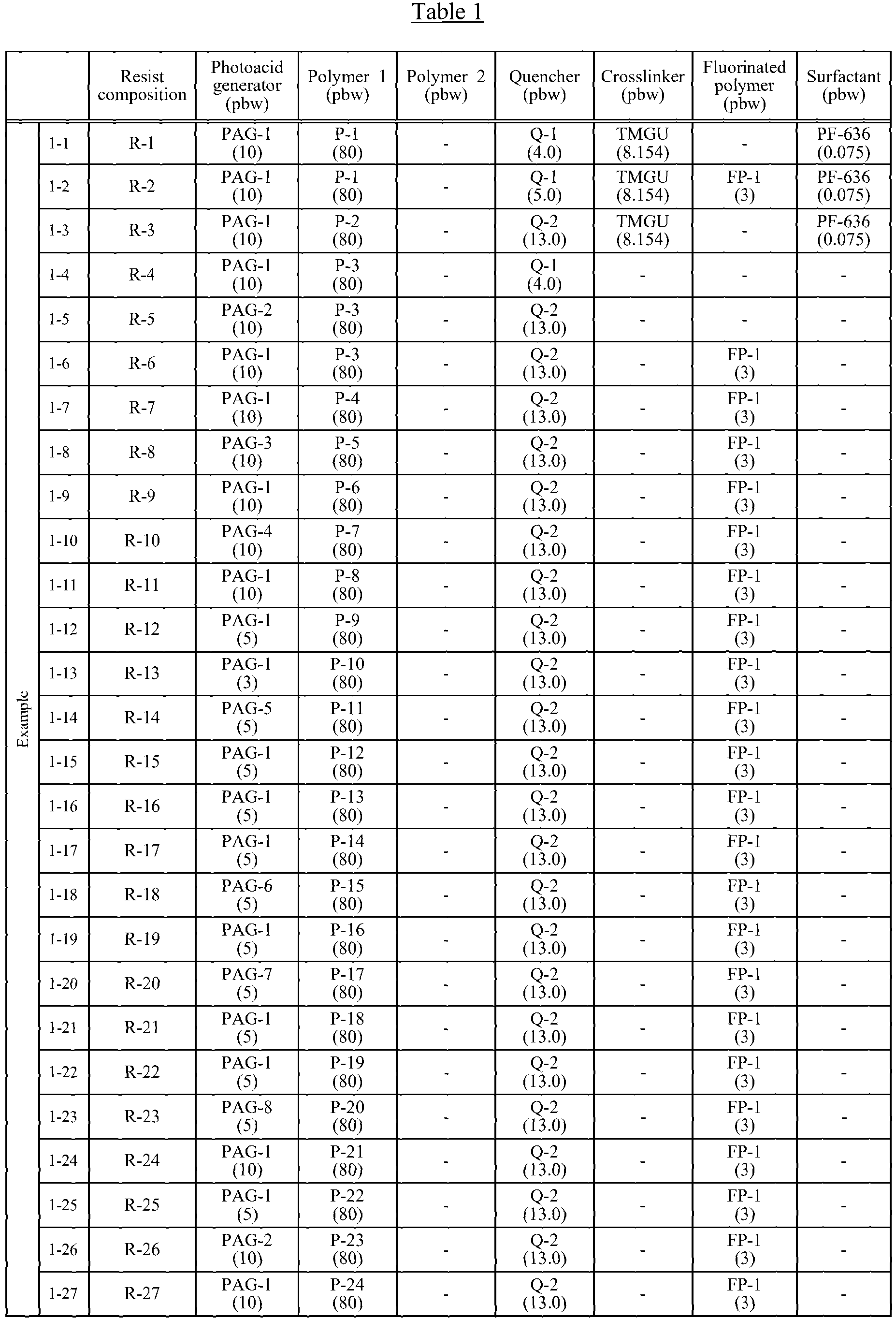

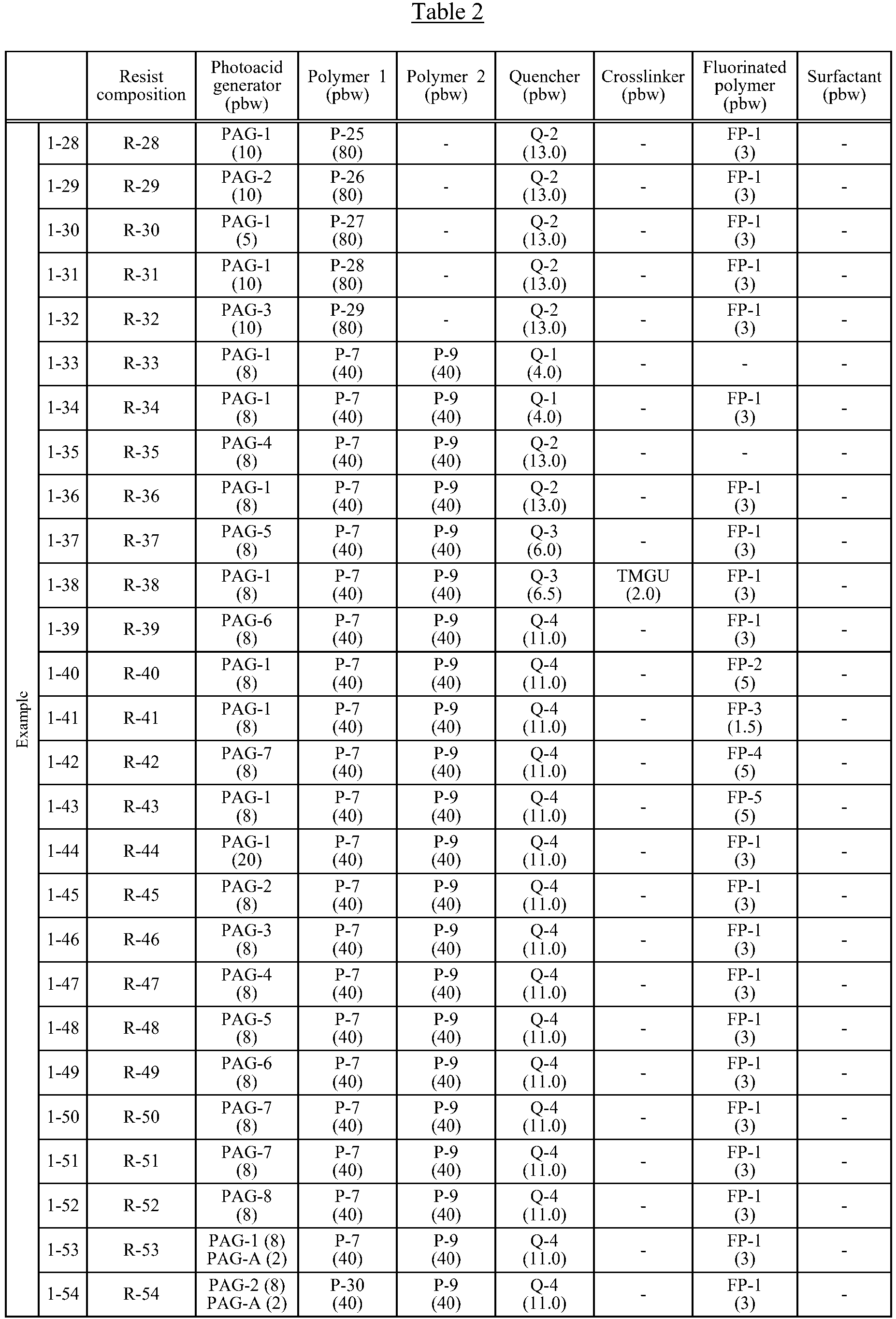

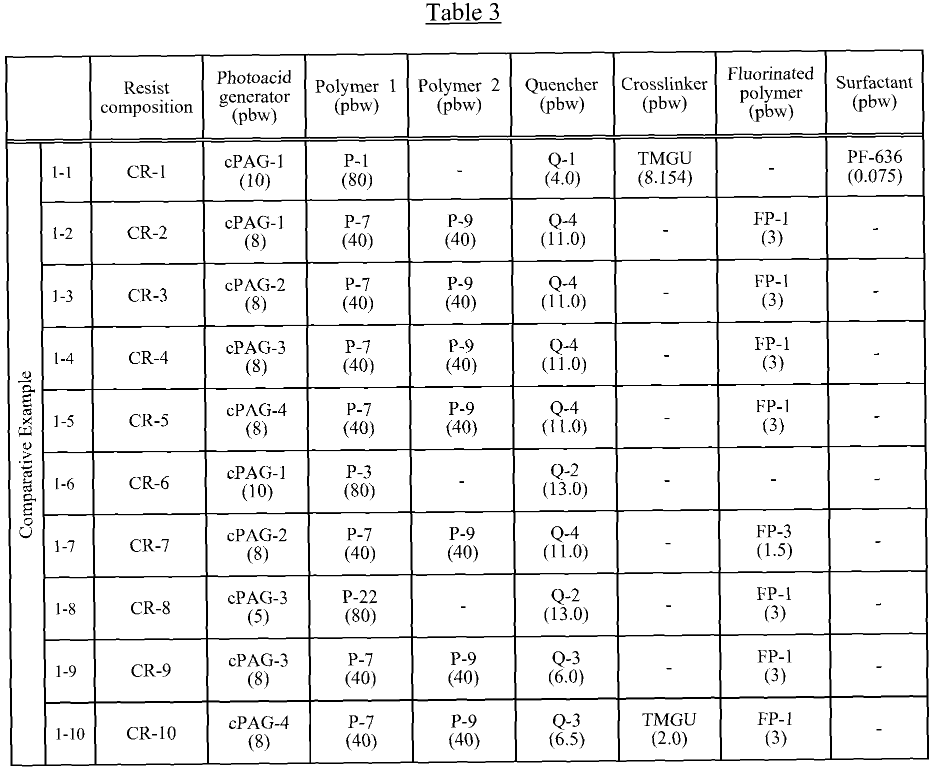

Polymers P-1 to P-30 used in resist compositions have the structure shown in Table 4. The polymer was analyzed for Mw and Mw/Mn by GPC versus polystyrene standards using THF or DMF solvent.

**Table 4**

| | Unit 1 | Incorporation ratio (mol%) | Unit 2 | Incorporation ratio (mol%) | Unit 3 | Incorporation ratio (mol%) | Unit 4 | Incorporation ratio (mol%) | Unit 5 | Incorporation ratio (mol%) | Mw | Mw/Mn |
|---|---|---|---|---|---|---|---|---|---|---|---|---|
| P-1 | A-1 | 80.0 | B-1 | 10.0 | B-5 | 10.0 | - | - | - | - | 4,500 | 1.65 |
| P-2 | A-1 | 80.0 | B-2 | 8.0 | B-4 | 12.0 | - | - | - | - | 4,400 | 1.64 |
| P-3 | A-1 | 60.0 | B-2 | 10.0 | C-1 | 30.0 | - | - | - | - | 3,700 | 1.62 |
| P-4 | A-1 | 70.0 | B-2 | 7.0 | C-2 | 23.0 | - | - | - | - | 3,600 | 1.63 |
| P-5 | A-1 | 70.0 | B-2 | 10.0 | C-3 | 20.0 | - | - | - | - | 3,900 | 1.65 |
| P-6 | A-1 | 30.0 | B-2 | 10.0 | C-4 | 60.0 | - | - | - | - | 3,900 | 1.62 |
| P-7 | A-1 | 45.0 | B-2 | 10.0 | C-5 | 45.0 | - | - | - | - | 4,100 | 1.63 |
| P-8 | A-1 | 55.0 | B-4 | 10.0 | C-1 | 35.0 | - | - | - | - | 4,000 | 1.63 |
| P-9 | A-1 | 66.0 | B-2 | 9.0 | C-1 | 21.5 | E-1 | 3.5 | - | - | 13,000 | 1.62 |
| P-10 | A-1 | 60.0 | B-2 | 4.0 | C-1 | 24.0 | E-1 | 12.0 | - | - | 15,000 | 1.65 |
| P-11 | A-1 | 67.0 | B-2 | 10.0 | C-1 | 18.5 | E-2 | 4.5 | - | - | 14,000 | 1.63 |
| P-12 | A-1 | 67.0 | B-2 | 9.3 | C-1 | 20.0 | E-3 | 3.7 | - | - | 13,500 | 1.63 |
| P-13 | A-1 | 67.3 | B-2 | 10.0 | C-1 | 17.5 | E-4 | 5.2 | - | - | 13,200 | 1.64 |
| P-14 | A-1 | 64.1 | B-2 | 9.5 | C-1 | 22.0 | E-5 | 4.4 | - | - | 12,800 | 1.62 |
| P-15 | A-1 | 64.0 | B-2 | 10.0 | C-1 | 22.8 | E-6 | 3.2 | - | - | 13,500 | 1.63 |
| P-16 | A-1 | 62.0 | B-3 | 10.0 | C-1 | 24.3 | E-1 | 3.7 | - | - | 12,400 | 1.66 |
| P-17 | A-2 | 60.5 | B-4 | 10.0 | C-1 | 24.4 | E-2 | 5.1 | - | - | 12,300 | 1.65 |
| P-18 | A-1 | 70.0 | C-1 | 30.0 | - | - | - | - | - | - | 4,200 | 1.69 |
| P-19 | A-1 | 80.0 | B-2 | 5.0 | C-1 | 15.0 | - | - | - | - | 4,300 | 1.67 |
| P-20 | A-1 | 80.0 | B-2 | 2.5 | C-1 | 15.0 | E-1 | 2.5 | - | - | 12,100 | 1.69 |
| P-21 | A-2 | 50.0 | C-1 | 30.0 | D-1 | 20.0 | - | - | - | - | 4,600 | 1.67 |
| P-22 | A-2 | 50.0 | B-2 | 2.5 | C-1 | 30.0 | D-1 | 15.0 | E-1 | 2.5 | 12,700 | 1.73 |
| P-23 | A-2 | 50.0 | C-1 | 30.0 | D-2 | 20.0 | - | - | - | - | 5,400 | 1.72 |
| P-24 | A-2 | 50.0 | C-1 | 30.0 | D-3 | 20.0 | - | - | - | - | 6,100 | 1.73 |
| P-25 | A-2 | 50.0 | C-1 | 30.0 | D-4 | 20.0 | - | - | - | - | 7,000 | 1.76 |
| P-26 | A-1 | 67.5 | B-2 | 2.5 | C-1 | 30.0 | - | - | - | - | 4,100 | 1.65 |
| P-27 | A-1 | 57.5 | B-2 | 2.5 | C-1 | 30.0 | E-5 | 10 | - | - | 11,000 | 1.65 |
| P-28 | A-1 | 65.0 | C-1 | 25.0 | E-7 | 10.0 | - | - | - | - | 13,000 | 1.80 |
| P-29 | A-1 | 65.0 | C-1 | 25.0 | E-8 | 10.0 | - | - | - | - | 12,500 | 1.80 |
| P-30 | A-3 | 76.0 | B-2 | 6.0 | C-1 | 18.0 | - | - | - | - | 4,500 | 1.68 |

The structure of each unit in Table 4 is shown below.

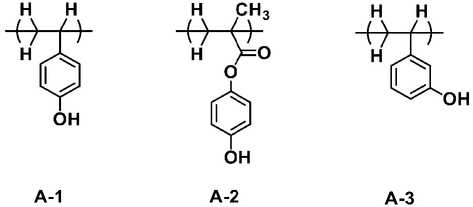

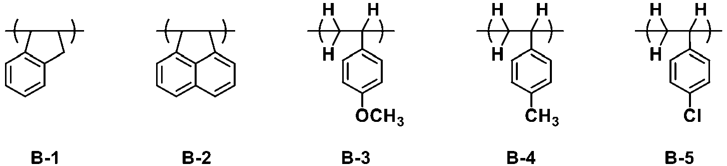

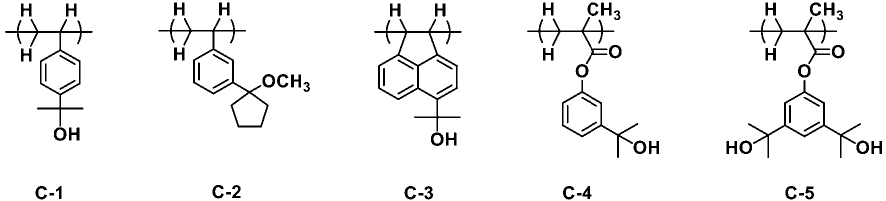

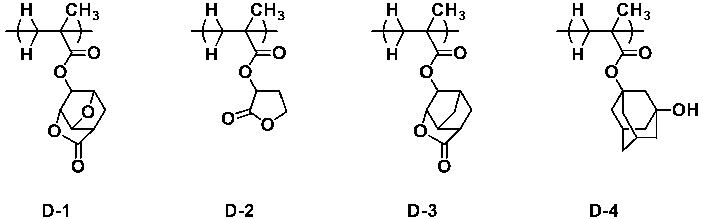

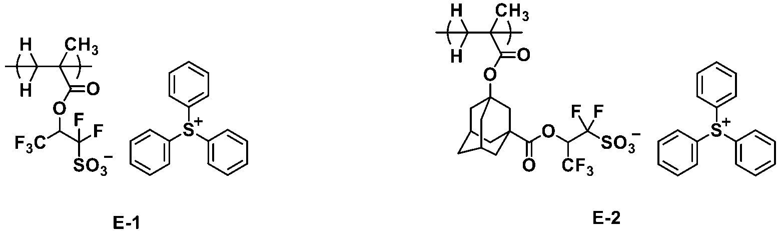

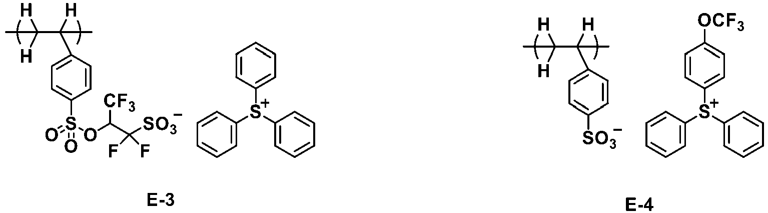

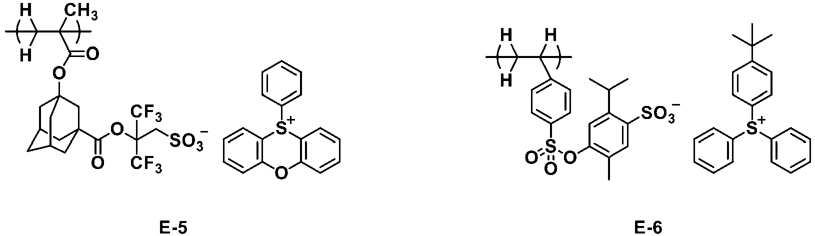

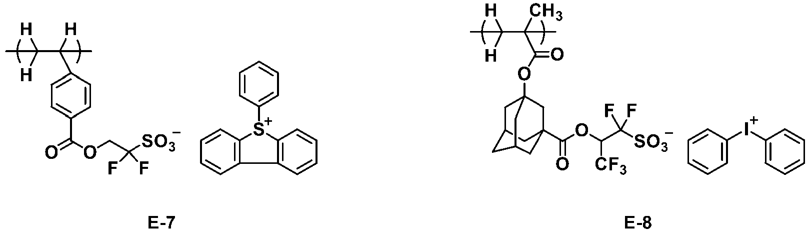

In Tables 1 to 3, other photoacid generator PAG-A, comparative photoacid generators cPAG-1 to cPAG-4, quenchers Q-1 to Q-4, and fluorinated polymers FP-1 to FP-5 have the following structure.

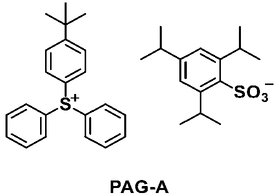

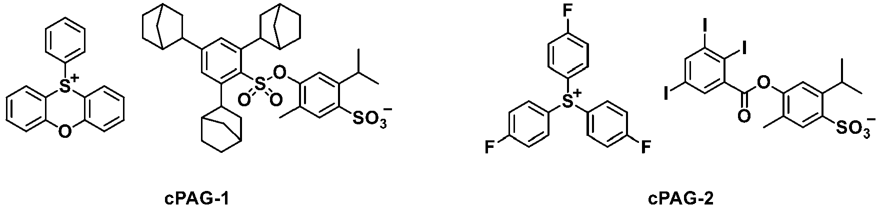

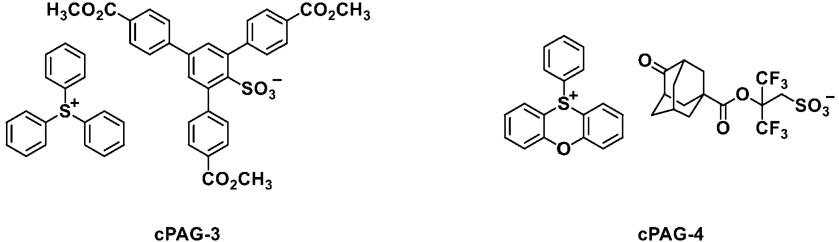

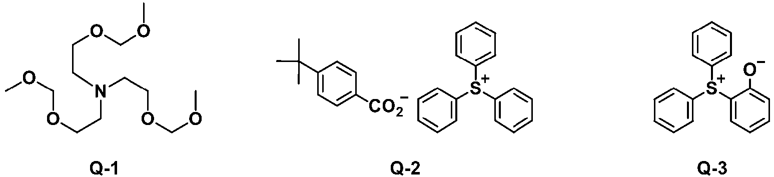

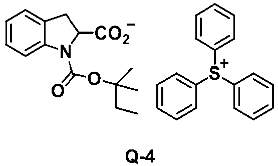

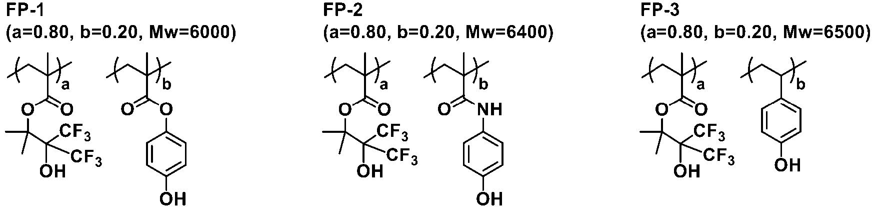

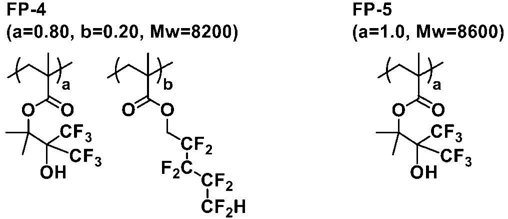

### [3] EB lithography test

### Examples 2-1 to 2-54 and Comparative Examples 2-1 to 2-10

Using a coater/developer system ACT-M (Tokyo Electron Ltd.), each of the negative resist compositions (R-1 to R-54 and CR-1 to CR-10) was spin coated onto a mask blank of 152 mm squares having the outermost surface of a silicon oxide film, which had been vapor primed with hexamethyldisilazane (HMDS), and prebaked on a hotplate at 110°C for 600 seconds to form a resist film of 80 nm thick. The thickness of the resist film was measured by an optical film thickness measurement system Nanospec (Nanometrics Inc.). Measurement was made at 81 points in the plane of the blank substrate excluding a peripheral band extending 10 mm inward from the blank periphery, and an average film thickness and a film thickness range were computed therefrom.

The resist film was exposed to EB using an EB writer system EBM-5000Plus (NuFlare Technology Inc., accelerating voltage 50 kV), then baked (PEB) at 120°C for 600 seconds, and developed in a 2.38 wt% TMAH aqueous solution, thereby yielding a negative pattern.

The resist pattern was evaluated as follows. The patterned mask blank was observed under a top-down scanning electron microscope (TDSEM). The optimum dose (Eop) was defined as the exposure dose (µC/cm²) which provided a 1:1 resolution at the top and bottom of a 200-nm 1:1 line-and-space (LS) pattern. The resolution (or maximum resolution) was defined as the minimum line width of a LS pattern that could be resolved at the optimum dose.

The 200-nm LS pattern printed by exposure at the optimum dose (Eop) was observed under SEM. For each of the edges of 32 lines of the LS pattern, edge detection was carried out at 80 points, from which a 3-fold value (3σ) of the standard deviation (σ) or variation was determined and reported as LER (nm). It was judged by visual observation whether or not the pattern profile was rectangular. For the evaluation of pattern fidelity, when a square dot pattern of size 120 nm and density 36% was placed, an area loss (%) at one corner of the square dot was computed. A smaller value indicates that the dot profile is more rectangular. The results are shown in Tables 5 to 7.

**Table 5**

| | | Resist composition | Eop (µC/cm²) | Maximum resolution (nm) | LER (nm) | Pattern profile | Area loss (%) |
|---|---|---|---|---|---|---|---|
| | 2-1 | R-1 | 100 | 36 | 4.8 | rectangular | 10 |
| | 2-2 | R-2 | 95 | 36 | 4.7 | rectangular | 10 |
| | 2-3 | R-3 | 100 | 37 | 4.7 | rectangular | 9 |
| | 2-4 | R-4 | 100 | 32 | 4.1 | rectangular | 10 |
| | 2-5 | R-5 | 105 | 33 | 4.0 | rectangular | 9 |
| | 2-6 | R-6 | 100 | 32 | 4.1 | rectangular | 9 |
| | 2-7 | R-7 | 105 | 33 | 4.2 | rectangular | 9 |
| | 2-8 | R-8 | 100 | 34 | 4.1 | rectangular | 9 |
| | 2-9 | R-9 | 100 | 32 | 4.1 | rectangular | 9 |
| | 2-10 | R-10 | 100 | 33 | 4.2 | rectangular | 9 |
| | 2-11 | R-11 | 95 | 34 | 4.3 | rectangular | 9 |
| | 2-12 | R-12 | 95 | 33 | 4.3 | rectangular | 9 |
| | 2-13 | R-13 | 100 | 34 | 4.2 | rectangular | 9 |
| Example | 2-14 | R-14 | 100 | 33 | 4.1 | rectangular | 9 |
| | 2-15 | R-15 | 105 | 33 | 4.2 | rectangular | 9 |
| | 2-16 | R-16 | 100 | 34 | 4.3 | rectangular | 9 |
| | 2-17 | R-17 | 100 | 33 | 4.1 | rectangular | 9 |
| | 2-18 | R-18 | 100 | 32 | 4.2 | rectangular | 9 |
| | 2-19 | R-19 | 95 | 33 | 4.1 | rectangular | 9 |
| | 2-20 | R-20 | 100 | 33 | 4.1 | rectangular | 9 |
| | 2-21 | R-21 | 95 | 32 | 4.1 | rectangular | 9 |
| | 2-22 | R-22 | 95 | 34 | 4.3 | rectangular | 9 |
| | 2-23 | R-23 | 100 | 33 | 4.2 | rectangular | 9 |
| | 2-24 | R-24 | 95 | 33 | 4.1 | rectangular | 9 |
| | 2-25 | R-25 | 100 | 34 | 4.0 | rectangular | 9 |
| | 2-26 | R-26 | 100 | 33 | 4.1 | rectangular | 9 |
| | 2-27 | R-27 | 95 | 33 | 4.2 | rectangular | 9 |

**Table 6**

| | | Resist composition | Eop (µC/cm²) | Maximum resolution (nm) | LER (nm) | Pattern profile | Area loss (%) |
|---|---|---|---|---|---|---|---|
| | 2-28 | R-28 | 95 | 32 | 4.0 | rectangular | 9 |
| | 2-29 | R-29 | 105 | 33 | 4.1 | rectangular | 9 |
| | 2-30 | R-30 | 100 | 31 | 4.2 | rectangular | 9 |
| | 2-31 | R-31 | 95 | 32 | 4.1 | rectangular | 9 |
| | 2-32 | R-32 | 95 | 31 | 4.1 | rectangular | 9 |
| | 2-33 | R-33 | 100 | 33 | 4.3 | rectangular | 9 |
| | 2-34 | R-34 | 95 | 31 | 4.2 | rectangular | 9 |
| | 2-35 | R-35 | 100 | 32 | 4.1 | rectangular | 9 |
| | 2-36 | R-36 | 105 | 31 | 4.2 | rectangular | 9 |
| | 2-37 | R-37 | 100 | 34 | 4.1 | rectangular | 9 |
| | 2-38 | R-38 | 95 | 32 | 4.2 | rectangular | 9 |
| | 2-39 | R-39 | 100 | 31 | 4.3 | rectangular | 9 |
| | 2-40 | R-40 | 105 | 33 | 4.2 | rectangular | 9 |
| Example | 2-41 | R-41 | 105 | 32 | 4.1 | rectangular | 9 |
| | 2-42 | R-42 | 105 | 31 | 4.2 | rectangular | 9 |
| | 2-43 | R-43 | 100 | 32 | 4.0 | rectangular | 9 |
| | 2-44 | R-44 | 105 | 32 | 4.2 | rectangular | 9 |
| | 2-45 | R-45 | 100 | 33 | 4.1 | rectangular | 9 |
| | 2-46 | R-46 | 105 | 32 | 4.1 | rectangular | 9 |
| | 2-47 | R-47 | 105 | 31 | 4.2 | rectangular | 9 |
| | 2-48 | R-48 | 105 | 32 | 4.1 | rectangular | 9 |
| | 2-49 | R-49 | 100 | 32 | 4.3 | rectangular | 9 |
| | 2-50 | R-50 | 95 | 31 | 4.2 | rectangular | 9 |
| | 2-51 | R-51 | 100 | 32 | 4.3 | rectangular | 9 |
| | 2-52 | R-52 | 105 | 32 | 4.2 | rectangular | 9 |
| | 2-53 | R-53 | 105 | 32 | 4.1 | rectangular | 9 |
| | 2-54 | R-54 | 105 | 31 | 4.2 | rectangular | 9 |

**Table 7**

| | | Resist composition | Eop (µC/cm²) | Maximum resolution (nm) | LER (nm) | Pattern profile | Area loss (%) |
|---|---|---|---|---|---|---|---|
| | 2-1 | CR-1 | 90 | 60 | 6.1 | undercut | 14 |
| | 2-2 | CR-2 | 110 | 50 | 5.5 | footing | 15 |
| | 2-3 | CR-3 | 110 | 51 | 5.3 | footing | 16 |
| | 2-4 | CR-4 | 105 | 47 | 5.3 | footing | 15 |
| Comparative Example | 2-5 | CR-5 | 110 | 48 | 5.4 | footing | 15 |
| | 2-6 | CR-6 | 110 | 47 | 5.3 | footing | 16 |
| | 2-7 | CR-7 | 110 | 48 | 5.2 | footing | 14 |
| | 2-8 | CR-8 | 105 | 48 | 5.1 | footing | 15 |
| | 2-9 | CR-9 | 110 | 50 | 5.4 | footing | 16 |
| | 2-10 | CR-10 | 110 | 47 | 5,3 | footing | 15 |

All the chemically amplified negative resist compositions (R-1 to R-54) within the scope of the invention show satisfactory resolution, reduced LER, pattern rectangularity, and pattern fidelity. The comparative resist compositions (CR-1 to CR-10) lack resolution, LER and pattern rectangularity because the acid generator is of insufficient design.

The resist pattern forming process using the negative resist composition is useful in photolithography for the fabrication of semiconductor devices and the processing of photomask blanks of transmission or reflection type.

## Claims

1. A chemically amplified negative resist composition comprising (A) a photoacid generator in the form of an onium salt having the formula (A) and (B) a base polymer containing a polymer comprising repeat units having the formula (B1): 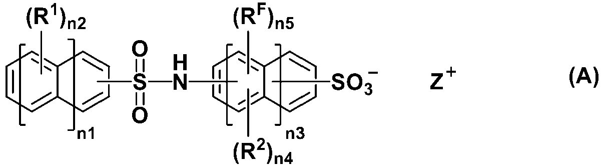
wherein n1 is 0 or 1, n2 is 1, 2, 3, 4 or 5 when n1=0, n2 is 1, 2, 3, 4, 5, 6 or 7 when n1=1, n3 is 0 or 1, n4 is 0, 1, 2, 3 or 4, n5 is 0, 1, 2, 3 or 4, n3 to n5 are in the range: 0 ≤ n4+n5 ≤ 4 when n3=0, and 0 ≤ n4+n5 ≤ 6 when n3=1,
R¹ is each independently iodine or a C₃-C₂₀ branched or cyclic hydrocarbyl group which may contain a heteroatom, at least one R¹ is bonded to a carbon atom adjoining the carbon atom to which S is bonded; when n2 is 2 or more, a plurality of R¹ may be identical or different and a plurality of R¹ may bond together to form a ring with the carbon atoms to which they are attached,
R² is halogen exclusive of fluorine, or a C₁-C₂₀ hydrocarbyl group which may contain a heteroatom exclusive of fluorine; when n4 is 2, 3 or 4, a plurality of R² may be identical or different and a plurality of R² may bond together to form a ring with the carbon atoms to which they are attached,
R^{F} is fluorine, a C₁-C₆ fluorinated alkyl group, C₁-C₆ fluorinated alkoxy group or C₁-C₆ fluorinated alkylthio group; when n5 is 2, 3 or 4, a plurality of R^{F} may be identical or different,
Z⁺ is an onium cation, 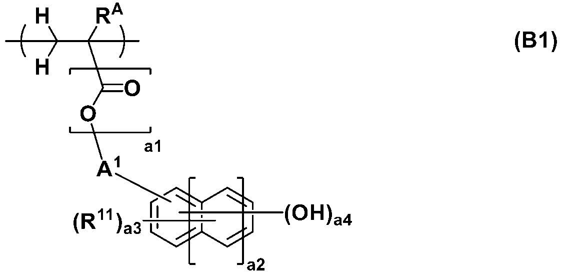
wherein a1 is 0 or 1, a2 is 0, 1 or 2, a3 is an integer meeting 0 ≤ a3 ≤ 5+2(a2)-a4, a4 is 1, 2 or 3,
R^{A} is hydrogen, fluorine, methyl or trifluoromethyl,
R¹¹ is halogen, nitro group, carboxy group, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group; when a3 is 2 or more, a plurality of R¹¹ may be identical or different, and
A¹ is a single bond or C₁-C₁₀ saturated hydrocarbylene group in which some -CH₂-may be replaced by -O-.

2. The negative resist composition of claim 1 wherein Z⁺ is a sulfonium cation having the formula (Z-1), iodonium cation having the formula (Z-2) or sulfonium cation having the formula (Z-3): 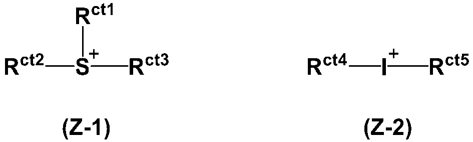
wherein R^{ct1} to R^{ct5} are each independently halogen or a C₁-C₃₀ hydrocarbyl group which may contain a heteroatom, R^{ct1} and R^{ct2} may bond together to form a ring with the sulfur atom to which they are attached, 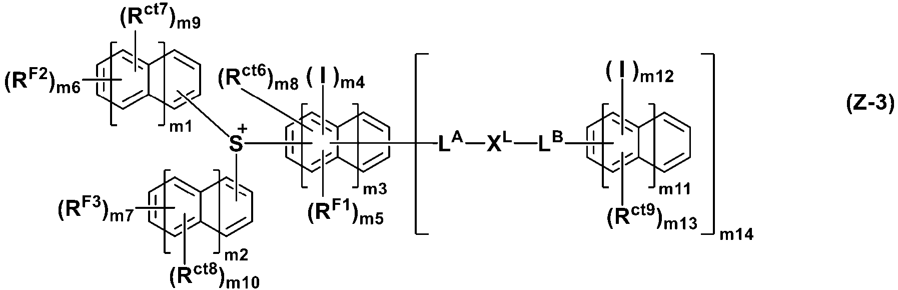
wherein m1 is 0 or 1, m2 is 0 or 1, m3 is 0 or 1, m4 is 0, 1, 2, 3 or 4, m5 is 0, 1, 2, 3 or 4, m6 is 0, 1, 2, 3, 4, 5 or 6, m7 is 0, 1, 2, 3, 4, 5 or 6, m8 is 0, 1 or 2, m9 is 0, 1 or 2, m10 is 0, 1 or 2, m11 is 0 or 1, m12 is 0, 1, 2, 3 or 4, m13 is 0, 1 or 2, m14 is 0, 1 or 2, meeting 0 ≤ m6+m9 ≤ 4 when m1=0, 0 ≤ m6+m9 ≤ 6 when m1=1, 0 ≤ m7+m10 ≤ 4 when m2=0, 0 ≤ m7+m10 ≤ 6 when m2=1, 1 ≤ m4+m5+m8+m14 ≤ 4 when m3=0, 1 ≤ m4+m5+m8+m14 ≤ 6 when m3=1, 0 ≤ m12+m13 ≤ 4 when m11=0, 0 ≤ m12+m13 ≤ 6 when m11=1, and m4+m12 ≥ 1,
R^{F1} to R^{F3} are each independently fluorine, a C₁-C₆ fluorinated saturated hydrocarbyl group, C₁-C₆ fluorinated saturated hydrocarbyloxy group, or C₁-C₆ fluorinated saturated hydrocarbylthio group, with the proviso that a plurality of R^{F1} may be identical or different when m5 is 2, 3 or 4, a plurality of R^{F2} may be identical or different when m6 is 2, 3, 4, 5 or 6, and a plurality of R^{F3} may be identical or different when m7 is 2, 3, 4, 5 or 6,
R^{ct6} to R^{ct9} are each independently halogen exclusive of iodine and fluorine, nitro, cyano, a C₁-C₂₀ hydrocarbyl group which may contain a heteroatom, C₁-C₂₀ hydrocarbyloxy group which may contain a heteroatom, or C₁-C₂₀ hydrocarbylthio group which may contain a heteroatom, with the proviso that two R^{ct6} may be identical or different and two R^{ct6} may bond together to form a ring with the carbon atoms to which they are attached when m8=2, two R^{ct7} may be identical or different and two R^{ct7} may bond together to form a ring with the carbon atoms to which they are attached when m9=2, two R^{ct8} may be identical or different and two R^{ct8} may bond together to form a ring with the carbon atoms to which they are attached when m10=2, two R^{ct9} may be identical or different and two R^{ct9} may bond together to form a ring with the carbon atoms to which they are attached when m13=2,
the aromatic rings directly bonded to S⁺ in the sulfonium cation may bond together to form a ring with S⁺,
L^{A} and L^{B} are each independently a single bond, ether bond, ester bond, amide bond, sulfonate ester bond, sulfonamide bond, carbonate bond or carbamate bond, and
X^{L} is a single bond or a C₁-C₄₀ hydrocarbylene group which may contain a heteroatom.

3. The negative resist composition of claim 1 or 2 wherein the polymer further comprises repeat units of at least one type selected from repeat units having the formula (B2) and repeat units having the formula (B3): 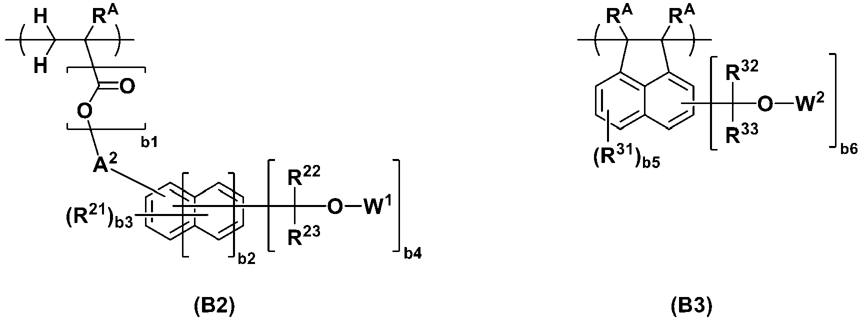 wherein b1 is 0 or 1, b2 is 0, 1 or 2, b3 is an integer meeting 0 ≤ b3 ≤ 5+2(b2)-b4, b4 is 1, 2 or 3, b5 is 0, 1 or 2, b6 is 1 or 2,
R^{A} is each independently hydrogen, fluorine, methyl or trifluoromethyl,
R²¹ is halogen or a C₁-C₂₀ hydrocarbyl group which may contain a heteroatom, a plurality of R²¹ may be identical or different when b3 is 2 or more,
R²² and R²³ are each independently hydrogen, a C₁-C₁₅ saturated hydrocarbyl group which may be substituted with a hydroxy or C₁-C₆ saturated hydrocarbyloxy moiety, or an optionally substituted C₆-C₁₅ aryl group, excluding that R²² and R²³ are hydrogen at the same time, R²² and R²³ may bond together to form a ring with the carbon atom to which they are attached, some -CH₂- in the ring may be replaced by -O- or -S-; a plurality of R²² may be identical or different when b4 is 2 or 3, a plurality of R²³ may be identical or different when b4 is 2 or 3,
R³¹ is halogen or a C₁-C₂₀ hydrocarbyl group which may contain a heteroatom, a plurality of R³¹ may be identical or different when b5=2,
R³² and R³³ are each independently hydrogen, a C₁-C₁₅ saturated hydrocarbyl group which may be substituted with a hydroxy or C₁-C₆ saturated hydrocarbyloxy moiety, or an optionally substituted C₆-C₁₅ aryl group, excluding that R³² and R³³ are hydrogen at the same time, R³² and R³³ may bond together to form a ring with the carbon atom to which they are attached, some -CH₂- in the ring may be replaced by -O- or -S-; a plurality of R³² may be identical or different when b6=2, and a plurality of R³³ may be identical or different when b6=2,
A² is a single bond or C₁-C₁₀ saturated hydrocarbylene group in which some -CH₂-may be replaced by -O-,
W¹ and W² are each independently hydrogen, a C₁-C₁₀ aliphatic hydrocarbyl group, C₂-C₁₀ aliphatic hydrocarbylcarbonyl group, or optionally substituted C₆-C₁₅ aryl group; a plurality of W¹ may be identical or different when b4 is 2 or 3, and a plurality of W² may be identical or different when b6=2.

4. The negative resist composition of any one of claims 1 to 3 wherein the polymer further comprises repeat units of at least one type selected from repeat units having the formula (B4), repeat units having the formula (B5), and repeat units having the formula (B6): 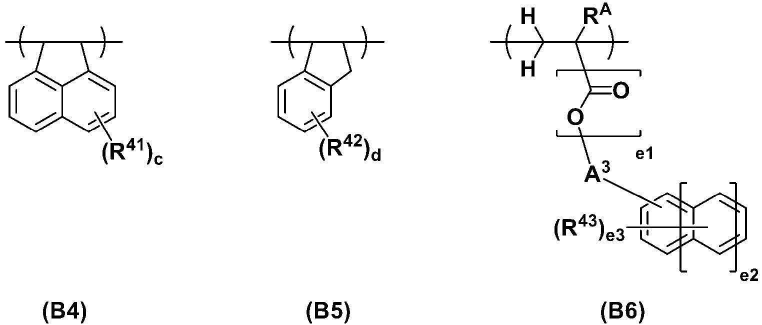 wherein c and d are each independently 0, 1, 2, 3 or 4, e1 is 0 or 1, e2 is 0, 1 or 2, e3 is 0, 1, 2, 3, 4 or 5,
R^{A} is hydrogen, fluorine, methyl or trifluoromethyl,
R⁴¹ and R⁴² are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group; a plurality of R⁴¹ may be identical or different when c is 2, 3 or 4, and a plurality of R⁴² may be identical or different when d is 2, 3 or 4,
R⁴³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro, cyano, C₁-C₂₀ saturated hydrocarbylsulfinyl group, or C₁-C₂₀ saturated hydrocarbylsulfonyl group, a plurality of R¹³ may be identical or different when e3 is 2, 3, 4 or 5, and
A³ is a single bond or C₁-C₁₀ saturated hydrocarbylene group in which some -CH₂-may be replaced by -O-.

5. The negative resist composition of claim 3 wherein the polymer further comprises repeat units of at least one type selected from repeat units having the formula (B7), repeat units having the formula (B8), repeat units having the formula (B9), repeat units having the formula (B10), and repeat units having the formula (B11): 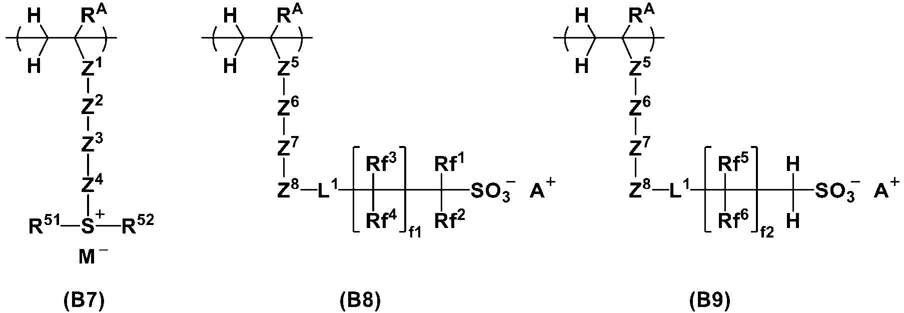 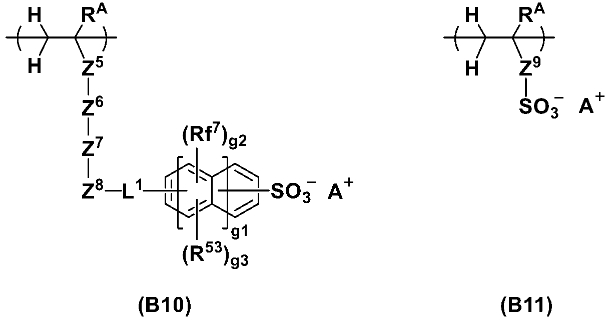 wherein f1 and f2 are each independently 0, 1, 2 or 3, g1 is 0 or 1, g2 is 0, 1, 2, 3 or 4, g3 is 0, 1, 2, 3 or 4, meeting 0 ≤ g2+g3 ≤ 4 when gl=0, and 0 ≤ g2+g3 ≤ 6 when gl=1,
R^{A} is each independently hydrogen, fluorine, methyl or trifluoromethyl,
Z¹ is a single bond or an optionally substituted phenylene group,
Z² is a single bond, **-C(=O)-O-Z²¹-, **-C(=O)-NH-Z²¹-, or **-O-Z²¹-, Z²¹ is a C₁-C₆ aliphatic hydrocarbylene group, phenylene group or a divalent group obtained by combining the foregoing, which may contain halogen, carbonyl moiety, ester bond, ether bond or hydroxy moiety,
Z³ is a single bond, ether bond, ester bond, amide bond, sulfonate ester bond, sulfonamide bond, carbonate bond or carbamate bond,
Z⁴ is a single bond, or a C₁-C₆ aliphatic hydrocarbylene group, phenylene group or a divalent group obtained by combining the foregoing, which may contain halogen, carbonyl moiety, ester bond, ether bond or hydroxy moiety,
Z⁵ is each independently a single bond, an optionally substituted phenylene, naphthylene, or *-C(=O)-O-Z⁵¹-, Z⁵¹ is a C₁-C₁₀ aliphatic hydrocarbylene group which may contain halogen, hydroxy moiety, ether bond, ester bond or lactone ring, or phenylene or naphthylene group,
Z⁶ is a single bond, ether bond, ester bond, amide bond, sulfonate ester bond, sulfonamide bond, carbonate bond or carbamate bond,
Z⁷ is each independently a single bond, ***-Z⁷¹-C(=O)-O-, ***-C(=O)-NH-Z⁷¹-, or ***-O-Z⁷¹-, Z⁷¹ is a C₁-C₂₀ hydrocarbylene group which may contain a heteroatom,
Z⁸ is each independently a single bond, ****-Z⁸¹-C(=O)-O-, ****-C(=O)-NH-Z⁸¹-, or ****-O-Z⁸¹-, Z⁸¹ is a C₁-C₂₀ hydrocarbylene group which may contain a heteroatom,
Z⁹ is a single bond, methylene, ethylene, phenylene, fluorinated phenylene, trifluoromethyl-substituted phenylene, *-C(=O)-O-Z⁹¹-, *-C(=O)-N(H)-Z⁹¹-, or *-O-Z⁹¹-, Z⁹¹ is a C₁-C₆ aliphatic hydrocarbylene group, phenylene group, fluorinated phenylene group or trifluoromethyl-substituted phenylene group, which may contain a carbonyl moiety, ester bond, ether bond or hydroxy moiety,
* is a point of attachment to the carbon atom in the backbone, ** is a point of attachment to Z¹, *** is a point of attachment to Z⁶, **** is a point of attachment to Z⁷,
L¹ is a single bond, ether bond, ester bond, carbonyl group, sulfonate ester bond, sulfonamide bond, carbonate bond or carbamate bond,
Rf¹ and Rf² are each independently fluorine or a C₁-C₆ fluorinated saturated hydrocarbyl group,
Rf³ and Rf⁴ are each independently hydrogen, fluorine, or a C₁-C₆ fluorinated saturated hydrocarbyl group,
Rf⁵ and Rf⁶ are each independently hydrogen, fluorine, or a C₁-C₆ fluorinated saturated hydrocarbyl group, excluding that all Rf⁵ and Rf⁶ are hydrogen at the same time,
Rf⁷ is fluorine, a C₁-C₆ fluorinated alkyl group, C₁-C₆ fluorinated alkoxy group, or C₁-C₆ fluorinated alkylthio group, a plurality of Rf⁷ may be identical or different when g2 is 2, 3 or 4,
R⁵¹ and R⁵² are each independently a C₁-C₂₀ hydrocarbyl group which may contain a heteroatom, R⁵¹ and R³² may bond together to form a ring with the sulfur atom to which they are attached,
R⁵³ is halogen exclusive of fluorine, or a C₁-C₂₀ hydrocarbyl group which may contain a heteroatom; when g3 is 2, 3 or 4, a plurality of R⁵³ may be identical or different and a plurality of R⁵³ may bond together to form a ring with the carbon atoms to which they are attached,
M⁻ is a non-nucleophilic counter ion,
A⁺ is an onium cation.

6. The negative resist composition of claim 5 wherein the base polymer (B) contains a polymer comprising repeat units having formula (B1) and repeat units having formula (B2) or (B3), but not repeat units having formulae (B7) to (B11).

7. The negative resist composition of any one of claims 1 to 6 wherein repeat units having an aromatic ring structure account for at least 60 mol% of the overall repeat units of the polymer in the base polymer.

8. The negative resist composition of any one of claims 1 to 7, further comprising (C) a crosslinker.

9. The negative resist composition of any one of claims 1 to 8 which is free of a crosslinker.

10. The negative resist composition of any one of claims 1 to 9, further comprising (D) a fluorinated polymer comprising repeat units of at least one type selected from repeat units having the formula (D1), repeat units having the formula (D2), repeat units having the formula (D3) and repeat units having the formula (D4) and optionally repeat units of at least one type selected from repeat units having the formula (D5) and repeat units having the formula (D6): 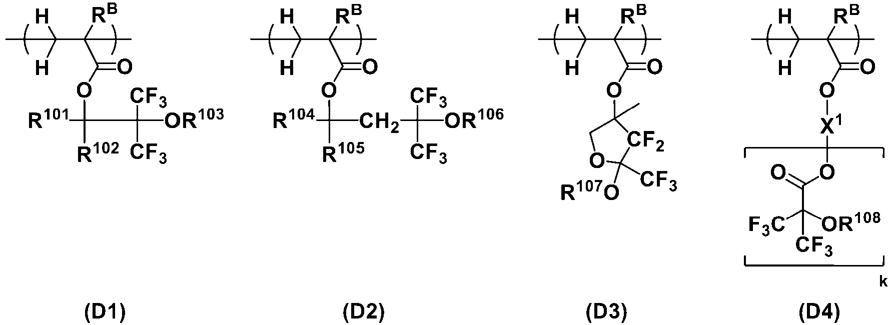 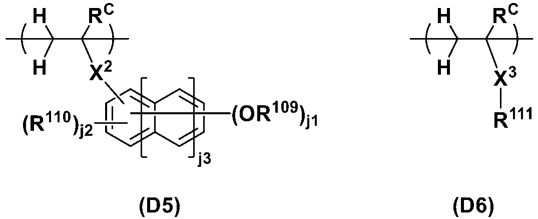 wherein j1 is 1, 2 or 3, j2 is an integer meeting 0 ≤ j2 ≤ 5+2(j3)-j1, j3 is 0 or 1, k is 1, 2 or 3,
R^{B} is each independently hydrogen, fluorine, methyl or trifluoromethyl,
R^{C} is each independently hydrogen or methyl,
R¹⁰¹, R¹⁰², R¹⁰⁴ and R¹⁰⁵ are each independently hydrogen or a C₁-C₁₀ saturated hydrocarbyl group,
R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, and when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
R¹⁰⁹ is hydrogen or a C₁-C₅ straight or branched hydrocarbyl group in which a heteroatom-containing moiety may intervene in a carbon-carbon bond,
R¹¹⁰ is a C₁-C₅ straight or branched hydrocarbyl group in which a heteroatom-containing moiety may intervene in a carbon-carbon bond,
R¹¹¹ is a C₁-C₂₀ saturated hydrocarbyl group in which at least one hydrogen is substituted by fluorine, and in which some constituent -CH₂- may be replaced by an ester bond or ether bond,
X¹ is a C₁-C₂₀ (k+1)-valent hydrocarbon group or C₁-C₂₀ (k+1)-valent fluorinated hydrocarbon group,
X² is a single bond, *-C(=O)-O- or *-C(=O)-NH-, * designates a point of attachment to the carbon atom in the backbone,
X³ is a single bond, -O-, *-C(=O)=O-X³¹-X³²- or *-C(=O)-NH-X³¹-X³²-, X³¹ is a single bond or C₁-C₁₀ saturated hydrocarbylene group, X³² is a single bond, ester bond, ether bond, or sulfonamide bond, and * designates a point of attachment to the carbon atom in the backbone.

11. The negative resist composition of any one of claims 1 to 10, further comprising (E) a quencher.

12. The negative resist composition of claim 11 wherein the acid generator (A) and the quencher (E) are present in a weight ratio of less than 6/1.

13. The negative resist composition of any one of claims 1 to 12, further comprising (F) an organic solvent.

14. A resist pattern forming process comprising the steps of:
applying the chemically amplified negative resist composition of any one of claims 1 to 13 onto a substrate to form a resist film thereon,
exposing the resist film patternwise to high-energy radiation, and
developing the exposed resist film in an alkaline developer.

15. A mask blank of transmission or reflection type which is coated with the chemically amplified negative resist composition of any one of claims 1 to 13.
